(19) Europäisches Patentamt
European Patent Office
Office européen des brevets

(11) EP 3 991 983 B1

(12) # EUROPEAN PATENT SPECIFICATION

(45) Date of publication and mention of the grant of the patent:
**09.04.2025 Bulletin 2025/15**

(21) Application number: **20830606.8**

(22) Date of filing: **26.06.2020**

(51) International Patent Classification (IPC):
***B41C 1/10*** (2006.01) ***B41N 1/14*** (2006.01)
***B41M 1/06*** (2006.01) ***B41N 1/08*** (2006.01)
***B41N 3/03*** (2006.01) ***G03F 7/00*** (2006.01)
***G03F 7/004*** (2006.01) ***G03F 7/027*** (2006.01)
***G03F 7/028*** (2006.01) ***G03F 7/029*** (2006.01)
***G03F 7/033*** (2006.01) ***G03F 7/09*** (2006.01)
***G03F 7/11*** (2006.01)

(52) Cooperative Patent Classification (CPC):
**B41C 1/1008; B41N 1/083;** B41C 2201/02; B41C 2210/04; B41C 2210/08; B41C 2210/20; B41C 2210/24; B41M 1/06; B41N 3/034

(86) International application number:
**PCT/JP2020/025408**

(87) International publication number:
**WO 2020/262686 (30.12.2020 Gazette 2020/53)**

(54) **ON-PRESS DEVELOPMENT TYPE LITHOGRAPHIC PRINTING PLATE PRECURSOR, METHOD FOR MANUFACTURING A LITHOGRAPHIC PRINTING PLATE, AND LITHOGRAPHIC PRINTING METHOD**

LITHOGRAFIEDRUCKPLATTENVORLÄUFER MIT ENTWICKLUNG AUF DER DRUCKPRESSE, LITHOGRAFIEDRUCKPLATTENHERSTELLUNGSVERFAHREN UND LITHOGRAFIEDRUCKVERFAHREN

PRÉCURSEUR DE PLAQUE D'IMPRESSION LITHOGRAPHIQUE DE TYPE À DÉVELOPPEMENT SUR PRESSE, PROCÉDÉ DE PRODUCTION DE PLAQUE D'IMPRESSION LITHOGRAPHIQUE ET PROCÉDÉ D'IMPRESSION LITHOGRAPHIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.06.2019 JP 2019122491**
**30.08.2019 JP 2019158807**
**18.09.2019 JP 2019169799**

(43) Date of publication of application:
**04.05.2022 Bulletin 2022/18**

(73) Proprietor: **FUJIFILM Corporation**
**Tokyo 106-8620 (JP)**

(72) Inventor: **AIZU, Kohei**
**Shizuoka 421-0396 (JP)**

(74) Representative: **HGF**
**HGF Limited**
**1 City Walk**
**Leeds LS11 9DX (GB)**

(56) References cited:
**EP-A1- 2 042 337**
**EP-A1- 3 456 547**
**EP-A1- 3 476 616**
**WO-A1-2009/057465**
**WO-A1-2018/159640**
**WO-A1-2019/013268**
**WO-A1-2019/013268**
**WO-A1-2019/087516**
**JP-A- 2000 171 974**
**JP-A- 2004 090 334**
**JP-A- 2005 144 676**
**JP-A- 2006 205 394**
**JP-A- 2013 504 084**
**JP-A- 2014 079 960**
**JP-A- 2019 064 269**
**JP-A- S63 202 497**
**JP-B1- 6 461 447**
**US-A1- 2005 112 502**
**US-A1- 2018 207 925**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

BACKGROUND OF THE INVENTION

1. Field of the Invention

The present disclosure relates to an on-press development type lithographic printing plate precursor, a method for preparing a lithographic printing plate, and a lithographic printing method.

2. Description of the Related Art

Generally, a lithographic printing plate consists of a lipophilic image area that receives ink in a printing process and a hydrophilic non-image area that receives dampening water. Lithographic printing is a method exploiting the mutual repulsion of water and oil-based ink, in which the lipophilic image area and the hydrophilic non-image area of a lithographic printing plate are used as an ink-receiving portion and a dampening water-receiving portion (that is, a non-ink-receiving portion) respectively, the adhesiveness of ink is varied within the surface of the lithographic printing plate so that only the image area receives the ink, and then printing is performed by the transfer of the ink to a printing substrate such as paper.

In the related art, in order to prepare this lithographic printing plate, a lithographic printing plate precursor (also called "PS plate") has been widely used which is obtained by providing a lipophilic photosensitive resin layer (that is, an image-recording layer) on a hydrophilic support. Generally, a lithographic printing plate is obtained by a plate making method of exposing a lithographic printing plate precursor through an original picture such as a lith film, then keeping a portion of an image-recording layer that will be an image area while removing other unnecessary portions of the image-recording layer by dissolving such portions in an alkaline developer or an organic solvent, and forming a non-image area by exposing the hydrophilic surface of a support.

In response to the intensifying interest in the global environment, an environmental issue of waste liquid generated by wet treatments such as a development treatment has gathered more attention.

Regarding the environmental issue described above, in development or plate making, an attempt is made to simplify process or to remove treatments. As one of the methods for preparing lithographic printing plate in a simple way, method called "on-press development" is being carried out. That is, in this method, after being exposed, a lithographic printing plate precursor is immediately mounted on a printer without being developed as in the related art, and an unnecessary portion of the image-recording layer is removed at an early stage of the ordinary printing step.

Examples of the lithographic printing plate precursors in the related art include those described in WO2019/504780A or WO2018/181993A.

JP2019-504780A describes an infrared-sensitive negative tone lithographic printing plate precursor having a substrate that has a hydrophilic surface and an infrared-sensitive image forming layer that is disposed on the hydrophilic surface of the substrate, in which the infrared-sensitive image forming layer contains an initiator composition and a main polymer binder, and the initiator composition contains one or more free radically polymerizable compounds, one or more infrared absorbers, a compound A represented by the following structure (I), and one or more compounds represented by the following structure (II) or structure (III) collectively as a compound B and produces free radicals by exposure of the infrared-sensitive image forming layer to infrared.

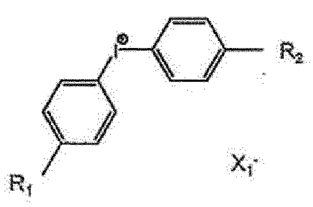

(I)

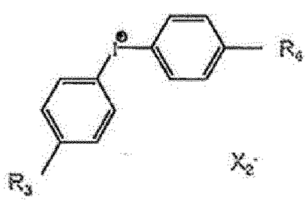

(II)

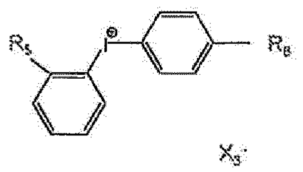

(III)

**In** the formula, $R_1$, $R_2$, $R_3$, $R_4$, $R_5$, and $R_6$ each independently represent a substituted or unsubstituted alkyl or alkoxy group each having 2 to 9 carbon atoms, at least one of $R_3$ or $R_4$ is different from $R_1$ or $R_2$, a difference between the total number of carbon atoms in $R_1$ and $R_2$ and the total number of carbon atoms in $R_3$ and $R_4$ is 0 to 4, a difference between the total number of carbon atoms in $R_1$ and $R_2$ and the total number of carbon atoms in $R_5$ and $R_6$ is 0 to 4, and $X_1$, $X_2$, and $X_3$ represent the same or different anions.

**In** addition, WO2018/181993A describes a lithographic printing plate precursor has a water-soluble or water-dispersible negative tone image-recording layer on a hydrophilized aluminum support, in which an arithmetic mean height Sa of a surface of an outermost layer on a side provided with the image-recording layer is 0.3 μm or more and 20 μm or less. EP3456547 A1 discloses a lithographic printing plate precursor including an image recording layer containing an infrared absorber represented by a particular Formula I on a support.

EP3476616 A1 discloses a lithographic printing plate precursor comprising an aluminum support and an image recording layer, wherein the aluminum support includes an aluminum plate and an anodized film of aluminum formed on the aluminum plate, wherein the anodized film is positioned closer to the image recording layer than the aluminum plate is, wherein the anodized film has micropores extending in a depth direction of the anodized film from a surface of the anodized film on the image recording layer side, wherein the micropores have an average diameter of more than 10 nm but not more than 100 nm at the surface of the anodized film, and wherein the surface of the anodized film on the image recording layer side has a lightness L* of 70 to 100 in a L*a*b* color system.

WO2019087516 A1 discloses a planographic printing plate original plate comprising an aluminum support body and an image recording layer arranged on the aluminum support body, wherein the density of concave parts having a depth of 0.70 μm or more from a central line is $3000/mm^2$ or more according to a measurement of a region of 400 μm × 400 μm of a surface on an image recording layer side of the aluminum support body using a non-contact three-dimensional roughness meter, and a surface area ratio ΔS calculated from an actual area Sx and a geometrical measurement area S0 of 35% or more.

WO2019/013268 A1 discloses a lithographic printing plate original plate having an image-recording layer on a hydrophilic support body, the image-recording layer including a polymerization initiator, an infrared ray absorber, a polymerizable compound, and an acid-generating color agent, and the infrared ray absorber including a compound represented by a particular formula 1.

EP2042337 A1 discloses a lithographic printing plate precursor includes: a support having a surface, a contact angle of water droplet in air on which is 70° or more; and a photosensitive layer, wherein the support has a compound having a functional group X on a surface of the support, the functional group X is a functional group capable of being decomposed to convert to a functional group Y, when the functional group X is treated with an aqueous solution having pH of from 2 to 10, so as to decrease the contact angle of water droplet in air on the surface of the support to 30° or less.

SUMMARY OF THE INVENTION

One embodiment according to the present invention relates to provide an on-press development type lithographic printing plate precursor that provides a lithographic printing plate excellently suppressing scratches and contamination of a non-image area.

Another embodiment according to the present invention relates to provide a method for preparing a lithographic printing plate and a lithographic printing method using the on-press development type lithographic printing plate precursor.

The present invention is as defined in the appended claim set.

According to one embodiment of the present invention, it is possible to provide an on-press development type lithographic printing plate precursor excellently suppressing scratches and contamination of a non-image area in the obtained lithographic printing plate.

According to another embodiment of the present invention, it is possible to provide a method for preparing a lithographic printing plate and a lithographic printing method using the on-press development type lithographic printing plate precursor.

BRIEF DESCRIPTION OF THE DRAWINGS

Fig. 1 is a schematic cross-sectional view of an embodiment of an aluminum support.

Fig. 2 is a schematic cross-sectional view of another embodiment of the aluminum support.

Fig. 3 is an example of a waveform graph of alternating current used for an electrochemical roughening treatment in a method for manufacturing an aluminum support.

Fig. 4 is a lateral view showing an example of a radial cell in an electrochemical roughening treatment using alternating current in a method for manufacturing an aluminum support.

Fig. 5 is a lateral view conceptually showing a brush graining step used in a mechanical roughening treatment in a method for manufacturing an aluminum support having an anodic oxide film.

Fig. 6 is a schematic view of an anodic oxidation treatment device used for an anodic oxidation treatment in preparing an aluminum support.

DESCRIPTION OF THE PREFERRED EMBODIMENTS

Hereinafter, the contents of the present disclosure will be specifically described. The following constituents will be described on the basis of typical embodiments of the present disclosure, but the present disclosure is not limited to such embodiments.

In the present disclosure, a numerical range expressed using "to" includes numerical values listed before and after "to" as the lower limit and the upper limit.

Regarding the numerical ranges described stepwise in the present disclosure, the upper limit or lower limit of a numerical range may be replaced with the upper limit or lower limit of another numerical range described stepwise. Furthermore, the upper limit and lower limit of a numerical range described in the present disclosure may be replaced with the values shown in Examples.

Furthermore, in the present disclosure, in a case where there is no description regarding whether a group (atomic group) is substituted or unsubstituted, such a group includes both a group having no substituent and a group having a substituent. For example, "alkyl group" includes not only an alkyl group having no substituent (unsubstituted alkyl group) but also an alkyl group having a substituent (substituted alkyl group).

In the present disclosure, "(meth)acryl" is a term used to explain a concept including both the acryl and methacryl, and "(meth)acryloyl" is a term used to explain a concept including both the acryloyl and methacryloyl.

In addition, the term "step" in the present disclosure means not only an independent step but also a step that cannot be clearly differentiated from other steps as long as the intended goal of the step is achieved. In the present disclosure, "% by mass" has the same definition as "% by weight", and "part by mass" has the same definition as "part by weight".

In the present disclosure, a combination of two or more preferred aspects is a more preferred aspect.

In addition, in the present disclosure, unless otherwise specified, each of the weight-average molecular weight (Mw) and number-average molecular weight (Mn) is a molecular weight that is detected using a gel permeation chromatography (GPC) analysis device using TSKgel GMHxL, TSKgel G4000HxL, and TSKgel G2000HxL (trade names, manufactured by Tosoh Corporation) as columns, tetrahydrofuran (THF) as a solvent, and a differential refractometer, and expressed in terms of polystyrene as a standard substance.

In the present disclosure, the term "lithographic printing plate precursor" refers not only to a lithographic printing plate precursor but also to a key plate precursor. In addition, the term "lithographic printing plate" refers not only to a lithographic printing plate prepared by performing operations such as exposure and development as necessary on a lithographic printing plate precursor but also to a key plate. The key plate precursor is not necessarily subjected to the operations such as exposure and development. The key plate refers to a lithographic printing plate precursor to be mounted on a plate cylinder that is not used, in a case where monochromatic or dichromatic printing is carried out on a part of paper during, for example, color newspaper printing.

Hereinafter, the on-press development type lithographic printing plate precursor, the method for preparing a lithographic printing plate, and the lithographic printing method will be specifically described.

(Lithographic printing plate precursor)

The on-press development type lithographic printing plate precursor (hereinafter, also simply called "lithographic printing plate precursor") according to the present invention has an aluminum support and an image-recording layer on the aluminum support,

in which the image-recording layer contains an infrared absorber, a polymerization initiator, a polymerizable compound, and an addition polymerization-type resin having a hydrophilic structure,
a water contact angle on a surface of the aluminum support on a side of the image-recording layer that is determined by an airborne water droplet method is 110° or less, and
the polymerizable compound includes a polymerizable compound having 7 or more functional groups.

The lithographic printing plate precursor according to the present invention is a negative tone lithographic printing plate precursor.
As a result of intensive studies, the inventors of the present invention have found that adopting the above configuration makes it possible to provide a lithographic printing plate precursor excellently suppressing scratches and contamination of a non-image area (hereinafter, also simply described as "suppression of scratches and contamination") in the obtained lithographic printing plate.
The detailed mechanism that brings about the aforementioned effect is unclear, but is assumed to be as below.
Presumably, because the image-recording layer contains an addition polymerization-type resin having a hydrophilic structure, and a water contact angle on a surface of the aluminum support on a side of the image-recording layer that is determined by an airborne water droplet method is 110° or less, the surface of the support on the side of the image-recording layer may have higher hydrophilicity, the ink receiving properties of a non-image area may deteriorate, and ink is unlikely to stick to the scratches on the non-image area. Presumably, as a result, scratches and contamination of the non-image area in the lithographic printing plate may be excellently suppressed.

<Image-recording layer>

The lithographic printing plate precursor according to the present invention has an aluminum support and an image-recording layer on the aluminum support, and the image-recording layer has an infrared absorber, a polymerization initiator, a polymerizable compound, and an addition polymerization-type resin having a hydrophilic structure.
From the viewpoint of printing durability and photosensitivity, the image-recording layer in the present disclosure preferably further contains an electron-accepting polymerization initiator as the polymerization initiator.
The image-recording layer used in the present disclosure may further contain an acid color-developing agent so that the exposed portion is checked before development.
In the lithographic printing plate precursor according to the present disclosure, from the viewpoint of on-press developability, it is preferable that a non-exposed portion of the image-recording layer can be removed with at least one material selected from the group consisting of dampening water and a printing ink.
Hereinafter, each of the components contained in the image-recording layer will be specifically described.

-Addition polymerization-type resin having hydrophilic structure-

The image-recording layer in the present invention contains an addition polymerization-type resin having a hydrophilic structure (hereinafter, also simply called "addition polymerization-type resin").
The addition polymerization-type resin in the present disclosure may be a binder resin (that is, a binder polymer) that is not in the form of particles, or may be particles. From the viewpoint of receptivity, the addition polymerization-type resin is preferably particles. From the viewpoint of stability of a coating solution used in a case where the image-recording layer is formed by coating, the addition polymerization-type resin is preferably a binder polymer (non-particle).

[Hydrophilic structure]

The addition polymerization-type resin preferably has a hydrophilic structure and a hydrophilic group-containing constitutional unit.
The hydrophilic group is not particularly limited as long as it is a hydrophilic structure. Examples of the hydrophilic group include an acid group such as a carboxy group, a hydroxyl group, an amino group, a cyano group, a polyalkylene oxide structure, and the like.
Among hydrophilic groups, from the viewpoint of UV printing durability and on-press developability, a group having a polyalkylene oxide structure, a group having a polyester structure, or a sulfonic acid group is preferable, a group

having a polyalkylene oxide structure or a sulfonic acid group is more preferable, and a group having a polyalkylene oxide structure is even more preferable.

From the viewpoint of on-press developability, the polyalkylene oxide structure is preferably a polyethylene oxide structure, a polypropylene oxide structure, or a poly(ethylene oxide/propylene oxide) structure.

Furthermore, from the viewpoint of on-press developability and suppressing development residues during on-press development, the resin preferably has, as a polyalkylene oxide structure, a polypropylene oxide structure, and more preferably has a polyethylene oxide structure and a polypropylene oxide structure, among hydrophilic groups.

From the viewpoint of on-press developability, the number of alkylene oxide structures in the polyalkylene oxide structure is preferably 2 or more, more preferably 5 or more, even more preferably 5 to 200, and particularly preferably 8 to 150.

Furthermore, from the viewpoint of on-press developability, the hydrophilic structure preferably includes a group represented by Formula Z, and more preferably has a group represented by Formula Z.

*-Q-W-Y Formula Z

**In** Formula Z, Q represents a divalent linking group, W represents a divalent group having a hydrophilic structure or a divalent group having a hydrophobic structure, Y represents a monovalent group having a hydrophilic structure or a monovalent group having a hydrophobic structure, either W or Y has a hydrophilic structure, and * represents a binding site with other structures.

Q in Formula Z is preferably a divalent linking group having 1 to 20 carbon atoms, and more preferably a divalent linking group having 1 to 10 carbon atoms.

Furthermore, Q in Formula Z is preferably an alkylene group, an arylene group, an ester bond, an amide bond, or a group formed by combining two or more of these, and more preferably a phenylene group, an ester bond, or an amide bond.

The divalent group having a hydrophilic structure represented by W in Formula Z is preferably a polyalkyleneoxy group or a group in which $-CH_2CH_2NR^W-$ is bonded to one terminal of a polyalkyleneoxy group. $R^W$ represents a hydrogen atom or an alkyl group.

The divalent group having a hydrophobic structure represented by W in Formula Z is preferably $-R^{WA}-$, $-O-R^{WA}-O-$, $-R^WN-R^{WA}-NR^W-$, $-OC(=O)-R^{WA}-O-$, or $-OC(=O)-R^{WA}-O-$. $R^{WA}$ each independently represents a linear, branched, or cyclic alkylene group having 6 to 120 carbon atoms, a haloalkylene group having 6 to 120 carbon atoms, an arylene group having 6 to 120 carbon atoms, an alkarylene group having 6 to 120 carbon atoms (divalent group formed by removing one hydrogen atom from an alkylaryl group), or an aralkylene group having 6 to 120 carbon atoms.

The monovalent group having a hydrophilic structure represented by Y in Formula Z is preferably -OH, -C(=O)OH, a polyalkyleneoxy group having a hydrogen atom or an alkyl group on a terminal, or a group in which $-CH_2CH_2N(R^W)-$ is bonded to one terminal of a polyalkyleneoxy group having a hydrogen atom or an alkyl group on the other terminal.

The monovalent group having a hydrophobic structure represented by Y in Formula Z is preferably a linear, branched, or cyclic alkyl group having 6 to 120 carbon atoms, a haloalkyl group having 6 to 120 carbon atoms, an aryl group having 6 to 120 carbon atoms, an alkaryl group having 6 to 120 carbon atoms (alkylaryl group), an aralkyl group having 6 to 120 carbon atoms, $-OR^{WB}$, $-C(=O)OR^{WB}$, or $-OC(=O)R^{WB}$. $R^{WB}$ represents an alkyl group having 6 to 20 carbon atoms.

From the viewpoint of printing durability, receptivity, and on-press developability, in a group represented by formula Z, W is more preferably a divalent group having a hydrophilic structure, Q is more preferably a phenylene group, an ester bond, or an amide bond, W is more preferably a polyalkyleneoxy group, and Y is more preferably a polyalkyleneoxy group having a hydrogen atom or an alkyl group on a terminal.

From the viewpoint of receptivity and on-press developability, it is preferable that the addition polymerization-type resin have a constitutional unit formed of an aromatic vinyl compound and a constitutional unit formed of an acrylonitrile compound.

[Constitutional unit formed of aromatic vinyl compound]

The addition polymerization-type resin preferably has a constitutional unit formed of an aromatic vinyl compound.

The aromatic vinyl compound may be any compound having a structure in which a vinyl group is bonded to an aromatic ring. Examples of the aromatic vinyl compound include a styrene compound, a vinylnaphthalene compound, and the like. Among these, a styrene compound is preferable, and styrene is more preferable.

Examples of the styrene compound include styrene, p-methylstyrene, p-methoxystyrene, β-methylstyrene, p-methyl-β-methylstyrene, α-methylstyrene, p-methoxy-β-methylstyrene, and the like. Among these, for example, styrene is preferable.

Examples of the vinylnaphthalene compound include 1-vinylnaphthalene, methyl-1-vinylnaphthalene, β-methyl-1-vinylnaphthalene, 4-methyl-1-vinylnaphthalene, 4-methoxy-1-vinylnaphthalene, and the like. Among these,

for example, 1-vinylnaphthalene is preferable.

As the constitutional unit formed of an aromatic vinyl compound, for example, a constitutional unit represented by Formula A1 is preferable.

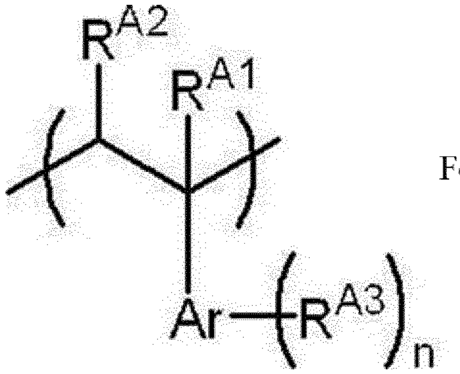

Formula A1

In Formula A1, $R^{A1}$ and $R^{A2}$ each independently represent a hydrogen atom or an alkyl group, Ar represents an aromatic ring group, $R^{A3}$ represents a substituent, and n represents an integer equal to or less than the maximum number of substituents of Ar.

In Formula A1, $R^{A1}$ and $R^{A2}$ preferably each independently represent a hydrogen atom or an alkyl group having 1 to 4 carbon atoms, more preferably each independently represent a hydrogen atom or a methyl group, and even more preferably both represent a hydrogen atom.

In Formula A1, Ar is preferably a benzene ring or a naphthalene ring, and more preferably a benzene ring.

In Formula A1, $R^{A3}$ is preferably an alkyl group or an alkoxy group, more preferably an alkyl group having 1 to 4 carbon atoms or an alkoxy group having 1 to 4 carbon atoms, and even more preferably a methyl group or a methoxy group.

In a case where there is a plurality of $R^{A3}$'s in Formula A1, the plurality of $R^{A3}$'s may be the same as or different from each other.

In Formula A1, n is preferably an integer of 0 to 2, more preferably 0 or 1, and even more preferably 0.

In the addition polymerization-type resin, the content of the constitutional unit formed of an aromatic vinyl compound with respect to the total mass of the addition polymerization-type resin is preferably 15% by mass to 85% by mass, and more preferably 30% by mass to 70% by mass.

[Constitutional unit formed of acrylonitrile compound]

The addition polymerization-type resin preferably has a constitutional unit formed of an acrylonitrile compound.

Examples of the acrylonitrile compound include (meth)acrylonitrile and the like. Among these, for example, acrylonitrile is preferable.

Preferable examples of the constitutional unit formed of an acrylonitrile compound include a constitutional unit represented by Formula B1.

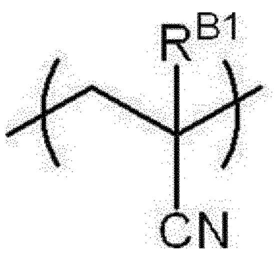

Formula B1

In Formula B1, $R^{B1}$ represents a hydrogen atom or an alkyl group.

In Formula B1, $R^{B1}$ is preferably a hydrogen atom or an alkyl group having 1 to 4 carbon atoms, more preferably a hydrogen atom or a methyl group, and even more preferably a hydrogen atom.

In the addition polymerization-type resin, the content of the constitutional unit formed of an acrylonitrile compound with respect to the total mass of the addition polymerization-type resin is preferably 15% by mass to 85% by mass, and more preferably 30% by mass to 70% by mass.

[Constitutional unit formed of N-vinyl heterocyclic compound]

From the viewpoint of printing durability and chemical resistance, it is preferable that the addition polymerization-type resin further have a constitutional unit formed of N-vinyl heterocyclic compound.
Examples of the N-vinyl heterocyclic compound include N-vinylpyrrolidone, N-vinylcarbazole, N-vinylpyrrole, N-vinylphenothiazine, N-vinylsuccinic acid imide, N-vinylphthalimide, N-vinylcaprolactam, and N-vinylimidazole. Among these, N-vinylpyrrolidone is preferable.
As the constitutional unit formed of a N-vinyl heterocyclic compound, for example, a constitutional unit represented by Formula C1 is preferable.

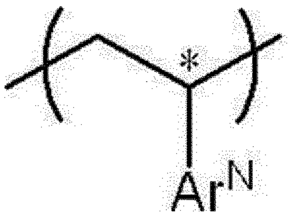

Formula C1

In Formula C1, $Ar^N$ represents a nitrogen atom-containing heterocyclic structure, and the nitrogen atom in $Ar^N$ is bonded to the carbon atom represented by *.
In Formula C1, the heterocyclic structure represented by $Ar^N$ is preferably a pyrrolidone ring, a carbazole ring, a pyrrole ring, a phenothiazine ring, a succinimide ring, a phthalimide ring, a caprolactam ring, or an imidazole ring, and more preferably a pyrrolidone ring.
Furthermore, the heterocyclic structure represented by $Ar^N$ may have a known substituent.
In the addition polymerization-type resin, the content of the constitutional unit formed of a N-vinyl heterocyclic compound with respect to the total mass of the addition polymerization-type resin is preferably 5% by mass to 50% by mass, and more preferably 10% by mass to 40% by mass.

[Ethylenically unsaturated group-containing constitutional unit]

The addition polymerization-type resin may further have an ethylenically unsaturated group-containing constitutional unit.
The ethylenically unsaturated group is not particularly limited, and examples thereof include a vinyl group, an allyl group, a vinylphenyl group, a (meth)acrylamide group, a (meth)acryloyloxy group, and the like. From the viewpoint of reactivity, the ethylenically unsaturated group is preferably a (meth)acryloyloxy group.
The ethylenically unsaturated group-containing constitutional unit can be introduced into the addition polymerization-type resin by a polymer reaction or copolymerization. Specifically, this constitutional unit can be introduced into the resin, for example, by a method of reacting a compound (such as glycidyl methacrylate) having an epoxy group or an ethylenically unsaturated group with a polymer into which a constitutional unit having a carboxy group such as methacrylic acid is introduced, a method of reacting a compound (such as 2-isocyanatoethyl methacrylate) having an isocyanate group and an ethylenically unsaturated group with a polymer into which a constitutional unit having an active hydrogen-containing group such as a hydroxyl group is introduced, and the like.
Furthermore, the ethylenically unsaturated group-containing constitutional unit may be introduced into the addition polymerization-type resin by a method of reacting a compound having a carboxy group and an ethylenically unsaturated group with a polymer into which a constitutional unit having an epoxy group such as glycidyl (meth)acrylate is introduced.
In addition, the ethylenically unsaturated group-containing constitutional unit may be introduced into the addition polymerization-type resin, for example, by using a monomer having a partial structure represented by Formula d1 or Formula d2. Specifically, for example, after polymerization is performed using at least the aforementioned monomer, an ethylenically unsaturated group is formed in the partial structure represented by Formula d1 or Formula d2 by a dissociation reaction using a base compound so that the ethylenically unsaturated group-containing constitutional unit is introduced into the addition polymerization-type resin.

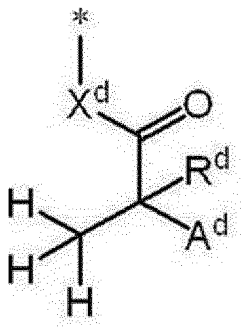

Formula d1

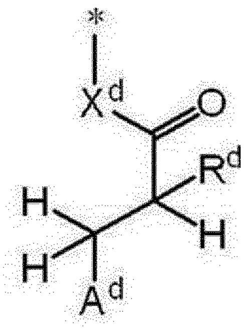

Formula d2

In Formula d1 and Formula d2, $R^d$ represents a hydrogen atom or an alkyl group, $A^d$ represents a halogen atom, $X^d$ represents -O- or $-NR^N-$, $R^N$ represents a hydrogen atom or an alkyl group, and * represents a binding site with other structures.

In Formula d1 and Formula d2, $R^d$ is preferably a hydrogen atom or a methyl group.

In Formula d1 and Formula d2, $A^d$ is preferably a chlorine atom, a bromine atom, or an iodine atom.

In Formula d1 and Formula d2, $X^d$ is preferably -O-. In a case where $X^d$ represents $-NR^N-$, $R^N$ is preferably a hydrogen atom or an alkyl group having 1 to 4 carbon atoms, and more preferably a hydrogen atom.

Examples of the ethylenically unsaturated group-containing constitutional unit include a constitutional unit represented by Formula D1.

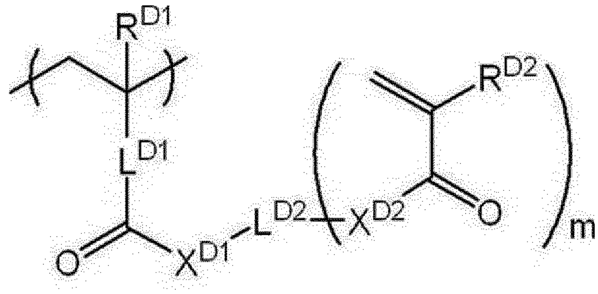

Formula D1

In Formula D1, $L^{D1}$ represents a single bond or a divalent linking group, $L^{D2}$ represents an (m + 1)-valent linking group, $X^{D1}$ and $X^{D2}$ each independently represent -O- or $-NR^N-$, $R^N$ represents a hydrogen atom or an alkyl group, $R^{D1}$ and $R^{D2}$ each independently represent a hydrogen atom or a methyl group, and m represents an integer of 1 or more.

In Formula D1, $L^{D1}$ is preferably a single bond. In a case where $L^{D1}$ represents a divalent linking group, an alkylene group, an arylene group, or a divalent group in which two or more of these are bonded is preferable, and an alkylene group having 2 to 10 carbon atoms or a phenylene group is more preferable.

In Formula D1, $L^{D2}$ is preferably a group represented by any of Formula D2 to Formula D6.

In Formula D1, $X^{D1}$ and $X^{D2}$ preferably both represent -O-. In a case where at least one of $X^{D1}$ or $X^{D2}$ represents $-NR^N-$, $R^N$ is preferably a hydrogen atom or an alkyl group having 1 to 4 carbon atoms, and more preferably a hydrogen atom.

In Formula D1, $R^{D1}$ is preferably a methyl group.

In Formula D1, at least one of m pieces of $R^{D2}$ is preferably a methyl group.

In Formula D1, m is preferably an integer of 1 to 4, more preferably 1 or 2, and even more preferably 1.

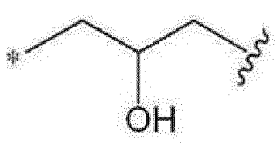

Formula D2

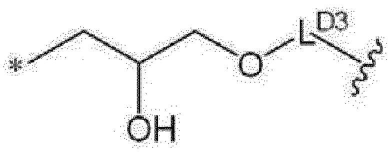

Formula D3

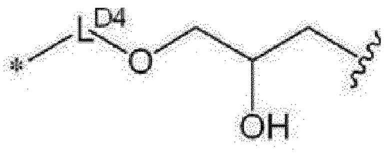

Formula D4

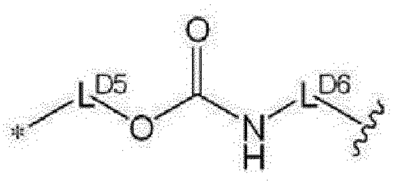

Formula D5

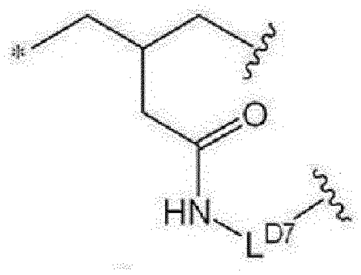

Formula D6

In Formula D2 to Formula D6, $L^{D3}$ to $L^{D7}$ each represent a divalent linking group, $L^{D5}$ and $L^{D6}$ may be different from each other, * represents the binding site with $X^{D1}$ in Formula D1, and the portion of the wavy line represents a binding site with $X^{D2}$ in Formula D1.

In Formula D3, $L^{D3}$ is preferably an alkylene group, an arylene group, or a group in which two or more of these are bonded, and more preferably an alkylene group having 1 to 10 carbon atoms, a phenylene group, or a group in which two or more of these are bonded.

In Formula D4, $L^{D4}$ is preferably an alkylene group, an arylene group, or a group in which two or more of these are bonded, and more preferably an alkylene group having 1 to 10 carbon atoms, a phenylene group, or a group in which two or more of these are bonded.

In Formula D5, $L^{D5}$ is preferably an alkylene group, an arylene group, or a group in which two or more of these are bonded, and more preferably an alkylene group having 1 to 10 carbon atoms, a phenylene group, or a group in which two or more of these are bonded.

In Formula D6, $L^{D6}$ is preferably an alkylene group, an arylene group, or a group in which two or more of these are bonded, and more preferably an alkylene group having 1 to 10 carbon atoms, a phenylene group, or a group in which two or more of these are bonded.

In Formula D7, $L^{D7}$ is preferably an alkylene group, an arylene group, or a group in which two or more of these are bonded, and more preferably an alkylene group having 1 to 10 carbon atoms, a phenylene group, or a group in which two or more of these are bonded.

Specific examples of the ethylenically unsaturated group-containing constitutional unit will be shown below. However, the ethylenically unsaturated group-containing constitutional unit contained in the addition polymerization-type resin according to the present disclosure is not limited thereto. In the following specific examples, R each independently represents a hydrogen atom or a methyl group.

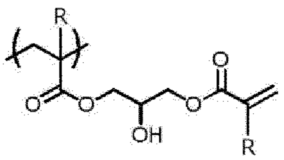
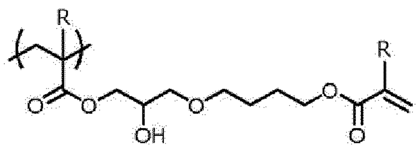
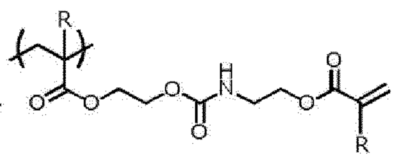

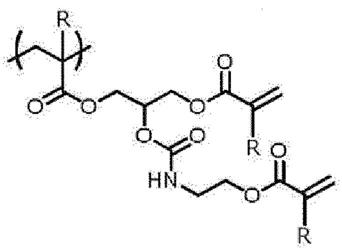
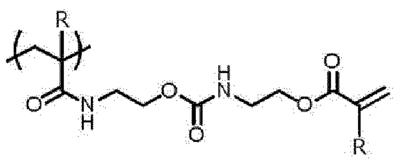

In the addition polymerization-type resin, the content of the ethylenically unsaturated group-containing constitutional unit with respect to the total mass of the addition polymerization-type resin is preferably 5% by mass to 60% by mass, and more preferably 10% by mass to 30% by mass.

[Acid group-containing constitutional unit]

The addition polymerization-type resin may contain an acid group-containing constitutional unit. From the viewpoint of on-press developability and ink receptivity, it is preferable that the addition polymerization-type resin do not

contain an acid group-containing constitutional unit.

Specifically, in the addition polymerization-type resin, the content of the acid group-containing constitutional unit is preferably 20% by mass or less, more preferably 10% by mass or less, and even more preferably 5% by mass or less. The lower limit of the content of the acid group-containing constitutional unit is not particularly limited, and may be 0% by mass.

The acid value of the addition polymerization-type resin is preferably 160 mg KOH/g or less, more preferably 80 mg KOH/g or less, and even more preferably 40 mg KOH/g or less. The lower limit of the acid value is not particularly limited, and may be 0 mg KOH/g.

In the present disclosure, the acid value is determined by the measurement method based on JIS K0070: 1992.

[Hydrophobic group-containing constitutional unit]

From the viewpoint of ink receptivity, the addition polymerization-type resin may contain a hydrophobic group-containing constitutional unit.

Examples of the hydrophobic group include an alkyl group, an aryl group, an aralkyl group, and the like.

As the hydrophobic group-containing constitutional unit, a constitutional unit formed of an alkyl (meth)acrylate compound, an aryl (meth)acrylate compound, or an aralkyl (meth)acrylate compound is preferable, and a constitutional unit formed of an alkyl (meth)acrylate compound is more preferable.

The alkyl group in the alkyl (meth)acrylate compound preferably has 1 to 10 carbon atoms. The alkyl group may be linear or branched or may have a cyclic structure. Examples of the alkyl (meth)acrylate compound include methyl (meth) acrylate, ethyl (meth)acrylate, propyl (meth)acrylate, cyclohexyl (meth)acrylate, 2-ethylhexyl (meth)acrylate, dicyclopentanyl (meth)acrylate, and the like.

The aryl group in the aryl (meth)acrylate compound preferably has 6 to 20 carbon atoms. The aryl group is more preferably a phenyl group. The aryl group may have a known substituent. As the aryl (meth)acrylate compound, for example, phenyl (meth)acrylate is preferable.

The alkyl group in the aralkyl (meth)acrylate compound preferably has 1 to 10 carbon atoms. The alkyl group may be linear or branched or may have a cyclic structure. The aryl group in the aralkyl (meth)acrylate compound preferably has 6 to 20 carbon atoms. The aryl group is more preferably a phenyl group. As the aralkyl (meth)acrylate compound, for example, benzyl (meth)acrylate is preferable.

In the addition polymerization-type resin, the content of the hydrophobic group-containing constitutional unit with respect to the total mass of the addition polymerization-type resin is preferably 5% by mass to 50% by mass, and more preferably 10% by mass to 30% by mass.

[Other constitutional units]

The addition polymerization-type resin may further contain other constitutional units. The resin can contain, as those other constitutional units, constitutional units other than the constitutional units described above without particular limitations. Examples thereof include constitutional units formed of an acrylamide compound, a vinyl ether compound, and the like.

Examples of the acrylamide compound include (meth)acrylamide, N-methyl (meth)acrylamide, N-ethyl (meth) acrylamide, N-propyl (meth)acrylamide, N-butyl (meth)acrylamide, N,N'-dimethyl (meth)acrylamide, N,N'-diethyl (meth) acrylamide, N-hydroxyethyl (meth)acrylamide, N-hydroxypropyl (meth)acrylamide, N-hydroxybutyl (meth)acrylamide, and the like.

Examples of the vinyl ether compound include methyl vinyl ether, ethyl vinyl ether, propyl vinyl ether, n-butyl vinyl ether, tert-butyl vinyl ether, 2-ethylhexyl vinyl ether, n-nonyl vinyl ether, lauryl vinyl ether, cyclohexyl vinyl ether, cyclohexyl methyl vinyl ether, 4-methylcyclohexyl methyl vinyl ether, benzyl vinyl ether, dicyclopentenyl vinyl ether, 2-dicyclopentenoxyethyl vinyl ether, methoxyethyl vinyl ether, ethoxyethyl vinyl ether, butoxyethyl vinyl ether, methoxyethoxyethyl vinyl ether, ethoxyethoxyethyl vinyl ether, methoxypolyethylene glycol vinyl ether, tetrahydrofurfuryl vinyl ether, 2-hydroxyethyl vinyl ether, 2-hydroxypropyl vinyl ether, 4-hydroxybutyl vinyl ether, 4-hydroxymethylcyclohexylmethyl vinyl ether, diethylene glycol monovinyl ether, polyethylene glycol vinyl ether, chloroethyl vinyl ether, chlorobutyl vinyl ether, chloroethoxyethyl vinyl ether, phenylethyl vinyl ether, phenoxypolyethylene glycol vinyl ether, and the like.

In the addition polymerization-type resin, the content of those other constitutional units with respect to the total mass of the addition polymerization-type resin is preferably 5% by mass to 50% by mass, and more preferably 10% by mass to 30% by mass.

The method for manufacturing the addition polymerization-type resin is not particularly limited. The addition polymerization-type resin can be manufactured by known methods.

For example, the addition polymerization-type resin is obtained by polymerizing a styrene compound, an acrylonitrile compound, an ethylenically unsaturated compound having a dispersible group, and at least one kind of

optional compound selected from the group consisting of a N-vinyl heterocyclic compound, a compound used for forming an ethylenically unsaturated group-containing constitutional unit, a compound used for forming an acid group-containing constitutional unit, a compound used for forming a hydrophobic group-containing constitutional unit, and a compound used for forming other constitutional units by known methods.

In a case where the addition polymerization-type resin is particles, the average particle diameter of the particles is preferably 0.01 μm to 3.0 μm, more preferably 0.03 μm to 2.0 μm, and even more preferably 0.10 μm to 1.0 μm. In a case where the average particle diameter of the particles is in this range, excellent resolution and excellent temporal stability are obtained. The average particle diameter of the particles is the average primary particle diameter.

In the present disclosure, the average primary particle diameter of the particles is measured using a light scattering method or by capturing an electron micrograph of the particles, measuring the particle diameter of a total of 5,000 particles in the photograph, and calculating the average thereof. For non-spherical particles, the value of particle diameter of spherical particles having the same area as the area of the particles on the photograph is adopted as the particle diameter.

Note that unless otherwise specified, the average particle diameter in the present disclosure means a volume average particle diameter.

The weight-average molecular weight of the addition polymerization-type resin is preferably 3,000 to 300,000, and more preferably 5,000 to 100,000.

Specific examples of the addition polymerization-type resin will be shown below, but the addition polymerization-type resin in the present disclosure is not limited thereto. In the structure below, n and m represent integers of 2 or more.

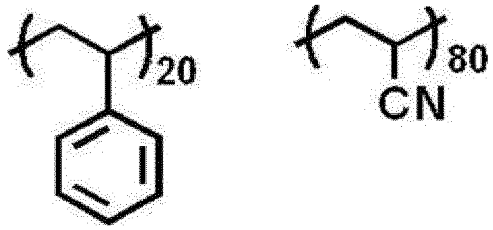

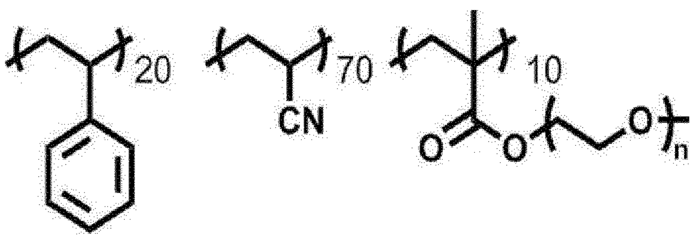

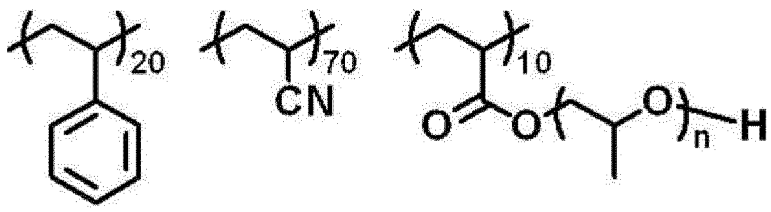

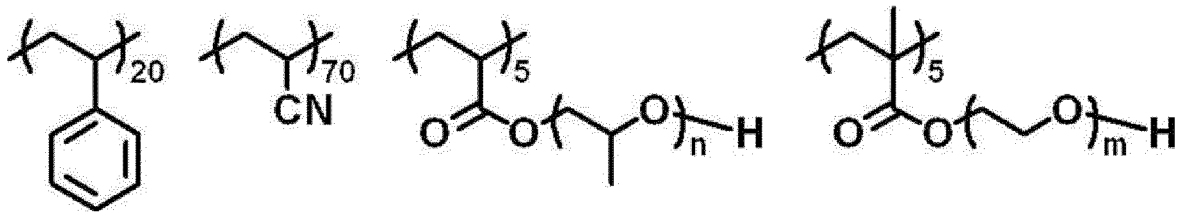

The content ratio of the constitutional units in the above specific examples can be appropriately changed according to the preferred range of the content of each of the constitutional units described above.

The weight-average molecular weight of each of the compounds shown in the above specific examples can be appropriately changed according to the preferred range of the weight-average molecular weight of the addition polymerization-type resin described above.

The image-recording layer may contain only one kind of addition polymerization-type resin, or two or more kinds of addition polymerization-type resins may be used in combination.

The content of the addition polymerization-type resin with respect to the total mass of the image-recording layer is preferably 5% by mass or more and 95% by mass or less, more preferably 7% by mass or more and 80% by mass or less, and even more preferably 10% by mass or more and 60% by mass or less.

-Other binder polymers-

The image-recording layer may contain other binder polymers. Other binder polymers do not include the above-mentioned addition polymerization-type resin.

In an aspect, from the viewpoint of suppressing on-press developability from deteriorating over time, the glass transition temperature (Tg) of those other binder polymers is preferably 50°C or higher, more preferably 70°C or higher, even more preferably 80°C or higher, and particularly preferably 90°C or higher.

Furthermore, from the viewpoint of ease of permeation of water into the image-recording layer, the upper limit of the glass transition temperature of the binder polymer is preferably 200°C, and more preferably 120°C or lower.

From the viewpoint of further inhibiting on-press developability from deteriorating over time, as the binder polymer having the above glass transition temperature, polyvinyl acetal is preferable.

Polyvinyl acetal is a resin obtained by acetalizing hydroxyl groups of polyvinyl alcohol with an aldehyde.

Particularly, polyvinyl butyral is preferable which is obtained by acetalizing (that is, butyralizing) hydroxyl groups of polyvinyl alcohol with butyraldehyde.

As polyvinyl acetal, a compound having a constitutional unit represented by the following (a) is preferable which is obtained by acetalizing hydroxyl groups of polyvinyl alcohol with an aldehyde.

(a)

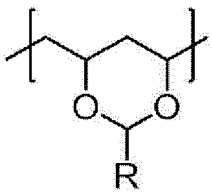

R represents a residue of aldehyde used for acetalization.

Examples of R include a hydrogen atom, an alkyl group, and an ethylenically unsaturated group which will be described later.

The content of the constitutional unit represented by (a) (also described as the amount of ethylene groups in the main chain contained in the constitutional unit represented by (a), which is also called degree of acetalization) with respect to the total content of constitutional units of the polyvinyl acetal (total amount of ethylene groups in the main chain) is preferably 50 mol% to 90 mol%, more preferably 55 mol% to 85 mol%, and even more preferably 55 mol% to 80 mol%.

The degree of acetalization is a value obtained by dividing the amount of ethylene groups to which acetal groups are bonded (amount of ethylene groups in the main chain contained in the constitutional unit represented by (a)) by the total amount of ethylene groups in the main chain and expressing the thus obtained molar fraction as a percentage.

The same shall be applied to the content of each constitutional unit of polyvinyl acetal which will be described later.

From the viewpoint of improving printing durability, the polyvinyl acetal preferably has an ethylenically unsaturated group.

From the viewpoint of improving printing durability, the polyvinyl acetal preferably has an ethylenically unsaturated group.

The ethylenically unsaturated group that the polyvinyl acetal has is not particularly limited. From the viewpoint of reactivity, on-press developability, and printing durability, the ethylenically unsaturated group is preferably at least one kind of group selected from the group consisting of a vinyl phenyl group (styryl group), a vinyl ester group, a vinyl ether group, an allyl group, a (meth)acryloxy group, and a (meth)acrylamide group. Among these, a vinyl group, an allyl group, a (meth) acryloxy group, and the like are more preferable.

From the viewpoint of improving printing durability, the polyvinyl acetal preferably has an ethylenically unsaturated group-containing constitutional unit.

The ethylenically unsaturated group-containing constitutional unit may be the aforementioned constitutional unit having an acetal ring or a constitutional unit other than the constitutional unit having an acetal ring.

Particularly, from the viewpoint of increasing crosslink density during exposure, the polyvinyl acetal is preferably a compound in which an ethylenically unsaturated group is introduced into an acetal ring. That is, it is preferable that the constitutional unit represented by (a) have an ethylenically unsaturated group as R.

**In** a case where the ethylenically unsaturated group-containing constitutional unit is a constitutional unit other than the constitutional unit having an acetal ring, for example, the ethylenically unsaturated group-containing constitutional unit may be a constitutional unit having an acrylate group, specifically, a constitutional unit represented by (d).

(d)

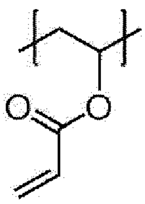

In a case where the ethylenically unsaturated group-containing constitutional unit is a constitutional unit other than the constitutional unit having an acetal ring, the content of the ethylenically unsaturated group-containing constitutional unit (also called amount of acrylate groups) with respect to the total content of constitutional units of the polyvinyl acetal is preferably 1 mol% to 15 mol%, and more preferably 1 mol% to 10 mol%.

From the viewpoint of on-press developability, the polyvinyl acetal preferably further has a hydroxyl group-containing constitutional unit. That is, the polyvinyl acetal preferably contains a constitutional unit derived from vinyl alcohol.

Examples of the hydroxyl group-containing constitutional unit include a constitutional unit represented by (b).

(b)

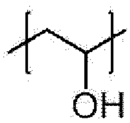

From the viewpoint of on-press developability, the content of the constitutional unit represented by (b) (also called amount of hydroxyl groups) with respect to the total content of constitutional units of the polyvinyl acetal is preferably 5 mol% to 50 mol%, more preferably 10 mol% to 40 mol%, and even more preferably 20 mol% to 40 mol%.

The polyvinyl acetal may further have other constitutional units.

Examples of those other constitutional units include a constitutional unit having an acetyl group, specifically, a constitutional unit represented by (c).

(c)

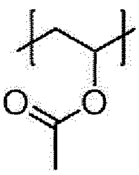

The content of the constitutional unit represented by (c) (also called amount of acetyl groups) with respect to the total content of constitutional units of the polyvinyl acetal is preferably 0.5 mol% to 10 mol%, more preferably 0.5 mol% to 8 mol%, and even more preferably 1 mol% to 3 mol%.

The degree of acetalization, the amount of acrylate groups, the amount of hydroxyl groups, and the amount of acetyl groups can be determined as follows.

That is, by $^1H$ NMR spectroscopy, the content expressed as mol% is calculated from the ratio of peak surface area of protons of a methyl or methylene moiety of acetal, a methyl moiety of an acrylate group, and a methyl moiety of a hydroxyl group and an acetyl group.

The weight-average molecular weight of the polyvinyl acetal is preferably 18,000 to 150,000.

The solubility parameter (also called SP value) of the polyvinyl acetal is preferably 17.5 $MPa^{0.5}$ to 20.0 $MPa^{0.5}$,

and more preferably 18.0 $MPa^{0.5}$ to 19.5 $MPa^{0.5}$.

In the present disclosure, as "solubility parameter, (unit: ($MPa^{0.5}$)", the Hansen solubility parameters described above are used.

Specific examples of the polyvinyl acetal are shown in the following [P-1 to P-3]. However, the polyvinyl acetal used in the present disclosure is not limited thereto.

In the following structures, "1" is 50 mol% to 90 mol%, "m" is 0.5 mol% to 10 mol%, "n" is 5 mol% to 50 mol%, and "o" is 1 mol% to 15 mol%.

P-1

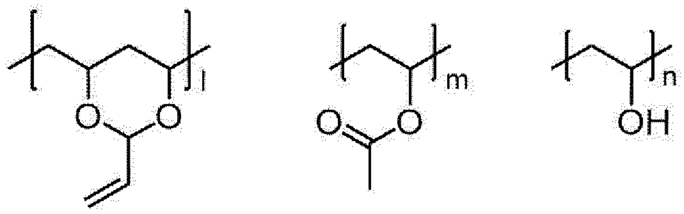

P-2

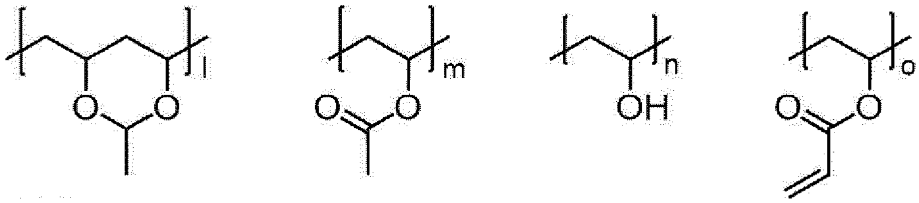

P-3

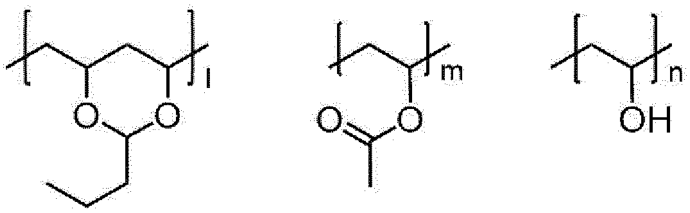

As the polyvinyl acetal resin, commercially available products can be used.

Examples of commercially available products of polyvinyl acetal resin include S-LEC BL series (specifically, S-LEC BL-10, BL-1, BL-5Z, BL-7Z, and the like), S-LEC BM series (specifically, S-LEC BM-1, BM-S(Z), BM-5, and the like), S-LEC BH series (specifically, S-LEC BH-S, BH-6, and BH-3(Z)), S-LEC BX series (S-LEC BX-L, BX-1, BX-5, and the like), and S-LEC KS series (S-LEC KS-10 and the like) manufactured by SEKISUI CHEMICAL CO., LTD.

-Infrared absorber-

The image-recording layer contains an infrared absorber.

Examples of the infrared absorber include a pigment and a dye.

As the dye that is used as the infrared absorber, it is possible to use commercially available dyes and known dyes described in publications, for example, "Dye Handbooks" (edited by the Society of Synthetic Organic Chemistry, Japan, 1970). Specific examples thereof include dyes such as an azo dye, a metal complex azo dye, a pyrazolone azo dye, a naphthoquinone dye, an anthraquinone dye, a phthalocyanine dye, a carbonium dye, a quinoneimine dye, a methine dye, a cyanine dye, a squarylium colorant, a pyrylium salt, and a metal thiolate complex.

Among these dyes, for example, a cyanine dye, a squarylium colorant, a pyrylium salt, a nickel thiolate complex, and an indolenine cyanine dye are particularly preferable. Furthermore, for example, a cyanine dye or an indolenine cyanine dye is preferable. Among these, a cyanine dye is particularly preferable.

Specific examples of the cyanine dye include the compounds described in paragraphs "0017" to "0019" of JP2001-133969A and the compounds described in paragraphs "0016" to "0021" of JP2002-023360A and paragraphs

"0012" to "0037" of JP2002-040638A. As the cyanine dye, for example, the compounds described in paragraphs "0034" to "0041" of JP2002-278057A and paragraphs "0080" to "0086" of JP2008-195018A are preferable, and the compounds described in paragraphs "0035" to "0043" of JP2007-90850A and the compounds described in paragraphs "0105" to "0113" of JP2012-206495A are particularly preferable.

Furthermore, the compounds described in paragraphs "0008" and "0009" of JP1993-5005A (JP-H05-5005A) and paragraphs "0022" to "0025" of JP2001-222101A can also be preferably used.

As pigments, the compounds described in paragraphs "0072" to "0076" of JP2008-195018A are preferable.

Furthermore, an infrared absorber that decomposes by exposure to infrared (also called "decomposable infrared absorber") can be suitably used.

As the infrared absorber that decomposes by exposure to infrared, those described in JP2008-544322A, WO2016/027886A, WO2017/141882A, or WO2018/043259A can also be suitably used.

One kind of infrared absorber may be used alone, or two or more kinds of infrared absorbers may be used in combination. In addition, as the infrared absorber, a pigment and a dye may be used in combination.

The content of the infrared absorber in the image-recording layer with respect to the total mass of the image-recording layer is preferably 0.1% by mass to 10.0% by mass, and more preferably 0.5% by mass to 5.0% by mass.

-Polymerization initiator-

The image-recording layer in the lithographic printing plate precursor according to the present disclosure contain a polymerization initiator.

From the viewpoint of sensitivity, printing durability, on-press developability, and receptivity, the polymerization initiator preferably includes an electron-accepting polymerization initiator, and more preferably includes an electron-accepting polymerization initiator and an electron-donating polymerization initiator.

<<Electron-accepting polymerization initiator»

It is preferable that the image-recording layer contain an electron-accepting polymerization initiator as a polymerization initiator.

The electron-accepting polymerization initiator is a compound which accepts an electron by intermolecular electron transfer in a case where electrons of an infrared absorber are excited by exposure to infrared, and generates a polymerization initiation species such as radicals.

The electron-accepting polymerization initiator used in the present disclosure is a compound that generates a polymerization initiation species such as a radical or a cation by either or both of light energy and heat energy, and can be appropriately selected from known thermal polymerization initiators, compounds having a bond that can be dissociated by little energy, photopolymerization initiators, and the like.

The electron-accepting polymerization initiator is preferably a radical polymerization initiator and more preferably an onium salt compound.

In addition, as the electron-accepting polymerization initiator, an infrared-ray-sensitive polymerization initiator is preferable.

Examples of the electron-accepting radical polymerization initiator include (a) organic halide, (b) carbonyl compound, (c) azo compound, (d) organic peroxide, (e) metallocene compound, (f) azide compound, (g) hexaarylbiimidazole compound, (i) disulfone compound, (j) oxime ester compound, and (k) onium salt compound.

As (a) organic halide, for example, the compounds described in paragraphs "0022" and" 0023" of JP2008-195018A are preferable.

As (b) carbonyl compound, for example, the compounds described in paragraph "0024" of JP2008-195018A are preferable.

As (c) azo compound, for example, the azo compounds described in JP1996-108621A (JP-H08-108621A) and the like can be used.

As (d) organic peroxide, for example, the compounds described in paragraph "0025" of JP2008-195018A are preferable.

As (e) metallocene compound, for example, the compounds described in paragraph "0026" of JP2008-195018A are preferable.

Examples of (f) azide compound include compounds such as 2,6-bis(4-azidobenzylidene)-4-methylcyclohexanone.

As (g) hexaarylbiimidazole compound, for example, the compounds described in paragraph "0027" of JP2008-195018A are preferable.

Examples of (i) disulfone compound include the compounds described in JP1986-166544A (JP-S61-166544A) and JP2002-328465A.

As (j) oxime ester compound, for example, the compounds described in paragraphs "0028" to "0030" of JP2008-195018A are preferable.

Among the above electron-accepting polymerization initiators, from the viewpoint of curing properties, for example, (j) oxime ester compound and (k) onium salt compound are preferable. Particularly, from the viewpoint of printing durability, an iodonium salt compound, a sulfonium salt compound, or an azinium salt compound is preferable, an iodonium salt compound or a sulfonium salt compound is more preferable, and an iodonium salt compound is particularly preferable.

Specific examples of these compounds are shown below, but the electron-accepting polymerization initiator in the present disclosure is not limited thereto.

As the iodonium salt compound, for example, a diaryl iodonium salt compound is preferable. Particularly, a diphenyl iodonium salt compound substituted with an electron donating group such as an alkyl group or an alkoxyl group is more preferable. Furthermore, an asymmetric diphenyl iodonium salt compound is preferable. Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyl iodonium=hexafluorophosphate, 4-hexyloxyphenyl-2,4-diethoxyphenyl iodonium=tetrafluoroborate, 4-octyloxyphenyl-2,4,6-trimethoxyphenyl iodonium=1-perfluorobutane sulfonate, 4-octyloxyphenyl-2,4,6-trimethoxyphenyliodonium=-hexafluorophosphate, and bis(4-t-butylphenyl)iodonium=hexafluorophosphate.

As the sulfonium salt compound, for example, a triarylsulfonium salt compound is preferable. Particularly, a triarylsulfonium salt compound is preferable in which at least some of electron-withdrawing groups such as groups on an aromatic ring are substituted with halogen atoms, and a triarylsulfonium salt compound is more preferable in which the total number of halogen atoms as substituents on an aromatic ring is 4 or more. Specific examples thereof include triphenylsulfonium=hexafluorophosphate, triphenylsulfonium=benzoyl formate, bis(4-chlorophenyl)phenylsulfonium=-benzoyl formate, bis(4-chlorophenyl)-4-methylphenylsulfonium=tetrafluoroborate, tris(4-chlorophenyl)sulfonium=3,5-bis(methoxycarbonyl)benzenesulfonate, tris(4-chlorophenyl)sulfonium=hexafluorophosphate, and tris(2,4-dichlorophenyl)sulfonium=hexafluorophosphate.

As a counteranion of the iodonium salt compound and the sulfonium salt compound, a sulfonamide anion or a sulfonimide anion is preferable, and a sulfonimide anion is more preferable.

As the sulfonamide anion, an aryl sulfonamide anion is preferable.

As the sulfonimide anion, a bisaryl sulfonimide anion is preferable.

Specific examples of the sulfonamide anion or the sulfonimide anion are shown below, but the sulfonamide anion or the sulfonimide anion in the present disclosure is not limited thereto. In the following specific examples, Ph represents a phenyl group, Me represents a methyl group, and Et represents an ethyl group.

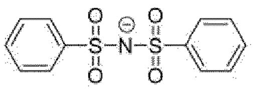

I-1

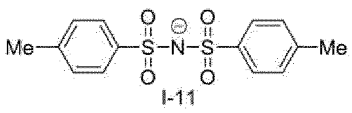

I-11

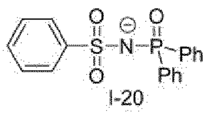

I-20

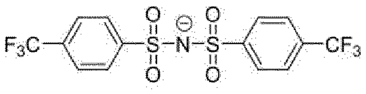
I-2

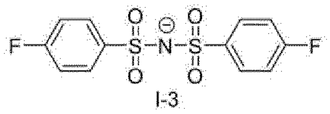
I-3

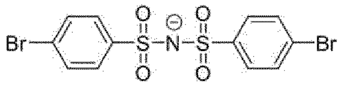
I-4

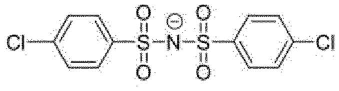
I-5

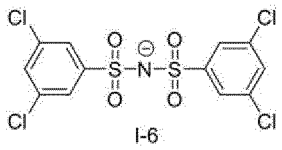
I-6

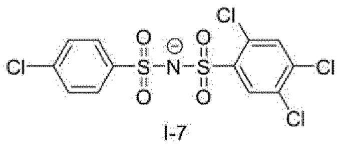
I-7

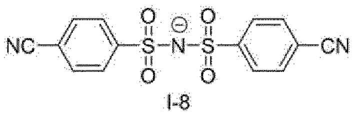
I-8

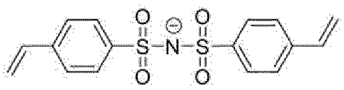
I-9

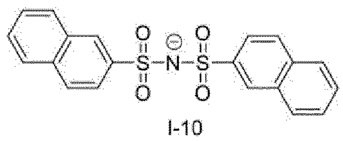
I-10

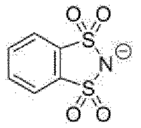
I-12

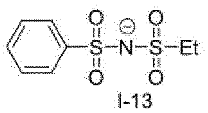
I-13

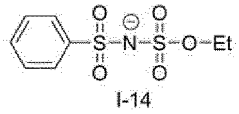
I-14

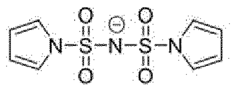
I-15

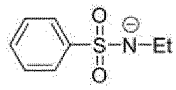
I-16

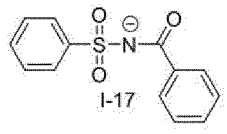
I-17

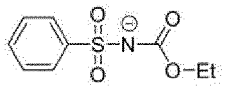
I-18

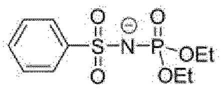
I-19

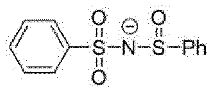
I-21

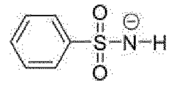
I-22

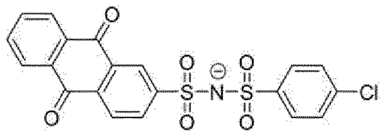
I-23

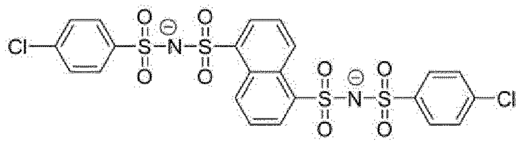
I-24

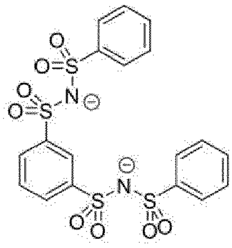
I-25

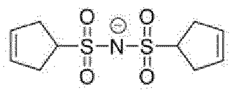
I-26

From the viewpoint of developability and UV printing durability of the lithographic printing plate to be obtained, the electron-accepting polymerization initiator may include a compound represented by Formula (I).

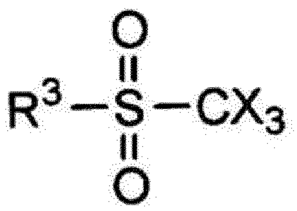
(I)

In Formula (I), X represents a halogen atom, and $R^3$ represents an aryl group.

Specifically, examples of X in Formula (I) include a fluorine atom, a chlorine atom, a bromine atom, and an iodine atom. Among these, a chlorine atom or a bromine atom is preferable because these have excellent sensitivity, and a bromine atom is particularly preferable.

Furthermore, from the viewpoint of excellent balance between sensitivity and storage stability, $R^3$ in Formula (I) is preferably an aryl group substituted with an amide group.

Specific examples of the compound represented by Formula (I) include compounds represented by the following formulas. However, the present disclosure is not limited thereto.

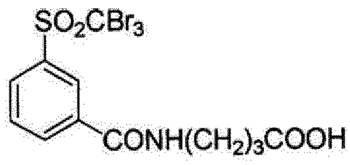
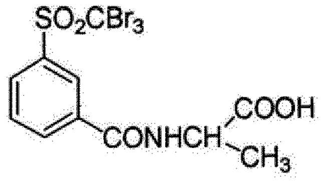
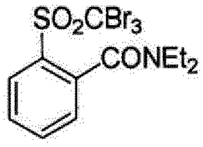

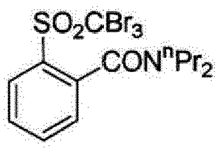
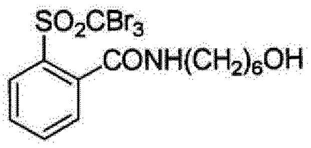
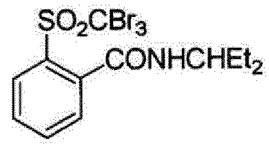

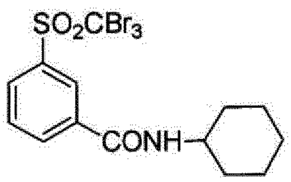
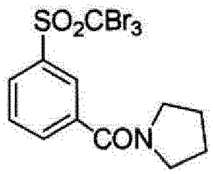
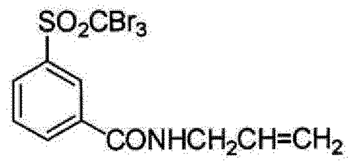

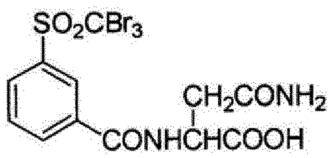
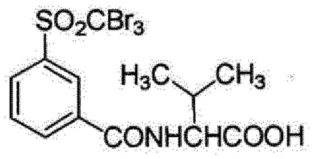
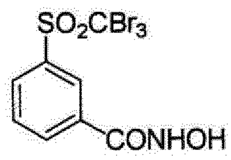

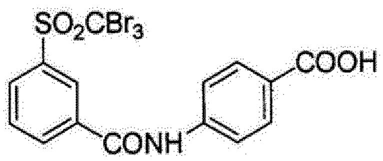
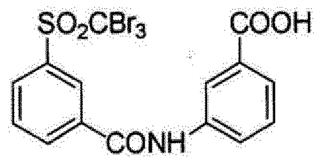
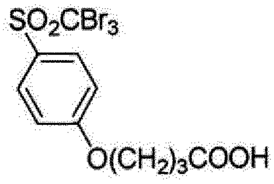

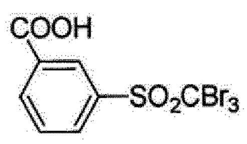
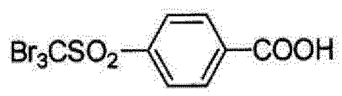
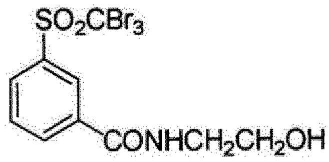

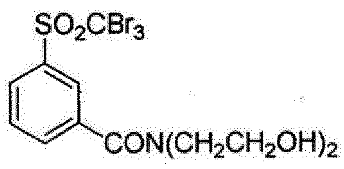
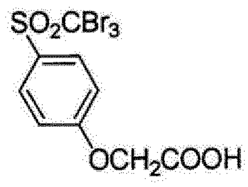
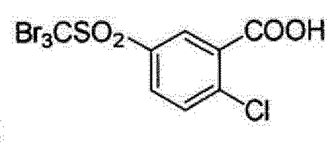

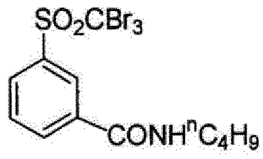
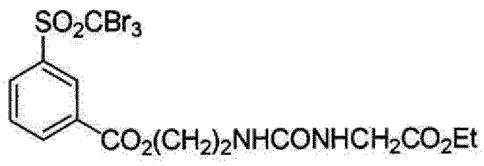

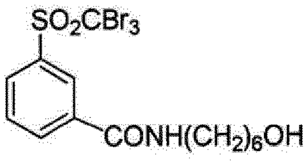
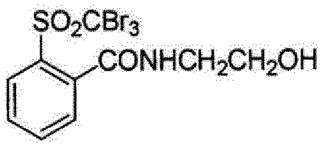

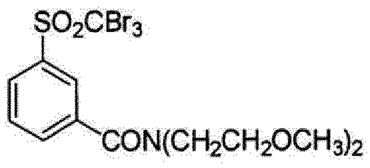
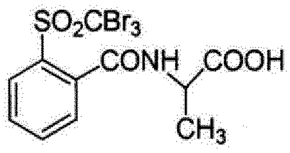

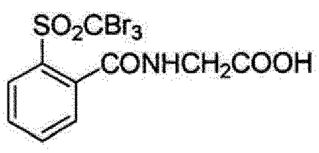
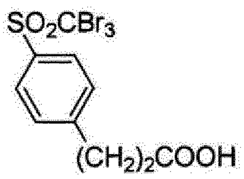
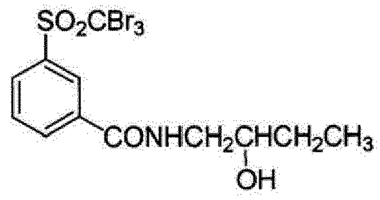

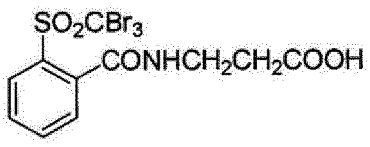
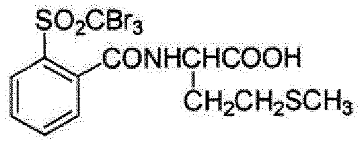

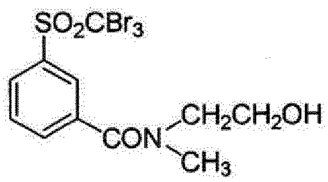
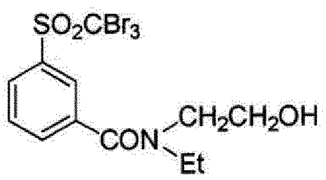
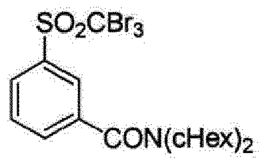

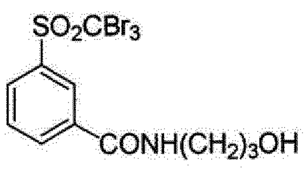
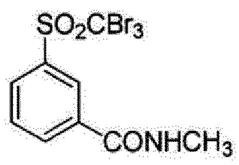
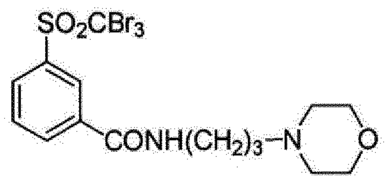

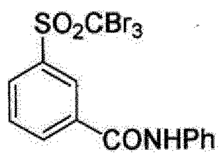
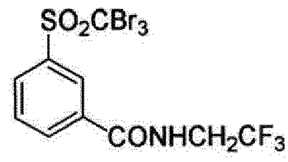
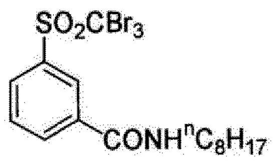

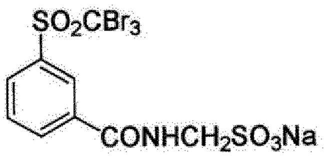
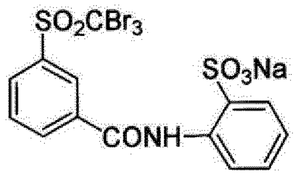
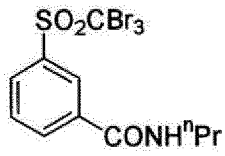

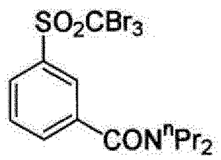
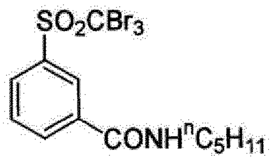
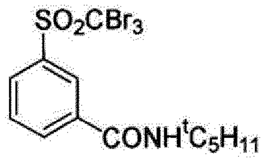

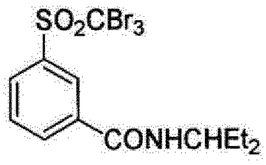
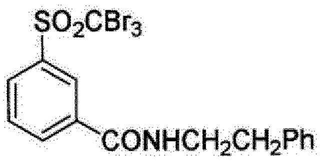
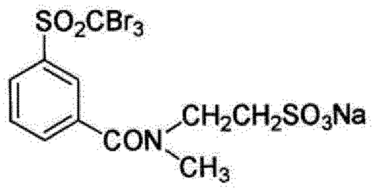

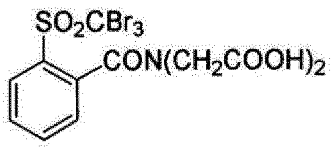
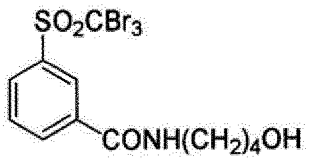

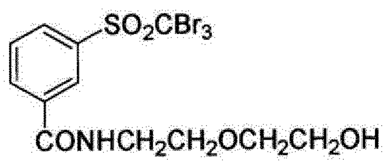
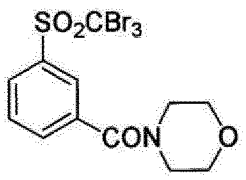
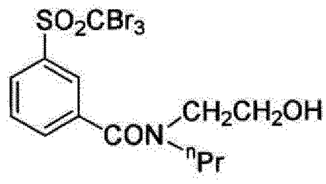

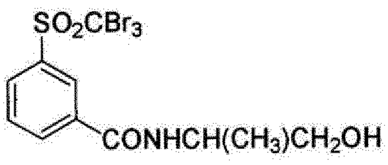
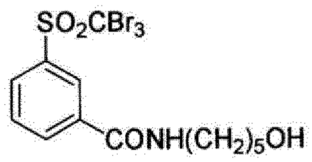

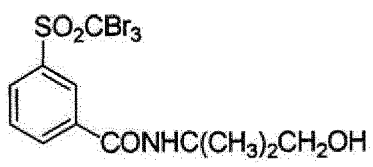
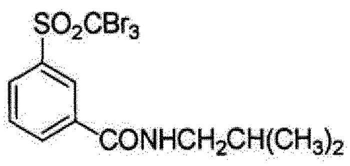

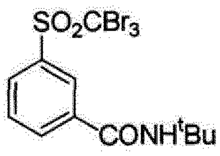
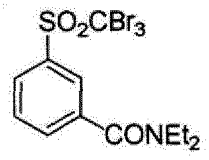
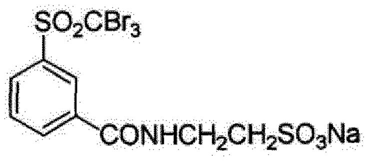

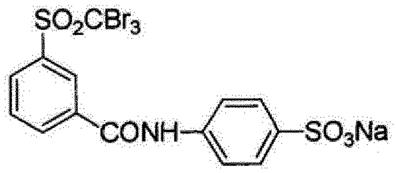
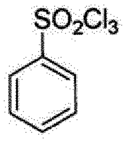
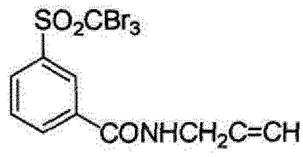

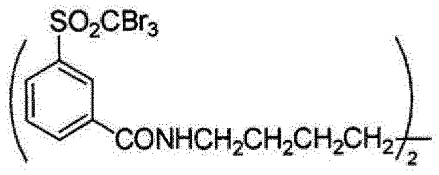
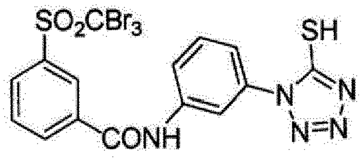

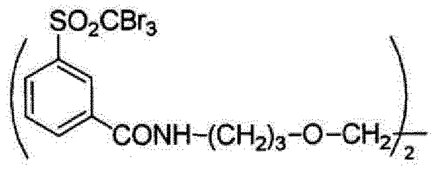
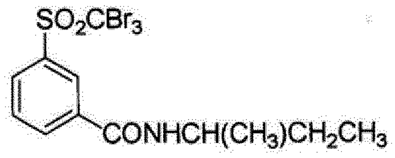

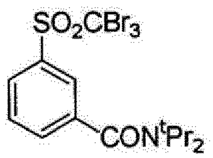
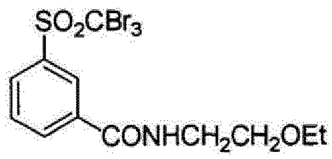
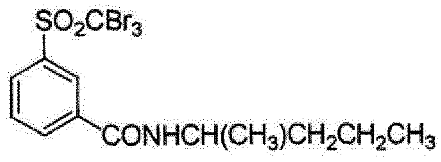

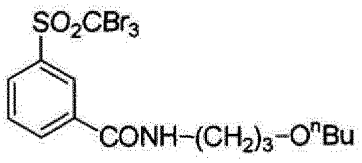
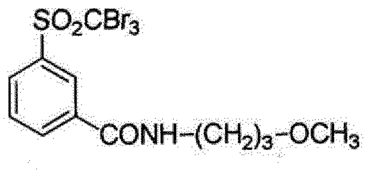

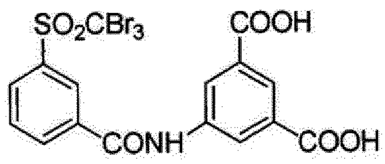
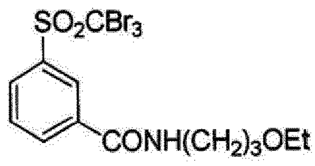

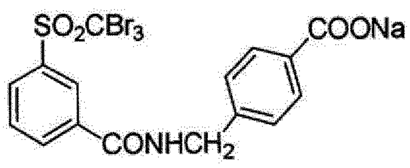
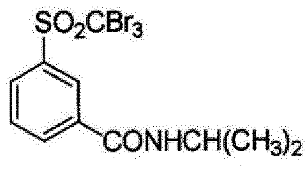

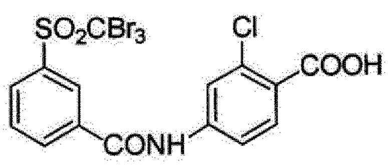
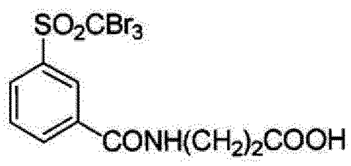

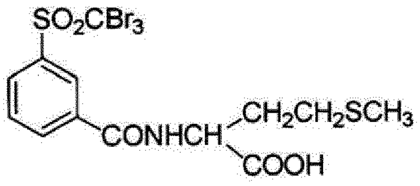
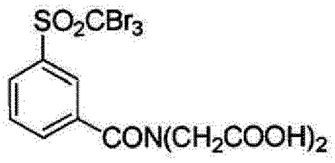

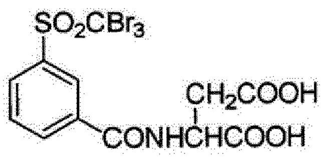
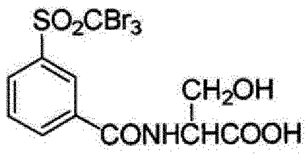
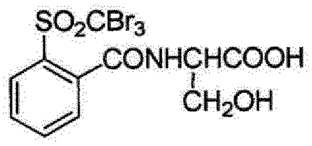

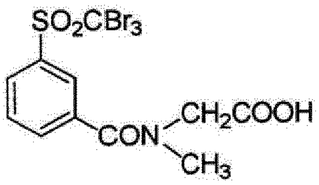
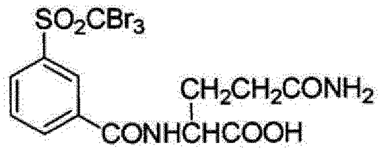
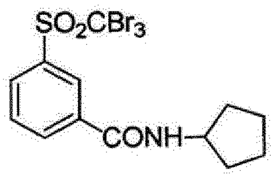

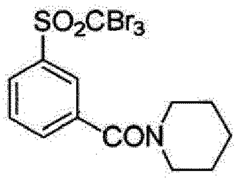
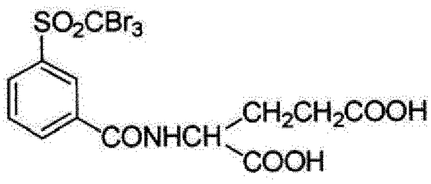

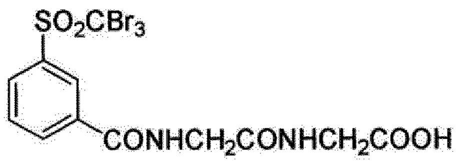
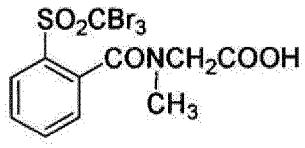

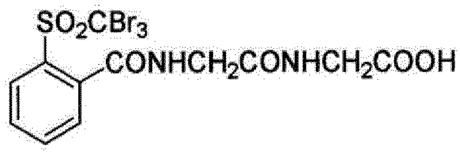
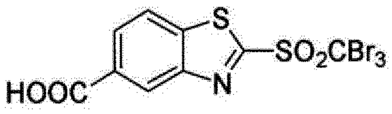

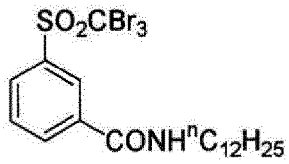
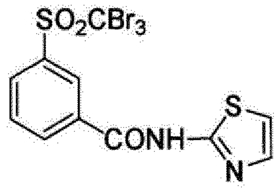
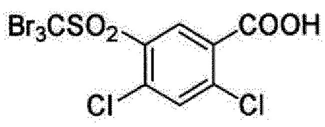

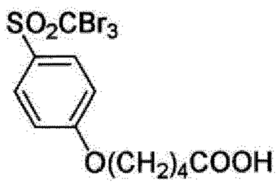
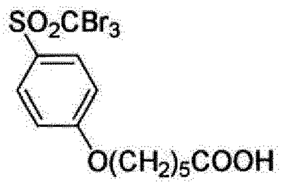

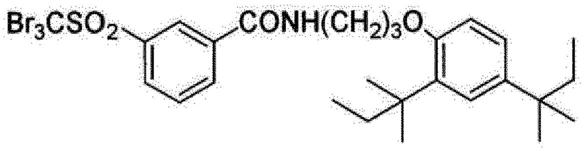

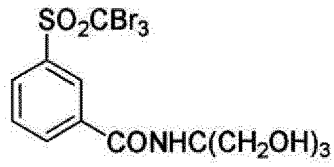

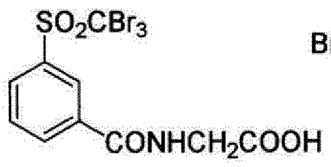

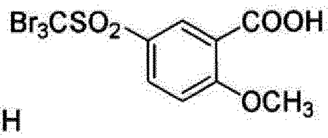

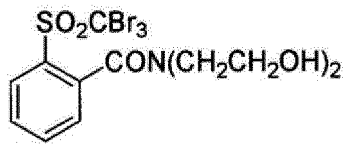

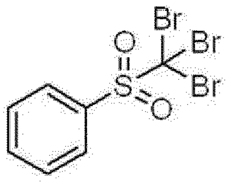

(IS-1)

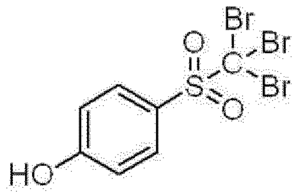

(IS-2)

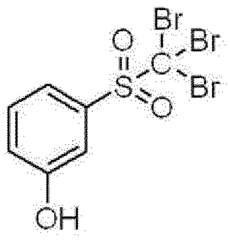

(IS-3)

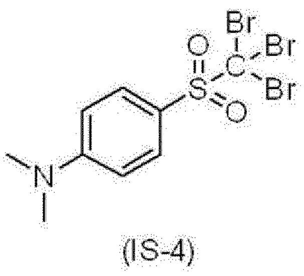

(IS-4)

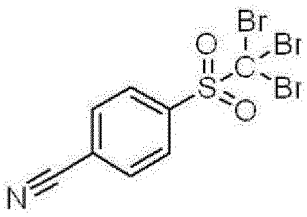

(IS-5)

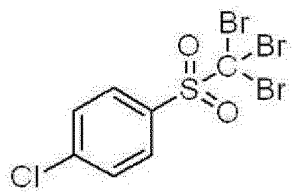

(IS-6)

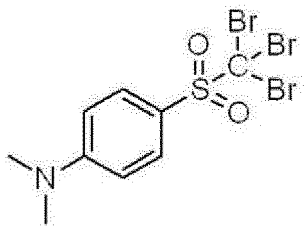

(IS-7)

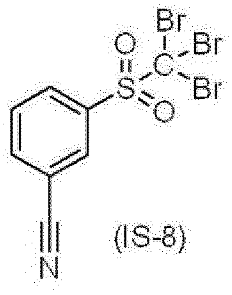

(IS-8)

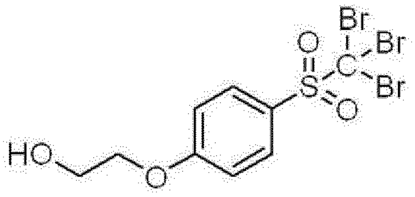

(IS-9)

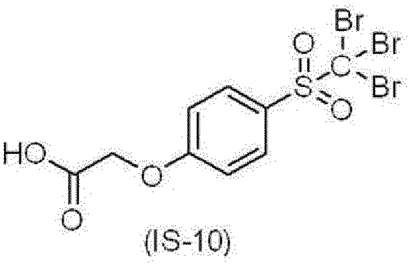

(IS-10)

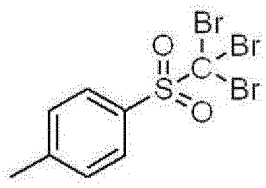

(IS-11)

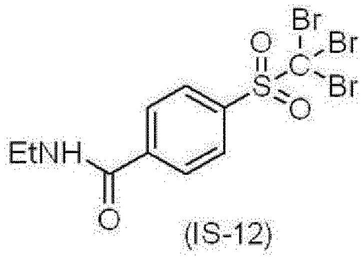

(IS-12)

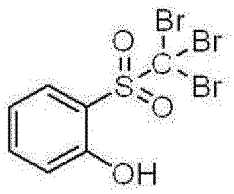

(IS-13)

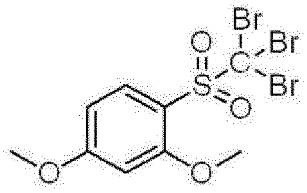

(IS-14)

From the viewpoint of improving sensitivity and suppressing the occurrence of plate missing, the lowest unoccupied molecular orbital (LUMO) of the electron-accepting polymerization initiator is preferably -3.00 eV or less, and more preferably -3.02 eV or less.

The lower limit of LUMO is preferably -3.80 eV or more, and more preferably -3.60 eV or more.

One kind of electron-accepting polymerization initiator may be used alone, or two or more kinds of electron-accepting polymerization initiators may be used in combination.

The content of the electron-accepting polymerization initiator with respect to the total mass of the image-recording layer is preferably 0.1% by mass to 50% by mass, more preferably 0.5% by mass to 30% by mass, and particularly preferably 0.8% by mass to 20% by mass.

-Relationship between electron-accepting polymerization initiator and infrared absorber-

From the viewpoint of improving sensitivity and suppressing UV plate missing, the image-recording layer in the present disclosure contains the electron-accepting polymerization initiator and the infrared absorber. LUMO of the infrared absorber - LUMO of the electron-accepting polymerization initiator is preferably 1.00 eV or less, more preferably 0.70 eV or less, and particularly preferably 0.70 eV to -0.10 eV. Herein, the value of LUMO of the infrared absorber - LUMO of the electron-accepting polymerization initiator is in other words a value (eV) obtained by subtracting the value (eV) of LUMO of the electron-accepting polymerization initiator from the value (eV) of LUMO of the infrared absorber.

The negative sign means that LUMO of the electron-accepting polymerization initiator is higher than LUMO of the infrared absorber.

In the present disclosure, the highest occupied molecular orbital (HOMO) and the lowest unoccupied molecular orbital (LUMO) are calculated by the following methods.

First, the counteranion in the compound as a subject of calculation is ignored.

The structural optimization is carried out by DFT (B3LYP/6-31G(d)) using quantum chemical calculation software Gaussian 09.

The molecular orbital (MO) energy is calculated by DFT (B3LYP/6-31+G(d,p)/CPCM (solvent = methanol)) using the structure obtained by the structural optimization.

By the following formula, the MO energy Ebare (unit: hartree) obtained by the above MO energy calculation is converted into Escaled (unit: eV) used as the values of HOMO and LUMO in the present disclosure.

$$\text{Escaled} = 0.823168 \times 27.2114 \times \text{Ebare} - 1.07634$$

27.2114 is a simply a coefficient for converting hartree into eV, and 0.823168 and -1.07634 are adjustment coefficients. These are determined such that the calculated values of HOMO and LUMO of the compound as a calculation object match the measured values.

<<Electron-donating polymerization initiator (polymerization aid)>>

The image-recording layer preferably contains, as a polymerization initiator, an electron-donating polymerization initiator (also called "polymerization aid"), and more preferably contains an electron-accepting polymerization initiator and an electron-donating polymerization initiator.

The electron-donating polymerization initiator in the present disclosure is a compound which donates one electron by intermolecular electron transfer to an orbit of an infrared absorber that has lost one electron in a case where electrons of the infrared absorber are excited or perform intramolecular transfer by exposure to infrared, and thus generates polymerization initiation species such as radicals.

The electron-donating polymerization initiator is preferably an electron-donating radical polymerization initiator.

From the viewpoint of improving the printing durability of the lithographic printing plate, the image-recording layer more preferably contains the electron-donating polymerization initiator that will be described below. Examples thereof include the following 5 initiators.

(i) Alkyl or arylate complex: considered to generate active radicals by oxidative cleavage of carbon-hetero bond. Specifically, a borate compound is preferable.

(ii) N-arylalkylamine compound: considered to generate active radicals by oxidation-induced cleavage of C-X bond on carbon adjacent to nitrogen. X is preferably a hydrogen atom, a carboxyl group, a trimethylsilyl group, or a benzyl group. Specifically, examples thereof include N-phenylglycines (which may or may not have a substituent on a phenyl group) and N-phenyl iminodiacetic acids (which may or may not have a substituent on a phenyl group).

(iii) Sulfur-containing compound: compound obtained by substituting nitrogen atoms of the aforementioned amines with sulfur atoms and capable of generating active radicals by the same action as that of the amines. Specific examples thereof include phenylthioacetic acids (which may or may not have a substituent on a phenyl group).

(iv) Tin-containing compound: compound obtained by substituting nitrogen atoms of the aforementioned amines with tin atoms and capable of generating active radicals by the same action as that of the amines.

(v) Sulfinates: capable of generating active radicals by oxidation. Specifically, examples thereof include sodium aryl sulfinate and the like.

From the viewpoint of printing durability, the image-recording layer preferably contains a borate compound among the above.

From the viewpoint of printing durability and color developability, the borate compound is preferably a tetraaryl borate compound or a monoalkyl triaryl borate compound, and more preferably a tetraaryl borate compound.

A countercation that the borate compound has is not particularly limited, but is preferably an alkali metal ion or a tetraalkyl ammonium ion and more preferably a sodium ion, a potassium ion, or a tetrabutylammonium ion.

Specifically, as the borate compound, for example, sodium tetraphenyl borate is preferable.

Specifically, as the electron-donating polymerization initiator, for example, the following B-1 to B-9 are preferable. It goes without saying that the present disclosure is not limited thereto. In the following chemical formulas, Ph represents a phenyl group, and Bu represents a n-butyl group.

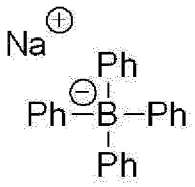

B - 1

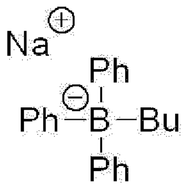

B - 2

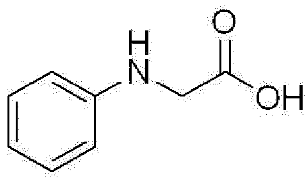

B - 3

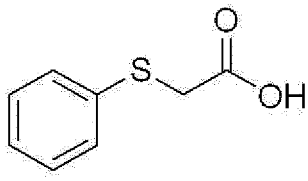

B - 4

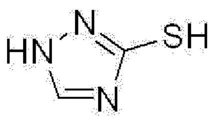

B - 5

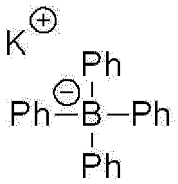

B - 6

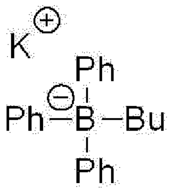

B - 7

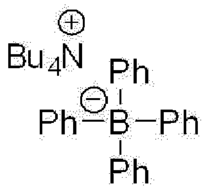

B - 8

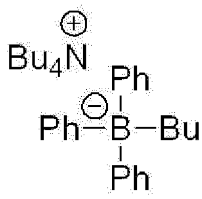

B - 9

From the viewpoint of improving sensitivity and suppressing the occurrence of plate missing, the highest occupied molecular orbital (HOMO) of the electron-donating polymerization initiator in the present disclosure is preferably -6.00 eV or more, more preferably -5.95 eV or more, and even more preferably -5.93 eV or more.

The upper limit of HOMO is preferably -5.00 eV or less, and more preferably -5.40 eV or less.

The image-recording layer may contain only one kind of electron-donating polymerization initiator, or two or more kinds of electron-donating polymerization initiators may be used in combination.

From the viewpoint of sensitivity and printing durability, the content of the electron-donating polymerization initiator with respect to the total mass of the image-recording layer is preferably 0.01% by mass to 30% by mass, more preferably 0.05% by mass to 25% by mass, and even more preferably 0.1% by mass to 20% by mass.

In the present disclosure, in a case where the image-recording layer contains an onium ion and an anion of the aforementioned electron-donating polymerization initiator, the image-recording layer is regarded as containing an electron-accepting polymerization initiator and the electron-donating polymerization initiator described above.

=Relationship between electron-donating polymerization initiator and infrared absorber=

From the viewpoint of improving sensitivity and suppressing UV plate missing, the image-recording layer in the present disclosure contains the electron-donating polymerization initiator and the infrared absorber described above. HOMO of the infrared absorber - HOMO of the electron-donating polymerization initiator is preferably 0.70 eV or less, and more preferably 0.70 eV to -0.10 eV.

The value of HOMO of the infrared absorber - HOMO of the electron-donating polymerization initiator means a value (eV) obtained by subtracting the value (eV) of HOMO of the electron-donating polymerization initiator from the value (eV) of HOMO of the infrared absorber.

The negative sign means that HOMO of the electron-donating polymerization initiator is higher than HOMO of the infrared absorber.

=Preferred aspects of infrared absorber and electron-accepting polymerization initiator=

From the viewpoint of improving sensitivity and suppressing the occurrence of plate missing, in a preferred aspect, the infrared absorber in the present disclosure has an organic anion that satisfies $\delta d \geq 16$, $\delta p$ = 16 to 32, and $\delta h \leq \delta p \times 0.6$ in the Hansen solubility parameters.

From the viewpoint of improving sensitivity and suppressing the occurrence of plate missing, in a preferred aspect, the electron-accepting polymerization initiator in the present disclosure has an organic anion that satisfies $\delta d \geq 16$, $\delta p$ = 16 to 32, and $\delta h \leq \delta p \times 0.6$ in the Hansen solubility parameters.

In the present disclosure, as $\delta d$, $\delta p$, and $\delta h$ in the Hansen solubility parameters, the dispersion element $\delta d$ [unit: $MPa^{0.5}$] and the polarity element $\delta p$ [unit: $MPa^{0.5}$] in the Hansen solubility parameters are used. The Hansen solubility parameters are obtained by dividing the solubility parameters introduced by Hildebrand into three components, a dispersion element $\delta d$, a polarity element $\delta p$, and a hydrogen bond element $\delta h$, and expressing the parameters in a three-dimensional space.

Details of the Hansen solubility parameters are described in the document "Hansen Solubility Parameters; A Users Handbook (CRC Press, 2007)" written by Charles M. Hansen.

In the present disclosure, $\delta d$, $\delta p$, and $\delta h$ of the organic anion in the Hansen solubility parameters are values estimated from the chemical structure by using the computer software "Hansen Solubility Parameters in Practice (HSPiP ver. 4.1.07)".

Specifically, suitable examples of the organic anion that satisfies $\delta d \geq 16$, $\delta p$ = 16 to 32, and $\delta h \leq \delta p \times 0.6$ in the Hansen solubility parameters include specific examples (I-1) to (I-26) of the sulfonamide anion or sulfonimide anion in the aforementioned electron-accepting polymerization initiator. It goes without saying that the organic anion is not limited thereto.

-Polymerizable compound-

The image-recording layer contains a polymerizable compound having 7 or more functional groups (hereinafter, also called "specific polymerizable compound").

From the viewpoint of suppressing scratches and contamination and printing durability, the specific polymerizable compound preferably includes a polymerizable compound having 11 or more functional groups, and more preferably includes a polymerizable compound having 15 or more functional groups.

Furthermore, the image-recording layer may contain a polymerizable compound having 6 or less functional groups. The polymerizable compound having 6 or less functional groups may be a compound having one or two ethylenically unsaturated bonding groups.

The specific polymerizable compound used in the present disclosure may be, for example, a radically polymerizable compound or a cationically polymerizable compound. The specific polymerizable compound preferably includes an addition polymerizable compound having at least 7 ethylenically unsaturated bonds (ethylenically unsaturated compound). From the viewpoint of suppressing scratches and contamination and printing durability, the ethylenically unsaturated compound preferably includes a compound having at least 7 terminal ethylenically unsaturated bonds, more preferably includes a compound having 11 or more terminal ethylenically unsaturated bonds, and even more preferably includes a compound having 15 or more terminal ethylenically unsaturated bonds.

The chemical form of the specific polymerizable compound is, for example, a monomer, a prepolymer which is in other words a dimer, a trimer, or an oligomer, a mixture of these, or the like.

Examples of the monomer include unsaturated carboxylic acids (for example, acrylic acid, methacrylic acid, itaconic acid, crotonic acid, isocrotonic acid, maleic acid, and the like), and esters or amides thereof. Among these, esters of unsaturated carboxylic acids and polyhydric alcohol compounds and amides of unsaturated carboxylic acids and polyvalent amine compounds are preferable. In addition, products of an addition reaction between unsaturated carboxylic

acid esters or amides having a nucleophilic substituent such as a hydroxyl group, an amino group, or a mercapto group and monofunctional or polyfunctional isocyanates or epoxies, products of a dehydrocondensation reaction between the aforementioned unsaturated carboxylic acid esters or amides reactants and a monofunctional or polyfunctional carboxylic acid, and the like are also suitably used. Furthermore, products of an addition reaction between unsaturated carboxylic acid esters or amides having an electrophilic substituent such as an isocyanate groups or an epoxy group and monofunctional or polyfunctional alcohols, amines, or thiols, and products of a substitution reaction between unsaturated carboxylic acid esters or amides having a dissociable substituent such as a halogen atom or a tosyloxy group and monofunctional or polyfunctional alcohols, amines, or thiols are also suitable. Moreover, for example, it is also possible to use a group of compounds obtained by substituting the unsaturated carboxylic acid with an unsaturated phosphonic acid, styrene, a vinyl ether, or the like. These compounds are described in JP2006-508380A, JP2002-287344A, JP2008-256850A, JP2001-342222A, JP1997-179296A (JP-H09-179296A), JP1997-179297A (JP-H09-179297A), JP1997-179298A (JP-H09-179298A), JP2004-294935A, JP2006-243493A, JP2002-275129A, JP2003-64130A, JP2003-280187A, JP1998-333321A (JP-H10-333321A), and the like.

Specific examples of monomers of esters of polyhydric alcohol compounds and unsaturated carboxylic acids include acrylic acid esters such as ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO)-modified triacrylate, and polyester acrylate oligomers, and methacrylic acid esters such as tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl] dimethyl methane, and bis[p-(methacryloxyethoxy)phenyl] dimethyl methane. In addition, specific examples of monomers of amides of polyvalent amine compounds and unsaturated carboxylic acids include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide, xylylene bismethacrylamide, and the like.

In addition, urethane-based addition polymerizable compounds produced using an addition reaction between an isocyanate and a hydroxyl group are also suitable, and specific examples thereof include vinyl urethane compounds having two or more polymerizable vinyl groups in one molecule obtained by adding vinyl monomers having a hydroxyl group represented by Formula (M) to a polyisocyanate compound having two or more isocyanate groups in one molecule which is described in, for example, JP1973-041708B (JP-S48-041708B).

$$CH_2=C(R^{M4})COOCH_2CH(R^{M5})OH \qquad \text{Formula (M)}$$

In Formula (M), $R^{M4}$ and $R^{M5}$ each independently represent a hydrogen atom or a methyl group.

Furthermore, urethane acrylates described in JP1976-37193A (JP-S51-37193A), JP1990-32293B (JP-H02-32293B), JP1990-16765B (JP-H02-16765B), JP2003-344997A, and JP2006-65210A; urethane compounds having an ethylene oxide-based skeleton described in JP1983-49860B (JP-S58-49860B), JP1981-17654B (JP-S56-17654B), JP1987-39417B (JP-S62-39417B), JP1987-39418B (JP-S62-39418B), JP2000-250211A, and JP2007-94138A; and urethane compounds having a hydrophilic group described in US7153632B, JP1996-505958A (JP-H08-505958A), JP2007-293221A, and JP2007-293223A are also suitable.

(Specific compound A1)

In an aspect, from the viewpoint of accelerating the curing reaction of the image-recording layer by exposure and improving printing durability, the polymerizable compound may be a compound having an ethylenically unsaturated bond valence of 5.0 mmol/g or more (hereinafter, this compound will be also called specific compound A1). In the present disclosure, an ethylenically unsaturated group is also called "C=C group", and the ethylenically unsaturated bond valence is also called "C=C valence".

The ethylenically unsaturated bond valence of the specific compound A1 is preferably 5.5 mmol/g or more, and more preferably 6.0 mmol/g or more. The upper limit of the ethylenically unsaturated bond valence of the specific compound A1 is, for example, 10.0 mmol/g or less, and more preferably 8.5 mmol/g or less.

In the present disclosure, the ethylenically unsaturated bond valence of a compound having an ethylenically unsaturated bond is determined by the following method. First, for a predetermined amount (for example, 0.2 g) of sample compound, the structure of the compound is specified using, for example, pyrolysis GC/MS, FT-IR, NMR, TOF-SIMS, and the like, and the total amount (mmol) of ethylenically unsaturated groups is determined. The determined total amount (mmol) of ethylenically unsaturated groups is divided by the amount (g) of the sample compound, thereby calculating the ethylenically unsaturated bond valence of the compound.

The specific compound A1 is preferably a compound represented by Formula (II), because such a compound satisfies the C=C valence described above.

Formula (II): X-(Y)n

In Formula (II), X represents an n-valent organic group having a hydrogen bonding group, Y represents a monovalent group having 2 or more ethylenically unsaturated groups, n represents an integer of 2 or more, and molecular weight of X/(molecular weight of Y $\times$ n) is 1 or less.

The hydrogen bonding group represented by X in Formula (II) is not particularly limited as long as it is a group capable of forming a hydrogen bond. The hydrogen bonding group may be a hydrogen bond donating group or a hydrogen bond accepting group. Examples of the hydrogen bonding group include a hydroxyl group, a carboxy group, an amino group, a carbonyl group, a sulfonyl group, a urethane group, a urea group, an imide group, an amide group, a sulfonamide group, and the like. Particularly, from the viewpoint of on-press developability and printing durability, the compound preferably contains, as the hydrogen bonding group, at least one kind of group selected from the group consisting of a urethane group, a urea group, an imide group, an amide group, and a sulfonamide group, more preferably contains at least one kind of group selected from the group consisting of a urethane group, a urea group, an imide group, and an amide group, even more preferably contains at least one kind of group selected from the group consisting of a urethane group, a urea group, and an imide group, and particularly preferably contains at least one kind of group selected from the group consisting of a urethane group and a urea group.

X in Formula (II) is preferably an organic group that does not have an ethylenically unsaturated bond.

Furthermore, from the viewpoint of on-press developability and printing durability, X in Formula (II) is preferably a group obtained by combining two or more kinds of structures selected from the group consisting of a mono- to n-valent aliphatic hydrocarbon group, a mono- to n-valent aromatic hydrocarbon group, a urethane bond, a urea bond, a biuret bond, and an allophanate bond, and more preferably a group obtained by combining two or more kinds of structures selected from the group consisting of a mono- to n-valent aliphatic hydrocarbon group, a mono- to n-valent aromatic hydrocarbon group, a urethane bond, a urea bond, and a biuret bond.

From the viewpoint of on-press developability and printing durability, X in Formula (II) is preferably a group obtained by removing a terminal isocyanate group from a substance prepared by multimerization of a polyfunctional isocyanate compound (including an adduct of a polyfunctional alcohol compound such as trimethylolpropane adduct), more preferably a group obtained by removing a terminal isocyanate group from a substance prepared by multimerization of a difunctional isocyanate compound (including an adduct of a polyfunctional alcohol compound), and particularly preferably a group obtained by removing a terminal isocyanate group from a substance prepared by multimerization of hexamethylene diisocyanate (including an adduct of a polyfunctional alcohol compound).

From the viewpoint of on-press developability and printing durability, the molecular weight of X in Formula (II) is preferably 100 to 1,000, more preferably 150 to 800, and particularly preferably 150 to 500.

The ethylenically unsaturated group represented by Y in Formula (II) is not particularly limited. From the viewpoint of reactivity, on-press developability, and printing durability, the ethylenically unsaturated group is preferably at least one kind of group selected from the group consisting of a vinyl phenyl group, a vinyl ester group, a vinyl ether group, an allyl group, a (meth)acryloxy group, and a (meth)acrylamide group. From the same viewpoint as above, the ethylenically unsaturated group represented by Y in Formula (II) is more preferably at least one kind of group selected from the group consisting of a vinyl phenyl group, a (meth)acryloxy group, and a (meth)acrylamide group, and even more preferably a (meth)acryloxy group. That is, from the viewpoint of on-press developability and printing durability, the ethylenically unsaturated group represented by Y in Formula (II) preferably includes a (meth)acryloxy group.

Y in Formula (II) is preferably a group having 3 or more (meth)acryloxy groups, more preferably a group having 5 or more (meth)acryloxy groups, and even more preferably a group having 5 to 12 (meth)acryloxy groups.

From the viewpoint of on-press developability and printing durability, Y in Formula (II) may have a structure represented by Formula (Y-1) or Formula (Y-2).

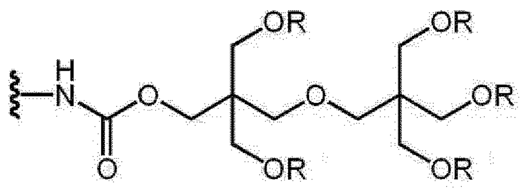
(Y-1)

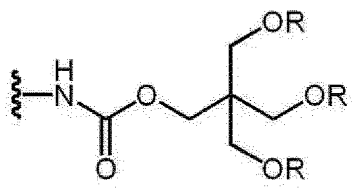
(Y-2)

In Formula (Y-1) and Formula (Y-2), R each independently represents an acryloyl group or a methacryloyl group, and the portion of the wavy line represents a binding position with other structures.

It is preferable that all Rs in Formula (Y-1) or Formula (Y-2) be the same group. Furthermore, it is preferable that all Rs in Formula (Y-1) or Formula (Y-2) be an acryloyl group.

It is preferable that all the n pieces of Y in Formula (II) be the same group.

From the viewpoint of on-press developability and printing durability, the molecular weight of Y in Formula (II) is preferably 200 or more and 1,000 or less, and more preferably 250 or more and 800 or less.

n in Formula (II) is an integer of 2 or more. From the viewpoint of on-press developability and printing durability, n is more preferably 2 or 3.

Molecular weight of X/(molecular weight of Y $\times$ n) is 1 or less. From the viewpoint of on-press developability and printing durability, the value of the expression is preferably 0.01 to 0.8, and more preferably 0.1 to 0.5.

As the structure of the specific compound A1, for example, a structure is preferable which is established by sealing a terminal isocyanate group of a multimerized substance (including an adduct) of a polyfunctional isocyanate compound with a compound having an ethylenically unsaturated group as described above. As the multimerized substance of the polyfunctional isocyanate compound, particularly, a multimerized substance of a difunctional isocyanate compound is preferable.

From the viewpoint of on-press developability and printing durability, the specific compound A1 is preferably a compound obtained by reacting a terminal isocyanate group of a multimerized substance prepared by multimerizing a polyfunctional isocyanate compound with a polyfunctional ethylenically unsaturated compound having a hydroxyl group (also called hydroxy group) on a terminal. Furthermore, from the same viewpoint as above, the specific compound A1 is more preferably a compound obtained by reacting a terminal isocyanate group of a multimerized substance prepared by multimerizing a difunctional isocyanate compound (including an adduct of a polyfunctional alcohol compound) with a polyfunctional ethylenically unsaturated compound having a hydroxyl group. Furthermore, from the same viewpoint as above, the specific compound A1 is particularly preferably a compound obtained by reacting a terminal isocyanate group of a multimerized substance prepared by multimerizing hexamethylene diisocyanate (including an adduct of a polyfunctional alcohol compound) with a polyfunctional ethylenically unsaturated compound having a hydroxyl group.

As the polyfunctional isocyanate compound, known compounds can be used without particular limitation. This compound may be an aliphatic polyfunctional isocyanate compound or an aromatic polyfunctional isocyanate compound. As the polyfunctional isocyanate compound, specifically, for example, 1,3-bis(isocyanatomethyl) cyclohexane, isophorone diisocyanate, trimethylene diisocyanate, tetramethylene diisocyanate, pentamethylene diisocyanate, hexamethylene diisocyanate, 1,3-cyclopentane diisocyanate, 9H-fluorene-2,7-diisocyanate, 9H-fluoren-9-on-2,7-diisocyanate, 4,4'-diphenylmethane diisocyanate, 1,3-phenylene diisocyanate, tolylene-2,4-diisocyanate, tolylene-2,6-diisocyanate, 1,3-bis(isocyanatomethyl) cyclohexane, 2,2-bis(4-isocyanatophenyl) hexafluoropropane, 1,5-diisocyanatonaphthalene, a dimer or trimer (isocyanurate bond) of these polyisocyanates, and the like are preferable. Furthermore, a biuret compound obtained by reacting the above polyisocyanate compound with a known amine compound may also be used.

Furthermore, the polyfunctional ethylenically unsaturated compound having a hydroxyl group is preferably a hydroxyl group-containing ethylenically unsaturated compound having 3 or more functional groups, and more preferably a hydroxyl group-containing ethylenically unsaturated compound having 5 or more functional groups. The aforementioned hydroxyl group-containing polyfunctional ethylenically unsaturated compound is preferably a polyfunctional (meth) acrylate compound having a hydroxyl group.

From the viewpoint of on-press developability and printing durability, the specific compound A1 preferably has at least one kind of structure selected from the group consisting of an adduct structure, a biuret structure, and an isocyanurate structure. From the same viewpoint as above, the specific compound A1 more preferably has at least one kind of structure selected from the group consisting of a trimethylolpropane adduct structure, a biuret structure, and an isocyanurate structure, and particularly preferably has a trimethylolpropane adduct structure.

From the viewpoint of on-press developability and printing durability, the specific compound A1 preferably has a structure represented by any of Formula (A-1) to Formula (A-3), and more preferably has a structure represented by Formula (A-1).

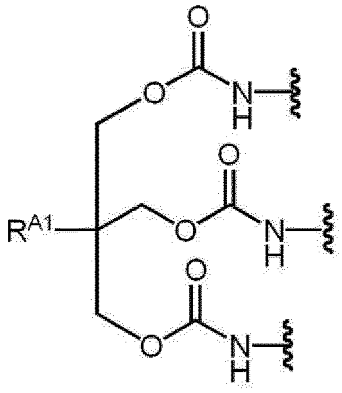

(A-1)

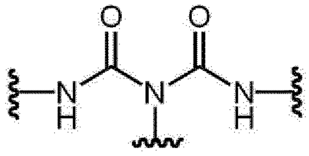

(A-2)

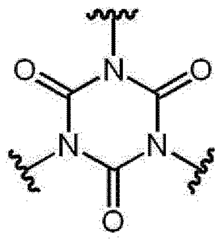

(A-3)

**In** Formula (A-1), $R^{A1}$ represents a hydrogen atom or an alkyl group having 1 to 8 carbon atoms, and the portion of the wavy line represents a binding position with other structures.

From the viewpoint of on-press developability and printing durability, $R^{A1}$ in Formula (A-1) is preferably a hydrogen atom or an alkyl group having 1 to 4 carbon atoms, more preferably an alkyl group having 1 to 3 carbon atoms, even more preferably a methyl group or an ethyl group, and particularly preferably an ethyl group.

From the viewpoint of on-press developability and printing durability, the specific compound A1 is preferably a (meth)acrylate compound having a urethane group, that is, a urethane (meth)acrylate oligomer.

As long as the specific compound A1 has an ethylenically unsaturated bond valence of 5.0 mmol/g or more, the specific compound A1 may be an oligomer having a polyester bond (hereinafter, also called polyester (meth)acrylate oligomer) or an oligomer having an epoxy residue (hereinafter, also called epoxy (meth)acrylate oligomer).

The epoxy residue in the epoxy (meth)acrylate oligomer is as described above.

The number of ethylenically unsaturated groups in the polyester (meth)acrylate oligomer as the specific compound A1 is preferably 3 or more, and more preferably 6 or more.

The epoxy (meth)acrylate oligomer as the specific compound A1 is preferably a compound containing a hydroxyl group. The number of ethylenically unsaturated groups in the epoxy (meth)acrylate oligomer is preferably 2 to 6, and more preferably 2 or 3. The epoxy (meth)acrylate oligomer can be obtained, for example, by reacting a compound having an epoxy group with an acrylic acid.

The molecular weight of the specific compound A1 (weight-average molecular weight in a case where the compound has molecular weight distribution) may be more than 1,000, and is preferably 1,100 to 10,000 and more preferably 1,100 to 5,000.

As the specific compound A1, a synthetic product or a commercially available product may be used.

Specific examples of the specific compound A1 include the following commercially available products. However, the specific compound A1 used in the present disclosure is not limited thereto. The number of functional groups (or the average number of functional groups) and C=C valence of the ethylenically unsaturated group are shown in each bracket.

Specific examples of the specific compound A1 include urethane (meth)acrylate oligomers such as U-10HA (number of functional groups: 10, C=C valence: 8 mmol/g) and U-15HA (number of functional groups: 15, C=C valence: 6 mmol/g) manufactured by SHIN-NAKAMURA CHEMICAL CO, LTD., UA-510H (number of functional groups: 10, C=C valence: 8 mmol/g) manufactured by KYOEISHA CHEMICAL Co., LTD., KRM8452 (number of functional groups: 10, C=C valence: 7 mmol/g) manufactured by DAICEL-ALLNEX LTD., and CN8885NS (number of functional groups: 9, C=C valence: 6 mmol/g) and CN9013NS (number of functional groups: 9, C=C valence: 6 mmol/g) manufactured by Sartomer Company Inc.

Specific examples of the specific compound A1 also include epoxy (meth)acrylate oligomers such as NK OLIGO EA-7420/PGMAc (number of functional groups: 10 to 15, C=C valence: 5 mmol/g) manufactured by SHIN-NAKAMURA CHEMICAL CO, LTD., and CN153 (C=C valence: 5 mmol/g) manufactured by Sartomer Company Inc.

Specific examples of the specific compound A1 also include polyester (meth)acrylate oligomers such as CN2267 (C=C valence: 5 mmol/g) manufactured by Sartomer Company Inc.

(Specific compound A2)

In an aspect, the polymerizable compound may be a compound having one or two ethylenically unsaturated bonding groups (hereinafter, this compound will be also called specific compound A2).

Preferred aspects of the ethylenically unsaturated group contained in the specific compound A2 are the same as preferred aspects of the ethylenically unsaturated group in the specific compound A1.

Furthermore, from the viewpoint of inhibiting the deterioration of on-press developability, the specific compound A2 is preferably a compound having 2 ethylenically unsaturated bonding groups (that is, a difunctional polymerizable compound).
From the viewpoint of on-press developability and printing durability, the specific compound A2 is preferably a methacrylate compound, that is, a compound having a methacryloxy group.
From the viewpoint of on-press developability, the specific compound A2 preferably has an alkyleneoxy structure or a urethane bond.
The molecular weight of the specific compound A2 (weight-average molecular weight in a case where the compound has molecular weight distribution) is preferably 50 or more and less than 1,000, more preferably 200 to 900, and even more preferably 250 to 800.
Specific examples of the specific compound A2 will be shown below. However, the specific compound A2 used in the present disclosure is not limited thereto. In the following compound (2), for example, n + m = 10.

(1)

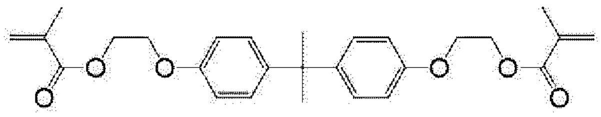

(2)

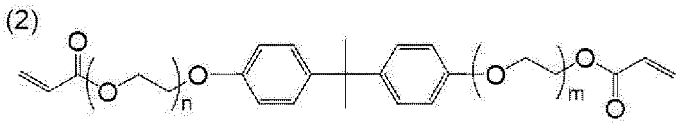

(3)

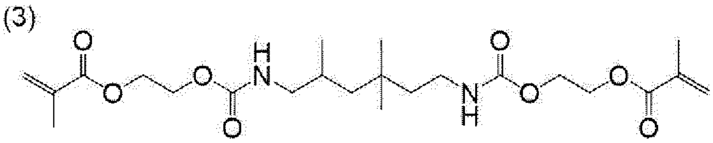

(4)

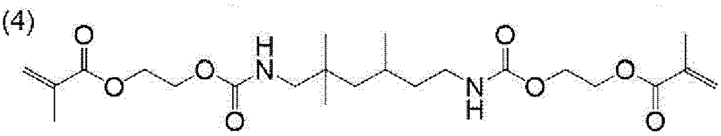

As the specific compound A2, the following commercially available products may be used. However, the specific compound A2 used in the present disclosure is not limited thereto.
Specific examples of the specific compound A2 include ethoxylated bisphenol A dimethacrylate such as BPE-80N (the above compound (1)), BPE-100, BPE-200, and BPE-500 manufactured by SHIN-NAKAMURA CHEMICAL CO, LTD., and CN104 (the above compound (1)) manufactured by Sartomer Company Inc.
Specific examples of the specific compound A2 include ethoxylated bisphenol A diacrylates such as A-BPE-10 (the above compound (2)) and A-BPE-4 manufactured by SHIN-NAKAMURA CHEMICAL CO, LTD.
Furthermore, specific examples of the specific compound A2 include difunctional methacrylate such as FST 510 manufactured by AZ Electronics.
"FST 510" described above is a product of a reaction between 1 mol of 2,2,4-trimethylhexamethylene diisocyanate and 2 mol of hydroxyethyl methacrylate, which is an 82% by mass methyl ethyl ketone solution of the compound (3).
The details of how to use the polymerizable compound, such as the structure of the compound, whether the compound is used alone or used in combination with other compounds, and the amount of the compound to be added, can be randomly set.
The content of the polymerizable compound with respect to the total mass of the image-recording layer is preferably 10% by mass to 90% by mass, more preferably 20% by mass to 80% by mass, and particularly preferably 30% by mass to 70% by mass.
In a case where the image-recording layer contains a polymerizable compound having 6 or less functional groups, the content of the polymerizable compound having 6 or less functional groups with respect to the total mass of the image-recording layer is preferably 10% by mass or less, and more preferably 5% by mass or less.
The ratio of the content of the specific polymerizable compound to the content of the polymerizable compound

having 6 or less functional groups is preferably 4:1 to 1:1 and more preferably 3:1 to 1:1.

-Hydrophilic polymer compound-

The image-recording layer may contain a hydrophilic polymer compound.
Examples of the hydrophilic polymer compound include a cellulose compound and the like. Among these, a cellulose compound is preferable.
Examples of the cellulose compound include cellulose or a compound obtained by modifying at least a part of cellulose (modified cellulose compound). Among these, a modified cellulose compound is preferable.
As the modified cellulose compound, for example, a compound is preferable which is obtained by substituting at least some of hydroxyl groups of cellulose with at least one kind of group selected from the group consisting of an alkyl group and a hydroxyalkyl group.
The degree of substitution of the compound, which is obtained by substituting at least some of hydroxyl groups of cellulose with at least one kind of group selected from the group consisting of an alkyl group and a hydroxyalkyl group, is preferably 0.1 to 6.0, and more preferably 1 to 4.
As the modified cellulose compound, an alkyl cellulose compound or a hydroxyalkyl cellulose compound is preferable, and a hydroxyalkyl cellulose compound is more preferable.
As the alkyl cellulose compound, for example, methyl cellulose is preferable.
As the hydroxyalkyl cellulose compound, for example, hydroxypropyl cellulose is preferable.
The molecular weight of the hydrophilic polymer compound (weight-average molecular weight in a case where the compound has molecular weight distribution) is preferably 3,000 to 5,000,000, and more preferably 5,000 to 200,000.

-Hydrophilic low-molecular-weight compound-

The image-recording layer may contain a hydrophilic low-molecular-weight compound.
Examples of the hydrophilic low-molecular-weight compound include a glycol compound, a polyol compound, an organic amine compound, an organic sulfonic acid compound, an organic sulfamine compound, an organic sulfuric acid compound, an organic phosphonic acid compound, an organic carboxylic acid compound, a betaine compound, and the like. Among these, a polyol compound, an organic sulfonic acid compound, or a betaine compound is preferable.
Examples of the glycol compound include glycols such as ethylene glycol, diethylene glycol, triethylene glycol, propylene glycol, dipropylene glycol, and tripropylene glycol, and ether or ester derivatives of these compounds.
Examples of the polyol compound include glycerin, pentaerythritol, tris(2-hydroxyethyl) isocyanurate, and the like.
Examples of the organic amine compound include triethanolamine, diethanolamine, monoethanolamine, salts of these, and the like.
Examples of the organic sulfonic acid compound include alkyl sulfonic acid, toluene sulfonic acid, benzene sulfonic acid, salts of these, and the like. Among these, for example, alkyl sulfonic acid having an alkyl group having 1 to 10 carbon atoms is preferable.
Examples of the organic sulfamine compound include alkylsulfamic acid, salts thereof, and the like.
Examples of the organic sulfuric acid compound include alkyl sulfuric acid, alkyl ether sulfuric acid, salts of these, and the like.
Examples of the organic phosphonic acid compound include phenylphosphonic acid, salts thereof, and the like.
Examples of the organic carboxylic acid compound include tartaric acid, oxalic acid, citric acid, malic acid, lactic acid, gluconic acid, salts of these, and the like.
Examples of the betaine compound include a phosphobetaine compound, a sulfobetaine compound, a carboxybetaine compound, and the like. Among these, for example, trimethylglycine is preferable.
The molecular weight of the hydrophilic low-molecular-weight compound (weight-average molecular weight in a case where the compound has molecular weight distribution) is preferably 100 or more and less than 3,000, and more preferably 300 to 2,500.

-Color developing agent-

The image-recording layer preferably contains a color developing agent, and more preferably contains an acid color-developing agent.
"Color developing agent" used in the present disclosure means a compound that has a property of developing or removing color by a stimulus such as light or an acid and thus changing the color of the image-recording layer. Furthermore, "acid color-developing agent" means a compound having a property of developing or removing color by being heated in a state of accepting an electron accepting compound (for example, a proton of an acid or the like) and thus

changing the color of the image-recording layer. The acid color-developing agent is particularly preferably a colorless compound which has a partial skeleton such as lactone, lactam, sultone, spiropyran, an ester, or an amide and allows such a partial skeleton to rapidly open the ring or to be cleaved when coming into contact with an electron accepting compound.

Examples of such an acid color-developing agent include phthalides such as 3,3-bis(4-dimethylaminophenyl)-6-dimethylaminophthalide (called "crystal violet lactone"), 3,3-bis(4-dimethylaminophenyl)phthalide, 3-(4-dimethylaminophenyl)-3-(4-diethylamino-2-methylphenyl)-6-dimethylaminophthalide, 3-(4-dimethylaminophenyl)-3-(1,2-dimethylindol-3-yl)phthalide, 3-(4-dimethylaminophenyl)-3-(2-methylindole-3-yl)phthalide, 3,3-bis(1,2-dimethylindol-3-yl)-5-dimethylaminophthalide, 3,3-bis(1,2-dimethylindol-3-yl)-6-dimethylaminophthalide, 3,3-bis(9-ethylcarbazol-3-yl)-6-dimethylaminophthalide, 3,3-bis(2-phenylindol-3-yl)-6-dimethylaminophthalide, 3-(4-dimethylaminophenyl)-3-(1-methylpyrrol-3-yl)-6-dimethylaminophthalide,

3,3-bis[1,1-bis(4-dimethylaminophenyl)ethylen-2-yl]-4,5,6,7-tetrachlorophthalide, 3,3-bis[1,1-bis(4-pyrrolidinophenyl)ethylen-2-yl]-4,5,6,7-tetrabromophthalide, 3,3-bis[1-(4-dimethylaminophenyl)-1-(4-methoxyphenyl)ethylen-2-yl]-4,5,6,7-tetrachlorophth alide, 3,3-bis[1-(4-pyrrolidinophenyl)-1-(4-methoxyphenyl)ethylen-2-yl]-4,5,6,7-tetrachlorophthalid e, 3-[1,1-di(1-ethyl-2-methylindol-3-yl)ethylen-2-yl]-3-(4-diethylaminophenyl)phthalide, 3-[1,1-di(1-ethyl-2-methylindol-3-yl)ethylen-2-yl]-3-(4-N-ethyl-N-phenylaminophenyl)phthali de, 3-(2-ethoxy-4-diethylaminophenyl)-3-(1-n-octyl-2-methylindol-3-yl)-phthalide, 3,3-bis(1-n-octyl-2-methylindol-3-yl)-phthalide, and 3-(2-methyl-4-diethylaminophenyl)-3-(1-n-octyl-2-methylindol-3-yl)-phthalide,

4,4-bis-dimethylaminobenzhydrinbenzyl ether, N-halophenyl-leucoauramine, N-2,4,5-trichlorophenylleucoauramine, rhodamine-B-anilinolactam, rhodamine-(4-nitroanilino)lactam, rhodamine-B-(4-chloroanilino)lactam, 3,7-bis(diethylamino)-10-benzoylphenoxazine, benzoyl leucomethylene blue, 4-nitrobenzoyl methylene blue,

fluorans such as 3,6-dimethoxyfluoran, 3-dimethylamino-7-methoxyfluoran, 3-diethylamino-6-methoxyfluoran, 3-diethylamino-7-methoxyfluoran, 3-diethylamino-7-chlorofluoran, 3-diethylamino-6-methyl-7-chlorofluoran, 3-diethylamino-6,7-dimethylfluoran, 3-N-cyclohexyl-N-n-butylamino-7-methylfluoran, 3-diethylamino-7-dibenzylaminofluoran, 3-diethylamino-7-octylaminofluoran, 3-diethylamino-7-di-n-hexylaminofluoran, 3-diethylamino-7-anilinofluoran, 3-diethylamino-7-(2'-fluorophenylamino)fluoran, 3-diethylamino-7-(2'-chlorophenylamino)fluoran, 3-diethylamino-7-(3'-chlorophenylamino)fluoran, 3-diethylamino-7-(2',3'-dichlorophenylamino)fluoran, 3-diethylamino-7-(3'-trifluoromethylphenylamino)fluoran, 3-di-n-butylamino-7-(2'-fluorophenylamino)fluoran, 3-di-n-butylamino-7-(2'-chlorophenylamino)fluoran, 3-N-isopentyl-N-ethylamino-7-(2'-chlorophenylamino)fluoran,

3-N-n-hexyl-N-ethylamino-7-(2'-chlorophenylamino)fluoran, 3-diethylamino-6-chloro-7-anilinofluoran, 3-di-n-butylamino-6-chloro-7-anilinofluoran, 3-diethylamino-6-methoxy-7-anilinofluoran, 3-di-n-butylamino-6-ethoxy-7-anilinofluoran, 3-pyrrolidino-6-methyl-7-anilinofluoran, 3-piperidino-6-methyl-7-anilinofluoran, 3-morpholino-6-methyl-7-anilinofluoran, 3-dimethylamino-6-methyl-7-anilinofluoran, 3-diethylamino-6-methyl-7-anilinofluoran, 3-di-n-butylamino-6-methyl-7-anilinofluoran, 3-di-n-pentylamino-6-methyl-7-anilinofluoran, 3-N-ethyl-N-methylamino-6-methyl-7-anilinofluoran, 3-N-n-propyl-N-methylamino-6-methyl-7-anilinofluoran, 3-N-n-propyl-N-ethylamino-6-methyl-7-anilinofluoran, 3-N-n-butyl-N-methylamino-6-methyl-7-anilinofluoran, 3-N-n-butyl-N-ethylamino-6-methyl-7-anilinofluoran, 3-N-isobutyl-N-methylamino-6-methyl-7-anilinofluoran, 3-N-isobutyl-N-ethylamino-6-methyl-7-anilinofluoran, 3-N-isopentyl-N-ethylamino-6-methyl-7-anilinofluoran, 3-N-n-hexyl-N-methylamino-6-methyl-7-anilinofluoran, 3-N-cyclohexyl-N-ethylamino-6-methyl-7-anilinofluoran, 3-N-cyclohexyl-N-n-propylamino-6-methyl-7-anilinofluoran, 3-N-cyclohexyl-N-n-butylamino-6-methyl-7-anilinofluoran, 3-N-cyclohexyl-N-n-hexylamino-6-methyl-7-anilinofluoran, 3-N-cyclohexyl-N-n-octylamino-6-methyl-7-anilinofluoran,

3-N-(2'-methoxyethyl)-N-methylamino-6-methyl-7-anilinofluoran, 3-N-(2'-methoxyethyl)-N-ethylamino-6-methyl-7-anilinofluoran, 3-N-(2'-methoxyethyl)-N-isobutylamino-6-methyl-7-anilinofluoran, 3-N-(2'-ethoxyethyl)-N-methylamino-6-methyl-7-anilinofluoran, 3-N-(2'-ethoxyethyl)-N-ethylamino-6-methyl-7-anilinofluoran, 3-N-(3'-methoxypropyl)-N-methylamino-6-methyl-7-anilinofluoran, 3-N-(3'-methoxypropyl)-N-ethylamino-6-methyl-7-anilinofluoran, 3-N-(3'-ethoxypropyl)-N-methylamino-6-methyl-7-anilinofluoran, 3-N-(3'-ethoxypropyl)-N-ethylamino-6-methyl-7-anilinofluoran, 3-N-(2'-tetrahydrofurfuryl)-N-ethylamino-6-methyl-7-anilinofluoran, 3-N-(4'-methylphenyl)-N-ethylamino-6-methyl-7-anilinofluoran, 3-diethylamino-6-ethyl-7-anilinofluoran, 3-diethylamino-6-methyl-7-(3'-methylphenylamino)fluoran, 3-diethylamino-6-methyl-7-(2',6'-dimethylphenylamino)fluoran, 3-di-n-butylamino-6-methyl-7-(2',6'-dimethylphenylamino)fluoran, 3-di-n-butylamino-7-(2',6'-dimethylphenylamino)fluoran, 2,2-bis[4'-(3-N-cyclohexyl-N-methylamino-6-methylfluoran)-7-ylaminophenyl]propane, 3-[4'-(4-phenylaminophenyl)aminophenyl]amino-6-methyl-7-chlorofluoran, and 3-[4'-(dimethylaminophenyl)]amino-5,7-dimethylfluoran,

phthalides such as 3-(2-methyl-4-diethylaminophenyl)-3-(1-ethyl-2-methylindol-3-yl)-4-azaphthalide, 3-(2-n-propoxycarbonylamino-4-di-n-propylaminophenyl)-3-(1-ethyl-2-methylindol-3-yl)-4-a zaphthalide, 3-(2-methylamino-4-di-n-propylaminophenyl)-3-(1-ethyl-2-methylindol-3-yl)-4-azaphthalide, 3-(2-methyl-4-di-n-hexylaminophenyl)-3-(1-n-octyl-2-methylindol-3-yl)-4,7-diazaphthalide, 3,3-bis(2-ethoxy-4-diethylaminophenyl)-4-azaphthalide, 3,3-bis(1-n-octyl-2-methylindol-3-yl)-4-azaphthalide, 3-(2-ethoxy-4-diethylaminophenyl)-3-(1-ethyl-2-methylindol-3-yl)-4-azaphthalide, 3-(2-ethoxy-4-diethylaminophenyl)-3-(1-octyl-2-methylindol-3-yl)-4 or 7-azaphthalide,

3-(2-ethoxy-4-diethylaminophenyl)-3-(1-ethyl-2-methylindol-3-yl)-4 or 7-azaphthalide, 3-(2-hexyloxy-4-diethylaminophenyl)-3-(1-ethyl-2-methylindol-3-yl)-4 or 7-azaphthalide, 3-(2-ethoxy-4-diethylaminophenyl)-3-(1-ethyl-2-phenylindol-3-yl)-4 or 7-azaphthalide, 3-(2-butoxy-4-diethylaminophenyl)-3-(1-ethyl-2-phenylindol-3-yl)-4 or 7-azaphthalide 3-methyl-spiro-dinaphthopyran, 3-ethyl-spiro-dinaphthopyran, 3-phenyl-spiro-dinaphthopyran, 3-benzyl-spiro-dinaphthopyran, 3-methyl-naphtho-(3-methoxybenzo)spiropyran, 3-propyl-spiro-dibenzopyran-3,6-bis(dimethylamino)fluorene-9-spiro-3'-(6'-dimethylamino)p hthalide, and 3,6-bis(diethylamino)fluorene-9-spiro-3'-(6'-dimethylamino) phthalide,

2'-anilino-6'-(N-ethyl-N-isopentyl)amino-3'-methylspiro[isobenzofuran-1(3H),9'-(9H)xanthe n-3-one, 2'-anilino-6'-(N-ethyl-N-(4-methylphenyl))amino-3'-methylspiro[isobenzofuran-1(3H),9'-(9H )xanthen]-3-one, 3'-N,N-dibenzylamino-6'-N,N-diethylaminospiro[isobenzofuran-1(3H),9'-(9H)xanthen]-3-on e, 2'-(N-methyl-N-phenyl)amino-6'-(N-ethyl-N-(4-methylphenyl))aminospiro[isobenzofuran-1( 3H),9'-(9H)xanthen]-3-one, and the like.

Particularly, from the viewpoint of color developability, the color developing agent in the present disclosure is preferably at least one kind of compound selected from the group consisting of a spiropyran compound, a spirooxazine compound, a spirolactone compound, and a spirolactam compound.

From the viewpoint of visibility, the hue of the colorant after color development is preferably green, blue, or black.

Furthermore, from the viewpoint of color developability and visibility of exposed portions, the acid color-developing agent is preferably a leuco colorant.

The leuco colorant is not particularly limited as long as it is a colorant having a leuco structure. The leuco colorant preferably has a spiro structure, and more preferably has a spirolactone ring structure.

From the viewpoint of color developability and visibility of exposed portions, the leuco colorant preferably has a phthalide structure or a fluoran structure.

Furthermore, from the viewpoint of color developability and visibility of exposed portions, the leuco colorant having a phthalide structure or a fluoran structure is preferably a compound represented by any of Formula (Le-1) to Formula (Le-3), and more preferably a compound represented by Formula (Le-2).

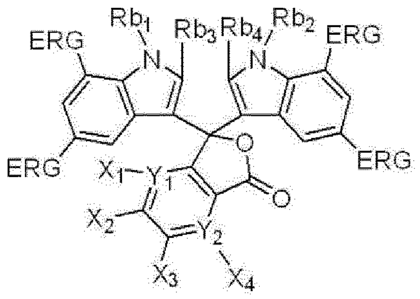

(Le-1)

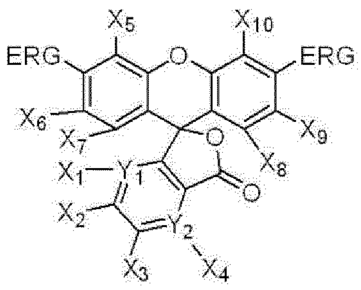

(Le-2)

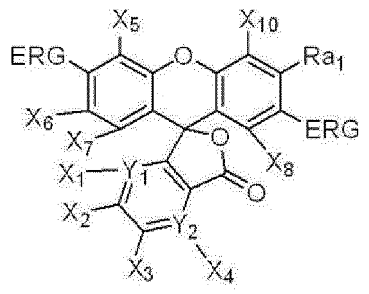

(Le-3)

In Formula (Le-1) to Formula (Le-3), ERG each independently represents an electron donating group, $X_1$ to $X_4$ each independently represent a hydrogen atom, a halogen atom, or dialkylanilino group, $X_5$ to $X_{10}$ each independently represent a hydrogen atom, a halogen atom, or a monovalent organic group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent an alkyl group or an aryl group.

As the electron donating groups represented by ERG in Formula (Le-1) to Formula (Le-3), from the viewpoint of color developability and visibility of exposed portions, an amino group, an alkylamino group, an arylamino group, a dialkylamino group, a monoalkyl monoarylamino group, a diarylamino group, an alkoxy group, an aryloxy group or an alkyl group is preferable, an amino group, alkylamino group, arylamino group, dialkylamino group, monoalkyl monoarylamino group, diarylamino group, alkoxy group, or an aryloxy group is more preferable, a monoalkyl monoarylamino group or a diarylamino group is even more preferable, and a monoalkyl monoarylamino group is particularly preferable.

From the viewpoint of color developability and visibility of exposed portions, $X_1$ to $X_4$ in Formula (Le-1) to Formula (Le-3) preferably each independently represent a hydrogen atom or a chlorine atom, and more preferably each independently represent a hydrogen atom.

From the viewpoint of color developability and visibility of exposed portions, $X_5$ to $X_{10}$ in Formula (Le-2) or Formula (Le-3) preferably each independently represent a hydrogen atom, a halogen atom, an alkyl group, an aryl group, an amino group, an alkylamino group, an arylamino group, a dialkylamino group, a monoalkyl monoarylamino group, a diarylamino group, a hydroxyl group, an alkoxy group, an aryloxy group, an acyl group, an alkoxycarbonyl group, an aryloxycarbonyl group, or an cyano group, more preferably each independently represent a hydrogen atom, a halogen atom, an alkyl group, an aryl group, an alkoxy group, or an aryloxy group, even more preferably each independently

represent a hydrogen atom, a halogen atom, an alkyl group, or an aryl group, and particularly preferably each independently represent a hydrogen atom.

From the viewpoint of color developability and visibility of exposed portions, it is preferable that at least one of $Y_1$ or $Y_2$ in Formula (Le-1) to Formula (Le-3) be C, and it is more preferable that both of $Y_1$ and $Y_2$ be C.

From the viewpoint of color developability and visibility of exposed portions, $Ra_1$ in Formula (Le-1) to Formula (Le-3) is preferably an alkyl group or an alkoxy group, more preferably an alkoxy group, and particularly preferably a methoxy group.

From the viewpoint of color developability and visibility of exposed portions, $Rb_1$ to $Rb_4$ in Formula (Le-1) to Formula (Le-3) preferably each independently represent a hydrogen atom or an alkyl group, more preferably each independently represent an alkyl group, and particularly preferably each independently represent a methyl group.

Furthermore, from the viewpoint of color developability and visibility of exposed portions, the leuco colorant having a phthalide structure or a fluoran structure is more preferably a compound represented by any of Formula (Le-4) to Formula (Le-6), and even more preferably a compound represented by Formula (Le-5).

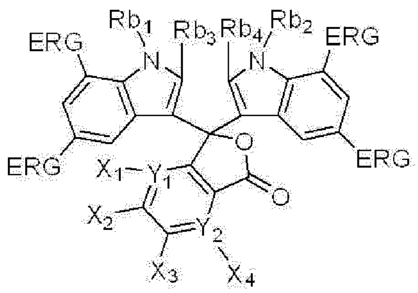

(Le-4)

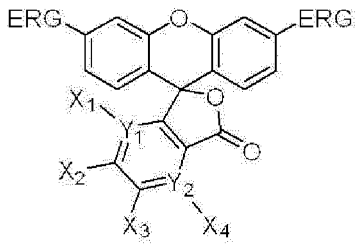

(Le-5)

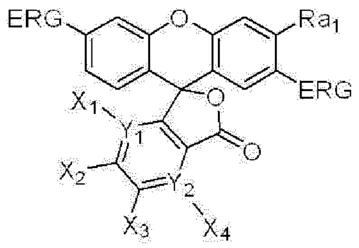

(Le-6)

In Formula (Le-4) to Formula (Le-6), ERG each independently represents an electron donating group, $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent an alkyl group or an aryl group.

ERG, $X_1$ to $X_4$, $Y_1$, $Y_2$, $Ra_1$, and $Rb_1$ to $Rb_4$ in Formula (Le-4) to Formula (Le-6) have the same definitions as ERG, $X_1$ to $X_4$, $Y_1$, $Y_2$, $Ra_1$, and $Rb_1$ to $Rb_4$ in Formula (Le-1) to Formula (Le-3) respectively, and preferred aspects thereof are also the same.

Furthermore, from the viewpoint of color developability and visibility of exposed portions, the leuco colorant having a phthalide structure or a fluoran structure is more preferably a compound represented by any of Formula (Le-7) to Formula (Le-9), and particularly preferably a compound represented by Formula (Le-8).

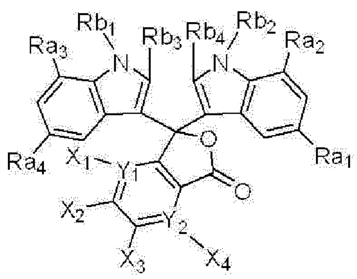

(Le-7)

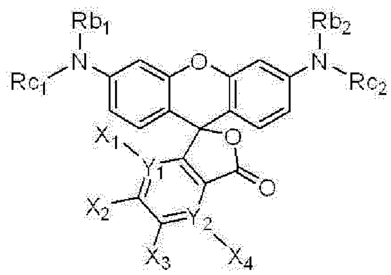

(Le-8)

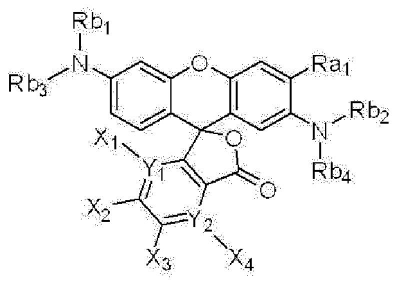

(Le-9)

In Formula (Le-7) to Formula (Le-9), $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ to $Ra_4$ each independently represent a hydrogen atom, an alkyl group, or an alkoxy group, $Rb_1$ to $Rb_4$ each independently represent an alkyl group or an aryl group, and $Rc_1$ and $Rc_2$ each independently represent an aryl group.

$X_1$ to $X_4$, $Y_1$, and $Y_2$ in Formula (Le-7) to Formula (Le-9) have the same definition as $X_1$ to $X_4$, $Y_1$, and $Y_2$ in Formula (Le-1) to Formula (Le-3) respectively, and preferred aspects thereof are also the same.

From the viewpoint of color developability and visibility of exposed portions, $Ra_1$ to $Ra_4$ in Formula (Le-7) to

Formula (Le-9) preferably each independently represent an alkyl group or an alkoxy group, more preferably each independently represent an alkoxy group, and particularly preferably each independently represent a methoxy group.

From the viewpoint of color developability and visibility of exposed portions, $Rb_1$ to $Rb_4$ in Formula (Le-7) to Formula (Le-9) preferably each independently represent an alkyl group or an aryl group substituted with an alkoxy group, more preferably each independently represent an alkyl group, and particularly preferably each independently represent a methyl group.

From the viewpoint of color developability and visibility of exposed portions, $Rc_1$ and $Rc_2$ in Formula (Le-7) to Formula (Le-9) preferably each independently represent a phenyl group or an alkylphenyl group, and more preferably each independently represent a phenyl group.

In Formula (Le-8), from the viewpoint of color developability and visibility of exposed portions, $X_1$ to $X_4$ preferably each represent a hydrogen atom, and $Y_1$ and $Y_2$ preferably each represent C.

Furthermore, from the viewpoint of color developability and visibility of exposed portions, in Formula (Le-8), $Rb_1$ and $Rb_2$ preferably each independently represent an alkyl group or an aryl group substituted with an alkoxy group.

The alkyl group in Formula (Le-1) to Formula (Le-9) may be linear or branched or may have a ring structure.

The number of carbon atoms in the alkyl group in Formula (Le-1) to Formula (Le-9) is preferably 1 to 20, more preferably 1 to 8, even more preferably 1 to 4, and particularly preferably 1 or 2.

The number of carbon atoms in the aryl group in Formula (Le-1) to Formula (Le-9) is preferably 6 to 20, more preferably 6 to 10, and particularly preferably 6 to 8.

Each of the groups in Formula (Le-1) to Formula (Le-9), such as a monovalent organic group, an alkyl group, an aryl group, a dialkylanilino group, an alkylamino group, and an alkoxy group, may have a substituent. Examples of the substituent include an alkyl group, an aryl group, a halogen atom, an amino group, an alkylamino group, an arylamino group, a dialkylamino group, a monoalkyl monoarylamino group, a diarylamino group, a hydroxyl group, an alkoxy group, an aryloxy group, an acyl group, an alkoxycarbonyl group, an aryloxycarbonyl group, a cyano group, and the like. These substituents may be further substituted with these substituents.

Examples of the leuco colorant having a phthalide structure or a fluoran structure that are suitably used include the following compounds.

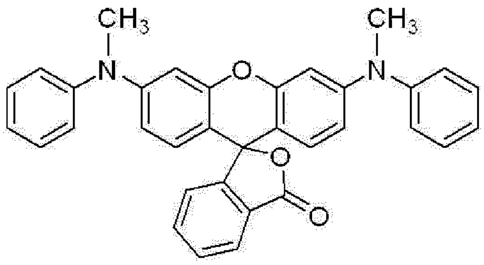

S - 1

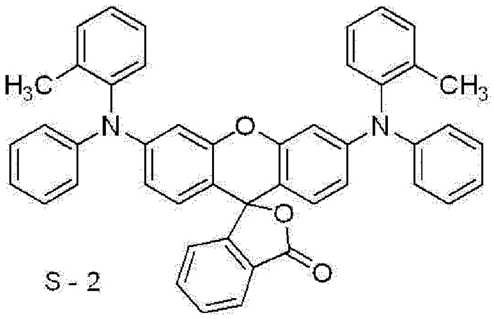

S - 2

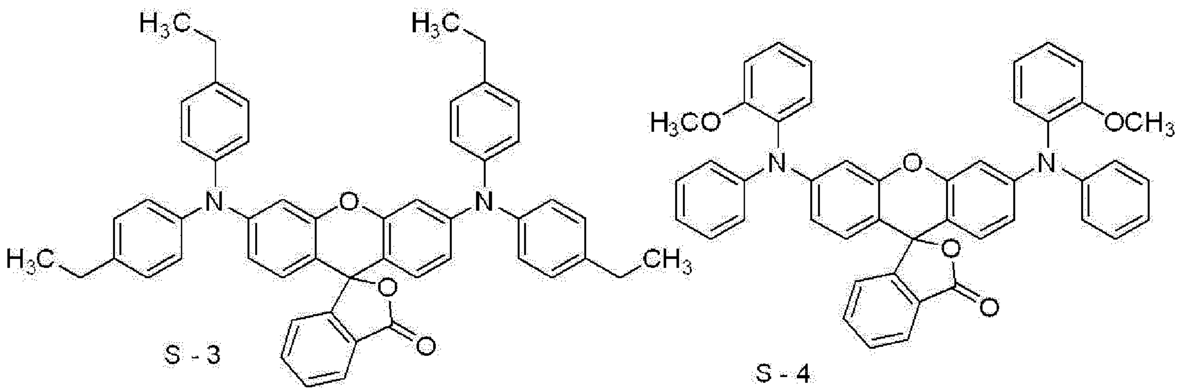

S - 3

S - 4

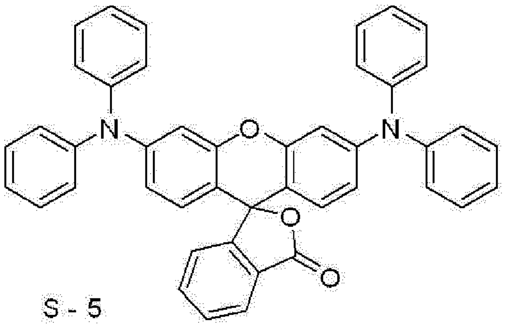

S - 5

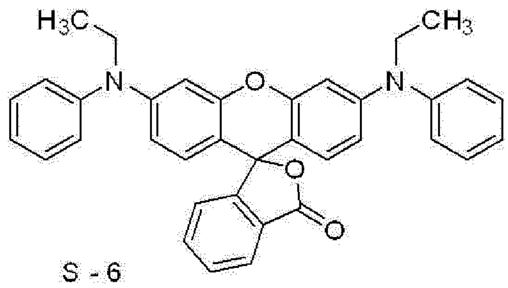

S - 6

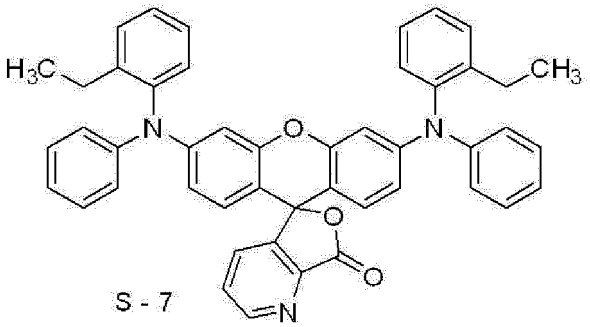

S - 7

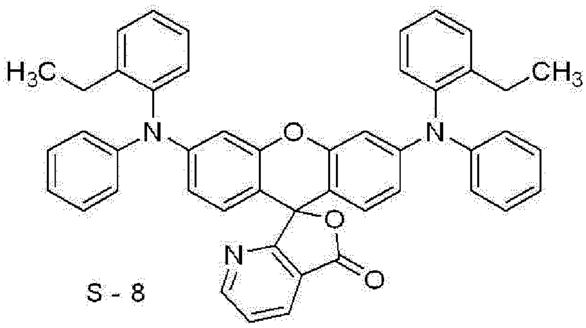

S - 8

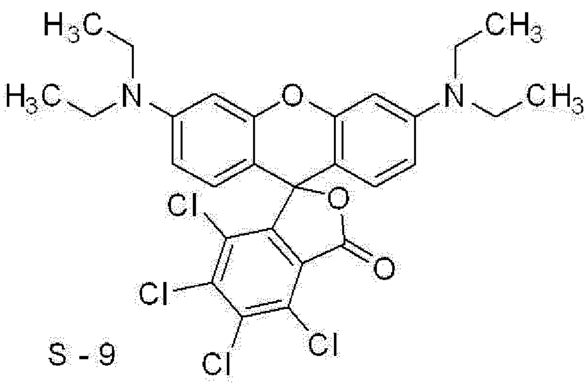

S - 9

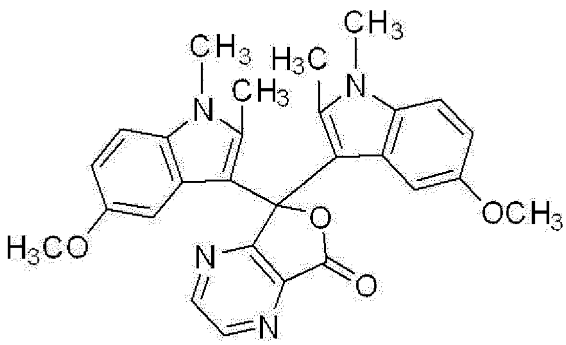

S - 10

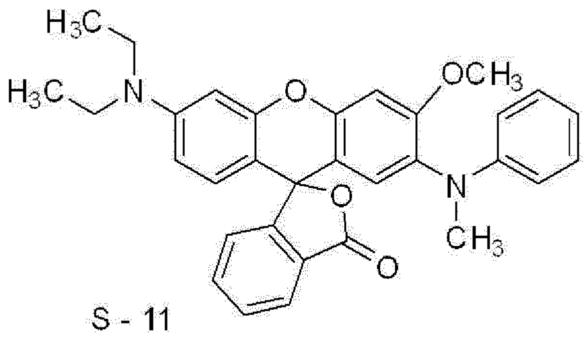

S - 11

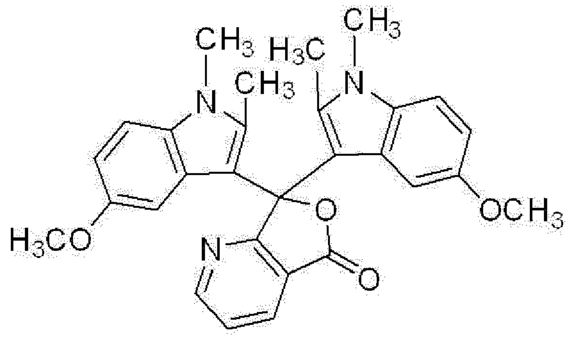

S - 12

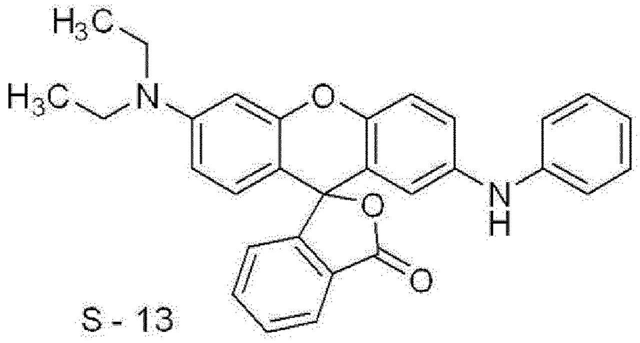

S - 13

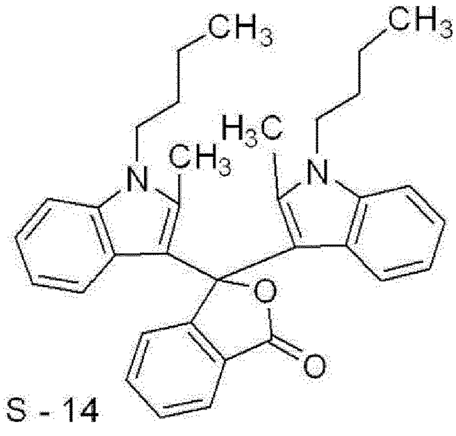

S - 14

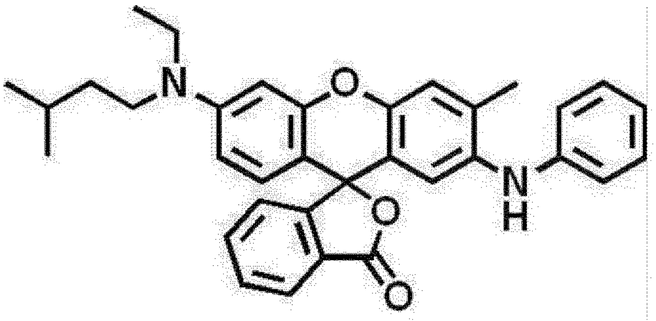

S-15

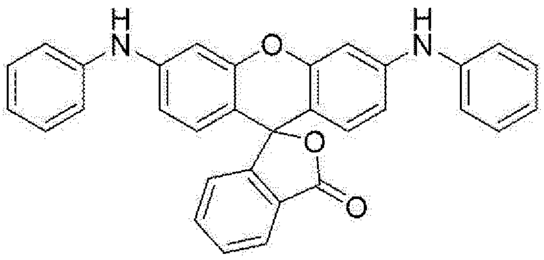

S - 16

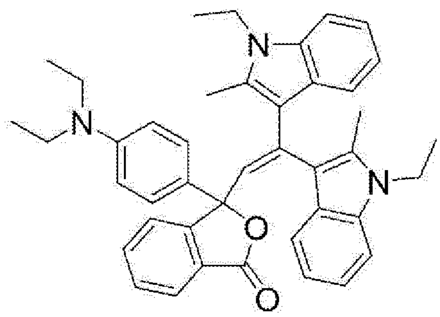

S - 17

As the acid color-developing agent, commercially available products can be used. Examples thereof include ETAC, RED500, RED520, CVL, S-205, BLACK305, BLACK400, BLACK100, BLACK500, H-7001, GREEN300, NIRBLACK78, BLUE220, H-3035, BLUE203, ATP, H-1046, and H-2114 (all manufactured by Fukui Yamada Chemical Co., Ltd.), ORANGE-DCF, Vermilion-DCF, PINK-DCF, RED-DCF, BLMB, CVL, GREEN-DCF, and TH-107 (all manufactured by Hodogaya Chemical Co., Ltd.), ODB, ODB-2, ODB-4, ODB-250, ODB-BlackXV, Blue-63, Blue-502, GN-169, GN-2, Green-118, Red-40, and Red-8 (all manufactured by Yamamoto Chemicals, Inc.), crystal violet lactone (manufactured by Tokyo Chemical Industry Co., Ltd.), and the like. Among these commercially available products, ETAC, S-205, BLACK305, BLACK400, BLACK100, BLACK500, H-7001, GREEN300, NIRBLACK78, H-3035, ATP, H-1046, H-2114, GREEN-DCF, Blue-63, GN-169, and crystal violet lactone are preferable because these form a film having excellent visible light absorbance.

One kind of each of these color developing agents may be used alone. Alternatively, two or more kinds of components can be used in combination.

The content of the color developing agent with respect to the total mass of the image-recording layer is preferably 0.5% by mass to 10% by mass, and more preferably 1% by mass to 5% by mass.

-Chain transfer agent-

The image-recording layer in the present disclosure may contain a chain transfer agent. The chain transfer agent contributes to the improvement of printing durability of the lithographic printing plate.

As the chain transfer agent, a thiol compound is preferable, a thiol having 7 or more carbon atoms is more preferable from the viewpoint of boiling point (low volatility), and a compound having a mercapto group on an aromatic ring (aromatic thiol compound) is even more preferable. The thiol compound is preferably a monofunctional thiol compound.

Specific examples of the chain transfer agent include the following compounds.

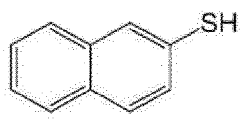

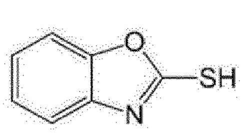 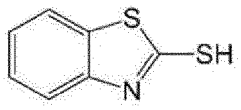 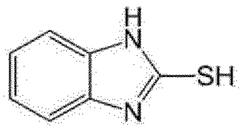

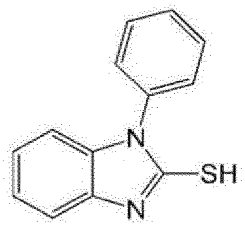 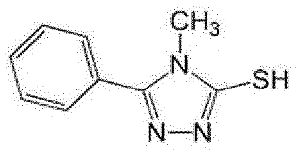 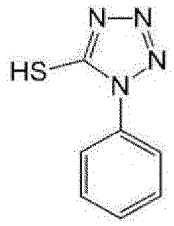

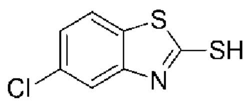 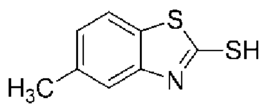 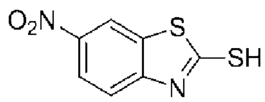 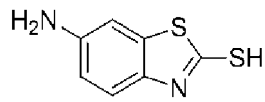

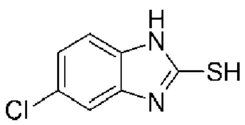 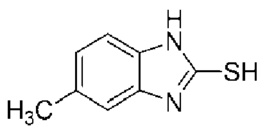 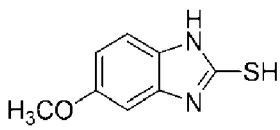 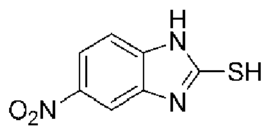

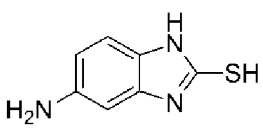 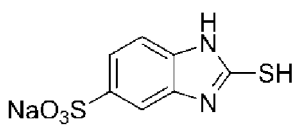 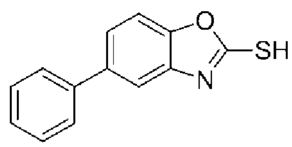

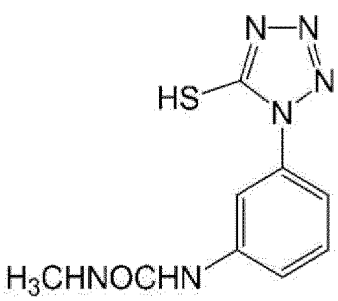 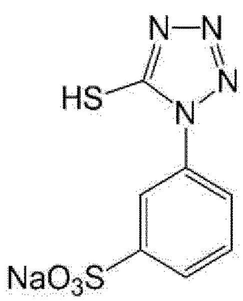

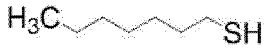
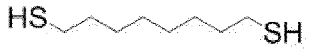
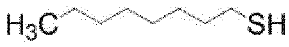
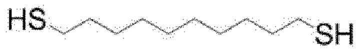
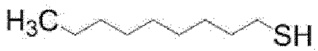
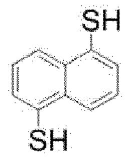
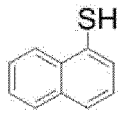
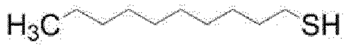
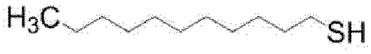
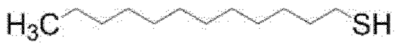
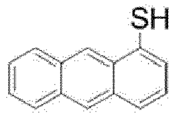
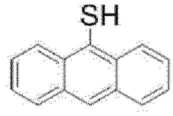
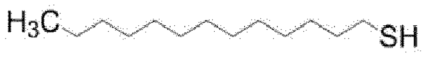
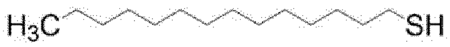
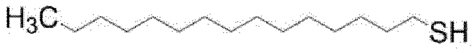
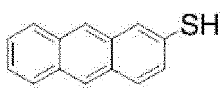
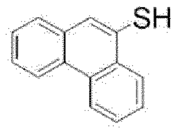
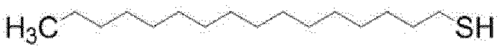
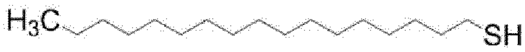
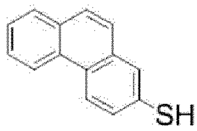
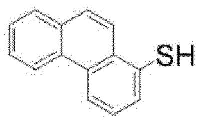
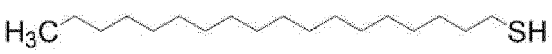
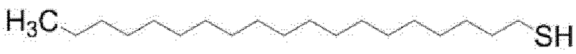
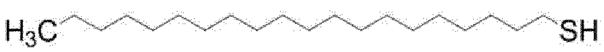
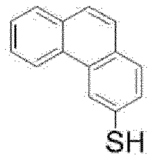
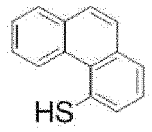
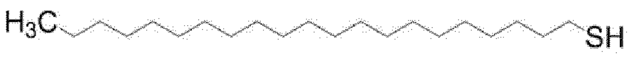
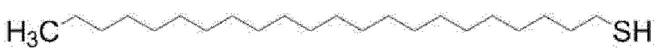

The image-recording layer may contain only one kind of chain transfer agent, or two or more kinds of chain transfer agents may be used in combination.

The content of the chain transfer agent with respect to the total mass of the image-recording layer is preferably 0.01% by mass to 50% by mass, more preferably 0.05% by mass to 40% by mass, and even more preferably 0.1% by mass to 30% by mass.

-Low-molecular-weight hydrophilic compound-

**In** order to suppress the deterioration of printing durability and improve on-press developability, the image-recording layer may contain a low-molecular-weight hydrophilic compound. The low-molecular-weight hydrophilic compound is preferably a compound having a molecular weight less than 1,000, more preferably a compound having a molecular weight less than 800, and even more preferably a compound having a molecular weight less than 500.

Examples of the low-molecular-weight hydrophilic compound include a water-soluble organic compound. Examples of the water-soluble organic compound include glycols such as ethylene glycol, diethylene glycol, triethylene glycol, propylene glycol, dipropylene glycol, and tripropylene glycol, ether or ester derivatives of these glycols, polyols such as glycerin, pentaerythritol, and tris(2-hydroxyethyl)isocyanurate, organic amines and salts thereof such as triethanolamine, diethanolamine, and monoethanolamine, organic sulfonic acids and salts thereof such as alkyl sulfonate, toluene sulfonate, and benzene sulfonate, organic sulfamic acids and salts thereof such as alkylsulfamate, organic sulfuric acids and salts thereof such as alkyl sulfate and alkyl ether sulfate, organic phosphonic acids and salts thereof such as phenyl phosphate, organic carboxylic acids and salts thereof such as tartaric acid, oxalic acid, citric acid, malic acid, lactic acid, gluconic acid, and amino acid, betaines, and the like.

As the low-molecular-weight hydrophilic compound, at least one compound selected from polyols, organic sulfates, organic sulfonates, and betaines is preferably incorporated into the image-recording layer.

Specific examples of the organic sulfonates include alkyl sulfonates such as sodium n-butyl sulfonate, sodium n-hexyl sulfonate, sodium 2-ethylhexyl sulfonate, sodium cyclohexyl sulfonate, and sodium n-octyl sulfonate; alkyl sulfonates having a polyethyleneoxy chain such as sodium 5,8,11-trioxapentadecane-1-sulfonate, sodium 5,8,11-trioxaheptadecane-1-sulfonate, sodium 13 -ethyl-5,8, 11-trioxaheptadecane-1-sulfonate, and sodium 5,8,11,14-tetraoxatetracosane-1-sulfonate; aryl sulfonates such as sodium benzenesulfonate, sodium p-toluenesulfonate, sodium p-hydroxybenzene sulfonate, sodium p-styrene sulfonate, sodium dimethyl isophthalate-5-sulfonate, sodium 1-naphthyl sulfonate, sodium 4-hydroxynaphthyl sulfonate, disodium 1,5-naphthalene disulfonate, and trisodium 1,3,6-naphthalene trisulfonate, the compounds described in paragraphs "0026" to "0031" of JP2007-276454A and paragraphs "0020" to "0047" of JP2009-154525A, and the like. The salt may be a potassium salt or a lithium salt.

Examples of the organic sulfates include sulfates of alkyl, alkenyl, alkynyl, aryl, or heterocyclic monoether of a polyethyleneoxy structure. The number of ethyleneoxy units is preferably 1 to 4, and the salt is preferably a sodium salt, a potassium salt, or a lithium salt. Specific examples thereof include the compounds described in paragraphs "0034" to "0038" of JP2007-276454A.

As the betaines, compounds in which a nitrogen atom is substituted with a hydrocarbon substituent having 1 to 5 carbon atoms are preferable. Specifically, examples thereof include trimethylammonium acetate, dimethylpropylammonium acetate, 3-hydroxy-4-trimethylammoniobutyrate, 4-(1-pyridinio)butyrate, 1-hydroxyethyl-1-imidazolioacetate, trimethylammonium methanesulfonate, dimethylpropylammonium methanesulfonate, 3-trimethylammonio-1-propanesulfonate, 3-(1-pyridinio)-1-propanesulfonate, and the like.

The low-molecular-weight hydrophilic compound substantially does not have a surface activation action because a hydrophobic portion in this compound has a small structure. Therefore, this compound prevents dampening water from permeating the exposed portion of the image-recording layer (image area) and deteriorating hydrophobicity or film hardness of the image area. Accordingly, the image-recording layer can maintain excellent ink receiving properties and printing durability.

The content of the low-molecular-weight hydrophilic compound with respect to the total mass of the image-recording layer is preferably 0.5% by mass to 20% by mass, more preferably 1% by mass to 15% by mass, and even more preferably 2% by mass to 10% by mass. In a case where the content is within this range, excellent on-press developability and printing durability can be obtained.

One kind of low-molecular-weight hydrophilic compound may be used alone, or two or more kinds of low-molecular-weight hydrophilic compounds may be used by being mixed together.

-Fluorine-containing copolymer-

The image-recording layer in the present disclosure preferably contains a fluorine-containing copolymer, and more preferably contains a fluorine-containing copolymer having a constitutional unit formed of a fluorine-containing monomer. Among fluorine-containing copolymers, a fluoroaliphatic group-containing copolymer is preferable.

In a case where the fluorine-containing copolymer (preferably a fluoroaliphatic group-containing copolymer) is used, it is possible to inhibit surface abnormalities resulting from foaming during the formation of the image-recording layer and to improve the condition of the coating surface, and the formed image-recording layer has higher ink receptivity.

In addition, the image-recording layer containing the fluorine-containing copolymer (preferably a fluoroaliphatic group-containing copolymer) has high gradation and is highly sensitive, for example, to laser light. Therefore, the obtained lithographic printing plate exhibits excellent fogging properties by scattered light, reflected light, and the like and has excellent printing durability.

The fluoroaliphatic group-containing copolymer preferably has a constitutional unit formed of a fluoroaliphatic group-containing monomer. Particularly, the fluoroaliphatic group-containing copolymer preferably has a constitutional unit formed of a compound represented by any of Formula (F1) or Formula (F2).

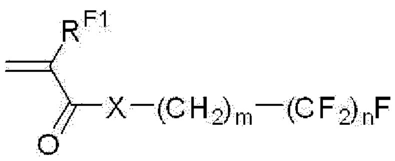

(F1)

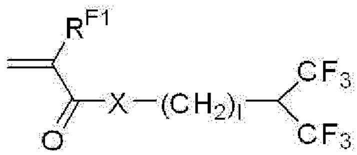

(F2)

In Formula (F1) and Formula (F2), $R^{F1}$ each independently represents a hydrogen atom or a methyl group, X each independently represents an oxygen atom, a sulfur atom, or $-N(R^{F2})-$, m represents an integer of 1 to 6, n represents an integer of 1 to 10, l represents an integer of 0 to 10, and $R^{F2}$ represents a hydrogen atom or an alkyl group having 1 to 4

carbon atoms.

The alkyl group having 1 to 4 carbon atoms represented by $R^{F2}$ in Formula (F1) and Formula (F2) is preferably a methyl group, an ethyl group, a n-propyl group, or a n-butyl group, and more preferably a hydrogen atom or a methyl group.

X in Formula (F1) and Formula (F2) is preferably an oxygen atom.
m in Formula (F1) is preferably 1 or 2, and more preferably 2.
n in Formula (F1) is preferably 2, 4, 6, 8, or 10, and more preferably 4 or 6.
l in Formula (F1) is preferably 0.

Specific examples of the compound represented by any of Formula (F1) or Formula (F2) will be shown below, but the compound represented by any of Formula (F1) or Formula (F2) is not limited thereto.

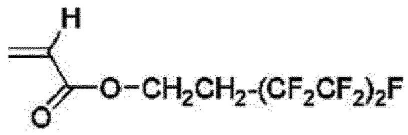
F-1

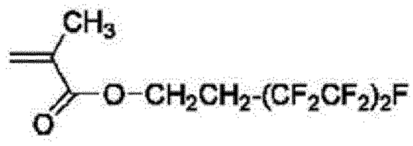
F-2

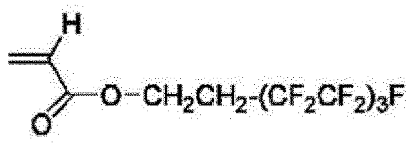
F-3

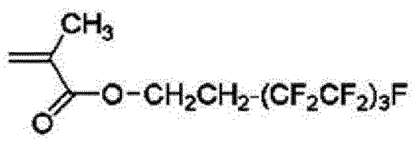
F-4

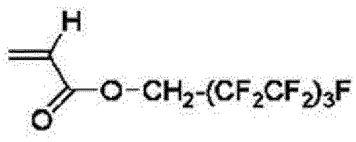
F-5

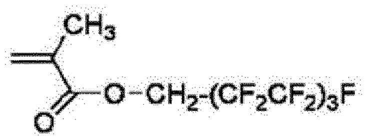
F-6

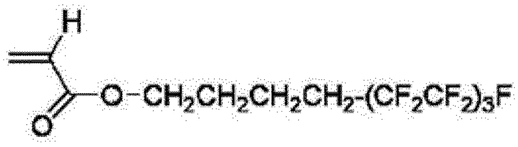
F-7

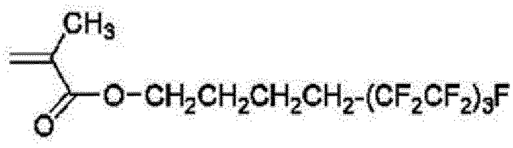

F-8

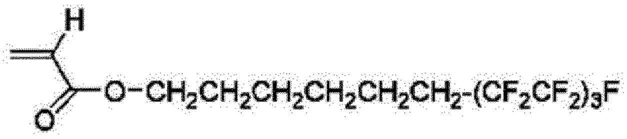

F-9

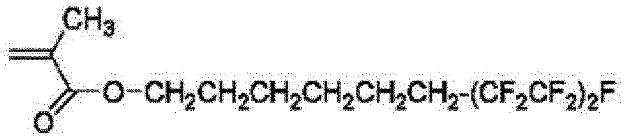

F-10

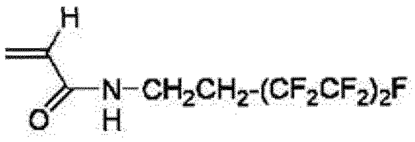

F-11

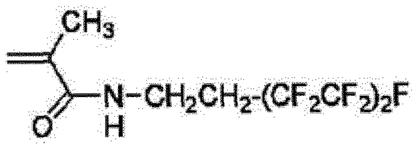

F-12

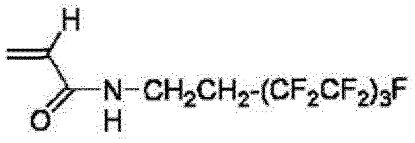

F-13

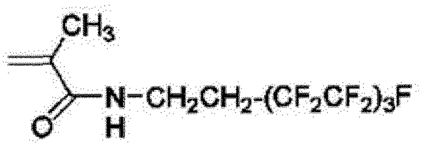

F-14

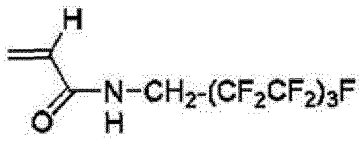

F-15

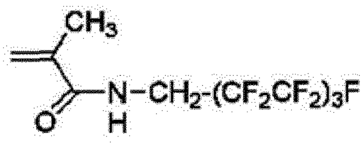

F-16

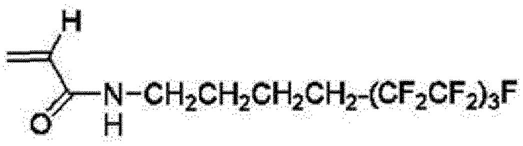

F-17

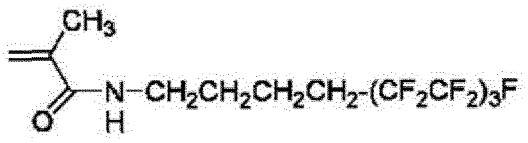

F-18

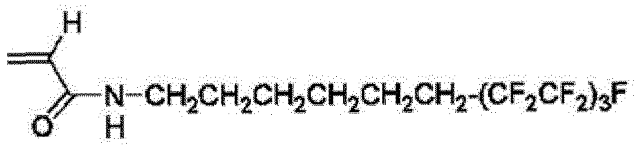

F-19

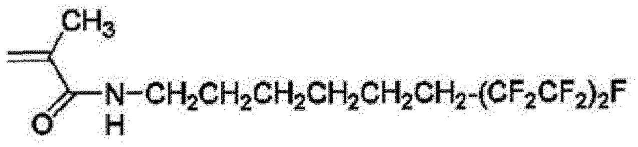

F-20

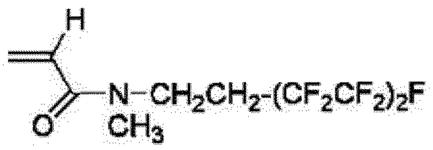

F-21

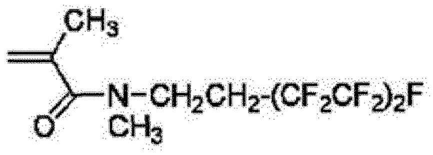

F-22

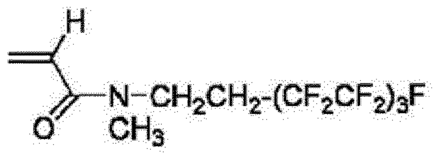

F-23

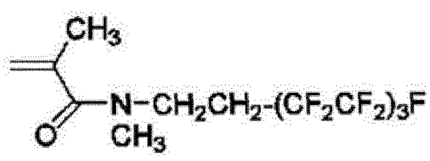

F-24

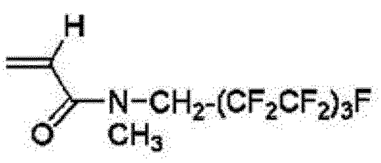

F-25

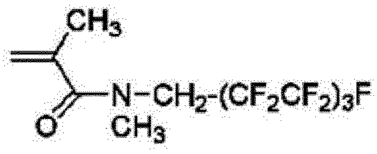

F-26

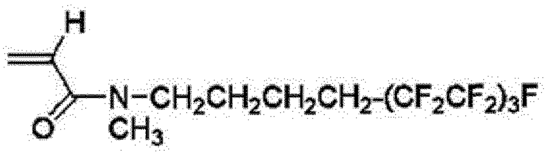

F-27

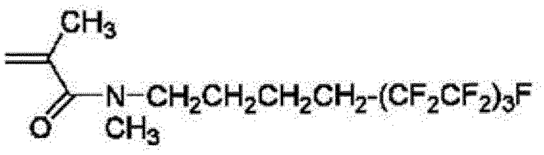

F-28

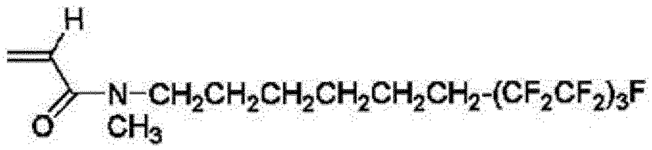

F-29

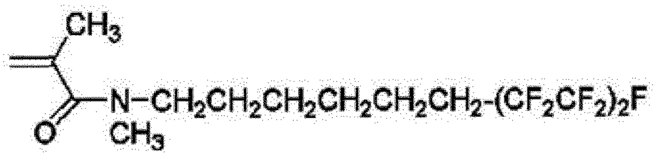

F-30

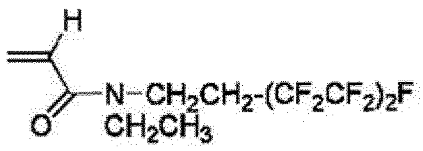

F-31

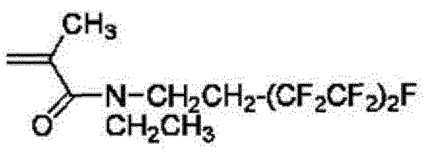

F-32

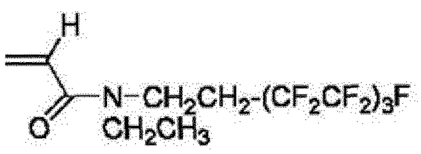

F-33

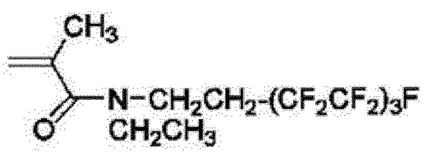

F-34

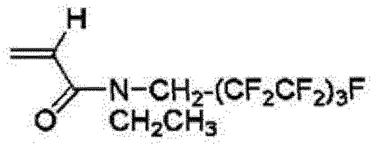

F-35

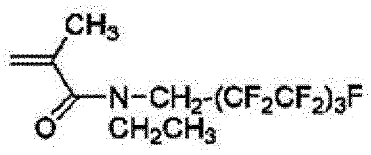

F-36

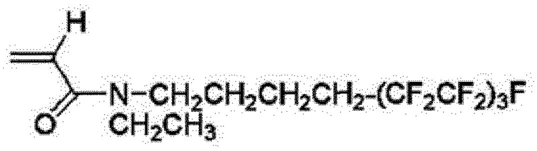

F37

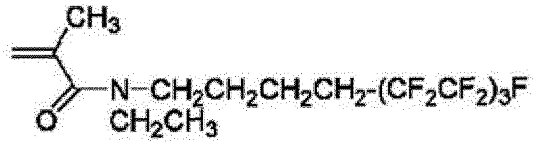

F38

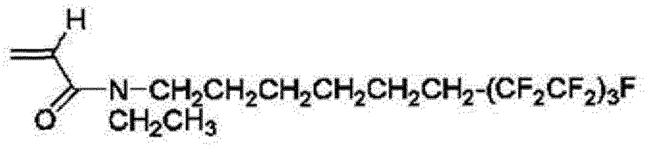

F-39

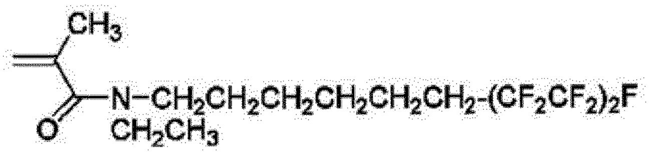

F-40

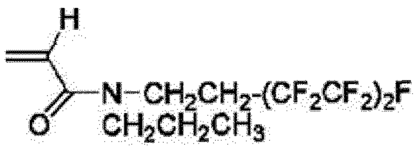

F-41

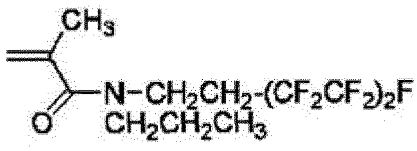

F-42

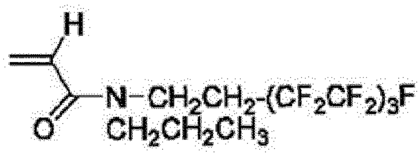

F-43

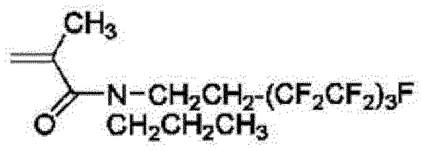

F-44

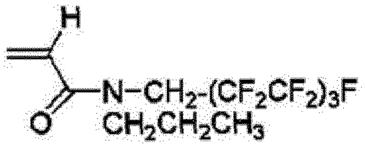

F-45

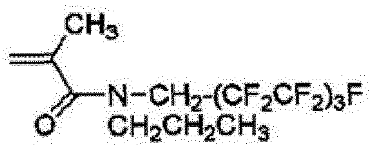

F-46

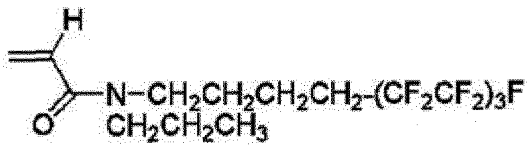

F-47

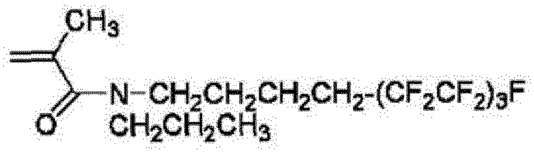

F-48

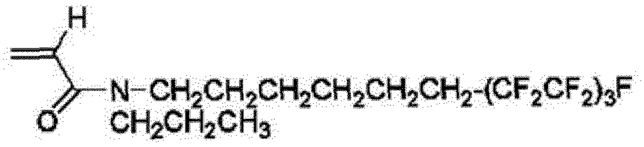

F-49

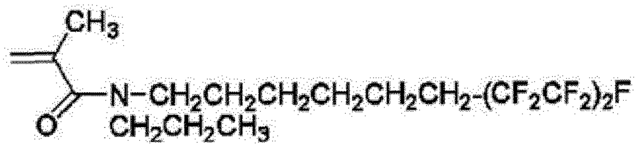

F-50

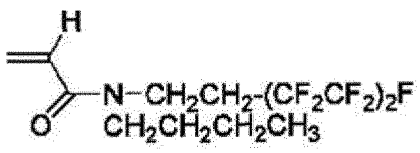

F-51

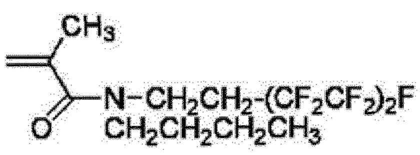

F-52

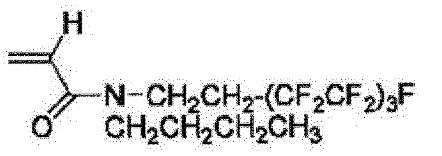

F-53

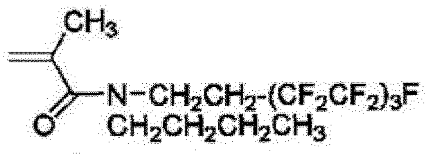

F-54

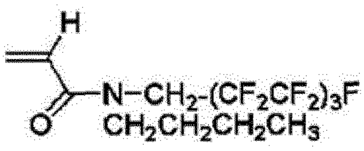

F-55

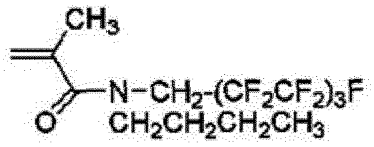

F-56

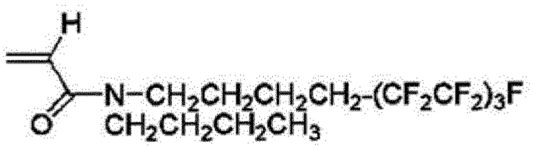

F-57

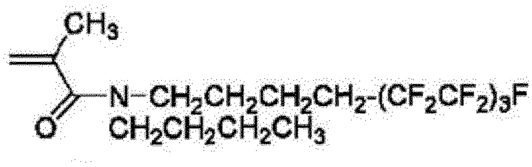

F-58

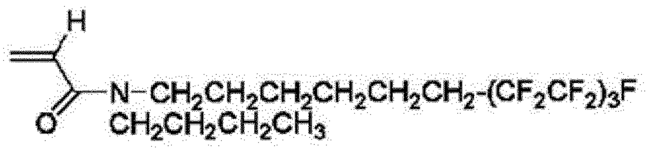

F-59

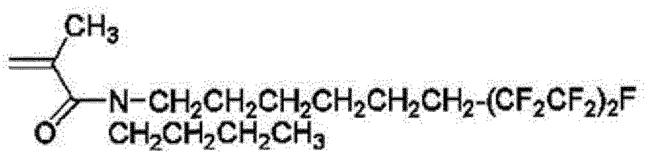

F-60

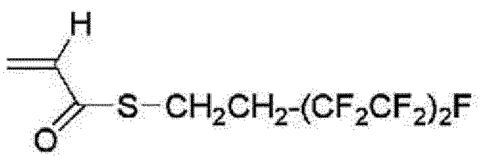

F-61

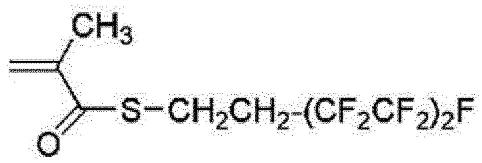

F-62

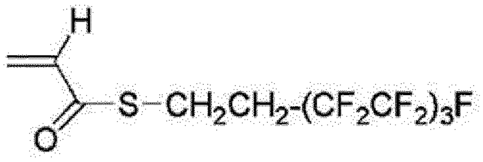

F-63

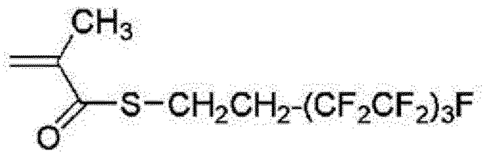

F-64

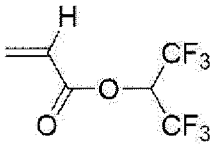

F-65

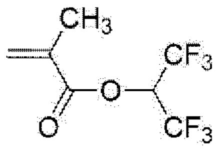

F-66

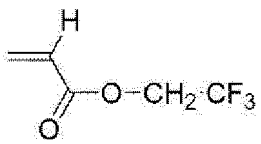

F-67

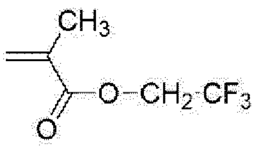

F-68

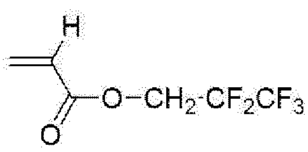

F-69

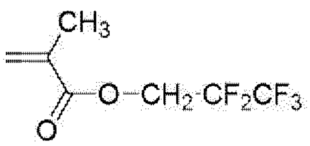

F-70

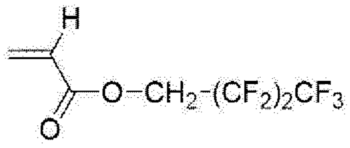
F-71

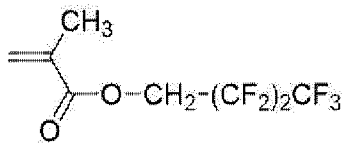
F-72

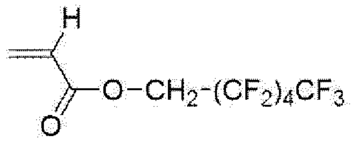
F-73

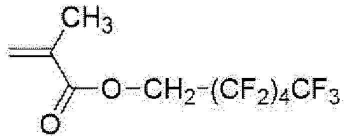
F-74

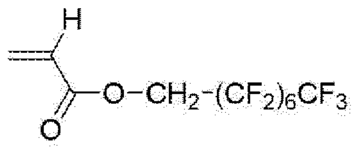
F-75

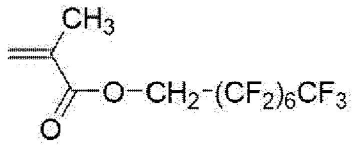
F-76

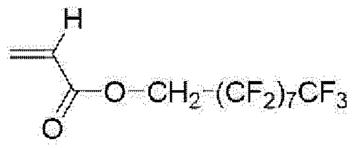
F-77

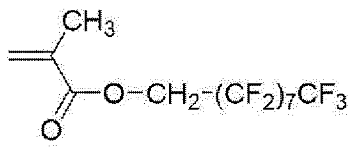
F-78

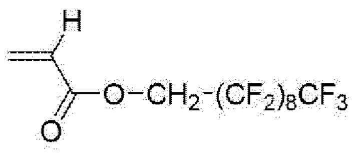
F-79

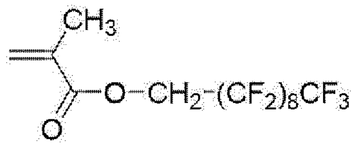

F-80

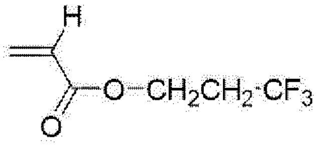

F-81

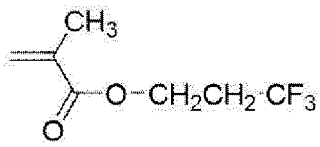

F-82

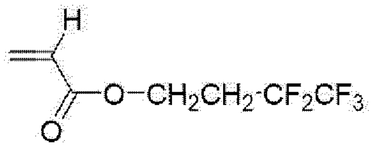

F-83

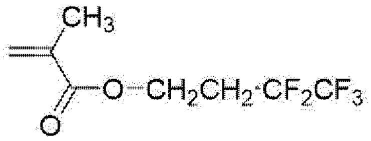

F-84

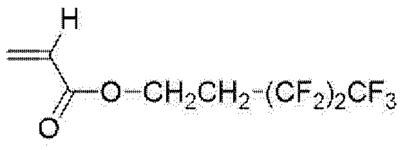

F-85

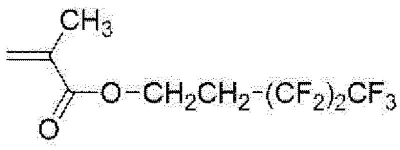

F-86

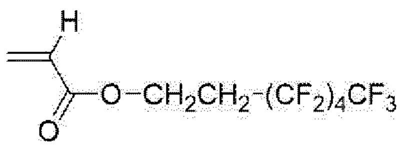

F-87

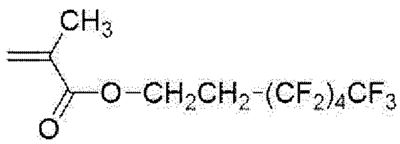

F-88

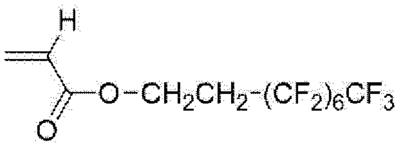

F-89

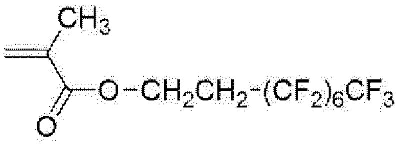

F-90

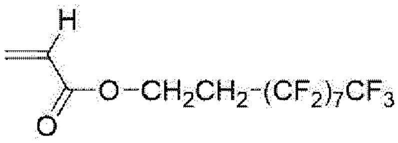

F-91

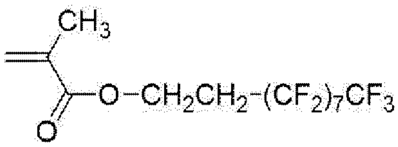

F-92

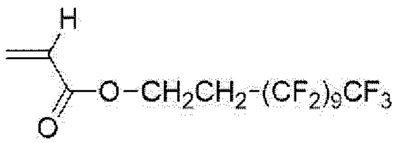

F-93

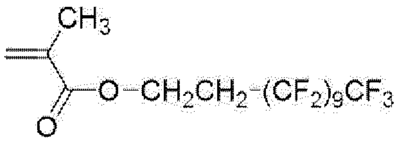

F-94

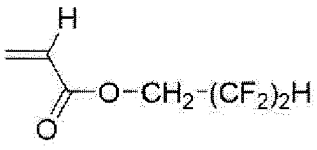

F-95

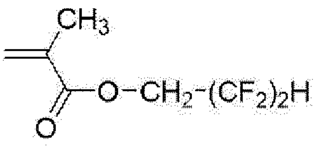

F-96

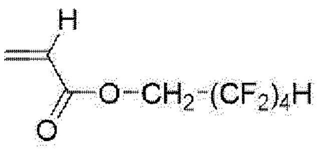

F-97

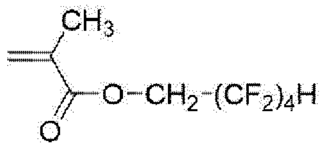

F-98

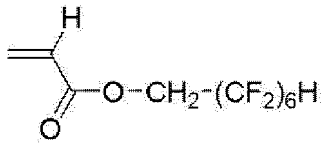

F-99

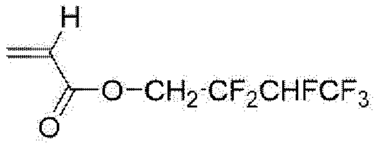

F-100

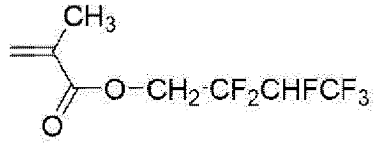

F-101

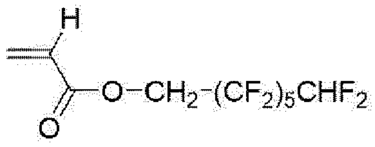

F-102

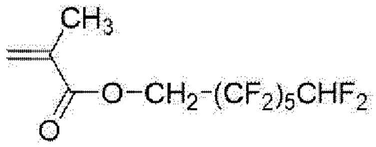

F-103

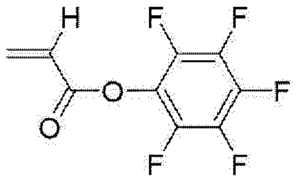

F-104

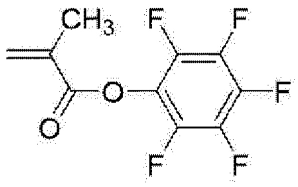

F-105

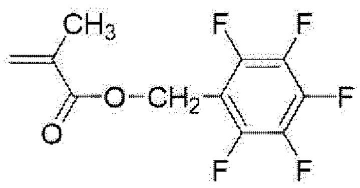

F-106

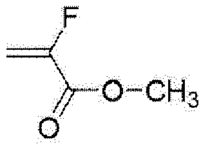

F-107

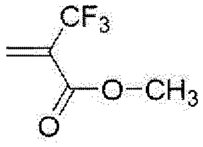

F-108

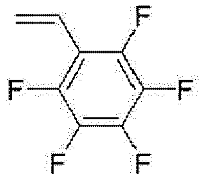

F-109

It is preferable that the fluorine-containing copolymer further has a constitutional unit formed of at least one kind of compound selected from the group consisting of poly(oxyalkylene) acrylate and a poly(oxyalkylene) methacrylate, in addition to the constitutional unit formed of a fluorine-containing monomer.

The fluoroaliphatic group-containing copolymer preferably further has a constitutional unit formed of at least one kind of compound selected from the group consisting of poly(oxyalkylene) acrylate and a poly(oxyalkylene) methacrylate, in addition to the constitutional unit formed of a compound represented by any of Formula (F1) or Formula (F2).

The polyoxyalkylene group in the poly(oxyalkylene) acrylate and poly(oxyalkylene) methacrylate can be represented by $-(OR^{F3})_x-$. $R^{F3}$ represents an alkyl group, and x represents an integer of 2 or more. $R^{F3}$ is preferably a linear or branched alkylene group having 2 to 4 carbon atoms. As the linear or branched alkylene group having 2 to 4 carbon atoms, $-CH_2CH_2-$, $-CH_2CH_2CH_2-$, $-CH(CH_3)CH_2-$, or $-CH(CH_3)CH(CH_3)-$ is preferable. x is preferably an integer of 2 to 100.

In the polyoxyalkylene groups, x pieces of "$OR^{F3}$" may be the same as or different from each other. That is, the polyoxyalkylene group may be composed of two or more kinds of "$OR^{F3}$" that are regularly or irregularly bonded to each other. For example, the polyoxyalkylene group may be composed of a linear or branched oxypropylene unit and an oxyethylene unit that are regularly or irregularly bonded to each other. More specifically, the polyoxyalkylene group may be composed of a block of a linear or branched oxypropylene unit and a block of an oxyethylene unit that are bonded to each other.

The polyoxyalkylene group may have one or more linking groups (for example, -CONH-Ph-NHCO-, -S-, and the like, in which Ph represents a phenylene group).

The molecular weight of the polyoxyalkylene group is preferably 250 to 3,000.

As the poly(oxyalkylene) acrylate and the poly(oxyalkylene) methacrylate described above, commercially available products or synthetic products may be used.

The poly(oxyalkylene) acrylate and the poly(oxyalkylene) methacrylate can be synthesized, for example, by reacting a hydroxypoly(oxyalkylene) compound with acrylic acid, methacrylic acid, acryloyl chloride, methacryloyl chloride, acrylic acid anhydride, or the like by known methods.

As the aforementioned hydroxypoly(oxyalkylene) compound, commercially available products may be used. Examples thereof include ADEKA (registered trademark) PLURONIC manufactured by ADEKA Corporation, ADEKA polyether manufactured by ADEKA Corporation, Carbowax (registered trademark) manufactured by Union Carbide Corporation, Triton manufactured by The Dow Chemical Company., PEG manufactured by DKS Co. Ltd., and the like.

As the poly(oxyalkylene) acrylate and the poly(oxyalkylene) methacrylate, poly(oxyalkylene) diacrylate or the like synthesized by known methods may also be used.

-Oil sensitizing agent-

In order to improve receptivity, the image-recording layer may contain an oil sensitizing agent such as a phosphonium compound, a nitrogen-containing low-molecular-weight compound, or an ammonium group-containing polymer. Particularly, in a case where an inorganic lamellar compound is incorporated into a protective layer, these compounds function as a surface coating agent for the inorganic lamellar compound and can inhibit the receptivity deterioration caused in the middle of printing by the inorganic lamellar compound.

As the oil sensitizing agent, it is preferable to use a phosphonium compound, a nitrogen-containing low-molecular-weight compound, and an ammonium group-containing polymer in combination, and it is more preferable to use a phosphonium compound, quaternary ammonium salts, and an ammonium group-containing polymer in combination.

Examples of the phosphonium compound include the phosphonium compounds described in JP2006-297907A and JP2007-050660A. Specific examples thereof include tetrabutylphosphonium iodide, butyltriphenylphosphonium bromide, tetraphenylphosphonium bromide, 1,4-bis(triphenylphosphonio)butane=di(hexafluorophosphate), 1,7-bis(triphenylphosphonio)heptane=sulfate, 1,9-bis(triphenylphosphonio)nonane=naphthalene-2,7-disulfonate, and the like.

Examples of the nitrogen-containing low-molecular-weight compound include amine salts and quaternary ammonium salts. In addition, examples thereof also include imidazolinium salts, benzimidazolinium salts, pyridinium salts, and quinolinium salts. Among these, quaternary ammonium salts and pyridinium salts are preferable. Specific examples thereof include tetramethylammonium=hexafluorophosphate, tetrabutylammonium=hexafluorophosphate, dodecyltrimethylammonium=p-toluene sulfonate, benzyltriethylammonium=hexafluorophosphate, benzyldimethyloctylammonium=hexafluorophosphate, benzyldimethyldodecylammonium=hexafluorophosphate, compounds described in paragraphs "0021" to "0037" of JP2008-284858A and paragraphs "0030" to "0057" of JP2009-090645A, and the like.

The ammonium group-containing polymer may have an ammonium group in the structure. As such a polymer, a polymer is preferable in which the content of (meth)acrylate having an ammonium group in a side chain as a copolymerization component is 5 mol% to 80 mol%. Specific examples thereof include the polymers described in paragraphs "0089" to "0105" of JP2009-208458A.

The reduced specific viscosity (unit: ml/g) of an ammonium group-containing polymer determined according to the measurement method described in JP2009-208458A is preferably in a range of 5 to 120, more preferably in a range of 10 to 110, and particularly preferably in a range of 15 to 100. In a case where the reduced specific viscosity is converted into a weight-average molecular weight (Mw), the weight-average molecular weight is preferably 10,000 to 1,500,000, more preferably 17,000 to 140,000, and particularly preferably 20,000 to 130,000.

Specific examples of the ammonium group-containing polymer will be shown below.

(1) 2-(Trimethylammonio)ethylmethacrylate=p-toluenesulfonate/3,6-dioxaheptylmethacrylate copolymer (molar ratio: 10/90, Mw: 45,000)

(2) 2-(Trimethylammonio)ethylmethacrylate=hexafluorophosphate/3,6-dioxaheptylmethacrylate copolymer (molar ratio: 20/80, Mw: 60,000)

(3) 2-(Ethyldimethylammonio)ethylmethacrylate=p-toluenesulfonate/hexylmethacrylate copolymer (molar ratio: 30/70, Mw: 45,000)

(4) 2-(Trimethylammonio)ethylmethacrylate=hexafluorophosphate/2-ethylhexylmethacrylate copolymer (molar ratio: 20/80, Mw: 60,000)

(5) 2-(Trimethylammonio)ethylmethacrylate=methylsulfate/hexylmethacrylate copolymer (molar ratio: 40/60, Mw: 70,000)

(6) 2-(Butyldimethylammonio)ethylmethacrylate=hexafluorophosphate/3,6-dioxaheptylmethacryl ate copolymer (molar ratio: 25/75, Mw: 65,000)

(7) 2-(Butyldimethylammonio)ethylacrylate=hexafluorophosphate/3,6-dioxaheptylmethacrylate copolymer (molar ratio: 20/80, Mw: 65,000)

(8) 2-(Butyldimethylammonio)ethylmethacrylate=13-ethyl-5,8,11-trioxa-1-heptadecanesulfonate/ 3,6-dioxaheptylmethacrylate copolymer (molar ratio: 20/80, Mw: 75,000)

(9) 2-(Butyldimethylammonio)ethylmethacrylate=hexafluorophosphate/3,6-dioxaheptylmethacryl ate/2-hydroxy-3-methacryloyloxypropylmethacrylate copolymer (molar ratio: 15/80/5, Mw: 65,000)

The content of the oil sensitizing agent with respect to the total mass of the image-recording layer is preferably 0.01% by mass to 30.0% by mass, more preferably 0.1% by mass to 15.0% by mass, and even more preferably 1% by mass to 10% by mass.

-Other components-

As other components, a surfactant, a polymerization inhibitor, a higher fatty acid derivative, a plasticizer, inorganic particles, an inorganic lamellar compound, and the like can be incorporated into the image-recording layer. Specifically, the description in paragraphs "0114" to "0159" of JP2008-284817A can be referred to.

<<Dynamic friction coefficient>>

From the viewpoint of printing durability and suppressing scratches and contamination, a dynamic friction coefficient of a surface of the image-recording layer opposite to the support is preferably 0.6 or less.

In the lithographic printing plate precursor according to the present disclosure, the dynamic friction coefficient of the surface of the image-recording layer opposite to the support is a dynamic friction coefficient of the surface of the outermost layer of the lithographic printing plate precursor.

In the lithographic printing plate precursor according to the present disclosure, in a case where the image-recording layer is the outermost layer, the dynamic friction coefficient of the surface of the image-recording layer opposite to the support is a dynamic friction coefficient of the surface of the image-recording layer.

Furthermore, in a case where the lithographic printing plate precursor according to the present disclosure has a water-soluble overcoat layer, which will be described later, on the image-recording layer, the dynamic friction coefficient of the surface of the image-recording layer opposite to the support is a dynamic friction coefficient of a surface of the water-soluble overcoat layer.

From the viewpoint of printing durability and suppressing scratches and contamination, the dynamic friction coefficient of the surface of the outermost layer is preferably 0.55 or less, more preferably 0.50, even more preferably 0.45 or less, and particularly preferably 0.40 or less.

The lower limit of the dynamic friction coefficient is not particularly limited, but is preferably 0.005 or more and more preferably 0.01 or more.

In the present disclosure the dynamic friction coefficient is measured by the following method.

By using a surface property analyzer TRIBOGEAR TYPE: 18LFW (manufactured by Shinto Scientific Co., Ltd.) and a 0.1 mm sapphire needle, the surface of the outermost layer of the lithographic printing plate precursor is scanned under a load of 50 $g/m^2$ at a scanning speed of 20 mm/s, and the dynamic friction coefficient during scratching is calculated from the resistance during scanning.

-Compound having adsorbent group-

From the viewpoint of suppressing scratches and contamination, the image-recording layer preferably contains a compound having an adsorbent group. The compound having an adsorbent group may be incorporated into an undercoat layer which will be described later.

The compound having an adsorbent group may correspond to a hydrophilic compound which will be described later.

Furthermore, from the viewpoint of suppressing scratches and contamination, the surface of the aluminum support preferably has the compound having an adsorbent group.

Examples of the adsorbent group include a carboxy group, a sulfo group, a phosphoric acid group, and an amino group. Among these, for example, a carboxy group is suitable.

Examples of the compound having a carboxy group include salts of organic acids such as citric acid, maleic acid, fumaric acid, succinic acid, adipic acid, glutaric acid, ascorbic acid, malic acid, tartaric acid, propionic acid, lactic acid, acetic acid, glycolic acid, and gluconic acid. Among these, for example, sodium gluconate is suitable.

The molecular weight of the compound having an adsorbent group is preferably 500 or less, more preferably 300 or less, and even more preferably 50 or more and 300 or less.

The content of the compound having an adsorbent group with respect to the total mass of the image-recording layer is preferably 2% by mass to 40% by mass, and more preferably 5% by mass to 35% by mass.

The content of the compound having an adsorbent group with respect to the total mass of the undercoat layer is preferably 5% by mass to 30% by mass, and more preferably 10% by mass to 25% by mass.

The image-recording layer may contain only one kind of compound having an adsorbent group, or two or more kinds of compounds having an adsorbent group in combination.

**In** a case where the surface of the aluminum support has a compound having an adsorbent group, the compound having an adsorbent group can be introduced into the surface of the aluminum support by using a known method. Examples thereof include a method of coating the aluminum support with a coating solution for an undercoat layer adsorbent group containing a compound having an adsorbent group.

-Formation of image-recording layer-

The image-recording layer in the lithographic printing plate precursor according to the present disclosure can be formed, for example, by preparing a coating solution by dispersing or dissolving the necessary components described above in a known solvent, coating a support with the coating solution by a known method such as bar coating, and drying the coating solution, as described in paragraphs "0142" and "0143" of JP2008-195018A.

As the solvent, known solvents can be used. Specific examples thereof include water, acetone, methyl ethyl ketone (2-butanone), cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 1-methoxy-2-propanol, 3-methoxy-1-propanol, methoxy methoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, $\gamma$-butyrolactone, methyl lactate, ethyl lactate, and the like. One kind of solvent may be used alone, or two or more kinds of the solvents may be used in combination. The concentration of solid contents in the coating solution is preferably about 1% to 50% by mass.

The coating amount (solid content) of the image-recording layer after coating and drying varies with uses. However, from the viewpoint of obtaining excellent sensitivity and excellent film characteristics of the image-recording layer, the coating amount is preferably 0.3 $g/m^2$ to 3.0 $g/m^2$.

<Aluminum support>

In the aluminum support of the lithographic printing plate precursor according to the present disclosure (hereinafter, also simply called "support" in some cases), a water contact angle on a surface of the aluminum support on the image-recording layer side that is determined by an airborne water droplet method is 110° or less.

In the present disclosure, the water contact angle on a surface of the aluminum support on the image-recording layer side that is determined by an airborne water droplet method is measured by the following method.

The lithographic printing plate precursor is immersed in a solvent capable of removing the image-recording layer, and the image-recording layer is scraped off with at least one of sponge or cotton or dissolved in a solvent, so that the surface of the aluminum support is exposed.

The water contact angle on a surface of the exposed aluminum support on the image-recording layer side is measured using a measurement device, a fully automatic contact angle meter (for example, DM-501 manufactured by Kyowa Interface Science Co., Ltd.), as a water droplet contact angle on the surface at 25°C (after 0.2 seconds).

From the viewpoint of suppressing scratches and contamination, the water contact angle on the surface of the aluminum support on the image-recording layer side that is determined by an airborne water droplet method is preferably 90° or less, more preferably 80° or less, even more preferably 50° or less, particularly preferably 30° or less, most preferably 20° or less, and most preferably 10° or less.

The water contact angle on the surface of the aluminum support on the image-recording layer side that is determined by an airborne water droplet method can be adjusted to 110° or less, for example, by a method such as a micropore widening treatment of the anodic oxide film that will be described later, a surface hydrophilizing treatment with alkali metal silicate, or the like.

From the viewpoint of suppressing scratches and contamination, the content of silicon atoms contained in the aluminum support is preferably 5.0 $g/m^2$ to 20.0 $g/m^2$, more preferably 5.0 $g/m^2$ to 15.0 $g/m^2$, and even more preferably 8.0 $g/m^2$ to 12.0 $g/m^2$.

The content of silicon atoms contained in the aluminum support can be appropriately adjusted by surface hydrophilizing treatment with alkali metal silicate or the like.

The content of silicon atoms contained in the aluminum support is determined by X-ray fluoroscopy (XRF).

As the aluminum support in the present disclosure, an aluminum plate is preferable which has been roughened using a known method and has undergone an anodic oxidation treatment. That is, the aluminum support in the present disclosure preferably has an aluminum plate and an aluminum anodic oxide film disposed on the aluminum plate.

One of the examples of preferred aspects of the aluminum support used in the present disclosure (the aluminum support according to this example is also called "support (1)") is as below.

That is, in a preferred aspect, the support (1) has an aluminum plate and an anodic oxide film of aluminum disposed on the aluminum plate, the anodic oxide film is at a position closer to a side of the image-recording layer than the aluminum plate and has micropores extending in a depth direction from the surface of the anodic oxide film on the side of the image-recording layer, the average diameter of the micropores within the surface of the anodic oxide film is more than 10 nm and 100 nm or less, and a value of brightness L* of the surface of the anodic oxide film on the side of the image-recording layer is 70 to 100 in the L*a*b* color space.

Fig. 1 is a schematic cross-sectional view of an embodiment of an aluminum support 12a.

The aluminum support 12a has a laminated structure in which an aluminum plate 18 and an anodic oxide film 20 of aluminum (hereinafter, also simply called "anodic oxide film 20a") are laminated in this order. The anodic oxide film 20a in the aluminum support 12a is positioned so that the anodic oxide film 20a is closer to the image-recording layer side than the aluminum plate 18. That is, it is preferable that the lithographic printing plate precursor according to the present disclosure have at least an anodic oxide film and an image-recording layer in this order on an aluminum plate.

-Anodic oxide film-

Hereinafter, preferred aspects of the anodic oxide film 20a will be described.

The anodic oxide film 20a is a film prepared on a surface of the aluminum plate 18 by an anodic oxidation treatment. This film has uniformly distributed ultrafine micropores 22a approximately perpendicular to the surface of the film. The micropores 22a extend from a surface of the anodic oxide film 20a on the image-recording layer side (a surface of the anodic oxide film 20a opposite to the aluminum plate 18) along the thickness direction (toward the aluminum plate 18).

Within the surface of the anodic oxide film, the average diameter (average opening diameter) of the micropores 22a in the anodic oxide film 20a is preferably more than 10 nm and 100 nm or less. Particularly, from the viewpoint of balance between printing durability, antifouling properties, and image visibility, the average diameter of the micropores 22a is more preferably 12.5 nm to 60 nm, even more preferably 15 nm to 50 nm, and particularly preferably 20 nm to 40 nm. The internal diameter of the pores may be larger or smaller than the pore diameter within the surface layer.

In a case where the average diameter is more than 10 nm, printing durability and image visibility are further improved. Furthermore, in a case where the average diameter is 100 nm or less, printing durability is further improved.

The average diameter of the micropores 22a is determined by observing the surface of the anodic oxide film 20a with a field emission scanning electron microscope (FE-SEM) at 150,000X magnification (N = 4), measuring the size (diameter) of 50 micropores existing in a range of $400 \times 600$ $nm^2$ in the obtained 4 images, and calculating the arithmetic mean thereof.

In a case where the shape of the micropores 22a is not circular, the equivalent circular diameter is used. "Equivalent circular diameter" is a diameter determined on an assumption that the opening portion is in the form of a circle having the same projected area as the projected area of the opening portion.

The depth of the micropores 22a is not particularly limited, but is preferably 10 nm to 3,000 nm, more preferably 50 nm to 2,000 nm, and even more preferably 300 nm to 1,600 nm.

The depth is a value obtained by taking a photograph (150,000X magnification) of a cross section of the anodic oxide film 20a, measuring the depths of 25 or more micropores 22a, and calculating the average thereof.

The shape of the micropores 22a is not particularly limited. In Fig. 1, the micropores 22a have a substantially straight tubular shape (substantially cylindrical shape). However, the micropores 22a may have a conical shape that tapers along the depth direction (thickness direction). The shape of the bottom portion of the micropores 22a is not particularly limited, and may be a curved (convex) or flat surface shape.

In the L*a*b* color space, the value of brightness L* of the surface of the aluminum support 12a on the image-recording layer side (surface of the anodic oxide film 20a on the image-recording layer side) is preferably 70 to 100. Especially, the value of brightness L* is preferably 75 to 100 and more preferably 75 to 90, because printing durability and image visibility are better balanced in this range.

The brightness L* is measured using a color difference meter Spectro Eye manufactured by X-Rite, Incorporated.

The range of the steepness a45 that is obtained by extracting components having a wavelength of 0.2 $\mu$m to 2 $\mu$m within the surface of the anodic oxide film 20a on the image-recording layer 16 side and represents an area ratio of a portion having a gradient of 45° or more is not particularly limited. In view of further improving antifouling properties and deinking properties, the steepness a45 is preferably 2% to 30%, more preferably 2% to 25%, even more preferably 5% to 20% or less, and particularly preferably 5% to 18%.

The steepness a45 is one of the factors representing the surface condition, and is a value obtained according to the following procedures (1) to (3).

(1) Measuring surface shape and obtaining three-dimensional data

First, the surface shape of the aluminum support 12a on the anodic oxide film 20a side is measured with an atomic force microscope (AFM), and three-dimensional data is obtained.

The measurement is performed under the following conditions, for example. Specifically, the aluminum support 12a is cut in a size of 1 cm $\times$ 1 cm, set on a horizontal sample stage of a piezo scanner, and a cantilever is caused to approach the sample surface. At a point in time when the cantilever reaches a region where atom force works, the sample is scanned in the XY direction, and the irregularity of the sample observed at that time is adopted as piezo displacement in the

Z direction. As the piezo scanner, a scanner that can scan 150 μm in the XY direction and 10 μm in the Z direction is used. As the cantilever, a cantilever having a resonance frequency of 120 kHz to 150 kHz and a spring constant of 12 N/m to 20 N/m (SI-DF20, manufactured by NANOPROBE) is used, and the measurement is performed in a Dynamic Force mode (DFM). The obtained three-dimensional data is subjected to least squares approximation so that the slight inclination of the sample is corrected, thereby obtaining a reference surface.

During the measurement, 512 × 512 points in a 25 μm × 25 μm region within the surface are measured. The resolution in the XY direction is 1.9 μm, the resolution in the Z direction is 1 nm, and the scanning speed is 60 μm/sec.

(2) Performing correction

For the calculation of the steepness a45, data is used which is obtained by correction as a process of selecting components having a wavelength of 0.2 μm to 2 μm from the three-dimensional data obtained in the above section (1). The correction makes it possible to remove noise that occurs when the probe touches the edge portion of a projection portion and thus bounces or when a portion of the probe other than the probe tip touches the wall surface of a deep depression portion in a case where the surface having deep irregularities, such as the aluminum support used in the lithographic printing plate precursor, is scanned with the AFM probe.

The correction is performed by subjecting the three-dimensional data obtained in the above section (1) to high-speed Fourier transform so as to obtain frequency distribution, then selecting components having a wavelength of 0.2 μm to 2 μm, and then performing an inverse Fourier transform.

(3) Calculating steepness a45

By using the three-dimensional data (f (x, y)) obtained by the correction in the above section (2), three adjacent points are extracted, and the angle formed between the reference surface and a minute triangle formed by the three points is calculated for all data, thereby obtaining a gradient distribution curve. Furthermore, the total area of the minute triangle is calculated and adopted as an actual area. From the gradient distribution curve, the steepness a45 (unit: %), which is the ratio of the area of the portion having a gradient of 45° or more to the actual area, is calculated.

In a case where $S_X$ represents an actual area obtained by an approximate three-point method from three-dimensional data obtained by measuring 512 × 512 points in a 25 μm × 25 μm region within the surface of the anodic oxide film 20a on the image-recording layer 16 side by using an atomic force microscope, and $S_0$ represents a geometrically measured area, and ΔS represents a specific surface area which is a value calculated by Equation (i), the range of ΔS is not particularly limited. However, ΔS is 15% or more in many cases. From the viewpoint of further improving antifouling properties, deinking properties, and image visibility, ΔS is preferably 20% or more, more preferably 20% to 40%, and even more preferably 25% to 35%.

$$\Delta S = (S_X - S0)/S0 \times 100\ (\%) \qquad \text{Equation (i)}$$

In measuring ΔS, first, three-dimensional data (f (x, y)) is obtained according to the same procedure as in the section (1) performed for calculating the steepness a45.

Then, by using the three-dimensional data (f (x, y)) obtained as above, three adjacent points are extracted, and the total area of the minute triangle formed by the three points is calculated and adopted as an actual area Sx. The surface area difference ΔS is calculated by Equation (i) from the obtained actual area Sx and the geometrically measured area S0.

For example, an aspect is also preferable in which the micropores in the support (1) are each composed of a large diameter portion that extends to a position at a depth of 10 nm to 1,000 nm from the surface of the anodic oxide film and a small diameter portion that is in communication with the bottom portion of the large diameter portion and extends to a position at a depth of 20 nm to 2,000 nm from a communication position, an average diameter of the large diameter portion within the surface of the anodic oxide film is 15 nm to 150 nm, and an average diameter of the small diameter portion at a communication position is 13 nm or less (hereinafter, the support according to this aspect will be also called "support (2)").

Fig. 2 is a schematic cross-sectional view of an embodiment of the aluminum support 12a that is different from what is shown in Fig. 1.

In Fig. 2, an aluminum support 12b includes an aluminum plate 18 and an anodic oxide film 20b having micropores 22b each composed of a large diameter portion 24 and a small diameter portion 26.

The micropores 22b in the anodic oxide film 20b are each composed of the large diameter portion 24 that extends to a position at a depth of 10 nm to 1,000 nm (depth D: see Fig. 2) from the surface of the anodic oxide film and the small diameter portion 26 that is in communication with the bottom portion of the large diameter portion 24 and further extends from the communication position to a position at a depth of 20 nm to 2,000 nm.

Hereinafter, the large diameter portion 24 and the small diameter portion 26 will be specifically described.

The average diameter of the large diameter portion 24 within the surface of the anodic oxide film 20b is the same as the average diameter of the micropores 22a in the aforementioned anodic oxide film 20a within the surface of the anodic oxide film, which is more than 10 nm and 100 nm or less. The suitable range thereof is also the same.
The method for measuring the average diameter of the large diameter portion 24 within the surface of the anodic oxide film 20b is the same as the method for measuring the average diameter of the micropores 22a in the anodic oxide film 20a within the surface of the anodic oxide film.
The bottom portion of the large diameter portion 24 is in a position at a depth of 10 nm to 1,000 nm (hereinafter, also called depth D) from the surface of the anodic oxide film. That is, the large diameter portion 24 is a pore portion extending to a position at a depth of 10 nm to 1,000 nm from the surface of the anodic oxide film in the depth direction (thickness direction). The depth is preferably 10 nm to 200 nm.
The depth is a value obtained by taking a photograph (150,000X magnification) of a cross section of the anodic oxide film 20b, measuring the depths of 25 or more large diameter portions 24, and calculating the average thereof.
The shape of the large diameter portion 24 is not particularly limited. Examples of the shape of the large diameter portion 24 include a substantially straight tubular shape (substantially cylindrical shape) and a conical shape that tapers along the depth direction (thickness direction). Among these, a substantially straight tubular shape is preferable.
As shown in Fig. 2, the small diameter portion 26 is a pore portion that is in communication with the bottom portion of the large diameter portion 24 and further extends from the communication position in the depth direction (thickness direction).
The average diameter of the small diameter portion 26 at the communication position is preferably 13 nm or less. Particularly, the average diameter is preferably 11 nm or less, and more preferably 10 nm or less. The lower limit thereof is not particularly limited, but is 5 nm or more in many cases.
The average diameter of the small diameter portion 26 is determined by observing the surface of the anodic oxide film 20a with FE-SEM at 150,000X magnification (N = 4), measuring the size (diameter) of the micropores (small diameter portion) existing in a range of 400 nm × 600 nm in the obtained 4 images, and calculating the arithmetic mean thereof. **In a** case where the large diameter portion is deep, if necessary, the upper portion of the anodic oxide film 20b (region where the large diameter portion is located) may be cut (for example, by using argon gas), then the surface of the anodic oxide film 20b may be observed with FE-SEM described above, and the average diameter of the small diameter portion may be determined.
In a case where the shape of the small diameter portion 26 is not circular, the equivalent circular diameter is used. "Equivalent circular diameter" is a diameter determined on an assumption that the opening portion is in the form of a circle having the same projected area as the projected area of the opening portion.
The bottom portion of the small diameter portion 26 is in a position 20 nm to 2,000 nm distant from the communication position with the large diameter portion 24 in the depth direction. In other words, the small diameter portion 26 is a pore portion that extends further from the communication position with the large diameter portion 24 in the depth direction (thickness direction), and the depth of the small diameter portion 26 is 20 nm to 2,000 nm. The depth is preferably 500 nm to 1,500 nm.
The depth is a value determined by taking a photograph (50,000X magnification) of a cross section of the anodic oxide film 20b, measuring the depths of 25 or more small diameter portions, and calculating the average thereof.
The shape of the small diameter portion 26 is not particularly limited. Examples of the shape of the small diameter portion 26 include a substantially straight tubular shape (substantially cylindrical shape) and a conical shape that tapers along the depth direction. Among these, a substantially straight tubular shape is preferable.

-Method for manufacturing aluminum support-

As a method for manufacturing the aluminum support used in the present disclosure, for example, a manufacturing method is preferable in which the following steps are sequentially performed.

·Roughening treatment step: step of performing roughening treatment on aluminum plate
·First anodic oxidation treatment step: step of subjecting aluminum plate having undergone roughening treatment to anodic oxidation
·Pore widening treatment step: step of bringing aluminum plate having anodic oxide film obtained by first anodic oxidation treatment step into contact with aqueous acid solution or aqueous alkali solution so that diameter of micropores in anodic oxide film increases

Hereinafter, the procedure of each step will be specifically described.

[Roughening treatment step]

The roughening treatment step is a step of performing a roughening treatment including an electrochemical roughening treatment on the surface of the aluminum plate. The roughening treatment step is preferably performed before the first anodic oxidation treatment step which will be described later. However, in a case where the surface of the aluminum plate already has a preferable shape, the roughening treatment step may not be performed.
As the roughening treatment, only an electrochemical roughening treatment may be performed, or an electrochemical roughening treatment and mechanical roughening treatment and/or a chemical roughening treatment may be performed in combination.
In a case where the mechanical roughening treatment and the electrochemical roughening treatment are combined, it is preferable to perform the electrochemical roughening treatment after the mechanical roughening treatment.
It is preferable to perform the electrochemical roughening treatment by using direct current or alternating current in an aqueous solution containing nitric acid or hydrochloric acid as a main component.
The method of the mechanical roughening treatment is not particularly limited. Examples thereof include the method described in JP1975-40047B (JP-S50-40047B).
Furthermore, the chemical roughening treatment is not particularly limited, and examples thereof include known methods.
After the mechanical roughening treatment, it is preferable to perform the following chemical etching treatment.
By the chemical etching treatment performed after the mechanical roughening treatment, the edge portion of surface irregularities of the aluminum plate smoothed, so that ink clotting that may occur during printing is prevented, the antifouling properties of the printing plate are improved, and unnecessary substances such as abrasive particles remaining on the surface are removed.
Examples of the chemical etching treatment include etching with an acid or etching with an alkali. One of the examples of particularly efficient etching methods is a chemical etching treatment using an aqueous alkali solution (hereinafter, also called "alkaline etching treatment").
The alkaline agent used in the aqueous alkali solution is not particularly limited. Examples thereof include caustic soda, caustic potash, sodium metasilicate, sodium carbonate, sodium aluminate, and sodium gluconate.
The aqueous alkali solution may contain aluminum ions.
The concentration of the alkaline agent in the aqueous alkali solution is preferably 0.01% by mass or more, and more preferably 3% by mass or more. Furthermore, the concentration of the alkaline agent is preferably 30% by mass or less.
In a case where the alkaline etching treatment is performed, in order to remove products generated by the alkaline etching treatment, it is preferable to perform the chemical etching treatment by using a low-temperature aqueous acidic solution (hereinafter, also called "desmutting treatment").
The acid used in the aqueous acidic solution is not particularly limited, and examples thereof include sulfuric acid, nitric acid, and hydrochloric acid. The temperature of the aqueous acidic solution is preferably 20°C to 80°C.
As the roughening treatment step, a method is preferable in which the treatments described in an aspect A or an aspect B are performed in the following order.

~Aspect A~

(2) Chemical etching treatment using aqueous alkali solution (first alkaline etching treatment)
(3) Chemical etching treatment using aqueous acidic solution (first desmutting treatment)
(4) Electrochemical roughening treatment using aqueous solution containing nitric acid as main component (first electrochemical roughening treatment)
(5) Chemical etching treatment using aqueous alkali solution (second alkaline etching treatment)
(6) Chemical etching treatment using aqueous acidic solution (second desmutting treatment)
(7) Electrochemical roughening treatment in aqueous solution containing hydrochloric acid as main component (second electrochemical roughening treatment)
(8) Chemical etching treatment using aqueous alkali solution (third alkaline etching treatment)
(9) Chemical etching treatment using aqueous acidic solution (third desmutting treatment)

~Aspect B~

(10) Chemical etching treatment using aqueous alkali solution (fourth alkaline etching treatment)
(11) Chemical etching treatment using aqueous acidic solution (fourth desmutting treatment)
(12) Electrochemical roughening treatment using aqueous solution containing hydrochloric acid as main component (third electrochemical roughening treatment)
(13) Chemical etching treatment using aqueous alkali solution (fifth alkaline etching treatment)
(14) Chemical etching treatment using aqueous acidic solution (fifth desmutting treatment)

If necessary, (1) mechanical roughening treatment may be performed before the treatment (2) of the aspect A or before the treatment (10) of the aspect B.

The amount of the aluminum plate dissolved by the first alkaline etching treatment and the fourth alkaline etching treatment is preferably 0.5 $g/m^2$ to 30 $g/m^2$, and more preferably 1.0 $g/m^2$ to 20 $g/m^2$.

Examples of the aqueous solution containing nitric acid as a main component used in the first electrochemical roughening treatment of the aspect A include aqueous solutions used in an electrochemical roughening treatment using direct current or alternating current. Examples thereof include an aqueous solution obtained by adding aluminum nitrate, sodium nitrate, ammonium nitrate, or the like to a 1 to 100 g/L aqueous nitric acid solution.

Examples of the aqueous solution containing hydrochloric acid as a main component used in the second electrochemical roughening treatment of the aspect A and in the third electrochemical roughening treatment of the aspect B include aqueous solutions used in the general electrochemical roughening treatment using direct current or alternating current. Examples thereof include an aqueous solution obtained by adding 0 g/L to 30 g/L of sulfuric acid to a 1 g/L to 100 g/L aqueous hydrochloric acid solution. Nitrate ions such as aluminum nitrate, sodium nitrate, and ammonium nitrate; hydrochloric acid ions such as aluminum chloride, sodium chloride, and ammonium chloride may be further added to this solution.

As the waveform of an alternating current power source for the electrochemical roughening treatment, a sine wave, a square wave, a trapezoidal wave, a triangular wave, and the like can be used. The frequency is preferably 0.1 Hz to 250 Hz.

Fig. 3 is an example of a waveform graph of alternating current used for an electrochemical roughening treatment.

In Fig. 3, ta represents an anodic reaction time, tc represents a cathodic reaction time, tp represents the time taken for current to reach a peak from 0, Ia represents the peak current on the anodic cycle side, Ic represents the peak current on the cathodic cycle side, AA represents current for an anodic reaction of an aluminum plate, and CA represents current for a cathodic reaction of an aluminum plate. For a trapezoidal wave, the time tp taken for current to reach a peak from 0 is preferably 1 ms to 10 ms. Regarding the conditions of one cycle of alternating current used for the electrochemical roughening, a ratio tc/ta of the cathodic reaction time tc to the anodic reaction time ta of the aluminum plate is preferably within a range of 1 to 20, a ratio Qc/Qa of an electricity quantity Qc during the cathodic reaction to an electricity quantity Qa during the anodic reaction of the aluminum plate is preferably within a range of 0.3 to 20, and the anodic reaction time ta is preferably within a range of 5 ms to 1,000 ms. The peak current density of the trapezoidal wave is preferably 10 $A/dm^2$ to 200 $A/dm^2$ at both the anodic cycle side Ia and the cathodic cycle side Ic of the current. Ic/Ia is preferably 0.3 to 20. At a point time when the electrochemical roughening has ended, the total quantity of electricity that participates in the anodic reaction of the aluminum plate is preferably 25 $C/dm^2$ to 1,000 $C/dm^2$.

The electrochemical roughening using alternating current can be performed using the device shown in Fig. 4.

Fig. 4 is a lateral view showing an example of a radial cell in an electrochemical roughening treatment using alternating current.

In Fig. 4, 50 represents a main electrolytic cell, 51 represents an alternating current power source, 52 represents a radial drum roller, 53a and 53b represent main poles, 54 represents an electrolytic solution supply port, 55 represents an electrolytic solution, 56 represents a slit, 57 represents an electrolytic solution path, 58 represents an auxiliary anode, 60 represents an auxiliary anode tank, and W represents an aluminum plate. In Fig. 4, the arrow A1 represents a supply direction of an electrolytic solution, and the arrow A2 represents a discharge direction of the electrolytic solution. In a case where two or more electrolytic cells are used, the electrolysis conditions may be the same as or different from each other.

The aluminum plate W is wound around the radial drum roller 52 immersed and disposed in the main electrolytic cell 50. While being transported, the aluminum plate W is electrolyzed by the main poles 53a and 53b connected to the alternating current power source 51. From the electrolytic solution supply port 54, the electrolytic solution 55 is supplied to the electrolytic solution path 57 between the radial drum roller 52 and the main poles 53a and 53b through the slit 56. The aluminum plate W treated in the main electrolytic cell 50 is then electrolyzed in the auxiliary anode tank 60. **In** the auxiliary anode tank 60, the auxiliary anode 58 is disposed to face the aluminum plate W. The electrolytic solution 55 is supplied to flow in the space between the auxiliary anode 58 and the aluminum plate W.

In view of easily manufacturing a predetermined printing plate precursor, the amount of the aluminum plate dissolved by the second alkaline etching treatment is preferably 1.0 $g/m^2$ or more, and more preferably 2.0 $g/m^2$ to 10 $g/m^2$.

In view of easily manufacturing a predetermined printing plate precursor, the amount of the aluminum plate

dissolved by the third alkaline etching treatment and the fourth alkaline etching treatment is preferably 0.01 $g/m^2$ to 0.8 $g/m^2$, and more preferably 0.05 $g/m^2$ to 0.3 $g/m^2$.

In the chemical etching treatment (first to fifth desmutting treatments) using an aqueous acidic solution, an aqueous acidic solution containing phosphoric acid, nitric acid, sulfuric acid, chromic acid, hydrochloric acid, or a mixed acid consisting of two or more of these acids is suitably used.

The concentration of the acid in the aqueous acidic solution is preferably 0.5% by mass to 60% by mass.

[Anodic oxidation treatment step]

The procedure of the anodic oxidation treatment step is not particularly limited as long as the aforementioned micropores can be obtained. Examples thereof include known methods.

In the first anodic oxidation treatment step, an aqueous solution of sulfuric acid, oxalic acid, phosphoric acid, or the like can be used as an electrolytic cell. For example, the concentration of sulfuric acid is 100 g/L to 300 g/L.

The conditions of the anodic oxidation treatment are appropriately set depending on the electrolytic solution used. For example, the conditions of the anodic oxidation treatment can be set such that, the liquid temperature is 5°C to 70°C (preferably 10°C to 60°C), the current density is 0.5 $A/dm^2$ to 60 $A/dm^2$ (preferably 5 $A/dm^2$ to 60 $A/dm^2$), the voltage is 1 V to 100 V (preferably 5 V to 50 V), the electrolysis time is 1 second to 100 seconds (preferably 5 seconds to 60 seconds), and the film amount is 0.1 $g/m^2$ to 5 $g/m^2$ (preferably 0.2 $g/m^2$ to 3 $g/m^2$).

[Pore widening treatment]

The pore widening treatment is a treatment of enlarging the diameter of micropores (pore diameter) present in the anodic oxide film formed by the aforementioned first anodic oxidation treatment step (pore diameter enlarging treatment).

The pore widening treatment can be carried out by bringing the aluminum plate obtained by the anodic oxidation treatment step into contact with an aqueous acid solution or an aqueous alkali solution. The contact method is not particularly limited, and examples thereof include a dipping method and a spraying method.

<Undercoat layer>

The lithographic printing plate precursor according to the present disclosure preferably has an undercoat layer (called interlayer in some cases) between the image-recording layer and the support. The undercoat layer enhances the adhesiveness between the support and the image-recording layer in an exposed portion, and enables the image-recording layer to be easily peeled from the support in a non-exposed portion. Therefore, the undercoat layer contributes to the improvement of developability without deteriorating printing durability. Furthermore, in the case of exposure to infrared laser, the undercoat layer functions as a heat insulating layer and thus brings about an effect of preventing sensitivity reduction resulting from the diffusion of heat generated by exposure to the support.

Examples of compounds that are used in the undercoat layer include polymers having adsorbent group that can be adsorbed onto the surface of the support and hydrophilic groups. In order to improve adhesiveness to the image-recording layer, polymers having an adsorbent group and hydrophilic groups plus crosslinking groups are preferable. The compounds that are used in the undercoat layer may be low-molecular-weight compounds or polymers. If necessary, as the compounds that are used in the undercoat layer, two or more kinds of compounds may be used as a mixture.

In a case where the compound used in the undercoat layer is a polymer, a copolymer of a monomer having an adsorbent group, a monomer having a hydrophilic group, and a monomer having a crosslinking group is preferable.

As the adsorbent group that can be adsorbed onto the surface of the support, a phenolic hydroxyl group, a carboxy group, $-PO_3H_2$, $-OPO_3H_2$, $-CONHSO_2-$, $-SO_2NHSO_2-$, and $-COCH_2COCH_3$ are preferable. As the hydrophilic groups, a sulfo group or salts thereof and salts of a carboxy group are preferable. As the crosslinking groups, an acryloyl group, a methacryloyl group, an acrylamide group, a methacrylamide group, an allyl group, and the like are preferable.

The polymer may have a crosslinking group introduced by the formation of a salt of a polar substituent of the polymer and a compound that has a substituent having charge opposite to that of the polar substituent and an ethylenically unsaturated bond, or may be further copolymerized with monomers other than the monomers described above and preferably with hydrophilic monomers.

Specifically, for example, silane coupling agents having addition polymerizable ethylenic double bond reactive groups described in JP1998-282679A (JP-H10-282679A) and phosphorus compounds having ethylenic double bond reactive groups described in JP1990-304441A (JP-H02-304441A) are suitable. The low-molecular-weight compounds or polymer compounds having crosslinking groups (preferably ethylenically unsaturated bonding groups), functional groups that interact with the surface of the support, and hydrophilic groups described in JP2005-238816A, JP2005-125749A, JP2006-239867A, and JP2006-215263A are also preferably used.

For example, the high-molecular-weight polymers having adsorbent groups that can be adsorbed onto the

surface of the support, hydrophilic groups, and crosslinking groups described in JP2005-125749A and JP2006-188038A are more preferable.

The content of ethylenically unsaturated bonding group in the polymer used in the undercoat layer is preferably 0.1 mmol to 10.0 mmol per gram of the polymer, and more preferably 0.2 mmol to 5.5 mmol per gram of the polymer

The weight-average molecular weight (Mw) of the polymer used in the undercoat layer is preferably 5,000 or more, and more preferably 10,000 to 300,000.

[Hydrophilic compound]

From the viewpoint of developability, it is preferable that the undercoat layer contain a hydrophilic compound.

The hydrophilic compound is not particularly limited, and known hydrophilic compounds used for the undercoat layer can be used.

Preferable examples of hydrophilic compounds include phosphonic acids having an amino group such as carboxymethyl cellulose and dextrin, an organic phosphonic acid, an organic phosphoric acid, an organic phosphinic acid, an amino acid, a hydrochloride of amine having a hydroxyl group, and the like.

In addition, examples of preferable hydrophilic compounds include a compound having an amino group or a functional group capable of inhibiting polymerization and a group that interacts with the surface of the support (for example, 1,4-diazabicyclo[2.2.2]octane (DABCO), 2,3,5,6-tetrahydroxy-p-quinone, chloranil, sulfophthalic acid, ethylenediaminetetraacetic acid (EDTA) or a salt thereof, hydroxyethyl ethylenediaminetriacetic acid or a salt thereof, dihydroxyethyl ethylenediaminediacetic acid or a salt thereof, hydroxyethyl iminodiacetic acid or a salt thereof, and the like).

From the viewpoint of suppressing scratches and contamination, it is preferable that the hydrophilic compound include hydroxycarboxylic acid or a salt thereof.

Furthermore, from the viewpoint of suppressing scratches and contamination, it is preferable that the hydrophilic compound (preferably hydroxycarboxylic acid or a salt thereof) be contained not only in the undercoat layer but also in a layer on the aluminum support. In addition, the layer on the aluminum support is preferably a layer on the side where the image-recording layer is formed or a layer in contact with the aluminum support.

Preferable examples of the layer on the aluminum support include a layer in contact with the aluminum support, such as the undercoat layer or the image-recording layer. Furthermore, a layer other than the layer in contact with the aluminum support, for example, the protective layer or the image-recording layer may contain a hydrophilic compound (preferably hydroxycarboxylic acid or a salt thereof).

In the lithographic printing plate precursor according to the present disclosure, from the viewpoint of suppressing scratches and contamination, it is preferable that the image-recording layer contain hydroxycarboxylic acid or a salt thereof.

Moreover, regarding the lithographic printing plate precursor according to the present disclosure, for example, an aspect is also preferable in which the surface of the aluminum support on the image-recording layer side is treated with a composition (for example, an aqueous solution or the like) containing at least hydroxycarboxylic acid or a salt thereof. In a case where the above aspect is adopted, at least some of the hydroxycarboxylic acid or a salt thereof used for treatment can be detected in a state of being contained in the layer on the image-recording layer side (for example, the image-recording layer or the undercoat layer) that is in contact with the aluminum support.

In a case where the layer on the image-recording layer side that is in contact with the aluminum support, such as the undercoat layer, contains hydroxycarboxylic acid or a salt thereof, the surface of the aluminum support on the image-recording layer side can be hydrophilized, and it is easy for the surface of the aluminum support on the image-recording layer side to have a water contact angle of 110° or less measured by an airborne water droplet method. Therefore, scratches and contamination are excellently suppressed.

"Hydroxycarboxylic acid" is the generic term for organic compounds having one or more carboxy groups and one or more hydroxyl groups in one molecule. These compounds are also called hydroxy acid, oxy acid, oxycarboxylic acid, or alcoholic acid (see Iwanami Dictionary of Physics and Chemistry, 5th Edition, published by Iwanami Shoten, Publishers.

(1998)). The hydroxycarboxylic acid or a salt thereof is preferably represented by Formula (HC).

$$R^{HC}(OH)_{mhc}(COOM^{HC})_{nhc} \qquad \text{Formula (HC)}$$

In Formula (HC), $R^{HC}$ represents an (mhc + nhc)-valent organic group, $M^{HC}$ each independently represents a hydrogen atom, an alkali metal, or an onium, and mhc and nhc each independently represent an integer of 1 or more. In a case where n is 2 or more, Ms may be the same or different from each other.

Examples of the (mhc + nhc)-valent organic group represented by $R^{HC}$ in Formula (HC) include an (mhc + nhc)-valent hydrocarbon group and the like. The hydrocarbon group may have a substituent and/or a linking group.

Examples of the hydrocarbon group include an (mhc + nhc)-valent group derived from aliphatic hydrocarbon, such as an alkylene group, an alkanetriyl group, an alkanetetrayl group, an alkanepentayl group, an alkenylene group, an

alkenetriyl group, an alkenetetrayl group, and alkenepentayl group, an alkynylene group, an alkynetriyl group, alkynetetrayl group, or an alkynepentayl group, an (mhc + nhc)-valent group derived from aromatic hydrocarbon, such as an arylene group, an arenetriyl group, an arenetetrayl group, or an arenepentayl group, and the like. Examples of the substituent other than a hydroxyl group and a carboxy group include an alkyl group, an alkenyl group, an alkynyl group, an aralkyl group, an aryl group, and the like. Specific examples of the substituent include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, eicosyl group, isopropyl group, isobutyl group, s-butyl group, t-butyl group, isopentyl group, a neopentyl group, a 1-methylbutyl group, an isohexyl group, a 2-ethylhexyl group, a 2-methylhexyl group, a cyclohexyl group, a cyclopentyl group, a 2-norbornyl group, a methoxymethyl group, a methoxyethoxyethyl group, an allyloxymethyl group, a phenoxymethyl group, an acetyloxymethyl group, a benzoyloxymethyl group, a benzyl group, a phenethyl group, an $\alpha$-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group, a 3-butynyl group, a phenyl group, a biphenyl group, a naphthyl group, a tolyl group, a xylyl group, a mesityl group, a cumenyl group, a methoxyphenyl group, an ethoxyphenyl group, a phenoxyphenyl group, an acetoxyphenyl group, a benzoyloxyphenyl group, a methoxycarbonylphenyl group, an ethoxycarbonylphenyl group, a phenoxycarbonylphenyl group, and the like. Furthermore, the linking group is composed of at least one atom selected from the group consisting of a hydrogen atom, a carbon atom, an oxygen atom, a nitrogen atom, a sulfur atom, and a halogen atom, and the number of atoms is preferably 1 to 50. Specific examples thereof include an alkylene group, a substituted alkylene group, an arylene group, a substituted arylene group, and the like. The linking group may have a structure in which a plurality of these divalent groups are linked through any of an amide bond, an ether bond, a urethane bond, a urea bond, and an ester bond.

Examples of the alkali metal represented by $M^{HC}$ include lithium, sodium, potassium, and the like. Among these, sodium is particularly preferable. Examples of the onium include ammonium, phosphonium, sulfonium, and the like. Among these, ammonium is particularly preferable.

From the viewpoint of suppressing scratches and contamination, $M^{HC}$ is preferably an alkali metal or an onium, and more preferably an alkali metal.

The total number of mhc and nhc is preferably 3 or more, more preferably 3 to 8, and even more preferably 4 to 6.

The molecular weight of the hydroxycarboxylic acid or a salt thereof is preferably 600 or less, more preferably 500 or less, and particularly preferably 300 or less. The molecular weight is preferably 76 or more.

Specifically, examples of the hydroxycarboxylic acid constituting the hydroxycarboxylic acid or a salt of the hydroxycarboxylic acid include gluconic acid, glycolic acid, lactic acid, tartronic acid, hydroxybutyrate (such as 2-hydroxybutyrate, 3-hydroxybutyrate, or $\gamma$-hydroxybutyr ate), malic acid, tartaric acid, citramalic acid, citric acid, isocitric acid, leucine acid, mevalonic acid, pantoic acid, ricinoleic acid, ricineraidic acid, cerebronic acid, quinic acid, shikimic acid, a monohydroxybenzoic acid derivative (such as salicylic acid, creosotic acid (homosalicylic acid, hydroxy(methyl) benzoate), vanillic acid, or syringic acid), a dihydroxybenzoic acid derivative (such as pyrocatechuic acid, resorcylic acid, protocatechuic acid, gentisic acid, or orsellinic acid), a trihydroxybenzoic acid derivative (such as gallic acid), a phenyl acetate derivative (such as mandelic acid, benzilic acid, or atrolactic acid), a hydrocinnamic acid derivative (such as melilotic acid, phloretic acid, coumaric acid, umbellic acid, caffeic acid, ferulic acid, sinapic acid, cerebronic acid, or carminic acid), and the like.

Among these, as the aforementioned hydroxycarboxylic acid or a hydroxycarboxylic acid constituting a salt of the hydroxycarboxylic acid, from the viewpoint of suppressing scratches and contamination, a compound having two or more hydroxyl groups is preferable, a compound having 3 or more hydroxyl groups is more preferable, a compound having 5 or more hydroxyl groups is even more preferable, and a compound having 5 to 8 hydroxyl groups is particularly preferable.

Furthermore, as a hydroxycarboxylic acid having one carboxy group and two or more hydroxyl groups, gluconic acid or shikimic acid is preferable.

As hydroxycarboxylic acid having two or more carboxy groups and one hydroxyl group, citric acid or malic acid is preferable.

As hydroxycarboxylic acid having two or more carboxy groups and two or more hydroxyl groups, tartaric acid is preferable.

Among these, gluconic acid is particularly preferable as the aforementioned hydroxycarboxylic acid.

One kind of hydrophilic compound may be used alone, or two or more kinds of hydrophilic compounds may be used in combination.

In a case where the undercoat layer contains a hydrophilic compound which is preferably hydroxycarboxylic acid or a salt thereof, the content of the hydrophilic compound, preferably the content of hydroxycarboxylic acid and a salt thereof, with respect to the total mass of the undercoat layer is preferably 1% by mass to 50% by mass, more preferably 5% by mass to 40% by mass, even more preferably 8% by mass to 30% by mass, and particularly preferably 10% by mass to 30% by mass.

In order to prevent contamination over time, the undercoat layer may contain a chelating agent, a secondary or

tertiary amine, a polymerization inhibitor, and the like, in addition to the following compounds for the undercoat layer described above.

The undercoat layer is formed by known coating methods. The coating amount (solid content) of the undercoat layer is preferably 0.1 mg/$m^2$ to 100 mg/$m^2$, and more preferably 1 mg/$m^2$ to 30 mg/$m^2$.

<Water-soluble overcoat layer>

The lithographic printing plate precursor according to the present disclosure preferably has a water-soluble overcoat layer (hereinafter, may be called "overcoat layer" or "protective layer") on the image-recording layer. It is more preferable that the lithographic printing plate precursor have a water-soluble overcoat layer.

The film thickness of the water-soluble overcoat layer is preferably larger than the film thickness of the image-recording layer.

The overcoat layer has a function of suppressing the reaction inhibiting image formation by blocking oxygen and a function of preventing the damage of the image-recording layer and preventing ablation during exposure to high-illuminance lasers.

The overcoat layer having such characteristics is described, for example, in US3458311A and JP1980-49729B (JP-S55-49729B). As polymers with low oxygen permeability that are used in the overcoat layer, any of water-soluble polymers and water-insoluble polymers can be appropriately selected. If necessary, two or more kinds of such polymers can be used by being mixed together. From the viewpoint of on-press developability, the polymers with low oxygen permeability preferably include a water-soluble polymer.

In the present disclosure, a water-soluble polymer refers to a polymer that dissolves 1 g or more in 100 g of pure water at 70°C and is not precipitated even though a solution of 1 g of the polymer in 100 g of pure water at 70°C is cooled to 25°C.

-Water-soluble polymer-

Preferable examples of the water-soluble polymer used in the overcoat layer include polyvinyl acetal such as polyvinyl alcohol and modified polyvinyl alcohol, polyvinylpyrrolidone, a water-soluble cellulose derivative, polyethylene glycol, poly(meth)acrylonitrile, and the like.

As the modified polyvinyl alcohol, acid-modified polyvinyl alcohol having a carboxy group or a sulfo group is preferably used. Specific examples thereof include modified polyvinyl alcohols described in JP2005-250216A and JP2006-259137A.

From the viewpoint of UV printing durability and on-press developability, the water-soluble polymer preferably includes at least one kind of compound selected from the group consisting of polyvinyl alcohol, polyvinylpyrrolidone, a water-soluble cellulose derivative, and polyethylene glycol, more preferably includes at least one kind of compound selected from the group consisting of polyvinyl alcohol, a water-soluble cellulose derivative, and polyethylene glycol, even more preferably includes polyvinyl alcohol, and particularly preferably include polyvinyl alcohol having a saponification degree of 50% or higher.

The saponification degree is preferably 60% or higher, more preferably 70% or higher, and even more preferably 85% or higher. The upper limit thereof of the saponification degree is not particularly limited, and may be 100% or less.

The saponification degree is measured according to the method described in JIS K 6726: 1994.

As an aspect of the overcoat layer, for example, an aspect in which the overcoat layer contains polyvinyl alcohol and polyethylene glycol is also preferable.

In a case where the overcoat layer in the present disclosure contains a water-soluble polymer, the content of the water-soluble polymer with respect to the total mass of the overcoat layer is preferably 30% by mass to 100% by mass, more preferably 40% by mass to 100% by mass, and even more preferably 50% by mass to 100% by mass.

-Inorganic lamellar compound-

In order to improve oxygen barrier properties, the overcoat layer may contain an inorganic lamellar compound. The inorganic lamellar compound refers to particles in the form of a thin flat plate, and examples thereof include mica groups such as natural mica and synthetic mica, talc represented by Formula 3MgO·4SiO·H2O, taeniolite, montmorillonite, saponite, hectorite, zirconium phosphate, and the like.

As the inorganic lamellar compound, a mica compound is preferably used. Examples of the mica compound include mica groups such as natural mica and synthetic mica represented by Formula: $A(B, C)_{2-5}D_4O_{10}(OH, F, O)_2$ [here, A represents any of K, Na, and Ca, B and C represent any of Fe (II), Fe (III), Mn, Al, Mg, and V, and D represents Si or Al.].

In the mica groups, examples of natural mica include white mica, soda mica, gold mica, black mica, and lepidolite. Examples of synthetic mica include non-swelling mica such as fluorophlogopite $KMg_3(AlSi_3O_{10})F_2$, potassium tetrasilic

mica $KMg_{2.5}(Si_4O_{10})F_2$, and, Na tetrasilylic mica $NaMg_{2.5}(Si_4O_{10})F_2$, swelling mica such as Na or Li taeniolite (Na, Li) $Mg_2Li(Si_4O_{10})F2$, montmorillonite-based Na or Li hectorite $(Na, Li)_{1/8}Mg_{2/5}Li_{1/8}(Si_4O_{10})F_2$, and the like. Furthermore, synthetic smectite is also useful.

Among the aforementioned mica compounds, fluorine-based swelling mica is particularly useful. That is, swelling synthetic mica has a laminate structure consisting of unit crystal lattice layers having a thickness in a range of approximately 10Å to 15Å (1Å is equal to 0.1 nm), and metal atoms in lattices are more actively substituted than in any other clay minerals. As a result, positive charges are deficient in the lattice layers, and positive ions such as $Li^+$, $Na^+$, $Ca^{2+}$, and $Mg^{2+}$ are adsorbed between the layers in order to compensate for the deficiency. Positive ions interposed between the layers are called exchangeable positive ions and are exchangeable with various positive ions. Particularly, in a case where the positive ions between the layers are $Li^+$ and $Na^+$, the ionic radii are small, and thus the bonds between lamellar crystal lattices are weak, and mica is significantly swollen by water. In a case where shear is applied in this state, mica easily cleavages and forms a stable sol in water. Swelling synthetic mica is particularly preferably used because it clearly exhibits such a tendency.

From the viewpoint of diffusion control, regarding the shapes of the mica compounds, the thickness is preferably thin, and the planar size is preferably large as long as the smoothness and actinic ray-transmitting property of coated surfaces are not impaired. Therefore, the aspect ratio is preferably 20 or higher, more preferably 100 or higher, and particularly preferably 200 or higher. The aspect ratio is the ratio of the long diameter to the thickness of a particle and can be measured from projection views obtained from the microphotograph of the particle. The higher the aspect ratio is, the stronger the obtained effect is.

Regarding the particle diameter of the mica compound, the average long diameter thereof is preferably 0.3 μm to 20 μm, more preferably 0.5 μm to 10 μm, and particularly preferably 1 μm to 5 μm. The average thickness of the particles is preferably 0.1 μm or less, more preferably 0.05 μm or less, and particularly preferably 0.01 μm or less. Specifically, for example, in the case of swelling synthetic mica which is a typical compound, an aspect is preferable in which the compound has a thickness of about 1 nm to 50 nm and a surface size (long diameter) of about 1 μm to 20 μm.

The content of the inorganic lamellar compound with respect to the total solid content of the overcoat layer is preferably 1% by mass to 60% by mass, and more preferably 3% by mass to 50% by mass. Even in a case where two or more kinds of inorganic lamellar compounds are used in combination, the total amount of the inorganic lamellar compounds preferable equals the content described above. In a case where the content is within the above range, the oxygen barrier properties are improved, and excellent sensitivity is obtained. In addition, the deterioration of receptivity can be prevented.

-Hydrophobic polymer-

The overcoat layer may contain a hydrophobic polymer.

The hydrophobic polymer refers to a polymer that dissolves less than 5 g or does not dissolve in 100 g of pure water at 125°C.

Examples of the hydrophobic polymer include polyethylene, polystyrene, polyvinyl chloride, polyvinylidene chloride, polyalkyl (meth)acrylate ester (for example, polymethyl (meth)acrylate, polyethyl (meth)acrylate, polybutyl (meth)acrylate, and the like), a copolymer obtained by combining raw material monomers of these resins, and the like.

The hydrophobic polymer preferably includes a polyvinylidene chloride resin.

Furthermore, the hydrophobic polymer preferably includes a styrene-acrylic copolymer (also called styrene acrylic resin).

From the viewpoint of on-press developability, the hydrophobic polymer is preferably hydrophobic polymer particles.

One kind of hydrophobic polymer may be used alone, or two or more kinds of hydrophobic polymers may be used in combination.

In a case where the overcoat layer contains a hydrophobic polymer, the content of the hydrophobic polymer with respect to the total mass of the overcoat layer is preferably 1% by mass to 80% by mass, and more preferably 5% by mass to 50% by mass.

In the present disclosure, the proportion of the area of the hydrophobic polymer occupying the surface of the overcoat layer is preferably 30 area% or higher, more preferably 40 area% or higher, and even more preferably 50 area% or higher.

The upper limit of the proportion of the area of the hydrophobic polymer occupying the surface of the overcoat layer is, for example, 90 area%.

The proportion of the area of the hydrophobic polymer occupying the surface of the overcoat layer can be measured as follows.

By using PHI nano TOFII time-of-flight secondary ion mass spectrometer (TOF-SIMS) manufactured by ULVAC-PHI, INCORPORATED., the surface of the overcoat layer is irradiated with Bi ion beams (primary ions) at an acceleration

voltage of 30 kV, and the peak of ions (secondary ions) corresponding to a hydrophobic portion (that is, a region formed of the hydrophobic polymer) that are emitted from the surface is measured so that the hydrophobic portion is mapped. By measuring the area of the hydrophobic portion in an area of 1 $\mu m^2$, the proportion of the area occupied by the hydrophobic portion is determined and adopted as "proportion of the area of the hydrophobic polymer occupying the surface of the overcoat layer".

For example, in a case where the hydrophobic polymer is an acrylic resin, the proportion is measured using the peak of $C_6H_{13}O^-$. Furthermore, in a case where the hydrophobic polymer is polyvinylidene chloride, the proportion is measured using the peak of $C_2H_2Cl^+$.

The proportion of occupied area can be adjusted by the amount of the hydrophobic polymer added or the like.

<<Discoloring compound>>

From the viewpoint of improving visibility of exposed portions, the overcoat layer may contain a discoloring compound.

In a case where the overcoat layer contains the discoloring compound, a brightness change ΔL in the lithographic printing plate precursor that will be described later can be easily set to 2.0 or more.

From the viewpoint of improving visibility of exposed portions, in a case where the lithographic printing plate precursor according to the present disclosure is exposed to infrared with a wavelength of 830 nm at an energy density of 110 mJ/cm$^2$, a brightness change ΔL between the brightness of the precursor before exposure and the brightness of the precursor after exposure is preferably 2.0 or more.

The brightness change ΔL is more preferably 3.0 or more, even more preferably 5.0 or more, particularly preferably 8.0 or more, and most preferably 10.0 or more.

An upper limit of the brightness change ΔL is, for example, 20.0.

The brightness change ΔL is measured by the following method.

In Luxel PLATESETTER T-9800 manufactured by FUJIFILM Graphic Systems that is equipped with an infrared semiconductor laser with a wavelength of 830 nm, the lithographic printing plate precursor is exposed under the conditions of output of 99.5%, outer drum rotation speed of 220 rpm, and resolution of 2,400 dpi (dots per inch, 1 inch = 25.4 mm (energy density of 110 mJ/cm$^2$). The exposure is performed in an environment of 25°C and 50%RH.

The brightness change of the lithographic printing plate precursor before and after exposure is measured.

The brightness change is measured using a spectrocolorimeter eXact manufactured by X-Rite, Incorporated. By using the L* value (brightness) in the L*a*b* color space, the absolute value of a difference between the L* value of the image-recording layer after the exposure and the L* value of the image-recording layer before the exposure is adopted as the brightness change ΔL.

In the present disclosure, "discoloring compound" refers to a compound which undergoes change in absorption in the visible light region (wavelength: 400 nm or more and less than 750 nm) due to the exposure to infrared. That is, in the present disclosure, "discoloring" means that the absorption in the visible light region (wavelength: 400 nm or more and less than 750 nm) changes due to the exposure to infrared.

Specifically, examples of the discoloring compound in the present disclosure include (1) compound that absorbs more light in the visible light region due to the exposure to infrared than before the exposure to infrared, (2) compound that is made capable of absorbing light in the visible light region due to the exposure to infrared, and (3) compound that is made incapable of absorbing light in the visible light region due to the exposure to infrared.

The infrared in the present disclosure is a ray having a wavelength of 750 nm to 1 mm, and preferably a ray having a wavelength of 750 nm to 1,400 nm.

The discoloring compound preferably includes a compound that develops color due to the exposure to infrared.

Furthermore, the discoloring compound is preferably an infrared absorber.

In addition, the discoloring compound preferably includes a decomposable compound that decomposes due to the exposure to infrared, and particularly preferably includes a decomposable compound that decomposes by either or both of heat and electron transfer due to the exposure to infrared.

More specifically, the discoloring compound in the present disclosure is preferably a compound that decomposes due to the exposure to infrared (more preferably, decomposes by either or both of heat or electron transfer due to the exposure to infrared) and absorbs more light in the visible light region than before the exposure to infrared or is made capable of absorbing light of longer wavelengths and thus capable of absorbing light in the visible light region.

"Decomposes by electron transfer" mentioned herein means that electrons excited to the lowest unoccupied molecular orbital (LUMO) from the highest occupied molecular orbital (HOMO) of the discoloring compound by exposure to infrared move to electron accepting groups (groups having potential close to LUMO) in a molecule by means of intramolecular electron transfer and thus result in decomposition.

Hereinafter, as an example of the discoloring compound, a decomposable compound will be described.

There are no limitations on the decomposable compound as long as it absorbs at least a part of light in the infrared

wavelength region (wavelength region of 750 nm to 1 mm, preferably a wavelength region of 750 nm to 1,400 nm) and decomposes. The decomposable compound is preferably a compound having maximum absorption wavelength in a wavelength region of 750 nm to 1,400 nm.

More specifically, the decomposable compound is preferably a compound that decomposes due to the exposure to infrared and generates a compound having maximum absorption wavelength in a wavelength region of 500 nm to 600 nm.

From the viewpoint of improving visibility of exposed portions, the decomposable compound is preferably a cyanine dye having a group that decomposes by the exposure to infrared (specifically, $R^1$ in Formula 1-1 to Formula 1-7).

From the viewpoint of improving visibility of exposed portions, the decomposable compound is more preferably a compound represented by Formula 1-1.

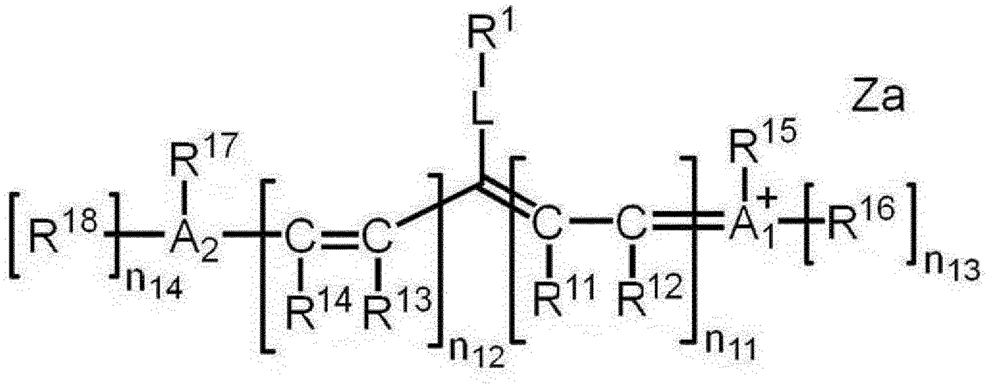

Formula 1-1

In Formula 1-1, $R^1$ represents a group that is represented by any of Formula 2 to Formula 4, $R^{11}$ to $R^{18}$ each independently represent a hydrogen atom, a halogen atom, $-R^a$, $-OR^b$, $-SR^c$, or $-NR^dR^e$, $R^a$ to $R^e$ each independently represent a hydrocarbon group, $A_1$, $A_2$, and a plurality of $R_{11}$ to $R_{18}$ may be linked to each other to form a monocyclic or polycyclic ring, $A_1$ and $A_2$ each independently represent an oxygen atom, a sulfur atom, or a nitrogen atom, $n_{11}$ and $n_{12}$ each independently represent an integer of 0 to 5, the sum of $n_{11}$ and $n_{12}$ is 2 or more, $n_{13}$ and $n_{14}$ each independently represent 0 or 1, L represents an oxygen atom, a sulfur atom, or $-NR^{10}-$, $R^{10}$ represents a hydrogen atom, an alkyl group, or an aryl group, and Za represents a counterion that neutralizes charge.

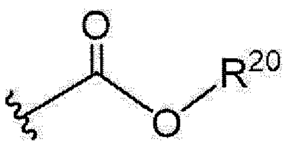

Formula 2

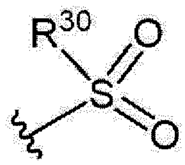

Formula 3

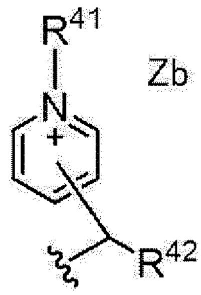

Formula 4

In Formula 2 to Formula 4, $R^{20}$, $R^{30}$, $R^{41}$, and $R^{42}$ each independently represent an alkyl group or an aryl group, Zb represents a counterion that neutralizes charge, the wavy line represents a binding site with the group represented by L in Formula 1-1.

In a case where the compound represented by Formula 1-1 is exposed to infrared, the $R^1$-L bond is cleaved, L turns into =O, =S, or $=NR^{10}$, and the compound is discolored.

In Formula 1-1, $R^1$ represents a group represented by any of Formula 2 to Formula 4.

Hereinafter, each of the group represented by Formula 2, the group represented by Formula 3, and the group represented by Formula 4 will be described.

In Formula 2, $R^{20}$ represents an alkyl group or an aryl group, and the portion of the wavy line represents a binding site with the group represented by L in Formula 1-1.

As the alkyl group represented by $R^{20}$, an alkyl group having 1 to 30 carbon atoms is preferable, an alkyl group having 1 to 15 carbon atoms is more preferable, and an alkyl group having 1 to 10 carbon atoms is even more preferable.

The alkyl group may be linear or branched, or may have a ring structure.

The aryl group represented by $R^{20}$ is preferably an aryl group having 6 to 30 carbon atoms, more preferably an aryl group having 6 to 20 carbon atoms, and even more preferably an aryl group having 6 to 12 carbon atoms.

From the viewpoint of color developability, $R^{20}$ is preferably an alkyl group.

From the viewpoint of decomposition properties and color developability, the alkyl group represented by $R^{20}$ is preferably a secondary alkyl group or a tertiary alkyl group, and more preferably a tertiary alkyl group.

Furthermore, from the viewpoint of decomposition properties and color developability, the alkyl group represented by $R^{20}$ is preferably an alkyl group having 1 to 8 carbon atoms, more preferably a branched alkyl group having 3 to 10 carbon atoms, even more preferably a branched alkyl group having 3 to 6 carbon atoms, particularly preferably an isopropyl group or a tert-butyl group, and most preferably a tert-butyl group.

The alkyl group represented by $R^{20}$ may be a substituted alkyl group substituted with a halogen atom (for example, a chloro group) or the like.

Specific examples of the group represented by Formula 2 will be shown below. However, the present disclosure is not limited thereto. In the following structural formulas, • represents a binding site with the group represented by L in Formula 1-1.

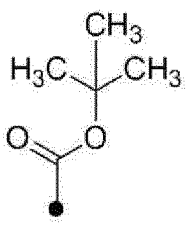
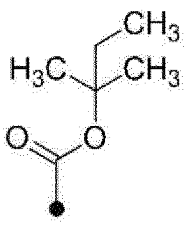
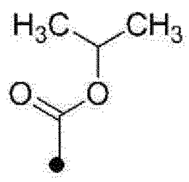
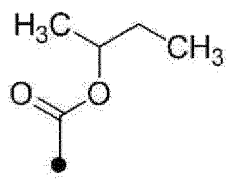
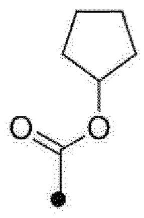

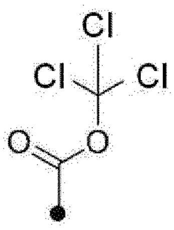

In Formula 3, $R^{30}$ represents an alkyl group or an aryl group, and the portion of the wavy line represents a binding site with the group represented by L in Formula 1-1.

The alkyl group and aryl group represented by $R^{30}$ are the same as the alkyl group and aryl group represented by $R^{20}$ in Formula 2, and the preferred aspects thereof are also the same.

From the viewpoint of decomposition properties and color developability, the alkyl group represented by $R^{30}$ is preferably a secondary alkyl group or a tertiary alkyl group, and more preferably a tertiary alkyl group.

Furthermore, from the viewpoint of decomposition properties and color developability, the alkyl group represented by $R^{30}$ is preferably an alkyl group having 1 to 8 carbon atoms, more preferably a branched alkyl group having 3 to 10 carbon atoms, even more preferably a branched alkyl group having 3 to 6 carbon atoms, particularly preferably an isopropyl group or a tert-butyl group, and most preferably a tert-butyl group.

In addition, from the viewpoint of decomposition properties and color developability, the alkyl group represented by $R^{30}$ is preferably a substituted alkyl group, more preferably a fluoro-substituted alkyl group, even more preferably a perfluoroalkyl group, and particularly preferably a trifluoromethyl group.

From the viewpoint of decomposition properties and color developability, the aryl group represented by $R^{30}$ is preferably a substituted aryl group. Examples of the substituent include an alkyl group (preferably an alkyl group having 1 to 4 carbon atoms), an alkoxy group (preferably an alkoxy group having 1 to 4 carbon atoms), and the like.

Specific examples of the group represented by Formula 3 will be shown below. However, the present disclosure is not limited thereto. In the following structural formulas, • represents a binding site with the group represented by L in Formula 1-1.

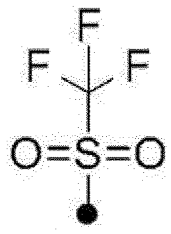 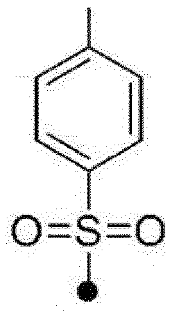

In Formula 4, $R^{41}$ and $R^{42}$ each independently represent an alkyl group or an aryl group, Zb represents a counterion that neutralizes charge, and the portion of the wavy line represents a binding site with the group represented by L in Formula 1-1.

The alkyl group and aryl group represented by $R^{41}$ or $R^{42}$ are the same as the alkyl group and aryl group represented by $R^{20}$ in Formula 2, and preferred aspects thereof are also the same.

From the viewpoint of decomposition properties and color developability, $R^{41}$ is preferably an alkyl group.

From the viewpoint of decomposition properties and color developability, $R^{42}$ is preferably an alkyl group.

From the viewpoint of decomposition properties and color developability, the alkyl group represented by $R^{41}$ is preferably an alkyl group having 1 to 8 carbon atoms, more preferably an alkyl group having 1 to 4 carbon atoms, and particularly preferably a methyl group.

From the viewpoint of decomposition properties and color developability, the alkyl group represented by $R^{42}$ is preferably a secondary alkyl group or a tertiary alkyl group, and more preferably a tertiary alkyl group.

Furthermore, from the viewpoint of decomposition properties and color developability, the alkyl group represented by $R^{42}$ is preferably an alkyl group having 1 to 8 carbon atoms, more preferably a branched alkyl group having 3 to 10 carbon atoms, even more preferably a branched alkyl group having 3 to 6 carbon atoms, particularly preferably an isopropyl group or a tert-butyl group, and most preferably a tert-butyl group.

Zb in Formula 4 may be a counterion that neutralizes charge, and may be included in Za in Formula 1-1 in the entirety of the compound.

Zb is preferably a sulfonate ion, a carboxylate ion, a tetrafluoroborate ion, a hexafluorophosphate ion, a p-toluenesulfonate ion, or a perchlorate ion, and more preferably a tetrafluoroborate ion.

Specific examples of the group represented by Formula 4 will be shown below. However, the present disclosure is not limited thereto. In the following structural formulas, • represents a binding site with the group represented by L in Formula 1-1.

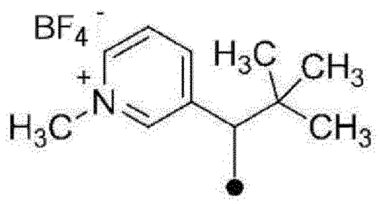

L in Formula 1-1 is preferably an oxygen atom or $-NR^{10}-$, and particularly preferably an oxygen atom.

Furthermore, $R^{10}$ in $-NR^{10}-$ is preferably an alkyl group. The alkyl group represented by $R^{10}$ is preferably an alkyl group having 1 to 10 carbon atoms. The alkyl group represented by $R^{10}$ may be linear or branched, or may have a ring structure.

Among the alkyl groups, a methyl group or a cyclohexyl group is preferable.

In a case where $R^{10}$ in $-NR^{10}-$ represents an aryl group, the aryl group is preferably an aryl group having 6 to 30 carbon atoms, more preferably an aryl group having 6 to 20 carbon atoms, and even more preferably an aryl group having 6 to 12 carbon atoms. These aryl groups may have a substituent.

In Formula 1-1, $R^{11}$ to $R^{18}$ preferably each independently represent a hydrogen atom, $-R^a$, $-OR^b$, $-SR^c$, or $-NR^dR^e$.

The hydrocarbon group represented by $R^a$ to $R^e$ is preferably a hydrocarbon group having 1 to 30 carbon atoms, more preferably a hydrocarbon group having 1 to 15 carbon atoms, and even more preferably a hydrocarbon group having 1 to 10 carbon atoms.

The hydrocarbon group may be linear or branched or may have a ring structure.

As the hydrocarbon group, an alkyl group is particularly preferable.

The aforementioned alkyl group is preferably an alkyl group having 1 to 30 carbon atoms, more preferably an alkyl group having 1 to 15 carbon atoms, and even more preferably an alkyl group having 1 to 10 carbon atoms.

The alkyl group may be linear or branched, or may have a ring structure.

Specific examples of the alkyl group include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group, and a 2-norbornyl group.

Among these alkyl groups, a methyl group, an ethyl group, a propyl group, or a butyl group is preferable.

The above alkyl group may have a substituent.

Examples of the substituent include an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, and groups obtained by combining these, and the like.

$R^{11}$ to $R^{14}$ in Formula 1-1 preferably each independently represent a hydrogen atom or - $R^a$ (that is, a hydrocarbon group), more preferably each independently represent a hydrogen atom or an alkyl group, and even more preferably each independently represent a hydrogen atom except in the cases described below.

Particularly, each of $R^{11}$ and $R^{13}$ bonded to the carbon atom that is bonded to the carbon atom to which L is bonded is preferably an alkyl group. It is more preferable that $R^{11}$ and $R^{13}$ be linked to each other to form a ring. The ring to be formed in this way may be a monocyclic or polycyclic ring. Specifically, examples of the ring to be formed include a monocyclic ring such as a cyclopentene ring, a cyclopentadiene ring, a cyclohexene ring, or a cyclohexadiene ring, and a polycyclic ring such as an indene ring or an indole ring.

Furthermore, it is preferable that $R^{12}$ bonded to the carbon atom to which $A_1^+$ is bonded be linked to $R^{15}$ or $R^{16}$ (preferably $R^{16}$) to form a ring, and $R^{14}$ bonded to the carbon atom to which $A_2$ is bonded be linked to $R^{17}$ or $R^{18}$ (preferably $R^{18}$) to form a ring.

In Formula 1-1, $n_{13}$ is preferably 1, and $R^{16}$ is preferably -$R^a$ (that is, a hydrocarbon group).

Furthermore, it is preferable that $R^{16}$ be linked to $R^{12}$ bonded to the carbon atom to which $A_1^+$ is bonded, so as to form a ring. As the ring to be formed, an indolium ring, a pyrylium ring, a thiopyrylium ring, a benzoxazoline ring, or a benzimidazoline ring is preferable, and an indolium ring is more preferable from the viewpoint of improving visibility of exposed portions. These rings may further have a substituent.

In Formula 1-1, $n_{14}$ is preferably 1, and $R^{18}$ is preferably - $R^a$ (that is, a hydrocarbon group).

Furthermore, it is preferable that $R^{18}$ be linked to $R^{14}$ bonded to the carbon atom to which $A_2$ is bonded, so as to form a ring. As the ring to be formed, an indole ring, a pyran ring, a thiopyran ring, a benzoxazole ring, or a benzimidazole ring is preferable, and an indole ring is more preferable from the viewpoint of improving visibility of exposed portions. These rings may further have a substituent.

It is preferable that $R^{16}$ and $R^{18}$ in Formula 1-1 be the same group. In a case where $R^{16}$ and $R^{18}$ each form a ring, it is preferable that the formed rings have the same structure except for $A_1^+$ and $A_2$.

It is preferable that $R^{15}$ and $R^{17}$ in Formula 1-1 be the same group. Furthermore, $R^{15}$ and $R^{17}$ are preferably -$R^a$ (that is, a hydrocarbon group), more preferably an alkyl group, and even more preferably a substituted alkyl group.

From the viewpoint of improving water solubility, $R^{15}$ and $R^{17}$ in the compound represented by Formula 1-1 are preferably a substituted alkyl group.

Examples of the substituted alkyl group represented by $R^{15}$ or $R^{17}$ include a group represented by any of Formula (a1) to Formula (a4).

$$-W\left(R^{W0}-O\right)_{n_{W1}}R^{W1} \qquad (a1)$$

$$-R^{W2}-CO_2M \qquad (a2)$$

$$-R^{W3}-PO_3M_2 \qquad (a3)$$

$$-R^{W4}-SO_3M \qquad (a4)$$

In Formula (a1) to Formula (a4), $R^{w0}$ represents an alkylene group having 2 to 6 carbon atoms, W represents a single bond or an oxygen atom, and $n_{W1}$ represents an integer of 1 to 45, $R^{W1}$ represents an alkyl group having 1 to 12 carbon atoms or -C(=O)-$R^{W5}$, $R^{W5}$ represents an alkyl group having 1 to 12 carbon atoms, $R^{W2}$ to $R^{W4}$ each independently represent a single bond or an alkylene group having 1 to 12 carbon atoms, and M represents a hydrogen atom, a sodium atom, a potassium atom, or an onium group.

Specific examples of the alkylene group represented by $R^{W0}$ in Formula (a1) include an ethylene group, a n-propylene group, an isopropylene group, a n-butylene group, an isobutylene group, a n-pentylene group, an isopentylene group, a n-hexyl group, an isohexyl group, and the like. Among these, an ethylene group, a n-propylene group, an isopropylene group, or a n-butylene group is preferable, and a n-propylene group is particularly preferable.

$n_{W1}$ is preferably 1 to 10, more preferably 1 to 5, and particularly preferably 1 to 3.

Specific examples of the alkyl group represented by $R^{W1}$ include a methyl group, an ethyl group, a n-propyl group, an isopropyl group, a n-butyl group, an isobutyl group, a tert-butyl group, a n-pentyl group, an isopentyl group, a neopentyl group, a n-hexyl group, a n-octyl group, a n-dodecyl group, and the like. Among these, a methyl group, an ethyl group, a n-propyl group, an isopropyl group, a n-butyl group, or a tert-butyl group is preferable, a methyl group or an ethyl group is more preferable, and a methyl group is particularly preferable.

The alkyl group represented by $R^{W5}$ is the same as the alkyl group represented by $R^{W1}$. Preferred aspects of the alkyl group represented by $R^{W5}$ are the same as preferred aspects of the alkyl group represented by $R^{W1}$.

Specific examples of the group represented by Formula (a1) will be shown below. However, the present disclosure is not limited thereto. In the following structural formulas, Me represents a methyl group, Et represents an ethyl group, and * represents a binding site.

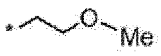
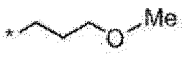
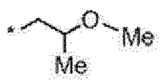
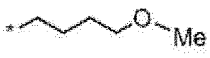
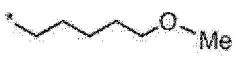

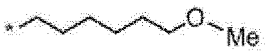
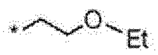
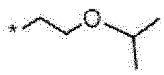
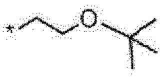

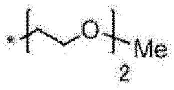
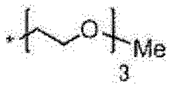
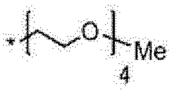
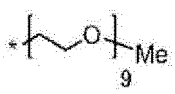
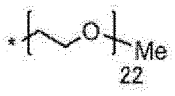

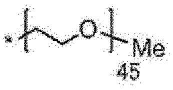
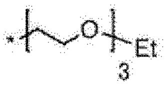
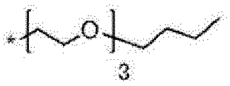
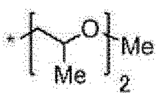
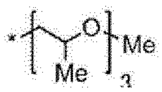

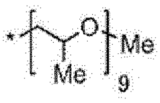
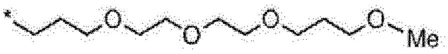

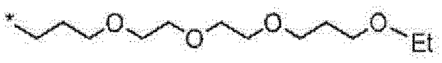
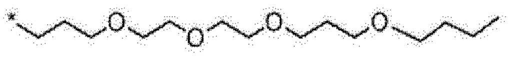

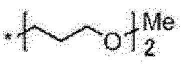
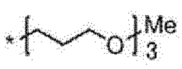
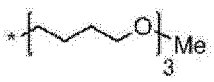

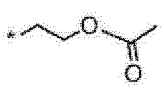
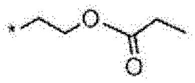
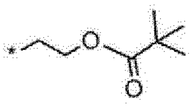
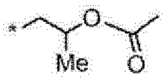
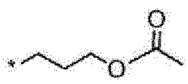

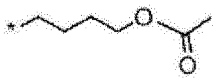
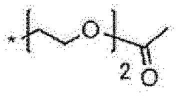
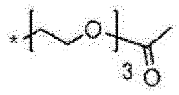
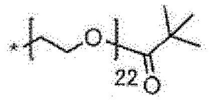

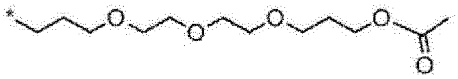

Specific examples of the alkylene group represented by $R^{W2}$ to $R^{W4}$ in Formula (a2) to Formula (a4) include a methylene group, an ethylene group, a n-propylene group, an isopropylene group, a n-butylene group, an isobutylene group, a n-pentylene group, an isopentylene group, a n-hexyl group, an isohexyl group, a n-octylene group, a n-dodecylene group, and the like. Among these, an ethylene group, a n-propylene group, an isopropylene group, or a n-butylene group is preferable, and an ethylene group or a n-propylene group is particularly preferable.

In Formula (a3), two Ms may be the same as or different from each other.

Examples of the onium group represented by M in Formula (a2) to Formula (a4) include an ammonium group, an iodonium group, a phosphonium group, a sulfonium group, and the like.

All of $CO_2M$ in Formula (a2), $PO_3M_2$ in Formula (a2), and $SO_3M$ in Formula (a4) may have an anion structure from which M is dissociated. The countercation of the anion structure may be $A_1^+$ or a cation that can be contained in $R^1$-L in Formula 1-1.

Among the groups represented by Formula (a1) to Formula (a4), the group represented by Formula (a1), Formula (a2), or Formula (a4) is preferable.

$n_{11}$ and $n_{12}$ in Formula 1-1 are preferably the same as each other, and preferably both represent an integer of 1 to 5, more preferably both represent an integer of 1 to 3, even more preferably both represent 1 or 2, and particularly preferably both represent 2.

$A_1$ and $A_2$ in Formula 1-1 each independently represent an oxygen atom, a sulfur atom, or a nitrogen atom. Among these, a nitrogen atom is preferable.

$A_1$ and $A_2$ in Formula 1-1 are preferably the same atoms.

Za in Formula 1-1 represents a counterion that neutralizes charge.

In a case where all of $R^{11}$ to $R^{18}$ and $R^1$-L are groups having a neutral charge, Za is a monovalent counteranion. Here, $R^{11}$ to $R^{18}$ and $R^1$-L may have an anion structure or a cation structure. For example, in a case where two or more among $R^{11}$ to $R^{18}$ and $R^1$-L have an anion structure, Za can also be a countercation.

In a case where the cyanine dye represented by Formula 1-1 has such a structure that the overall charge of the compound is neutral except for Za, Za is unnecessary.

In a case where Za is a counteranion, examples thereof include a sulfonate ion, a carboxylate ion, a tetrafluoroborate ion, a hexafluorophosphate ion, a p-toluenesulfonate ion, a perchlorate ion, and the like. Among these, a tetrafluoroborate ion is preferable.

In a case where Za is a countercation, examples thereof include an alkali metal ion, an alkaline earth metal ion, an ammonium ion, a pyridinium ion, sulfonium ion, and the like. Among these, a sodium ion, a potassium ion, an ammonium ion, a pyridinium ion, or a sulfonium ion is preferable, and a sodium ion, a potassium ion, or an ammonium ion is more preferable.

From the viewpoint of improving visibility of exposed portions, the decomposable compound is more preferably a compound represented by Formula 1-2 (that is, a cyanine dye).

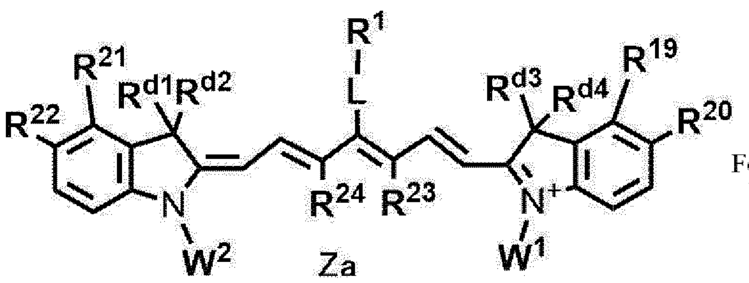

Formula 1-2

In Formula 1-2, $R^1$ represents a group represented by any of Formula 2 to Formula 4, $R^{19}$ to $R^{22}$ each independently represent a hydrogen atom, a halogen atom, $-R^a$, $-OR^b$, -CN, $-SR^c$, or $-NR^dR^e$, $R^{23}$ and $R^{24}$ each independently represent a hydrogen atom or $-R^a$, $R^a$ to $R^e$ each independently represent a hydrocarbon group, $R^{19}$ and $R^{20}$, $R^{21}$ and $R^{22}$, or $R^{23}$ and $R^{24}$ may be linked to each other to form a monocyclic or polycyclic ring, L represents an oxygen atom, a sulfur atom, or $-NR^{10}-$, $R^{10}$ represents a hydrogen atom, an alkyl group, or an aryl group, $R^{d1}$ to $R^{d4}$, $W^1$,

and $W^2$ each independently represent an alkyl group which may have a substituent, and Za represents a counterion that neutralizes charge.

$R^1$ in Formula 1-2 has the same definition as $R^1$ in Formula 1-1, and preferred aspects thereof are also the same.

In Formula 1-2, $R^{19}$ to $R^{22}$ preferably each independently represent a hydrogen atom, a halogen atom, $-R^a$, $-OR^b$, or -CN.

More specifically, $R^{19}$ and $R^{21}$ are preferably a hydrogen atom or $-R^a$.

Furthermore, $R^{20}$ and $R^{22}$ are preferably a hydrogen atom, $-R^a$, $-OR^b$, or -CN.

$-R^a$ represented by $R^{19}$ to $R^{22}$ is preferably an alkyl group or an alkenyl group.

In a case where all of $R^{19}$ to $R^{22}$ are $-R^a$, it is preferable that $R^{19}$ and $R^{20}$ and $R^{21}$ and $R^{22}$ be linked to each other to form a monocyclic or polycyclic ring.

Examples of the ring formed of $R^{19}$ and $R^{20}$ or $R^{21}$ and $R^{22}$ linked to each other include a benzene ring, a naphthalene ring, and the like.

$R^{23}$ and $R^{24}$ in Formula 1-2 are preferably linked to each other to form a monocyclic or polycyclic ring.

The ring formed of $R^{23}$ and $R^{24}$ linked to each other may be a monocyclic or polycyclic ring. Specific examples of the ring to be formed include a monocyclic ring such as a cyclopentene ring, a cyclopentadiene ring, a cyclohexene ring, or a cyclohexadiene ring, and a polycyclic ring such as an indene ring.

$R^{d1}$ to $R^{d4}$ in Formula 1-2 are preferably an unsubstituted alkyl group. Furthermore, all of $R^{d1}$ to $R^{d4}$ are preferably the same group.

Examples of the unsubstituted alkyl group include unsubstituted alkyl groups having 1 to 4 carbon atoms. Among these, a methyl group is preferable.

From the viewpoint of improving water solubility of the compound represented by Formula 1-2, $W^1$ and $W^2$ in Formula 1-2 preferably each independently represent a substituted alkyl group.

Examples of the substituted alkyl group represented by $W^1$ and $W^2$ include a group represented by any of Formula (a1) to Formula (a4) in Formula 1-1, and preferred aspects thereof are also the same.

From the viewpoint of on-press developability, $W^1$ and $W^2$ preferably each independently represent an alkyl group having a substituent. The alkyl group preferably has at least $-(OCH_2CH_2)-$, a sulfo group, a salt of a sulfo group, a carboxy group, or a salt of a carboxy group, as the substituent.

Za represents a counterion that neutralizes charge in the molecule.

In a case where all of $R^{19}$ to $R^{22}$, $R^{23}$ and $R^{24}$, $R^{d1}$ to $R^{d4}$, $W^1$, $W^2$, and $R^1$-L are groups having a neutral charge, Za is a monovalent counteranion. Here, $R^{19}$ to $R^{22}$, $R^{23}$ and $R^{24}$, $R^{d1}$ to $R^{d4}$, $W^1$, $W^2$, and $R^1$-L may have an anion structure or a cation structure. For example, in a case where two among $R^{19}$ to $R^{22}$, $R^{23}$ and $R^{24}$, $R^{d1}$ to $R^{d4}$, $W^1$, $W^2$, and $R^1$-L have an anion structure, Za can be a countercation.

In a case where the compound represented by Formula 1-2 has such a structure that the overall charge of the compound is neutral except for Za, Za is unnecessary.

Examples of the case where Za is a counteranion are the same as such examples of Za in Formula 1-1, and preferred aspects thereof are also the same. Furthermore, examples of the case where Za is a countercation are the same as such examples of Za in Formula 1-1, and preferred aspects thereof are also the same.

From the viewpoint of decomposition properties and color developability, the cyanine dye as a decomposable compound is even more preferably a compound represented by any of Formula 1-3 to Formula 1-7.

Particularly, from the viewpoint of decomposition properties and color developability, the cyanine dye is preferably a compound represented by any of Formula 1-3, Formula 1-5, and Formula 1-6.

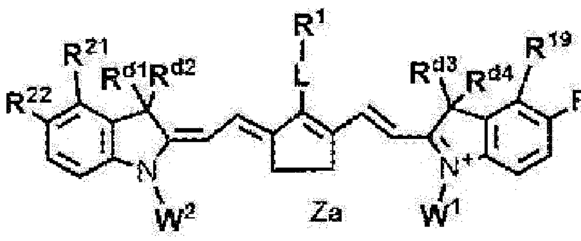

Formula 1-3

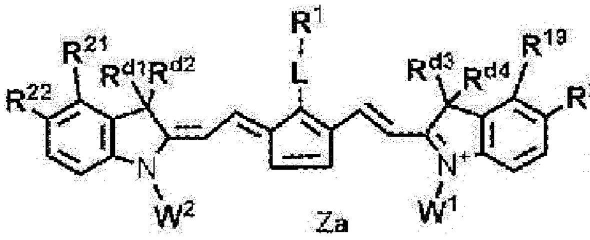

Formula 1-4

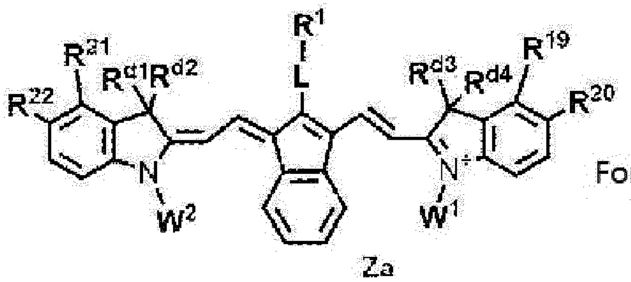

Formula 1-5

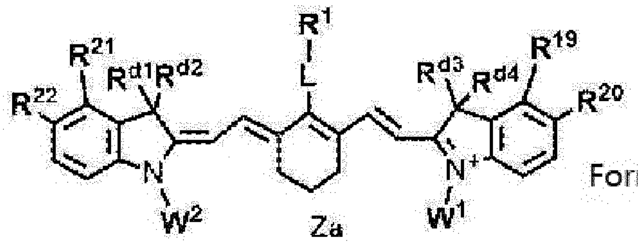

Formula 1-6

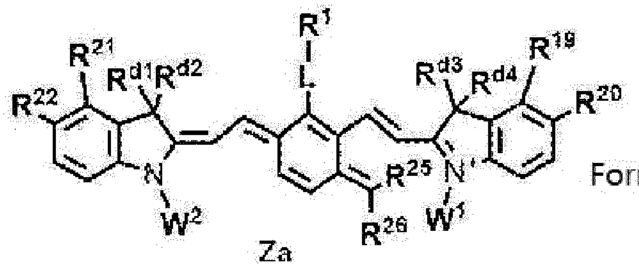

Formula 1-7

In Formula 1-3 to Formula 1-7, $R^1$ represents a group represented by any of Formula 2 to Formula 4, and $R^{19}$ to $R^{22}$ each independently represent a hydrogen atom, a halogen atom, $-R^a$, $-OR^b$, -CN, $-SR^c$, or $-NR^dR^e$, and $R^{25}$ and $R^{26}$ each independently represent a hydrogen atom, a halogen atom, or $-R^a$, and $R^a$ to $R^e$ each independently represent a hydrocarbon group, $R^{19}$ and $R^{20}$, $R^{21}$ and $R^{22}$, or $R^{25}$ and $R^{26}$ may be linked to each other to form a monocyclic or polycyclic ring, L represents an oxygen atom, a sulfur atom, or $-NR^{10}-$, $R^{10}$ represents a hydrogen atom, an alkyl group, or an aryl group, and $R^{d1}$ to $R^{d4}$, $W^1$, and $W^2$ each independently represent an alkyl group which may have a substituent, and Za represents a counterion that neutralizes charge.

$R^1$, $R^{19}$ to $R^{22}$, $R^{d1}$ to $R^{d4}$, $W^1$, $W^2$, and L in Formula 1-3 to Formula 1-7 have the same definitions as $R^1$, $R^{19}$ to $R^{22}$, $R^{d1}$ to $R^{d4}$, $W^1$, $W^2$, and L in Formula 1-2, and preferred aspects thereof are also the same.

$R^{25}$ and $R^{26}$ in Formula 1-7 preferably each independently represent a hydrogen atom or an alkyl group, more preferably each independently represent an alkyl group, and particularly preferably each independently represent a methyl group.

Specific examples of the cyanine dye as a decomposable compound will be shown below. However, the present disclosure is not limited thereto.

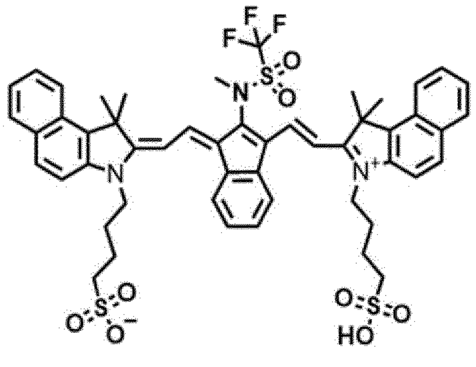
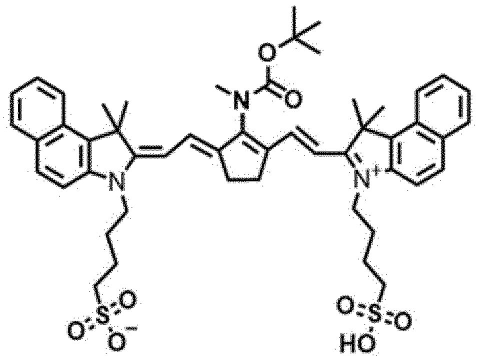
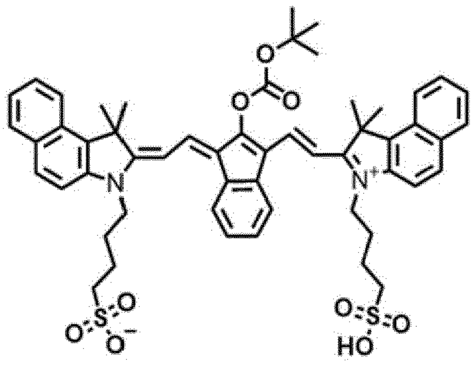
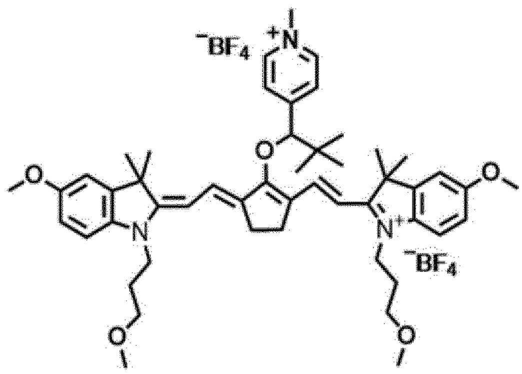
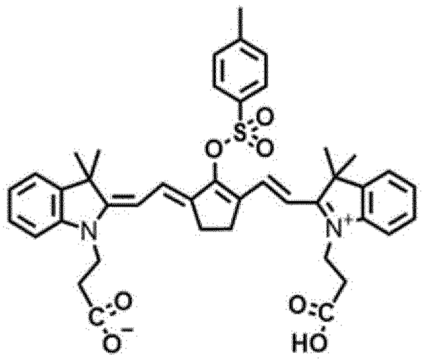
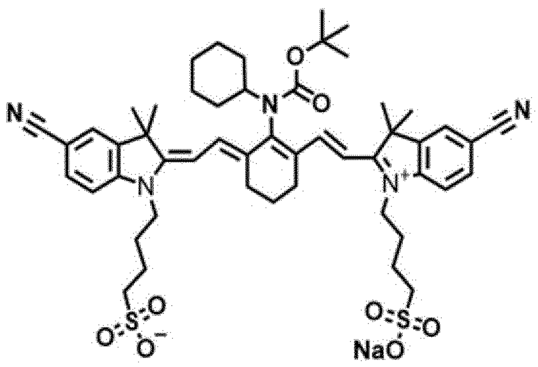

Furthermore, as the cyanine dye which is a decomposable compound, the infrared absorbing compound described in WO2019/219560A can be suitably used.

As the discoloring compound, an acid color-developing agent may also be used.

As the acid color-developing agent, it is possible to use the compounds described as acid color-developing agents in the image-recording layer, and preferred aspects thereof are also the same.

One kind of discoloring compound may be used alone, or two or more kinds of components may be combined and used as the discoloring compound.

From the viewpoint of color developability, the content of the discoloring compound in the overcoat layer with respect to the total mass of the overcoat layer is preferably 0.10% by mass to 50% by mass, more preferably 0.50% by mass to 30% by mass, and even more preferably 1.0% by mass to 20% by mass.

From the viewpoint of color developability, $M^X/M^Y$ which is a ratio of a content $M^X$ of the discoloring compound in the overcoat layer to a content $M^Y$ of the infrared absorber in the image-recording layer is preferably 0.1 or more, more preferably 0.2 or more, and particularly preferably 0.3 or more and 3.0 or less.

The overcoat layer may contain known additives such as a plasticizer for imparting flexibility, a surfactant for improving coating properties, and inorganic particles for controlling surface slipperiness. In addition, the oil sensitizing agent described above regarding the image-recording layer may be incorporated into the overcoat layer.

The method for forming the overcoat layer is not particularly limited, and the overcoat layer can be formed by a known method. The coating amount of the overcoat layer (solid content) is preferably 0.01 $g/m^2$ to 10 $g/m^2$, more preferably 0.02 $g/m^2$ to 3 $g/m^2$, and particularly preferably 0.02 $g/m^2$ to 1 $g/m^2$.

The film thickness of the overcoat layer in the lithographic printing plate precursor according to the present disclosure is preferably 0.8 μm to 3 μm, and more preferably 1 μm to 2 μm.

Furthermore, from the viewpoint of UV printing durability and on-press developability, the thickness of the overcoat layer is preferably greater than the thickness of the image-recording layer described above.

<<Film thickness ratio>>

From the viewpoint of UV printing durability and on-press developability, in the lithographic printing plate precursor according to the present disclosure, a ratio of film thickness of the overcoat layer/film thickness of the image-recording layer is preferably 0.5 to 5, more preferably 1.1 to 4, even more preferably 1.1 to 3, and particularly preferably 1.1 to 2.

The film thickness of each of the overcoat layer and the image-recording layer is determined by staining the lithographic printing plate precursor with osminium, then observing a cross section of the lithographic printing plate precursor with a scanning electron microscope (SEM), and calculating the average of film thickness of each layer at randomly extracted 20 points.

(Method for preparing lithographic printing plate and lithographic printing method)

It is possible to prepare a lithographic printing plate by performing image exposure and a development treatment on the lithographic printing plate precursor according to the present disclosure.

The method for preparing a lithographic printing plate according to the present disclosure preferably includes a step of exposing the lithographic printing plate precursor according to the present disclosure in the shape of an image (hereinafter, this step will be also called "exposure step") and a step of removing the image-recording layer in a non-image area on a printer by supplying at least one material selected from the group consisting of a printing ink and dampening water (hereinafter, this step will be also called "on-press development step").

The lithographic printing method according to the present disclosure preferably includes a step of exposing the lithographic printing plate precursor according to the present disclosure in the shape of an image (exposure step), a step of removing the image-recording layer in a non-image area on a printer by supplying at least one material selected from the group consisting of a printing ink and dampening water so that a lithographic printing plate is prepared (on-press development step), and a step of performing printing by using the obtained lithographic printing plate (printing step).

Hereinafter, regarding the method for preparing a lithographic printing plate according to the present disclosure and the lithographic printing method according to the present disclosure, preferred aspects of each step will be described in order. Note that the lithographic printing plate precursor according to the present disclosure can also be developed using a developer.

Hereinafter, the exposure step and the on-press development step in the method for preparing a lithographic printing plate will be described. The exposure step in the method for preparing a lithographic printing plate according to the present disclosure is the same step as the exposure step in the lithographic printing method according to the present disclosure. Furthermore, the on-press development step in the method for preparing a lithographic printing plate according to the present disclosure is the same step as the on-press development step in the lithographic printing method according to the present disclosure.

Furthermore, presumably, a part of the outermost layer may be removed during on-press development, and a part of the outermost layer may remain on the surface of the image area or permeate the inside of the image area by a printing ink.

<Exposure step>

The method for preparing a lithographic printing plate according to the present disclosure preferably includes an exposure step of exposing the lithographic printing plate precursor according to the present disclosure in the shape of an image so that an exposed portion and a non-exposed portion are formed. The lithographic printing plate precursor according to the present disclosure is preferably exposed to a laser through a transparent original picture having a linear image, a halftone dot image, or the like or exposed in the shape of an image by laser light scanning according to digital data or the like.

The wavelength of a light source to be used is preferably 750 nm to 1,400 nm. As the light source of 750 nm to 1,400 nm, a solid-state laser or a semiconductor laser that radiates infrared is suitable. In a case where an infrared laser is used, the output is preferably 100 mW or higher, the exposure time per pixel is preferably 20 microseconds or less, and the

amount of irradiation energy is preferably 10 mJ/cm$^2$ to 300 mJ/cm$^2$. In addition, in order to shorten the exposure time, a multibeam laser device is preferably used. The exposure mechanism may be any one of an in-plane drum method, an external surface drum method, a flat head method, or the like.

The image exposure can be carried out by a common method using a platesetter or the like. In the case of on-press development, image exposure may be carried out on a printer after the lithographic printing plate precursor is mounted on the printer.

<On-press development step>

The method for preparing a lithographic printing plate according to the present disclosure preferably includes an on-press development step of removing the image-recording layer in a non-image area on a printer by supplying at least one material selected from the group consisting of a printing ink and dampening water.

Hereinafter, the on-press development method will be described.

[On-press development method]

In the on-press development method, the lithographic printing plate precursor having undergone image exposure is preferably supplied with an oil-based ink and an aqueous component on a printer, so that the image-recording layer in a non-image area is removed and a lithographic printing plate is prepared.

That is, in a case where the lithographic printing plate precursor is subjected to image exposure and then directly mounted on a printer without being subjected to any development treatment, or in a case where the lithographic printing plate precursor is mounted on a printer, then subjected to image exposure on the printer, and then supplied with an oil-based ink and an aqueous component for printing, at the initial stage in the middle of printing, in a non-image area, a non-cured image-recording layer is removed by either or both of the supplied oil-based ink and the aqueous component by means of dissolution or dispersion, and the hydrophilic surface is exposed in the non-image area. On the other hand, in an exposed portion, the image-recording layer cured by exposure forms an oil-based ink-receiving portion having a lipophilic surface. Any of the oil-based ink and the aqueous component may be supplied first to the surface of the plate. However, in view of preventing the plate from being contaminated by the components of the image-recording layer from which aqueous components are removed, it is preferable that the oil-based ink be supplied first. **In** the manner described above, the lithographic printing plate precursor is subjected to on-press development on a printer and used as it is for printing a number of sheets. As the oil-based ink and the aqueous component, ordinary printing ink and ordinary dampening water for lithographic printing are suitably used.

As the laser used for performing image exposure on the lithographic printing plate precursor according to the present disclosure, a light source having a wavelength of 300 nm to 450 nm or 750 nm to 1,400 nm is preferably used. A light source of 300 nm to 450 nm is preferable for a lithographic printing plate precursor including an image-recording layer containing sensitizing dye having maximum absorption in such a wavelength range. The light source of 750 nm to 1,400 nm is preferable for the aforementioned lithographic printing plate precursor. As the light source of 300 nm to 450 nm, a semiconductor laser is suitable.

<Development step using developer>

The method for preparing a lithographic printing plate according to the present disclosure may be a method including a step of exposing the lithographic printing plate precursor according to the present disclosure in the shape of an image and a step of preparing a lithographic printing plate by removing the image-recording layer in a non-image area by using a developer (also called "development step using a developer)".

Furthermore, the lithographic printing method according to the present disclosure may be a method including a step of exposing the lithographic printing plate precursor according to the present disclosure in the shape of an image, a step of preparing a lithographic printing plate by removing the image-recording layer in a non-image area by using a developer, and a step of performing printing by using the obtained lithographic printing plate.

As the developer, known developers can be used.

The pH of the developer is not particularly limited, and the developer may be a strongly alkaline developer. Preferable examples of the developer include a developer having a pH of 2 to 11. Preferable examples of the developer having a pH of 2 to 11 include a developer containing at least one kind of component among surfactants and water-soluble polymer compounds.

Examples of the development treatment using a strongly alkaline developer include a method of removing the protective layer by a pre-rinsing step, then performing development using an alkali, rinsing and removing the alkali by a post-rinsing step, performing a gum solution treatment, and performing drying by a drying step.

In a case where the aforementioned developer containing a surfactant or a water-soluble polymer compound is

used, development and the gum solution treatment can be simultaneously performed. In this case, a post-rinsing step is unnecessary, and it is possible to perform both the development and gum solution treatment by using one solution and to subsequently perform a drying step. Furthermore, because the removal of the protective layer can be performed simultaneously with the development and the gum solution treatment, the pre-rinsing step is unnecessary as well. After the development treatment, it is preferable to remove an excess of developer by using a squeeze roller or the like and to subsequently perform drying.

<Printing step>

The lithographic printing method according to the present disclosure includes a printing step of printing a recording medium by supplying printing ink to the lithographic printing plate.

The printing ink is not particularly limited, and various known inks can be used as desired. In addition, as the printing ink, for example, oil-based ink or ultraviolet-curable ink (UV ink) is preferable.

In the printing step, if necessary, dampening water may be supplied.

Furthermore, the printing step may be successively carried out after the on-press development step or the development step using a developer, without stopping the printer.

The recording medium is not particularly limited, and known recording media can be used as desired.

In the method for preparing a lithographic printing plate from the lithographic printing plate precursor according to the present disclosure and in the lithographic printing method according to the present disclosure, if necessary, the entire surface of the lithographic printing plate precursor may be heated as necessary before exposure, in the middle of exposure, or during a period of time from exposure to development. In a case where the lithographic printing plate precursor is heated as above, an image-forming reaction in the image-recording layer is accelerated, which can result in advantages such as improvement of sensitivity and printing durability, stabilization of sensitivity, and the like. Heating before development is preferably carried out under a mild condition of 150°C or lower. In a case where this aspect is adopted, it is possible to prevent problems such as curing of a non-image area. For heating after development, it is preferable to use an extremely severe condition which is preferably in a range of 100°C to 500°C. In a case where this aspect is adopted, a sufficient image-strengthening action is obtained, and it is possible to inhibit problems such as the deterioration of the support or the thermal decomposition of the image area.

Examples

Hereinafter, the present disclosure will be specifically described based on examples, but the present disclosure is not limited thereto. In the present examples, unless otherwise specified, "%" and "part" mean "% by mass" and "part by mass" respectively. Unless otherwise described, the molecular weight of a polymer compound is a weight-average molecular weight (Mw), and the ratio of repeating constitutional units of a polymer compound is expressed as molar percentage. The weight-average molecular weight (Mw) is a value measured by gel permeation chromatography (GPC) and expressed in terms of polystyrene. In addition, unless otherwise specified, the average particle diameter means a volume average particle diameter.

In the examples, the value of $\delta p$ in the Hansen solubility parameters, HOMO and LUMO of the infrared absorber, LUMO of the electron-accepting polymerization initiator, HOMO of the electron-donating polymerization initiator, the average diameter of micropores, the value of L* of the anodic oxide film, the value of water contact angle determined by an airborne water droplet method, the content of silicon atoms, and the dynamic friction coefficient were measured by the methods described above.

<Preparation of support (1)>

(1-a) Alkaline etching treatment

From a spray tube, an aqueous solution of caustic soda having a caustic soda concentration of 26% by mass and an aluminum ion concentration of 6.5% by mass was sprayed onto an aluminum plate at a temperature of 70°C, thereby performing an etching treatment. Then, rinsing was performed by means of spraying. The amount of dissolved aluminum within the surface to be subjected to the electrochemical roughening treatment later was 1.0 g/$m^2$.

(1-b) Desmutting treatment in aqueous acidic solution (first desmutting treatment)

Next, a desmutting treatment was performed in an aqueous acidic solution. In the desmutting treatment, a 150 g/L aqueous sulfuric acid solution was used as the aqueous acidic solution. The liquid temperature was 30°C. The desmutting treatment was performed for 3 seconds by spraying the desmutting liquid. Then, a rinsing treatment was performed.

(1-c) Electrochemical roughening treatment in aqueous hydrochloric acid solution

Next, an electrolytic roughening treatment was performed using alternating current and an electrolytic solution having a hydrochloric acid concentration of 14 g/L, an aluminum ion concentration of 13 g/L, and a sulfuric acid concentration of 3 g/L. The liquid temperature of the electrolytic solution was 30°C. The aluminum ion concentration was adjusted by adding aluminum chloride.

The waveform of the alternating current was a sine wave in which positive and negative waveforms are symmetrical, the frequency was 50 Hz, the ratio of the anodic reaction time and the cathodic reaction time in one cycle of the alternating current was 1:1, and the current density was 75 A/dm$^2$ in terms of the peak current value of the alternating current waveform. In addition, the quantity of electricity was 450 C/dm$^2$ which is the total quantity of electricity used for the aluminum plate to have an anodic reaction, and the electrolysis treatment was performed 4 times by conducting electricity of 125 C/dm$^2$ for 4 seconds at each treatment session. A carbon electrode was used as the counter electrode of the aluminum plate. Then, a rinsing treatment was performed.

(1-d) Alkaline etching treatment

From a spray tube, an aqueous solution of caustic soda having a caustic soda concentration of 5% by mass and an aluminum ion concentration of 0.5% by mass was sprayed onto the aluminum plate having undergone the electrochemical roughening treatment at a temperature of 45°C, thereby performing an etching treatment. The amount of dissolved aluminum within the surface having undergone the electrochemical roughening treatment was 0.2 g/m$^2$. Then, a rinsing treatment was performed.

(1-e) Desmutting treatment in aqueous acidic solution

Next, a desmutting treatment was performed in an aqueous acidic solution. In the desmutting treatment, a waste liquid generated in the anodic oxidation treatment step (170 g/L aqueous sulfuric acid solution containing dissolved aluminum ions at 5.0 g/L) was used as an aqueous acidic solution. The liquid temperature was 30°C. The desmutting treatment was performed for 3 seconds by spraying the desmutting liquid.

(1-f) Anodic oxidation treatment

The aluminum plate having undergone the aformentioned roughening treatment was subjected to an anodic oxidation treatment using a 22% by mass aqueous phosphoric acid solution as an electrolytic solution at a treatment temperature of 38°C and a current density of 15 A/dm$^2$. Then, rinsing was performed by means of spraying. The amount of final oxide film was 1.5 g/m$^2$. The surface of this substrate was imaged using an electron microscope at 150,000X magnification, and diameters of pores (n =90) were measured to obtain the average which was 30 nm.

<Preparation of support (2)>

After (1-f) Anodic oxidation treatment which was the final step of Preparation of support (1) described above, the following (2-g) Hydrophilizing treatment was performed, thereby preparing a support (2).

(2-g) Hydrophilizing treatment

In order to ensure the hydrophilicity of the non-image area, the obtained aluminum plate was dipped in a 2.5% by mass No. 3 aqueous sodium silicate solution at 50°C for 7 seconds, thereby performing a silicate treatment. The amount of Si adhered was 10.0 mg/m$^2$. Then, rinsing was performed by means of spraying.

<Preparation of support (3)>

(3-a) Mechanical roughening treatment (brush graining method)

By using the device shown in Fig. 5, a pumice suspension (specific gravity: 1.1 g/cm$^3$) as a polishing slurry liquid was supplied to the surface of an aluminum plate, and in this state, a mechanical roughening treatment was performed using a rotating bundled brush. In Fig. 5, 1 represents an aluminum plate, 2 and 4 represent roller-shaped brushes (bundled brushes in the present example), 3 represents a polishing slurry liquid, and 5, 6, 7, and 8 represent support rollers.

In the mechanical roughening treatment, an abrasive having a median diameter (μm) of 30 μm and 4 brushes were used, and the rotation speed of the brushes was set to 250 rpm. The bundled brush was made of 6·10 nylon and

consisted of bristles having a diameter of 0.3 mm and a length of 50 mm. The brush was prepared by making holes in a φ 300 mm stainless steel cylinder and densely implanting bristles therein. The distance between two support rollers (φ 200 mm) under the bundled brush was 300 mm. The bundled brush was pressed until the load of the drive motor for rotating the brush was 10 kW higher than the load applied before the bundled brush was pressed on the aluminum plate. The direction of rotation of the brush was the same as the direction of movement of the aluminum plate.

(3-b) Alkaline etching treatment

From a spray tube, an aqueous solution of caustic soda having a caustic soda concentration of 26% by mass and an aluminum ion concentration of 6.5% by mass was sprayed onto the aluminum plate obtained above at a temperature of 70°C, thereby performing an etching treatment. Then, rinsing was performed by means of spraying. The amount of dissolved aluminum was 10 $g/m^2$.

(3-c) Desmutting treatment in aqueous acidic solution

Next, a desmutting treatment was performed in an aqueous nitric acid solution. As the aqueous nitric acid solution used in the desmutting treatment, the waste liquid of nitric acid used in the next step, electrochemical roughening, was used. The liquid temperature was 35°C. The desmutting treatment was performed for 3 seconds by spraying the desmutting liquid.

(3-d) Electrochemical roughening treatment

An electrochemical roughening treatment was continuously performed using nitric acid as an electrolyte at an alternating current voltage of 60 Hz. In this treatment, an electrolytic solution was used which was prepared by adding aluminum nitrate to 10.4 g/L aqueous nitric acid solution at a temperature of 35°C so that the aluminum ion concentration was adjusted to 4.5 g/L. By using an alternating current power source having the waveform shown in Fig. 3, alternating current having a trapezoidal rectangular waveform, and a carbon electrode as a counter electrode, an electrochemical roughening treatment was performed under the conditions of a time tp taken for the current value to reach the peak from zero of 0.8 msec and the duty ratio of 1:1. As an auxiliary anode, ferrite was used. The electrolytic cell shown in Fig. 4 was used. The current density was 30 $A/dm^2$ in terms of the peak value of current, and 5% of the current coming from the power source was allowed to flow into the auxiliary anode. The quantity of electricity ($C/dm^2$) was 185$C/dm^2$, which is the total quantity of electricity used during the anodization of the aluminum plate. Then, rinsing was performed by means of spraying.

(3-e) Alkaline etching treatment

From a spray tube, an aqueous solution of caustic soda having a caustic soda concentration of 27% by mass and an aluminum ion concentration of 2.5% by mass was sprayed onto the aluminum plate obtained above at a temperature of 50°C, thereby performing an etching treatment. Then, rinsing was performed by means of spraying. The amount of dissolved aluminum was 3.5 $g/m^2$.

(3-f) Desmutting treatment in aqueous acidic solution

Next, a desmutting treatment was performed in an aqueous sulfuric acid solution. The aqueous sulfuric acid solution used in the desmutting treatment had a sulfuric acid concentration of 170 g/L and an aluminum ion concentration of 5 g/L. The liquid temperature was 30°C. The desmutting treatment was performed for 3 seconds by spraying the desmutting liquid.

(3-g) Electrochemical roughening treatment

An electrochemical roughening treatment was continuously performed using hydrochloric acid as an electrolyte at an alternating current voltage of 60 Hz. An electrolytic solution was used which was prepared by adding aluminum chloride to 6.2 g/L aqueous hydrochloric acid solution at a temperature of 35°C so that the aluminum ion concentration was adjusted to 4.5 g/L. By using an alternating current power source having the waveform shown in Fig. 3, alternating current having a trapezoidal rectangular waveform, and a carbon electrode as a counter electrode, an electrochemical roughening treatment was performed under the conditions of a time tp taken for the current value to reach the peak from zero of 0.8 msec and the duty ratio of 1:1. As an auxiliary anode, ferrite was used. The electrolytic cell shown in Fig. 4 was used.
The current density was 25 $A/dm^2$ in terms of the peak value of current, and the quantity of electricity ($C/dm^2$)

during the hydrochloric acid electrolysis was 63 C/dm$^2$ which is the total quantity of electricity used during the anodization of the aluminum plate. Then, rinsing was performed by means of spraying.

(3-h) Alkaline etching treatment

From a spray tube, an aqueous solution of caustic soda having a caustic soda concentration of 5% by mass and an aluminum ion concentration of 0.5% by mass was sprayed onto the aluminum plate obtained above at a temperature of 60°C, thereby performing an etching treatment. Then, rinsing was performed by means of spraying. The amount of dissolved aluminum was 0.2 g/m$^2$.

(3-i) Desmutting treatment in aqueous acidic solution

Next, a desmutting treatment was performed in an aqueous sulfuric acid solution. Specifically, by using a waste liquid generated in the anodic oxidation treatment step (170 g/L aqueous nitric acid solution containing dissolved aluminum ions at a concentration of 5 g/L), the desmutting treatment was performed for 4 seconds at a liquid temperature of 35°C. The desmutting treatment was performed for 3 seconds by spraying the desmutting liquid.

(3-j) Anodic oxidation treatment

By using the anodic oxidation device for direct current electrolysis having the structure shown in Fig. 6, a first-stage anodic oxidation treatment was performed. The anodic oxidation treatment was performed at a sulfuric acid concentration of electrolytic solution of 170 g/L, electrolytic solution temperature of 50°C, and a current density of 30 A/dm$^2$, thereby forming an anodic oxide film having a film thickness of 110 nm.

In an anodic oxidation treatment device 610, an aluminum plate 616 is transported as indicated by the arrow in Fig. 6. In a power supply tank 612 containing an electrolytic solution 618, the aluminum plate 616 is positively (+) charged by a power supply electrode 620. Then, the aluminum plate 616 is transported upwards by a roller 622 in the power supply tank 612, makes a turn downwards by a nip roller 624, then transported toward an electrolytic treatment tank 614 containing an electrolytic solution 626, and makes a turn by a roller 628 so as to move in the horizontal direction. Subsequently, the aluminum plate 616 is negatively (-) charged by an electrolysis electrode 630. As a result, an anodic oxide film is formed on the surface of the aluminum plate 616. The aluminum plate 616 exits from the electrolytic treatment tank 614 and is then transported for the next step. In the anodic oxidation treatment device 610, the roller 622, the nip roller 624, and the roller 628 constitute a direction change unit. Furthermore, in the inter-tank portion between the power supply tank 612 and the electrolytic treatment tank 614, the aluminum plate 616 is transported in a ridge shape and an inverted U shape by the rollers 622, 624, and 628. The power supply electrode 620 and the electrolysis electrode 630 are connected to a direct current power source 634.

(3-k) Pore widening treatment

The aluminum plate having undergone the above anodic oxidation treatment was immersed in an aqueous solution of caustic soda at a temperature of 35°C and having a caustic soda concentration of 5% by mass and an aluminum ion concentration of 0.5% by mass under the following conditions, thereby performing a pore widening treatment. Then, rinsing was performed by means of spraying.

(3-l) Second-stage anodic oxidation treatment

By using the anodic oxidation device for direct current electrolysis having the structure shown in Fig. 6, a second-stage anodic oxidation treatment was performed. The anodic oxidation treatment was performed at a sulfuric acid concentration of electrolytic solution of 170 g/L, electrolytic solution temperature of 50°C, and a current density of 13 A/dm$^2$, thereby forming an anodic oxide film having a film thickness of 820 nm.

(3-m) Second-stage anodic oxidation treatment

By using the anodic oxidation device for direct current electrolysis having the structure shown in Fig. 6, a third-stage anodic oxidation treatment was performed. The anodic oxidation treatment was performed at a sulfuric acid concentration of electrolytic solution of 170 g/L, electrolytic solution temperature of 40°C, and a current density of 15 A/dm$^2$, thereby forming an anodic oxide film having a film thickness of 100 nm.

(3-n) Hydrophilizing treatment

In order to ensure the hydrophilicity of the non-image area, the obtained aluminum plate was dipped in a 2.5% by mass No. 3 aqueous sodium silicate solution at 50°C for 7 seconds, thereby performing a silicate treatment. The amount of Si adhered was 10.0 mg/$m^2$. Then, rinsing was performed by means of spraying.

<Preparation of support (4)>

A support (4) was prepared through the same steps and under the same conditions as those used for the support (3), except that the treatment temperature in (3-h) Alkaline etching treatment was changed to 70°C. The amount of dissolved aluminum was 0.4 g/$m^2$.

<Preparation of support (5)>

A support (5) was prepared through the same steps as those used for the support (4), except that the treatment temperature in (3-e) Alkaline etching treatment was changed to 30°C. The amount of dissolved aluminum was 1 g/$m^2$.

<Preparation of support (6)>

In order to obtain an average roughness (Ra) of 0.4 μm, an infrared-sensitive negative tone lithographic printing plate precursor was prepared using a substrate composed of an aluminum plate having undergone an electrolytic roughening treatment in a hydrochloric acid solution. Then, the aluminum plate was subjected to an anodic oxidation treatment in an aqueous phosphoric acid solution, thereby forming a 1.1 g/$m^2$ oxide film. Thereafter, the aluminum plate was coated with a post-treatment aqueous solution of poly(acrylic acid), thereby obtaining a dry thickness of 0.03 g/$m^2$.

(Examples 1 to 30 and Comparative Examples 1 and 2)

<Preparation of lithographic printing plate precursor>

The lithographic printing plate precursors of Examples 1 to 30 and Comparative Examples 1 and 2 were prepared by the following method.

The aluminum support described in Table 1 or Table 2 was coated with the coating solution for an undercoat layer described in Table 1 or Table 2 so that the dry coating amount was 20 mg/$m^2$, thereby forming an undercoat layer. The undercoat layer was bar-coated with the coating solution for an image-recording layer described in Table 1 or Table 2, and dried in an oven at 120°C for 40 seconds, thereby forming an image-recording layer having a dry coating amount of 1.0 g/$m^2$.

For the lithographic printing plate precursor having no undercoat layer, the aluminum support described in Table 1 was bar-coated with a coating solution (1) for an image-recording layer under the same conditions as described above, thereby forming an image-recording layer having a dry coating amount of 1.0 g/$m^2$.

For the lithographic printing plate precursor having an overcoat layer (protective layer), the image-recording layer was bar-coated with any of the following coating solutions (1) to (3) for a protective layer, and dried in an oven at 120°C for 60 seconds, thereby forming a protective layer having the dry coating amount (g/$m^2$) described in Formation of protective layers (1) to (3) described below.

The types of the undercoat layer, the image-recording layer, or the protective layer described in Table 1 or Table 2 represent the types of the coating solution for an undercoat layer, the coating solution for an image-recording layer, or the coating solution for a protective layer used for forming the undercoat layer, the image-recording layer, or the protective layer.

<Preparation of coating solution for undercoat layer>

The coating solution for an undercoat layer having the following composition was prepared.

<<Coating solution (1) for undercoat layer>>

· Compound for undercoat layer (UC-1) [the following structure]: 0.18 parts by mass
· Surfactant (EMALEX 710, manufactured by NIHON EMULSION Co., Ltd.): 0.03 parts by mass

· Water: 28.0 parts by mass

<<Coating solution (2) for undercoat layer>>

· Compound for undercoat layer (UC-1) [the following structure]: 0.18 parts by mass
· Surfactant (EMALEX 710, manufactured by NIHON EMULSION Co., Ltd.): 0.03 parts by mass
· Sodium gluconate: 0.05 parts by mass
· Water: 28.0 parts

(UC-1)

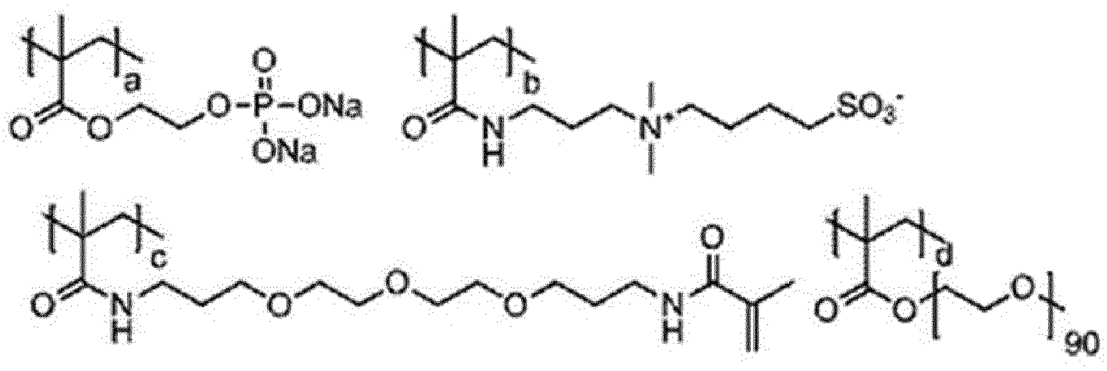

a / b / c / d = 14.2 / 71.8 / 9.0 / 5.0 (% by mass)
a / b / c / d = 19.0 / 72.8 / 7.8 / 0.4 (mol%)
Weight-average molecular weight = 200,000

A synthesis example of a polymer (U-1) used as a compound (UC-1) for undercoat layer will be described below.

-Synthesis of polymer (U-1)-

<<Purification of monomer UM-1>>

LIGHT ESTER P-1M (2-methacryloyloxyethyl acid phosphate, manufactured by KYOEISHA CHEMICAL Co., LTD.) (420 parts), 1,050 parts of diethylene glycol dibutyl ether, and 1,050 parts of distilled water were added to a separatory funnel, vigorously stirred, and then left to stand. The upper layer was discarded, 1,050 parts of diethylene glycol dibutyl ether was then added thereto, the solution was vigorously stirred, and then left to stand. The upper layer was discarded, thereby obtaining 1,300 parts of an aqueous solution of a monomer UM-1 (10.5% by mass in terms of solid contents).

<<Synthesis of polymer (U-1)>>

Distilled water (53.73 parts) and 3.66 parts of the following monomer UM-2 were added to a three-neck flask, and heated to 55°C in a nitrogen atmosphere. Then, the following dripping liquid 1 was added dropwise thereto for 2 hours, the obtained solution was stirred for 30 minutes, and 0.386 parts of VA-046B (manufactured by FUJIFILM Wako Pure Chemical Corporation) was added thereto. The solution was heated to 80°C and stirred for 1.5 hours. The reaction solution was returned to room temperature (25°C), a 30% by mass aqueous sodium hydroxide solution was added thereto so that the pH was adjusted to 8.0, and then 0.005 parts of 4-hydroxy-2,2,6,6-tetramethylpiperidin-1--oxyl (4-OH-TEMPO) was added thereto. By the above operation, 180 parts of an aqueous solution of the polymer (U-1) was obtained. The weight-average molecular weight (Mw) thereof was 200,000 that was measured by gel permeation chromatography (GPC) and expressed in terms of polyethylene glycol.

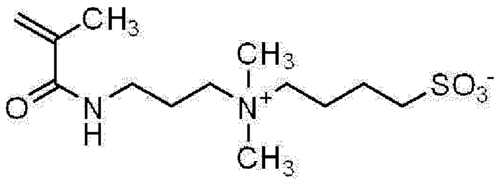

Monomer UM-2

<<Composition of dripping liquid 1>>

·Aqueous solution of the monomer UM-1: 87.59 parts
·The above monomer UM-2: 14.63 parts
·VA-046B (2,2'-azobis[2-(2-imidazolin-2-yl)propane] disulfate dihydrate, manufactured by FUJIFILM Wako Pure Chemical Corporation): 0.386 parts
·Distilled water: 20.95 parts

<Formation of protective layer (1)>

The image-recording layer was coated with a coating solution (1) for a protective layer having the following composition so that the dry coating amount was 1.0 g/$m^2$, thereby forming a protective layer (1).

<<Coating solution (1) for a protective layer>>

PVA-205: 0.658 parts by mass (partially hydrolyzed polyvinyl alcohol, manufactured by Kuraray Co., Ltd. (saponification degree: 86.5 to 89.5 mol%, viscosity = 4.6 to 5.4 mPa · s (20°C, in 4% by mass aqueous solution))
PVA-105: 0.142 parts by mass (fully hydrolyzed polyvinyl alcohol, manufactured by Kuraray Co., Ltd. (saponification degree: 98.0 to 99.0 mol%, viscosity = 5.2 to 6.0 mPa · s (20°C, in 4% by mass aqueous solution))
Poly(vinylpyrrolidone/vinyl acetate (1/1)) (molecular weight 70,000): 0.001 part by mass
Surfactant (EMALEX 710, manufactured by NIHON EMULSION Co., Ltd.): 0.002 parts by mass
· Water: 13 parts by mass

<Formation of protective layer (2)>

The image-recording layer was coated with a coating solution (1) for a protective layer having the above composition so that the dry coating amount was 2.0 g/$m^2$, thereby forming a protective layer (2).

<Formation of protective layer (3)>

The image-recording layer was coated with a coating solution (2) for a protective layer having the following composition so that the dry coating amount was 1.0 g/$m^2$, thereby forming a protective layer (3).

<<Coating solution (2) for protective layer>>

METOLOSE SM-04: 0.800 parts by mass (methyl cellulose, manufactured by Shin-Etsu Chemical Co., Ltd.)
Surfactant (EMALEX 710, manufactured by NIHON EMULSION Co., Ltd.): 0.002 parts by mass
· Water: 13 parts by mass

<Formation of image-recording layer (1)>

A support was coated with a coating solution (1) for an image-recording layer having the following composition so that the dry coating amount was 0.9 g/$m^2$, thereby forming an image-recording layer (1).

<<Coating solution (1) for image-recording layer>>

·Polymerizable compound A [the following structure]: 1.50 parts by mass

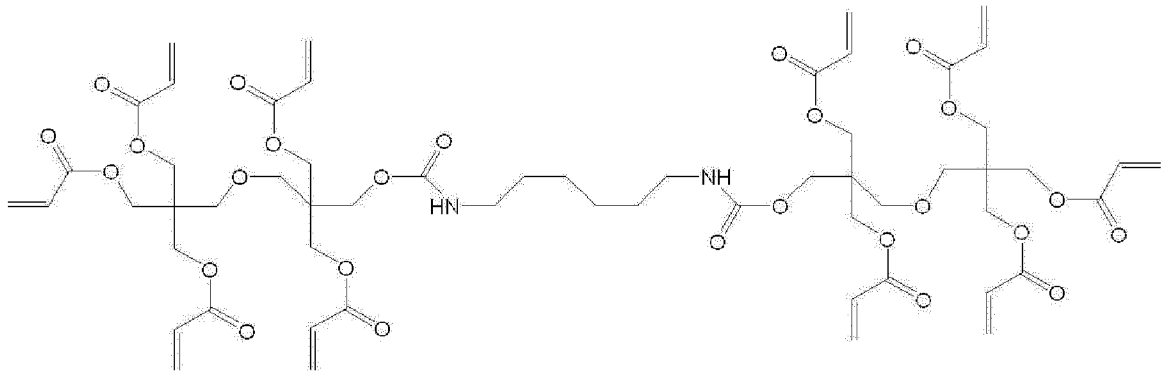

·Addition polymerization-type resin A [the following structure]: 7.14 parts by mass, n = 40 to 50, weight-average molecular weight = 90,000

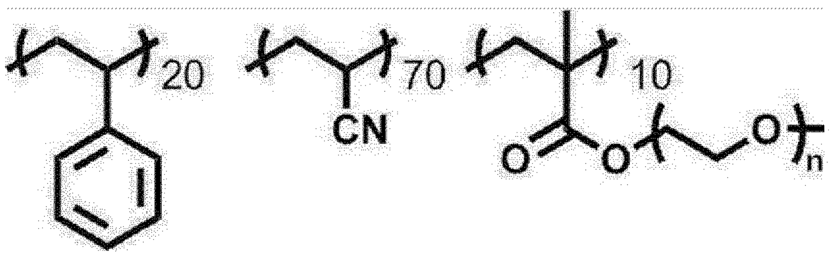

A

In Examples 21 and 22, an image-recording layer was formed using a coating solution (1) for an image-recording layer having the same composition as the coating solution (1) for an image-recording layer described above, except that the addition polymerization-type resin A in the composition of the coating solution (1) for an image-recording layer was changed to the addition polymerization-type resin D or E described in Table 1. Details of the addition polymerization-type resins D and E are as follows.

·Addition polymerization-type resin D [the following structure]: 7.14 parts by mass, m = 9, n = 45, weight-average molecular weight = 50,000

·Addition polymerization-type resin E [the following structure]: 7.14 parts by mass, m = 9, n = 45, weight-average molecular weight = 50,000

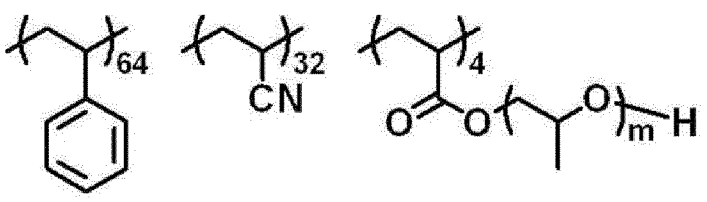

D

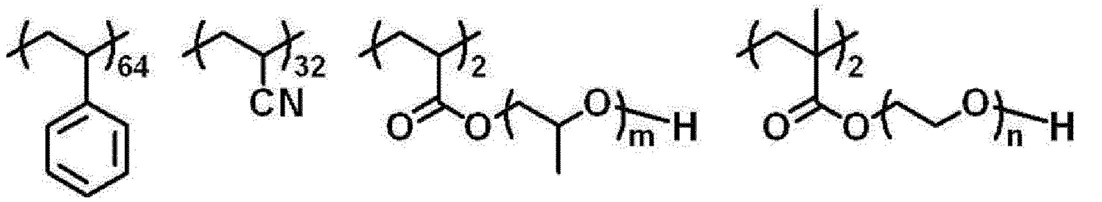

E

·Hydroxypropyl methylcellulose: 0.20 parts by mass

·Electron-accepting polymerization initiator A [the following structure]: 0.50 parts by mass, LUMO = -3.25 eV

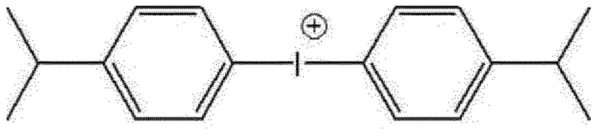

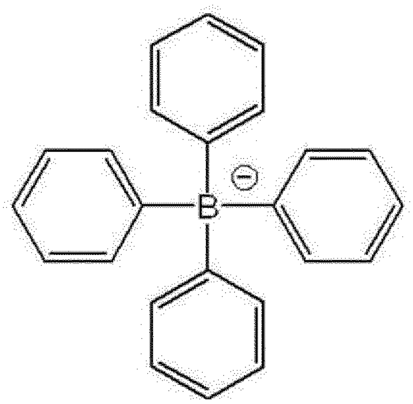

·Tetraphenyl borate [the following structure]: 0.15 parts by mass, HOMO = -5.91 eV

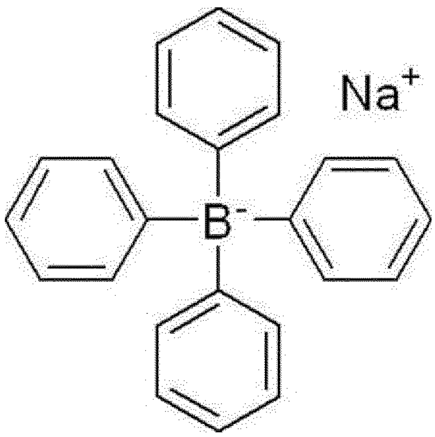

·Infrared absorbing dye A [the following structure]: 0.25 parts by mass, HOMO = -5.43 eV, LUMO = -3.8 eV

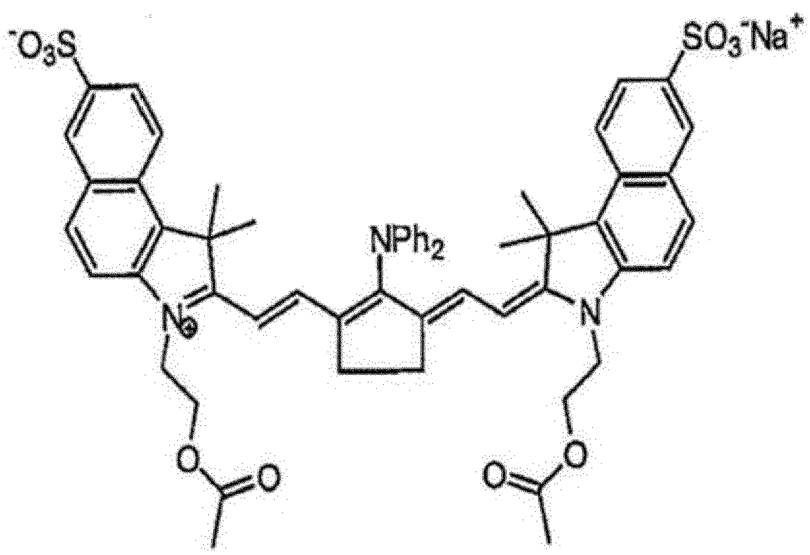

·BYK336: 0.05 parts by mass
·N-Propanol: 40.00 parts by mass
·Water: 20.00 parts by mass
·2-Butanone: 20.00 parts by mass

<Formation of image-recording layer (2)>

A support was coated with a coating solution (2) for an image-recording layer having the following composition so that the dry coating amount was 0.9 g/m$^2$, thereby forming an image-recording layer (2).

<<Coating solution (2) for image-recording layer>>

·Polymerizable compound A [the above structure]: 1.50 parts by mass
·Addition polymerization-type resin A [the above structure]: 7.14 parts by mass
·Hydroxypropyl methylcellulose: 0.20 parts by mass
·Electron-accepting polymerization initiator B [the following structure]: 0.50 parts by mass, LUMO = -3.02 eV

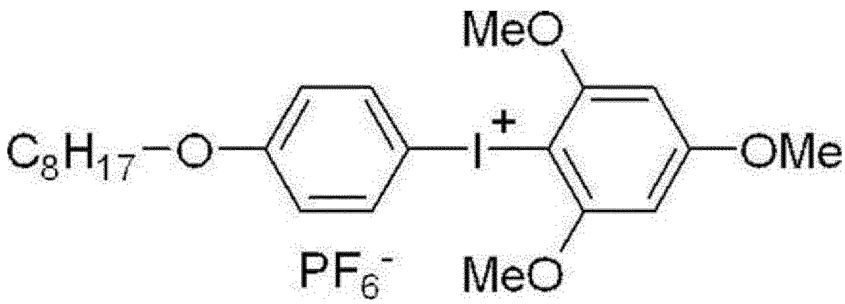

·Tetraphenyl borate [the above structure]: 0.15 parts by mass
·Infrared absorbing dye B [the following structure]: 0.25 parts by mass, HOMO = -5.27 eV, LUMO = -3.66 eV

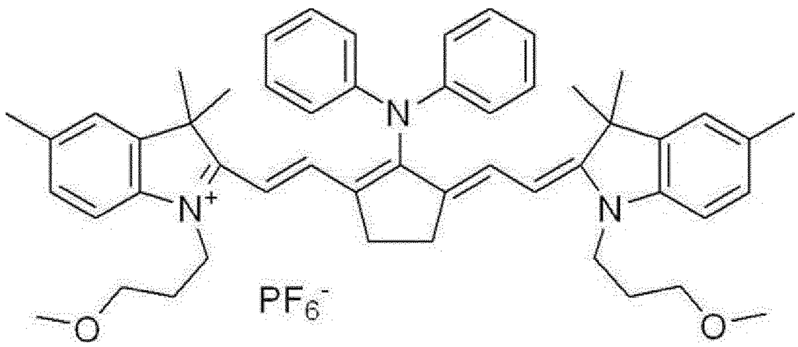

·BYK336: 0.05 parts by mass
·N-Propanol: 40.00 parts by mass
·Water: 20.00 parts by mass
·2-Butanone: 20.00 parts by mass

<Formation of image-recording layer (3)>

A support was coated with a coating solution (3) for an image-recording layer having the following composition so that the dry coating amount was 0.9 g/m$^2$, thereby forming an image-recording layer (3).

<<Coating solution (3) for image-recording layer>>

·Polymerizable compound B [the following structure]: 1.50 parts by mass

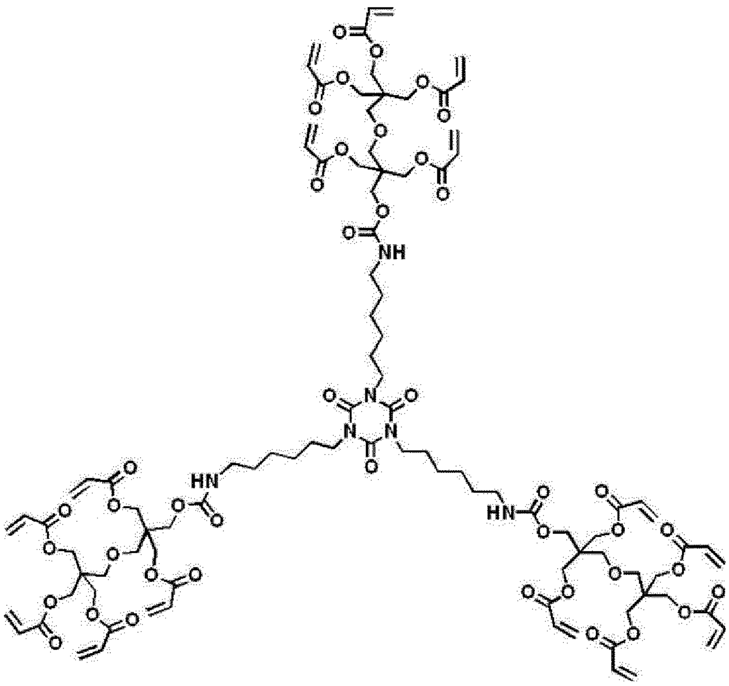

·Addition polymerization-type resin A [the above structure]: 7.14 parts by mass
·Hydroxypropyl methylcellulose: 0.20 parts by mass
·Electron-accepting polymerization initiator B [the above structure]: 0.50 parts by mass
·Tetraphenyl borate [the above structure]: 0.15 parts by mass
·Infrared absorbing dye B [the above structure]: 0.25 parts by mass
·BYK336: 0.05 parts by mass
·N-Propanol: 40.00 parts by mass
·Water: 20.00 parts by mass
·2-Butanone: 20.00 parts by mass

<Formation of image-recording layer (4)>

A support was coated with a coating solution (4) for an image-recording layer having the following composition so that the dry coating amount was 0.9 g/m$^2$, thereby forming an image-recording layer (4).

<<Coating solution (4) for image-recording layer>>

·Polymerizable compound B [the above structure]: 1.50 parts by mass
·Addition polymerization-type resin A [the above structure]: 7.14 parts by mass
·Hydroxypropyl methylcellulose: 0.20 parts by mass
·Electron-accepting polymerization initiator B [the above structure]: 0.50 parts by mass
·Tetraphenyl borate [the above structure]: 0.15 parts by mass
·Infrared absorbing dye C [the following structure]: 0.25 parts by mass, HOMO = -5.35 eV, LUMO = -3.73 eV

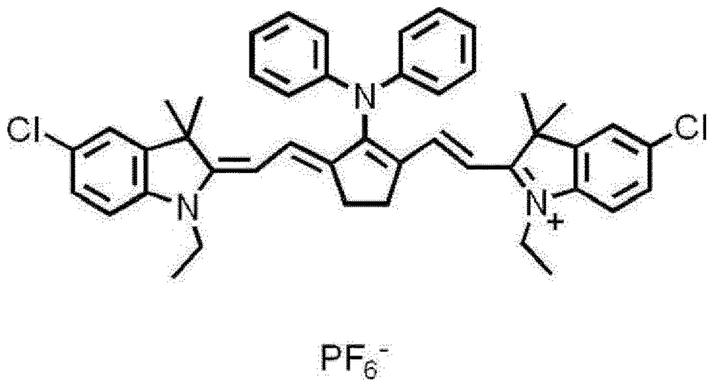

·BYK336: 0.05 parts by mass
·N-Propanol: 40.00 parts by mass
·Water: 20.00 parts by mass
·2-Butanone: 20.00 parts by mass

<Formation of image-recording layer (5)>

A support was coated with a coating solution (5) for an image-recording layer having the following composition so that the dry coating amount was 0.9 g/m$^2$, thereby forming an image-recording layer (5).

<<Coating solution (5) for image-recording layer>>

·Polymerizable compound B [the above structure]: 1.50 parts by mass
·Polymerizable compound C [the following structure]: 1.00 part by mass

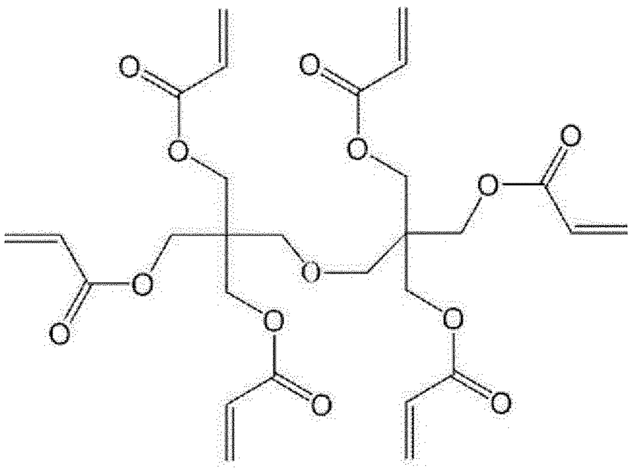

Chemical Formula: $C_{28}H_{34}O_{13}$
Exact Mass: 578.200

·Addition polymerization-type resin A [the above structure]: 7.14 parts by mass
·Hydroxypropyl methylcellulose: 0.20 parts by mass
·Electron-accepting polymerization initiator B [the above structure]: 0.50 parts by mass
·Tetraphenyl borate [the above structure]: 0.15 parts by mass
·Infrared absorbing dye C [the above structure]: 0.25 parts by mass
·BYK336: 0.05 parts by mass
·N-Propanol: 40.00 parts by mass

·Water: 20.00 parts by mass
·2-Butanone: 20.00 parts by mass

<Formation of image-recording layer (6)>

A support was coated with a coating solution (6) for an image-recording layer having the following composition so that the dry coating amount was 0.9 g/$m^2$, thereby forming an image-recording layer (6).

<<Coating solution (6) for image-recording layer>>

·Polymerizable compound A [the above structure]: 1.50 parts by mass
·Addition polymerization-type resin A [the above structure]: 7.14 parts by mass
·Addition polymerization-type resin B [the following structure, weight-average molecular weight: 90,000]: 3.00 parts by mass

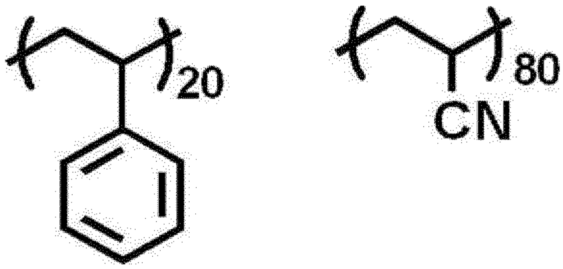

·Hydroxypropyl methylcellulose: 0.20 parts by mass
·Electron-accepting polymerization initiator A [the above structure]: 0.50 parts by mass
·Tetraphenyl borate [the above structure]: 0.15 parts by mass
·Infrared absorbing dye A [the above structure]: 0.25 parts by mass
·BYK336: 0.05 parts by mass
·N-Propanol: 40.00 parts by mass
·Water: 20.00 parts by mass
·2-Butanone: 20.00 parts by mass

<Formation of image-recording layer (7)>

A support was coated with a coating solution (7) for an image-recording layer having the following composition so that the dry coating amount was 0.9 g/$m^2$, thereby forming an image-recording layer (7).

<<Coating solution (7) for image-recording layer>>

·Polymerizable compound B [the above structure]: 1.50 parts by mass
·Polymerizable compound C [the above structure]: 1.00 part by mass
·Addition polymerization-type resin A [the above structure]: 7.14 parts by mass
·Hydroxypropyl methylcellulose: 0.20 parts by mass
·Electron-accepting polymerization initiator C [the above structure]: 0.50 parts by mass
·Tetraphenyl borate [the above structure]: 0.15 parts by mass
·Infrared absorbing dye D [the following structure]: 0.25 parts by mass, HOMO = -5.35 eV, LUMO = -3.73 eV

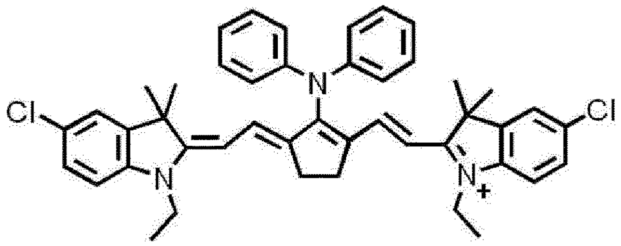

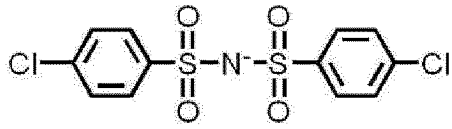

·BYK336: 0.05 parts by mass
·N-Propanol: 40.00 parts by mass
·Water: 20.00 parts by mass
·2-Butanone: 20.00 parts by mass

<Formation of image-recording layer (8)>

A support was coated with a coating solution (8) for an image-recording layer having the following composition so that the dry coating amount was 0.9 g/m$^2$, thereby forming an image-recording layer (8).

<<Coating solution (8) for image-recording layer>>

·Polymerizable compound B [the above structure]: 1.50 parts by mass
·Polymerizable compound C [the above structure]: 1.00 part by mass
·Addition polymerization-type resin A [the above structure]: 7.14 parts by mass
·Hydroxypropyl methylcellulose: 0.20 parts by mass
·Electron-accepting polymerization initiator C [the above structure]: 0.50 parts by mass
·Tetraphenyl borate [the above structure]: 0.15 parts by mass
·Infrared absorbing dye D [the above structure]: 0.25 parts by mass
·Color developing agent S-15 [the above structure]: 0.15 parts by mass, trade name: S-205 (manufactured by Fukui Yamada Chemical Co., Ltd.)
·BYK336: 0.05 parts by mass
·N-Propanol: 40.00 parts by mass
·Water: 20.00 parts by mass
·2-Butanone: 20.00 parts by mass

In Examples 23 to 30, an image-recording layer was formed using a coating solution (8) for an image-recording layer having the same composition as the aforementioned coating solution (8) for an image-recording layer, except that a color developing agent S-15 in the composition of the coating solution (8) for an image-recording layer was changed to the color developing agent (leuco colorant having a fluoran structure) described in Table 2, and the amount of the color developing agent added was changed as described in Table 2.

<Formation of image-recording layer (9)>

A support was coated with a coating solution (9) for an image-recording layer having the following composition so that the dry coating amount was 0.9 g/m$^2$, thereby forming an image-recording layer (9).

<<Coating solution (9) for image-recording layer>>

·Polymerizable compound C [the above structure]: 1.50 part by mass
·Addition polymerization-type resin A [the above structure]: 7.14 parts by mass
·Hydroxypropyl methylcellulose: 0.20 parts by mass
·Electron-accepting polymerization initiator B [the above structure]: 0.50 parts by mass
·Tetraphenyl borate [the above structure]: 0.15 parts by mass
·Infrared absorbing dye B [the above structure]: 0.25 parts by mass

·BYK336: 0.05 parts by mass
·N-Propanol: 40.00 parts by mass
·Water: 20.00 parts by mass
·2-Butanone: 20.00 parts by mass

<Formation of image-recording layer (10)>

A support was coated with a coating solution (10) for an image-recording layer having the following composition so that the dry coating amount was 0.9 g/m$^2$, thereby forming an image-recording layer (10).

<<Coating solution (10) for image-recording layer>>

·Polymerizable compound B [the above structure]: 1.50 parts by mass
·Polymerizable compound C [the above structure]: 1.00 part by mass
·Addition polymerization-type resin A [the above structure]: 7.14 parts by mass
·Hydroxypropyl methylcellulose: 0.20 parts by mass
·Polymerization initiator C [the following structure]: 0.50 parts by mass
·Tetraphenyl borate [the above structure]: 0.15 parts by mass
·Infrared absorbing dye D [the following structure]: 0.25 parts by mass
·Color developing agent S-14: leuco colorant having fluoran structure, 0.15 parts by mass, Red-40 (manufactured by Yamamoto Chemicals, Inc.)
·BYK336: 0.05 parts by mass
·N-Propanol: 40.00 parts by mass
·Water: 20.00 parts by mass
·2-Butanone: 20.00 parts by mass

<Evaluation>

[Suppression of scratches and contamination]

In Luxel PLATESETTER T-6000III manufactured by FUJIFILM Corporation that was equipped with an infrared semiconductor laser, each of the obtained lithographic printing plate precursors was exposed under the conditions of outer drum rotation speed of 1,000 rpm (revolutions per minute), a laser output of 70%, and resolution of 2,400 dpi (dot per inch). After the exposure treatment, the lithographic printing plate obtained in an environment of a temperature of 25°C and a humidity of 70% was scratched by a scratch tester.

As the scratch tester, HEIDON scratching Intersity TESTER HEIDEN-18 was used. In addition, a sapphire needle having a diameter of 0.1 mm was used, and the scratch load was set to 50 (g). Without being subjected to a development treatment, the scratched plate was mounted on the plate cylinder of DIA IF2 printer manufactured by Mitsubishi Heavy Industries, Ltd. By using dampening water containing IF102 (manufactured by FUJIFILM Corporation)/tap water = 3/97 (volume ratio) and Values-G(N) black ink (manufactured by DIC Corporation), on-press development was performed by supplying the dampening water and the ink according to the standard automatic printing start method of DIA IF2. Then, printing was performed using TOKUBISHI art paper (ream weight: 76.5 kg) at a printing rate of 10,000 sheets/hour, and whether the scratched portion turned into a printing stain was evaluated. The results are shown in Table 1.

In addition, regarding the intermediate points such as 9 points and 7 points, in a case the scratches and contamination of an example is in the intermediate level of the evaluation standard of upper limit, the intermediate points were given to the example. The evaluation standards of 10 to 6 points are preferable.

-Evaluation standard-

10 points: The scratched portion does not turn into a printing stain.
8 points: Slight printing stains that cannot be visually identified are observed on the scratched portion.
6 points: Slight printing stains are visually observed on the scratched portion.
4 points: Printing stains are visually observed on the scratched portion.
2 points: Noticeable printing stains are observed on the scratched portion.

[Printing durability]

In Luxel PLATESETTER T-6000III manufactured by FUJIFILM Corporation that was equipped with an infrared semiconductor laser, each of the obtained lithographic printing plate precursors was exposed under the conditions of outer drum rotation speed of 1,000 rpm, a laser output of 70%, and resolution of 2,400 dpi (dot per inch). The exposure image included a solid image, 3% halftone dots of TAFFET A20 (FM screen), and a chart of Mincho 7-point white letters. Note that 1 inch = 25.4 mm.

Without being subjected to a development treatment, the exposed lithographic printing plate precursor was mounted on the plate cylinder of DIA IF2 printer manufactured by Mitsubishi Heavy Industries, Ltd. By using dampening water containing IF102 (manufactured by FUJIFILM Corporation)/tap water = 3/97 (volume ratio) and Values-G(N) black ink (manufactured by DIC Corporation), on-press development was performed by supplying the dampening water and the ink according to the standard automatic printing start method of DIA IF2. Then, printing was performed using TOKUBISHI art paper (ream weight: 76.5 kg) at a printing rate of 10,000 sheets/hour.

After performing the on-press development as above, printing was further continued. As the number of printed sheets increased, the image-recording layer gradually worn out, and thus the ink density on the printed matter decreased. For the FM screen 3% halftone dots in the printed matter, the area ratio of the halftone dots was measured using a Gretag density meter. The number of printed sheets at a point in time when the measured area ratio was 5% lower than the area ratio measured after 100 sheets were printed was adopted as the number of completely printed sheets and used for evaluation of printing durability. The results are shown in Table 1.

The larger the number of completely printed sheets, the better the printing durability.

[Visibility (color developability)]

In Trendsetter 3244VX manufactured by Creo that was equipped with a water cooling-type 40 W infrared semiconductor laser, each of the obtained lithographic printing plate precursors was exposed under the conditions of an output of 11.5 W, an outer drum rotation speed of 220 rpm, and a resolution of 2,400 dpi (dot per inch, 1 inch = 25.4 mm). The exposure was carried out in an environment of 25°C and 50% RH.

Immediately after exposure, the precursor was stored for 2 hours in a dark place (25°C), and then color development of the lithographic printing plate precursor was measured. The measurement was performed by a specular component excluded (SCE) method by using a spectrocolorimeter CM2600d and operation software CM-S100W that are manufactured by Konica Minolt, Inc. The color developability was evaluated by a difference ΔL between an L* value of the exposed portion and an L* value of the non-exposed portion by using L* values of the L*a*b* color space.

It can be said that the higher the value of ΔL, the better the color developability. Color developability is an indicator of visibility.

[Suppression of residues of on-press development]

Printing was performed to evaluate UV printing durability described above, and then the state where the removed residues adhered to the dampening roller was evaluated. In this way, the development residues generated during on-press development were evaluated.

The indicators are as follows. The larger the value, the further the development residues are suppressed.

5: No residue is found on the dampening roller.
4: Few residues are found on the dampening roller.
3: Residues are found on the dampening roller.
2: Many residues are found on the dampening roller.
1: There are so many residues found on the dampening roller.

[Table 1]

| | | Aluminum support | | | | | Undercoat layer | Image-recording layer | | | | | | | | | | | Protective layer | Evaluation | | | |
|---|---|---|---|---|---|---|---|---|---|---|---|---|---|---|---|---|---|---|---|---|---|---|---|
| | | Type | Surface contact angle | Si amount (mg/m²) | ΔS (%) | a45 (%) | Type | Type | Polymerizable compound | Addition polymerization-type resin | Infrared absorber | | | Electron-accepting polymerization initiator | | Electron-donating polymerization initiator | | Color developing agent | | Dynamic friction coefficient | Suppression of scratches and contamination | Printing durability (×10,000 sheets) | Suppression of residues of on-press development |
| | | | | | | | | | Type | Type | Type | HOMO (eV) | LUMO (eV) | Type | LUMO (eV) | Type | HOMO (eV) | Type | Type | | | | |
| Example (not according to claim 1) | 1 | (1) | 80 | - | 35 | 10 | - | (1) | A | A | A | -5.43 | -3.8 | A | -3.25 | Tetraphenyl borate | -5.91 | - | - | 0.50 | 5 | 5 | 4 |
| | 2 | (2) | 60 | 10 | 35 | 10 | - | (1) | A | A | A | -5.43 | -3.8 | A | -3.25 | Tetraphenyl borate | -5.91 | - | - | 0.50 | 6 | 5 | - |
| | 3 | (2) | 30 | 10 | 35 | 10 | (1) | (1) | A | A | A | -5.43 | -3.8 | A | -3.25 | Tetraphenyl borate | -5.91 | - | - | 0.50 | 7 | 5 | - |
| | 4 | (3) | 15 | 10 | 56 | 20 | (1) | (1) | A | A | A | -5.43 | -3.8 | A | -3.25 | Tetraphenyl borate | -5.91 | - | - | 0.55 | 8 | 5 | - |
| | 5 | (3) | 15 | 10 | 56 | 20 | (1) | (2) | A | A | B | -5.27 | -3.66 | B | -3.02 | Tetraphenyl borate | -5.91 | - | - | 0.55 | 8 | 5.5 | - |
| | 6 | (3) | 15 | 10 | 56 | 20 | (1) | (3) | B | A | B | -5.27 | -3.66 | B | -3.02 | Tetraphenyl borate | -5.91 | - | - | 0.55 | 8 | 6 | - |
| | 7 | (3) | 15 | 10 | 56 | 20 | (1) | (4) | B | A | C | -5.35 | -3.73 | B | -3.02 | Tetraphenyl borate | -5.91 | - | - | 0.55 | 8 | 6.5 | - |
| | 8 | (3) | 10 | 10 | 56 | 20 | (2) | (4) | B | A | C | -5.35 | -3.73 | B | -3.02 | Tetraphenyl borate | -5.91 | - | - | 0.55 | 9 | 6.5 | - |
| | 9 | (3) | 10 | 10 | 56 | 20 | (2) | (5) | B&C | A | C | -5.35 | -3.73 | B | -3.02 | Tetraphenyl borate | -5.91 | - | - | 0.55 | 9 | 7 | - |
| | 10 | (1) | 80 | 10 | 35 | 10 | - | (6) | A | A&B | A | -5.43 | -3.8 | A | -3.25 | Tetraphenyl borate | -5.91 | - | - | 0.50 | 9 | 5.5 | - |
| | 11 | (1) | 80 | 10 | 35 | 10 | - | (6) | A | A&B | A | -5.43 | -3.8 | A | -3.25 | Tetraphenyl borate | -5.91 | - | (1) | 0.45 | 9 | 6.5 | - |
| | 12 | (1) | 80 | 10 | 35 | 10 | - | (6) | A | A&B | A | -5.43 | -3.8 | A | -3.25 | Tetraphenyl borate | -5.91 | - | (2) | 0.45 | 10 | 6.5 | - |
| | 13 | (1) | 80 | 10 | 35 | 10 | - | (6) | A | A&B | A | -5.43 | -3.8 | A | -3.25 | Tetraphenyl borate | -5.91 | - | (3) | 0.45 | 9 | 6.0 | - |
| | 14 | (3) | 10 | 10 | 56 | 20 | (2) | (7) | B&C | A | D | -5.35 | -3.73 | C | -3.02 | Tetraphenyl borate | -5.91 | - | - | 0.55 | 9 | 7 | - |
| | 15 | (3) | 10 | 10 | 56 | 20 | (2) | (8) | B&C | A | D | -5.35 | -3.73 | C | -3.02 | Tetraphenyl borate | -5.91 | S-15 | - | 0.55 | 9 | 7 | - |
| | 16 | (3) | 10 | 10 | 56 | 20 | (2) | (8) | B&C | A | D | -5.35 | -3.73 | C | -3.02 | Tetraphenyl borate | -5.91 | S-15 | - | 0.55 | 9 | 7 | - |
| | 17 | (4) | 10 | 10 | 35 | 20 | (2) | (8) | B&C | A | D | -5.35 | -3.73 | C | -3.02 | Tetraphenyl borate | -5.91 | S-15 | - | 0.50 | 9 | 7 | - |
| | 18 | (5) | 10 | 10 | 35 | 10 | (2) | (8) | B&C | A | D | -5.35 | -3.73 | C | -3.02 | Tetraphenyl borate | -5.91 | S-15 | - | 0.45 | 10 | 7 | - |
| | 19 | (5) | 10 | 10 | 35 | 10 | (2) | (8) | B&C | A | D | -5.35 | -3.73 | C | -3.02 | Tetraphenyl borate | -5.91 | S-15 | (1) | 0.40 | 10 | 8 | - |
| | 20 | (5) | 10 | 10 | 35 | 10 | (2) | (10) | B&C | A | D | -5.35 | -3.73 | C | -3.02 | Tetraphenyl borate | -5.91 | S-14 | - | 0.45 | 10 | 7 | - |
| | 21 | (1) | 80 | - | 35 | 10 | - | (1) | A | D | A | -5.43 | -3.8 | A | -3.25 | Tetraphenyl borate | -5.91 | - | - | - | - | - | 5 |
| | 22 | (1) | 80 | - | 35 | 10 | - | (1) | A | E | A | -5.43 | -3.8 | A | -3.25 | Tetraphenyl borate | -5.91 | - | - | - | - | - | 5 |
| Comparative Example | 1 | (6) | 120 | - | 15 | 30 | - | (1) | A | A | A | -5.43 | -3.8 | A | -3.25 | Tetraphenyl borate | -5.91 | - | - | 0.65 | 1 | 5 | - |
| | 2 | (3) | 15 | 10 | 56 | 20 | (1) | (9) | C | A | B | -5.27 | -3.66 | B | -3.02 | Tetraphenyl borate | -5.91 | - | - | 0.55 | 3 | 3 | - |

[Table 2]

| | | Aluminum support | | | | | Undercoat layer | Image-recording layer | | | | | | | | | | | | Protective layer | Evaluation |
|---|---|---|---|---|---|---|---|---|---|---|---|---|---|---|---|---|---|---|---|---|---|
| | | Type | Surface contact angle | Si amount (mg/m²) | ΔS (%) | a45 (%) | Type | Type | Polymerizable compound | Addition polymerization-type resin | Infrared absorber | | | Electron-accepting polymerization initiator | | Electron-donating polymerization initiator | | Color developing agent | | | Visibility |
| | | | | | | | | | Type | Type | Type | HOMO (eV) | LUMO (eV) | Type | LUMO (eV) | Type | HOMO (eV) | Type | Added amount (part by mass) | Type | |
| Example (not according to claim 1) | 23 | (5) | 10 | 10 | 35 | 10 | (2) | (8) | B&C | A | D | -5.35 | -3.73 | C | -3.02 | Tetraphenyl borate | -5.91 | S-1 | 0.15 | (1) | 12 |
| | 24 | (5) | 10 | 10 | 35 | 10 | (2) | (8) | B&C | A | D | -5.35 | -3.73 | C | -3.02 | Tetraphenyl borate | -5.91 | S-1 | 0.03 | (1) | 8 |
| | 25 | (5) | 10 | 10 | 35 | 10 | (2) | (8) | B&C | A | D | -5.35 | -3.73 | C | -3.02 | Tetraphenyl borate | -5.91 | S-6 | 0.15 | (1) | 11 |
| | 26 | (5) | 10 | 10 | 35 | 10 | (2) | (8) | B&C | A | D | -5.35 | -3.73 | C | -3.02 | Tetraphenyl borate | -5.91 | S-4 | 0.15 | (1) | 9 |
| | 27 | (5) | 10 | 10 | 35 | 10 | (2) | (8) | B&C | A | D | -5.35 | -3.73 | C | -3.02 | Tetraphenyl borate | -5.91 | S-11 | 0.15 | (1) | 6 |
| | 28 | (5) | 10 | 10 | 35 | 10 | (2) | (8) | B&C | A | D | -5.35 | -3.73 | C | -3.02 | Tetraphenyl borate | -5.91 | S-12 | 0.15 | (1) | 6 |
| | 29 | (5) | 10 | 10 | 35 | 10 | (2) | (8) | B&C | A | D | -5.35 | -3.73 | C | -3.02 | Tetraphenyl borate | -5.91 | S-13 | 0.15 | (1) | 4 |
| | 30 | (5) | 10 | 10 | 35 | 10 | (2) | (8) | B&C | A | D | -5.35 | -3.73 | C | -3.02 | Tetraphenyl borate | -5.91 | S-14 | 0.15 | (1) | 4.5 |

In Table 1 and Table 2, Si amount means the content of silicon atoms contained in the aluminum support.

In Table 1 and Table 2, ΔS means a specific surface area ΔS, which is a value obtained by the following Equation (i).

$$\Delta S = (S_X - S_0)/S_0 \times 100\ (\%) \qquad (i)$$

In Table 1 and Table 2, a45 means steepness a45 that is obtained by extracting components having a wavelength of 0.2 μm to 2 μm within a surface of the anodic oxide film on a side of the image-recording layer and represents an area ratio of a portion having a gradient of 45° or more.

In Table 1 and Table 2, "B & C" means that the polymerizable compound B and the polymerizable compound C are contained as polymerizable compounds.

In Table 1, "-" means that the example does not contain the corresponding component or the evaluation is not performed.

As is evident from the results described in Table 1 and Table 2, according to the lithographic printing plate precursors according to examples, on-press development type lithographic printing plate precursors excellently suppressing scratches and contamination can be obtained.

It has been revealed that the lithographic printing plate precursor according to the present disclosure has excellent printing durability. As is evident from Table 1, according to the lithographic printing plate precursors of Examples 1, 21, and 22, lithographic printing plates excellently suppressing the residues of on-press development can be obtained.

Furthermore, in a case where a leuco colorant was used as a color developing agent, all the lithographic printing plate precursors according to Examples 15 to 20 and Examples 23 to 30 had excellent visibility.

<Preparation of coating solution (3) for undercoat layer>

The coating solution (3) for an undercoat layer having the following composition was prepared.

-Composition of coating solution (3) for undercoat layer-

·Compound for undercoat layer (UC-1) [the above structure]: 0.18 parts by mass
·Surfactant (EMALEX 710, manufactured by NIHON EMULSION Co., Ltd.): 0.03 parts by mass
·Hydrophilic compound: amounts listed in Table 3.
·Water: 28.0 parts by mass

(Examples 31 to 34)

<Preparation of lithographic printing plate precursor>

The support described in Table 3 was coated with a coating solution for an undercoat layer described in Table 3 so that the dry coating amount was 20 mg/m$^2$, thereby forming an undercoat layer. The undercoat layer was bar-coated with the coating solution for an image-recording layer described in Table 3, followed by drying in an oven at 120°C for 40 seconds, thereby forming an image-recording layer having a dry coating amount of 1.0 g/m$^2$.

The type of the undercoat layer or the image-recording layer described in Table 3 represents the type of the coating solution for an undercoat layer or the coating solution for an image-recording layer used for forming an undercoat layer or an image-recording layer.

The obtained lithographic printing plate precursors were evaluated in terms of the suppression of scratches and contamination described above. The results are shown in Table 3.

[Table 3]

| | | Aluminum support | | | | | Layer on aluminum support | | | Image-recording layer | | | | | | | | | | | | | Protective layer | Evaluation |
|---|---|---|---|---|---|---|---|---|---|---|---|---|---|---|---|---|---|---|---|---|---|---|---|---|
| | | Type | Surface contact angle | Si amount (mg/m$^2$) | ΔS (%) | a45 (%) | Coating solution for undercoat layer | Hydrophilic compound | | Type | Polymerizable compound | Addition polymerization-type resin | Infrared absorber | | | Electron-accepting polymerization initiator | | Electron-donating polymerization initiator | | Color developing agent | | | | Suppression of scratches and contamination |
| | | | | | | | Type | Type | Part by mass | | Type | Type | Type | HOMO (eV) | LUMO (eV) | Type | LUMO (eV) | Type | HOMO (eV) | Type | Added amount (part by mass) | | Type | |
| Example (not according to claim 1) | 31 | (5) | 20 | 10 | 35 | 10 | (3) | Ethylenediaminetetraacetic acid 4Na | 0.03 | (8) | B&C | A | D | -5.35 | -3.73 | C | -3.02 | Tetraphenyl borate | -5.91 | S-1 | 0.15 | | N/A | 7 |
| | 32 | (5) | 9 | 10 | 35 | 10 | (3) | Tartaric acid 2K | 0.08 | (8) | B&C | A | D | -5.35 | -3.73 | C | -3.02 | Tetraphenyl borate | -5.91 | S-1 | 0.15 | | N/A | 10 |
| | 33 | (5) | 8 | 10 | 35 | 10 | (3) | Shikimic acid Na | 0.06 | (8) | B&C | A | D | -5.35 | -3.73 | C | -3.02 | Tetraphenyl borate | -5.91 | S-1 | 0.15 | | N/A | 10 |
| | 34 | (5) | 6 | 10 | 35 | 10 | (3) | Gluconic acid Na | 0.07 | (8) | B&C | A | D | -5.35 | -3.73 | C | -3.02 | Tetraphenyl borate | -5.91 | S-1 | 0.15 | | N/A | 10 |

"Surface contact angle" shown in Table 3 represents a water contact angle on a surface of the aluminum support on the image-recording layer side that is measured by an airborne water droplet method. The contact angle was measured by the method described above.

The details of the hydrophilic compounds shown in Table 3 are as follows.

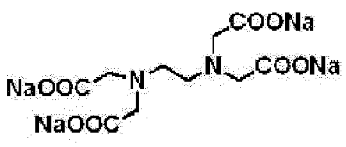
Ethylenediaminetetraacetic acid 4Na

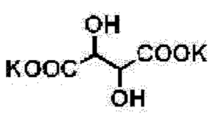
Tartaric acid 2K

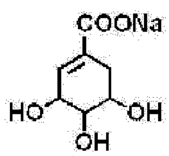
Shikimic acid Na

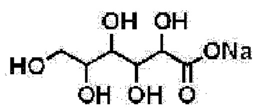
Gluconic acid Na

(Example 35)

<Preparation of support>

The support (3) prepared as above was used as an aluminum support.

<Formation of undercoat layer>

The support (3) was coated with the following coating solution (4) for an undercoat layer so that the dry coating amount was 80 mg/m$^2$, followed by drying, thereby forming an undercoat layer.

-Composition of coating solution (4) for undercoat layer-

·Compound for undercoat layer (UC-1) [the above structure]: 0.18 parts by mass
·Hydroxyethyl diiminodiacetic acid: 0.10 parts by mass
·Surfactant (EMALEX 710, manufactured by NIHON EMULSION Co., Ltd.): 0.03 parts by mass
·Water: 28.0 parts by mass

<Formation of image-recording layer>

The undercoat layer was coated with the following coating solution (11) for an image-recording layer so that the dry coating amount was 0.9 g/m$^2$, followed by drying, thereby forming an image-recording layer.

-Composition of coating solution (11) for image-recording layer-

·Polymerizable compound M'-1 (compound obtained in the following synthesis example): 0.175 parts by mass
·Polymerizable compound M'-2 (ethoxylated isocyanuric acid triacrylate, A-9300 manufactured by SHIN-NAKAMURA CHEMICAL CO, LTD.): 0.100 parts by mass
·Addition polymerization-type resin A [the above structure]: 0.400 parts by mass
·Infrared absorber E [the following structure]: 0.020 parts by mass
·Polymerization initiator D [the following structure]: 0.109 parts
·Tetraphenyl borate [the above structure]: 0.025 parts by mass
·Color developing agent S'-1 [the following structure]: 0.025 parts by mass
·Hydrophilic compound T'-1 [the following structure]: 0.012 parts by mass
·Additive O'-1 [the following structure]: 0.040 parts by mass
·Surfactant U'-1 [the following structure]: 0.042 parts by mass
·2-Butanone: 4.360 parts by mass
·1-Methoxy-2-propanol: 4.485 parts by mass
·Methanol: 2.284 parts by mass
·Water: 1.926 parts by mass

<Synthesis of polymerizable compound M'-1>

A mixed solution of TAKENATE (registered trademark) D-116N (manufactured by Mitsui Chemicals, Inc., 4.7 parts by mass) as polyisocyanate, ARONIX (registered trademark) M-403 (manufactured by TOAGOSEI CO., LTD.) as a hydroxyl group-containing polyfunctional acrylate in such an amount that the ratio of the NCO value of polyisocyanate to the hydroxyl number of hydroxyl group-containing polyfunctional acrylate was 1:1, 0.02 parts by mass of t-butylbenzoquinone, and 11.5 parts by mass of methyl ethyl ketone was heated at 65°C. NEOSTANN U-600 (bismuth-based polycondensation catalyst, manufactured by NITTO KASEI CO., LTD., 0.11 parts by mass) was added to the reaction solution, and the reaction solution was heated at the same temperature for 4 hours. The reaction solution was cooled to room temperature (25°C), and methyl ethyl ketone was added thereto, thereby synthesizing a urethane acrylate solution having a solid content of 50% by mass.

Subsequently, by using recycling GPC (instrument: LC908-C60, column: JAIGEL-1H-40 and 2H-40 (manufactured by Japan Analytical Industry Co., Ltd.) and tetrahydrofuran (THF) as an eluent, molecular weight fractionation of

the urethane acrylate solution was performed. In this way, a compound M'-1 was obtained which has a weight-average molecular weight: 150,000 and an ethylenically unsaturated bond valence (C=C valence) of 6.8 mmol/g.

The weight-average molecular weight of the polymerizable compound M'-1 was measured by the following measurement instruments and methods.

GPC measurement instrument: TOSOH HLC-8320 GPC, GPC mobile phase: THF
Inspector: Differential Refractometer (RI), flow rate: 0.35 mL/min
Columns: TSKgel SuperHZM-M, TSKgel SuperHZ4000, TSKgel SuperHZ3000, and TSKgel SuperHZ2000 were connected and used.
Column temperature: 40°C
Standard sample for molecular weight calibration curve: polystyrene (PS)

The ethylenically unsaturated bond valence (C=C valence) of the polymerizable compound M'-1 was calculated based on the structure of the compound (model) obtained by the structural analysis performed by 1H-NMR spectroscopy.

Infrared absorber E

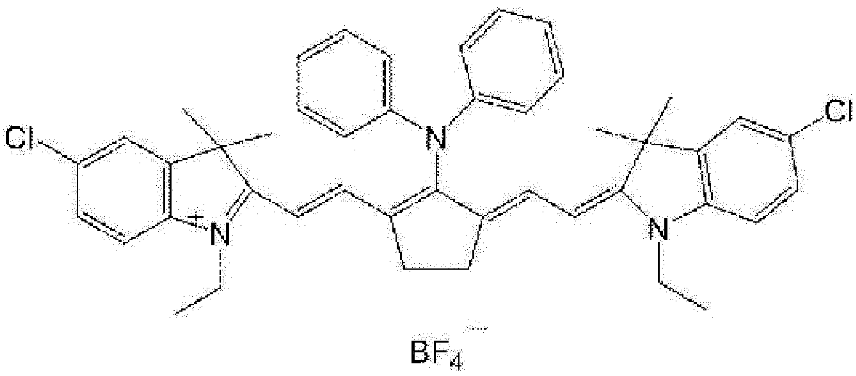

Polymerization initiator D

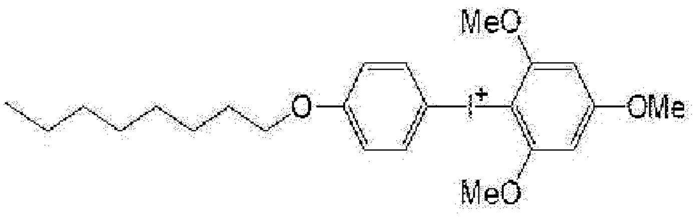

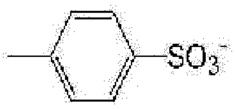

Color developing agent S'-1

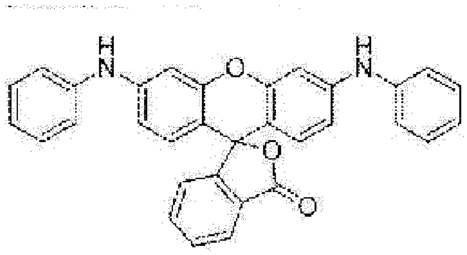

S'-1

Hydrophilic compound T'-1

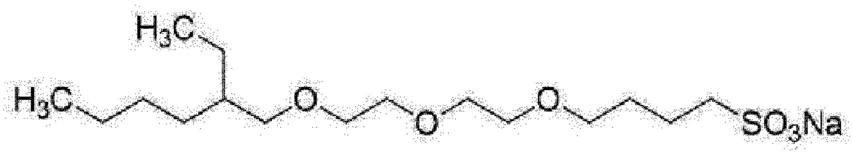

Additive O'-1

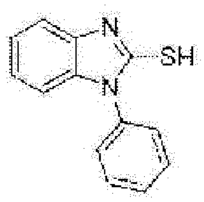

O'-1

Surfactant U'-1

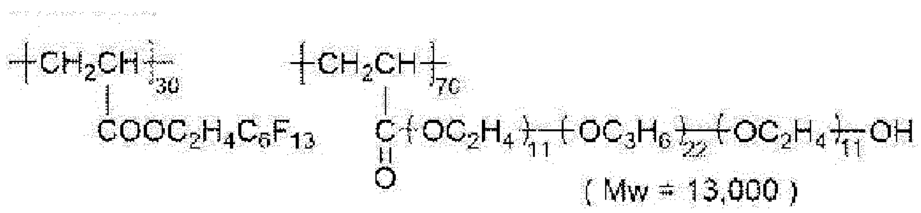

U'-1

<Formation of protective layer>

The image-recording layer was coated with a coating solution (4) for a protective layer having the following composition so that the dry coating amount was 0.2 g/$m^2$, followed by drying, thereby forming a protective layer.

-Composition of coating solution (4) for protective layer-

·Polymer WP'-1 (GOHSENX (registered trademark) L-3266, manufactured by Mitsubishi Chemical Corporation., saponification degree 86 to 89%): 0.050 parts by mass
·Hydrophobic polymer particles WR'-1 (17% aqueous solution, FS-102: styrene-acrylic resin, manufactured by Nipponpaint Industrial Coatings Co., LTD., Tg = 103°C): 0.100 parts by mass
·Surfactant (EMALEX 710, manufactured by NIHON EMULSION Co., Ltd.): 0.004 parts by mass
·Water: 0.3918 parts by mass

A lithographic printing plate precursor of Example 35 was prepared as above.

By using the obtained lithographic printing plate precursor, the same evaluation as in Example 1 was carried out. The evaluation results are shown in Table 4.

(Example 36)

A lithographic printing plate precursor of Example 36 was prepared in the same manner as in Example 35, except that in Example 35, the coating solution for an image-recording layer was changed to the following coating solution (12) for an image-recording layer and coating was performed so that the dry coating amount was 0.9 g/$m^2$.

-Composition of coating solution (12) for image-recording layer-

·Polymerizable compound M'-1 (compound synthesized by the above method): 0.175 parts by mass
·Polymerizable compound M'-2 (ethoxylated isocyanuric acid triacrylate, A-9300 manufactured by SHIN-NAKAMURA CHEMICAL CO, LTD.): 0.100 parts by mass
·Addition polymerization-type resin A [the above structure]: 0.400 parts by mass
·Infrared absorber E [the above structure]: 0.020 parts by mass
·Polymerization initiator D [the above structure]: 0.109 parts by mass
·Tetraphenyl borate [the above structure]: 0.025 parts by mass
·Color developing agent S'-1 [the above structure]: 0.025 parts by mass
·Hydrophilic compound T'-1 [the above structure]: 0.012 parts by mass
·Additive O'-1 [the above structure]: 0.040 parts by mass
·Surfactant U'-2 [the following structure]: 0.042 parts by mass
·2-Butanone: 4.360 parts by mass
·1-Methoxy-2-propanol: 4.485 parts by mass
·Methanol: 2.284 parts by mass
·Water: 1.926 parts by mass

Surfactant U'-2

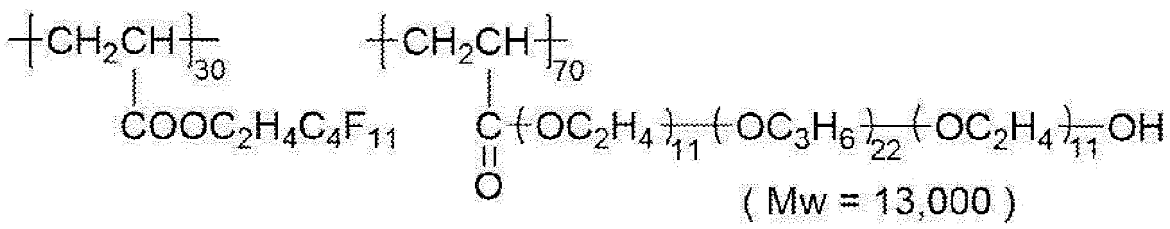

U'-2

A lithographic printing plate precursor of Example 36 was prepared as above.

By using the obtained lithographic printing plate precursor, the same evaluation as in Example 1 was carried out. The evaluation results are shown in Table 4.

(Example 37)

A lithographic printing plate precursor of Example 37 was prepared in the same manner as in Example 35, except that in Example 35, the coating solution for an image-recording layer was changed to the following coating solution (13) for an image-recording layer and coating was performed so that the dry coating amount was 0.1 $g/m^2$.

-Composition of coating solution (13) for image-recording layer-

·Polymerizable compound M'-1 (compound synthesized by the above method): 0.175 parts by mass
·Polymerizable compound M'-2 (ethoxylated isocyanuric acid triacrylate, A-9300 manufactured by SHIN-NAKAMURA CHEMICAL CO, LTD.): 0.100 parts by mass
·Addition polymerization-type resin A [the above structure]: 0.400 parts by mass
·Infrared absorber F [the following structure]: 0.020 parts by mass
·Polymerization initiator D [the above structure]: 0.109 parts by mass
·Tetraphenyl borate [the above structure]: 0.025 parts by mass
·Color developing agent S'-1 [the above structure]: 0.025 parts by mass
·Hydrophilic compound T'-1 [the above structure]: 0.012 parts by mass
·Additive O'-1 [the above structure]: 0.040 parts by mass
·Surfactant U'-2 [the above structure]: 0.042 parts by mass
·2-Butanone: 4.360 parts by mass
·1-Methoxy-2-propanol: 4.485 parts by mass
·Methanol: 2.284 parts by mass
·Water: 1.926 parts by mass

Infrared absorber F

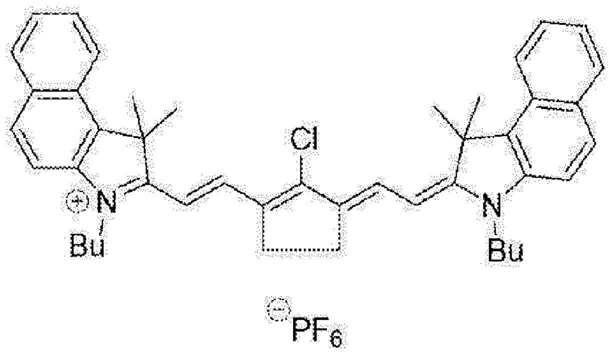

A lithographic printing plate precursor of Example 37 was prepared as above.
By using the obtained lithographic printing plate precursor, the same evaluation as in Example 1 was carried out. The evaluation results are shown in Table 4.

(Example 38)

<Preparation of support (7)>

-Alkaline etching treatment-

An aqueous solution of caustic soda having a caustic soda concentration of 26% by mass and an aluminum ion concentration of 6.5% by mass was sprayed onto the aluminum plate at a temperature of 55°C, thereby performing an etching treatment. Then, rinsing was performed by means of spraying. The amount of dissolved aluminum within the surface to be subjected to the electrochemical roughening treatment later was 3 $g/m^2$.

-Desmutting treatment using aqueous acidic solution (first desmutting treatment)-

Next, a desmutting treatment was performed using an aqueous acidic solution. In the desmutting treatment, a 170 g/L aqueous sulfuric acid solution was used as the aqueous acidic solution. The liquid temperature was 30°C. The desmutting treatment was performed for 3 seconds by spraying the aqueous acidic solution onto the aluminum plate. Then, a rinsing treatment was performed.

-Electrochemical roughening treatment-

Next, an electrochemical roughening treatment was performed using an electrolytic solution at a hydrochloric acid concentration and alternating current. The liquid temperature of the electrolytic solution was 40°C. The waveform of the alternating current was a sine wave in which the positive and negative waveforms are symmetrical, and the frequency was 50 Hz. The quantity of electricity was 300 $C/dm^2$, which is the total quantity of electricity that the aluminum plate stores during the anodic reaction. A carbon electrode was used as the counter electrode of the aluminum plate. Then, a rinsing treatment was performed.

-Alkaline etching treatment-

An aqueous solution of caustic soda having a caustic soda concentration of 5% by mass and an aluminum ion concentration of 0.5% by mass was sprayed onto the aluminum plate having undergone the electrochemical roughening treatment at a temperature of 35°C so that an etching amount was 0.1 $g/m^2$ or less, thereby performing an etching treatment. Then, a rinsing treatment was performed.

-Desmutting treatment using aqueous acidic solution-

Next, a desmutting treatment was performed using an aqueous acidic solution. In the desmutting treatment, a 170 g/L aqueous sulfuric acid solution was used as the aqueous acidic solution. The liquid temperature was 30°C. The desmutting treatment was performed for 3 seconds by spraying the aqueous acidic solution onto the aluminum plate. Then, a rinsing treatment was performed.

-Anodic oxidation treatment-

An anodic oxidation treatment was performed using 170 g/L of a sulfuric acid solution and direct current at a liquid temperature of 40°C so that the amount of the anodic oxide film was 3 $g/m^2$.

Through the above treatments, a support (7) was obtained.

<Formation of image-recording layer>

The support (7) was coating with the following coating solution (14) for an image-recording layer so that the dry coating amount was 0.1 $g/m^2$, followed by drying, thereby forming an image-recording layer.

-Composition of coating solution (14) for image-recording layer-

·Polymerizable compound M'-3 [the following structure, C=C valence 4.25]: 0.250 parts by mass
·Polymerizable compound M'-4 [the following structure, C=C valence 4.42]: 0.250 parts by mass
·Addition polymerization-type resin A [the above structure]: 0.150 parts by mass
·Infrared absorber G [the following structure]: 0.026 parts by mass
·Polymerization initiator E [the following structure]: 0.060 parts by mass
·Tetraphenyl borate: 0.050 parts by mass
·Color developing agent S'-2 [the following structure]: 0.025 parts by mass
·Surfactant U'-2 [the above structure]: 0.042 parts by mass
·2-Butanone: 7.336 parts by mass
·1-Methoxy-2-propanol: 4.988 parts by mass
·Water: 1.926 parts by mass

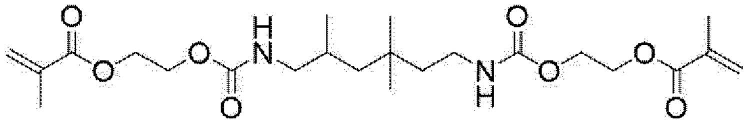

M' - 3

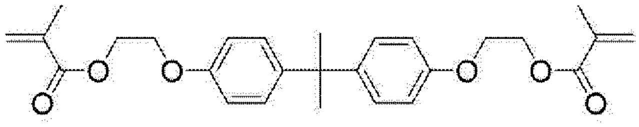

M' - 4

Infrared absorber G

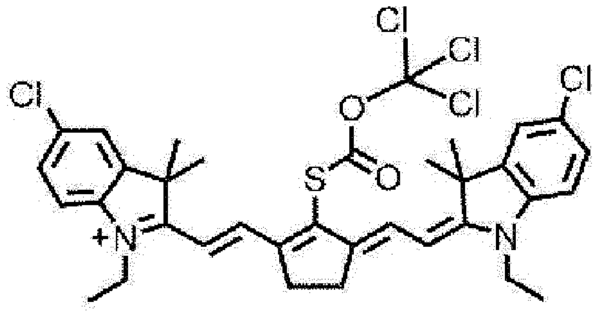

Polymerization initiator E

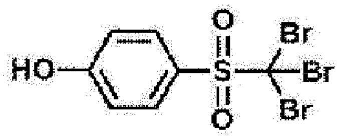

Color develoing agent S'-2

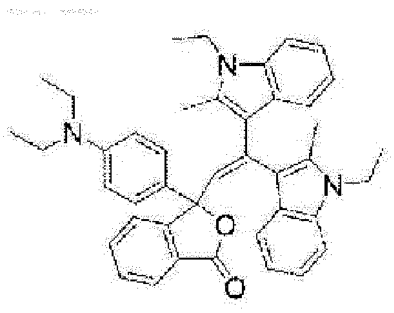

S'-2

<Formation of protective layer>

The image-recording layer was coated with a coating solution (5) for a protective layer having the following composition so that the dry coating amount was 0.7 g/$m^2$, followed by drying, thereby forming a protective layer.

-Composition of coating solution (5) for protective layer-

·Polymer WP'-2 (polyvinyl alcohol, Mowiol (registered trademark) 4-88, manufactured by Sigma-Aldrich Co. LLC): 0.280 parts by mass
·Polymer WP'-3 (polyvinyl alcohol, Mowiol (registered trademark) 8-88, manufactured by Sigma-Aldrich Co. LLC): 0.200 parts by mass
·Hydrophobic polymer particles WR'-1 (aqueous polyvinylidene chloride dispersion, Diofan (registered trademark) A50 manufactured by Solvin S.A.): 0.200 parts by mass
·Discoloring compound wIR'-1 [the following structure]: 0.020 parts by mass
·Surfactant (EMALEX 710, manufactured by NIHON EMULSION Co., Ltd.): 0.038 parts by mass
·Water: 6.800 parts

Discoloring compound wIR'-1

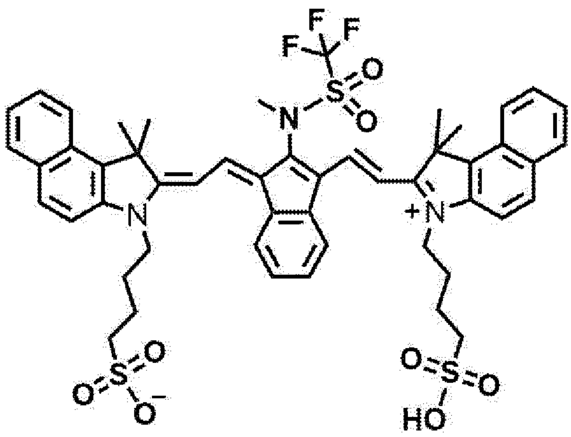

wIR' - 1

A lithographic printing plate precursor of Example 38 was prepared as above.

By using the obtained lithographic printing plate precursor, the same evaluation as in Example 1 was carried out. The evaluation results are shown in Table 4.

[Table 4]

| | | Aluminum support | | | | | Undercoat layer | Image-recording layer | | | | | | | | | | | Protective layer | Evaluation | | |
|---|---|---|---|---|---|---|---|---|---|---|---|---|---|---|---|---|---|---|---|---|---|---|
| | | Type | Surface contact angle | Si amount (mg/$m^2$) | ΔS (%) | a45 (%) | Type | Type | Polymerizable compound | Addition polymerization-type resin | Infrared absorber | | | Electron-accepting polymerization initiator | | Electron-donating polymerization initiator | | Color developing agent | | Dynamic friction coefficient | Suppression of scratches and contamination | Printing durability (× 10,000 sheets) |
| | | | | | | | | | Type | Type | Type | HOMO (eV) | LUMO (eV) | Type | LUMO (eV) | Type | HOMO (eV) | Type | Type | | | |
| Example | 35 | (3) | 10 | 10 | 56 | 20 | (3) | (11) | M'-1 M'-2 | A | E | -5.35 | -3.73 | D | -3.02 | Tetraphenyl borate | -5.91 | S'-1 | (4) | 0.55 | 10 | 8 |
| | 36 | (3) | 10 | 10 | 56 | 20 | (3) | (12) | M'-1 M'-2 | A | E | -5.35 | -3.73 | D | -3.02 | Tetraphenyl borate | -5.91 | S'-1 | (4) | 0.55 | 10 | 8 |
| | 37 | (3) | 10 | 10 | 56 | 20 | (3) | (13) | M'-1 M'-2 | A | F | -5.31 | -3.75 | D | -3.02 | Tetraphenyl borate | -5.91 | S'-1 | (4) | 0.55 | 10 | 9 |
| | 38 | (7) | 15 | 10 | 35 | 20 | - | (14) | M'-3 M'-4 | A | G | -5.56 | -3.84 | E | -3.18 | Tetraphenyl borate | -5.91 | S'-2 | (5) | 0.55 | 9 | 7 |

The types of the undercoat layer, the image-recording layer, or the protective layer described in Table 4 represent the types of the coating solution for an undercoat layer, the coating solution for an image-recording layer, or the coating

solution for a protective layer used for forming the undercoat layer, the image-recording layer, or the protective layer.

As is evident from the results described in Table 4, according to the lithographic printing plate precursors according to examples, on-press development type lithographic printing plate precursors excellently suppressing scratches and contamination can be obtained.

Explanation of References

18: aluminum plate, 12a, 12b: aluminum support, 20a, 20b: anodic oxide film, 22a, 22b: micropore, 24: large diameter portion, 26: small diameter portion, D: depth of large diameter portion, ta: anodic reaction time, tc: cathodic reaction time, tp: time taken for current to reach peak from 0, Ia: peak current on anodic cycle side, Ic: peak current on cathodic cycle side, AA: current of anodic reaction of aluminum plate, CA: current of cathodic reaction of aluminum plate, 50: main electrolytic cell, 51: alternating current power source, 52: radial drum roller, 53a, 53b: main pole, 54: electrolytic solution supply port, 55: electrolytic solution, 56: auxiliary anode, 60: auxiliary anode tank, W: aluminum plate, A1: solution supply direction, A2: electrolytic solution discharge direction, 610: anodic oxidation treatment device, 612: power supply tank, 614: electrolytic treatment tank, 616: aluminum plate, 618, 26: electrolytic solution, 620: power supply electrode, 622, 628: roller, 624: nip roller, 630: electrolysis electrode, 632: cell wall, 634: direct current power source, 1: aluminum plate, 2, 4: roller-shaped brush, 3: polishing slurry liquid, 5, 6, 7, 8: support roller, 18: aluminum plate

## Claims

**1.** An on-press development type lithographic printing plate precursor comprising:

an aluminum support; and
an image-recording layer on the aluminum support,
wherein the image-recording layer contains an infrared absorber, a polymerization initiator, a polymerizable compound, the polymerizable compound includes a polymerizable compound having 7 or more functional groups; wherein the functional groups are ethylenically unsaturated bonds; and an addition polymerization-type resin having a hydrophilic structure,
**characterized in that** a water contact angle on the image-recording layer side of the aluminum support that is determined by an airborne water droplet method is 110° or less at 25 °C after 0.2 seconds, and
wherein the on-press development type lithographic printing plate precursor further comprises a water-soluble overcoat layer on the image-recording layer, wherein
the water-soluble overcoat layer contains a hydrophobic polymer, wherein the hydrophobic polymer is a polymer that dissolves less than 5 g or does not dissolve in 100 g of pure water at 125 °C; and wherein the hydrophobic polymer includes a polyvinylidene chloride resin or a styrene acrylic resin.

**2.** The on-press development type lithographic printing plate precursor according to claim 1,
wherein the water contact angle on the surface of the aluminum support on the side of the image-recording layer that is determined by the airborne water droplet method is 50° or less.

**3.** The on-press development type lithographic printing plate precursor according to claim 1 or 2, wherein the polymerizable compound having 7 or more functional groups includes a polymerizable compound having 11 or more functional groups; wherein the functional groups are ethylenically unsaturated bonds.

**4.** The on-press development type lithographic printing plate precursor according to any one of claims 1 to 3, wherein the image-recording layer further contains a compound having an adsorbent group, wherein the adsorbent group is selected from a carboxy group, a sulfo group, a phosphoric acid group, and an amino group.

**5.** The on-press development type lithographic printing plate precursor according to any one of claims 1 to 4,

wherein a layer on the aluminum support contains a hydroxycarboxylic acid or a salt thereof, and
wherein the hydroxycarboxylic acid or a salt thereof includes a compound having three or more hydroxyl groups,
wherein the layer on the aluminum support containing a hydroxycarboxylic acid or a salt thereof is preferably an undercoat layer.

**6.** The on-press development type lithographic printing plate precursor according to any one of claims 1 to 5, wherein a content of silicon atoms contained in the aluminum support is 5.0 $g/m^2$ to 20.0 $g/m^2$.

**7.** The on-press development type lithographic printing plate precursor according to any one of claims 1 to 6, wherein a film thickness of the water-soluble overcoat layer is larger than a film thickness of the image-recording layer.

**8.** The on-press development type lithographic printing plate precursor according to any one of claims 1 to 7,

wherein the hydrophilic structure includes a group represented by Formula Z,

*-Q-W-Y Formula Z

in Formula Z, Q represents a divalent linking group, W represents a divalent group having a hydrophilic structure or a divalent group having a hydrophobic structure, Y represents a monovalent group having a hydrophilic structure or a monovalent group having a hydrophobic structure, either W or Y has a hydrophilic structure, and * represents a binding site with other structures.

**9.** The on-press development type lithographic printing plate precursor according to any one of claims 1 to 8, wherein the hydrophilic structure includes a polyalkylene oxide structure, and wherein the polyalkylene oxide structure includes a polyethylene oxide structure and a polypropylene oxide structure.

**10.** The on-press development type lithographic printing plate precursor according to any one of claims 1 to 9,

wherein the polymerization initiator includes an electron-accepting polymerization initiator, and
wherein (LUMO of the electron-accepting polymerization initiator) - (LUMO of the infrared absorber) is 0.70 eV or less.

**11.** The on-press development type lithographic printing plate precursor according to any one of claims 1 to 10,

wherein the polymerization initiator includes an electron-donating polymerization initiator, and
wherein (HOMO of the infrared absorber) - (HOMO of the electron-donating polymerization initiator) is 0.70 eV or less.

**12.** The on-press development type lithographic printing plate precursor according to any one of claims 1 to 11, wherein the image-recording layer further contains a color developing agent, and wherein the color developing agent is an acid color-developing agent.

**13.** The on-press development type lithographic printing plate precursor according to any one of claims 1 to 12,

wherein the polymerization initiator includes an electron-accepting polymerization initiator, and
the electron-accepting polymerization initiator includes a compound represented by Formula (I),

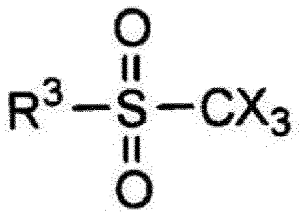 (I)

in Formula (I), X represents a halogen atom, and $R^3$ represents an aryl group.

**14.** The on-press development type lithographic printing plate precursor according to any one of claims 1 to 13,

wherein the polymerizable compound includes a compound having an ethylenically unsaturated bond valence of 5.0 mmol/g or more, and
the compound having an ethylenically unsaturated bond valence of 5.0 mmol/g or more is a compound represented by Formula (II),

Formula (II): $X-(Y)_n$

in Formula (II), X represents an n-valent organic group having a hydrogen bonding group, Y represents a monovalent group having 2 or more ethylenically unsaturated groups, n represents an integer of 2 or more, and molecular weight of X/(molecular weight of Y × n) is 1 or less.

**15.** The on-press development type lithographic printing plate precursor according to claim 1, wherein the water-soluble overcoat layer contains a discoloring compound, wherein a discoloring compound is a compound which undergoes change in absorption in the visible light region which is in the wavelength range of 400 nm or more and less than 750 nm, due to the exposure to infrared, where infrared means a ray having a wavelength of 750 nm to 1 mm.

**16.** The on-press development type lithographic printing plate precursor according to claim 15, wherein the discoloring compound is an infrared absorber.

**17.** The on-press development type lithographic printing plate precursor according to claim 15 or 16, wherein the discoloring compound includes a decomposable compound that decomposes due to exposure to infrared.

**18.** A method for manufacturing a lithographic printing plate, comprising:

a step of exposing the on-press development type lithographic printing plate precursor according to any one of claims 1 to 17 in the shape of an image; and
a step of supplying at least one material selected from the group consisting of a printing ink and dampening water on a printer so as to remove an image-recording layer in a non-image area.

**19.** A lithographic printing method, comprising:

a step of exposing the on-press development type lithographic printing plate precursor according to any one of claims 1 to 17 in the shape of an image;
a step of supplying at least one material selected from the group consisting of a printing ink and dampening water so as to remove an image-recording layer in a non-image area and to prepare a lithographic printing plate; and
a step of performing printing by using the obtained lithographic printing plate.

**Patentansprüche**

**1.** Lithographischer Druckplattenvorläufer des Auf-Presse-Entwicklungstyps, umfassend:

einen Aluminiumträger; und
eine Bildaufzeichnungsschicht auf dem Aluminiumträger,
wobei die Bildaufzeichnungsschicht einen Infrarotabsorber, einen Polymerisationsinitiator, eine polymerisierbare Verbindung enthält, wobei die polymerisierbare Verbindung eine polymerisierbare Verbindung mit 7 oder mehr Funktionsgruppen enthält; wobei die Funktionsgruppen ethylenisch ungesättigte Bindungen sind; und ein Harz des Additionspolymerisationstyps eine hydrophile Struktur aufweist,
**dadurch gekennzeichnet, dass** ein Wasserkontaktwinkel auf der Seite von Bildaufzeichnungsschicht des Aluminiumträgers, der durch ein Verfahren mit in Luft getragenen Wassertropfen bestimmt wird, bei 25 °C nach 0,2 Sekunden 110° oder weniger beträgt, und
wobei der lithographische Druckplattenvorläufer des Auf-Presse-Entwicklungstyps ferner eine wasserlösliche Deckschicht auf der Bildaufzeichnungsschicht umfasst, wobei die wasserlösliche Deckschicht ein hydrophobes Polymer enthält, wobei das hydrophobe Polymer ein Polymer ist, das sich in 100 g reinem Wasser bei 125 °C weniger als 5 g löst oder nicht löst; und wobei das hydrophobe Polymer ein Polyvinyliden-Chlorid-Harz oder ein Styrol-Acryl-Harz umfasst.

**2.** Lithographischer Druckplattenvorläufer des Auf-Presse-Entwicklungstyps nach Anspruch 1,
wobei der Wasserkontaktwinkel auf der Oberfläche des Aluminiumträgers auf der Seite der Bildaufzeichnungsschicht, der durch das Verfahren mit in Luft getragenen Wassertropfen bestimmt wird, 50° oder weniger beträgt.

**3.** Lithographischer Druckplattenvorläufer des Auf-Presse-Entwicklungstyps nach Anspruch 1 oder 2, wobei die polymerisierbare Verbindung mit 7 oder mehr Funktionsgruppen eine polymerisierbare Verbindung mit 11 oder mehr Funktionsgruppen umfasst; wobei die Funktionsgruppen ethylenisch ungesättigte Bindungen sind.

**4.** Lithographischer Druckplattenvorläufer des Auf-Presse-Entwicklungstyps nach einem der Ansprüche 1 bis 3, wobei die Bildaufzeichnungsschicht ferner eine Verbindung mit einer adsorbierenden Gruppe enthält, wobei die adsorbierende Gruppe aus einer Carboxygruppe, einer Sulfogruppe, einer Phosphorsäuregruppe und einer Aminogruppe ausgewählt wird.

**5.** Lithographischer Druckplattenvorläufer des Auf-Presse-Entwicklungstyps nach einem der Ansprüche 1 bis 4,

wobei eine Schicht auf dem Aluminiumträger eine Hydroxycarbonsäure oder ein Salz davon enthält, und wobei die Hydroxycarbonsäure oder ein Salz davon eine Verbindung mit drei oder mehr Hydroxylgruppen umfasst, wobei die Schicht auf dem Aluminiumsupport, die eine Hydroxycarbonsäure oder ein Salz davon enthält, bevorzugt eine Unterschicht ist.

**6.** Lithographischer Druckplattenvorläufer des Auf-Presse-Entwicklungstyps nach einem der Ansprüche 1 bis 5, wobei ein Gehalt an Siliciumatomen, die in dem Aluminiumträger enthalten sind, 5,0 g/$m^2$ bis 20,0 g/$m^2$ beträgt.

**7.** Lithographischer Druckplattenvorläufer des Auf-Presse-Entwicklungstyps nach einem der Ansprüche 1 bis 6, wobei eine Filmdicke der wasserlöslichen Deckschicht dicker als eine Filmdicke der Bildaufzeichnungsschicht ist.

**8.** Lithographischer Druckplattenvorläufer des Auf-Presse-Entwicklungstyps nach einem der Ansprüche 1 bis 7,

wobei die hydrophile Struktur eine Gruppe enthält, die durch Formel Z dargestellt wird,

*-Q-W-Y Formel Z

In Formel Z Q eine divalente Verbindungsgruppe darstellt, W eine divalente Gruppe mit einer hydrophilen Struktur oder eine divalente Gruppe mit einer hydrophoben Struktur darstellt, Y eine monovalente Gruppe mit einer hydrophilen Struktur oder eine monovalente Gruppe mit einer hydrophoben Struktur darstellt, entweder W oder Y eine hydrophile Struktur aufweist und * eine Bindungsstelle mit anderen Strukturen darstellt.

**9.** Lithographischer Druckplattenvorläufer des Auf-Presse-Entwicklungstyps nach einem der Ansprüche 1 bis 8, wobei die hydrophile Struktur eine Polyalkylenoxidstruktur umfasst und wobei die Polyalkylenoxidstruktur eine Polyethylenoxidstruktur und eine Polypropylenoxidstruktur umfasst.

**10.** Lithographischer Druckplattenvorläufer des Auf-Presse-Entwicklungstyps nach einem der Ansprüche 1 bis 9,

wobei der Polymerisationsinitiator einen elektronenannehmenden Polymerisationsinitiator umfasst, und wobei (LUMO des elektronenannehmenden Polymerisationsinitiators) - (LUMO des Infrarotabsorbers) 0,70 eV oder weniger beträgt.

**11.** Lithographischer Druckplattenvorläufer des Auf-Presse-Entwicklungstyps nach einem der Ansprüche 1 bis 10,

wobei der Polymerisationsinitiator einen elektronenspendenden Polymerisationsinitiator umfasst, und wobei (HOMO des Infrarotabsorbers) - (HOMO des elektronenspendenden Polymerisationsinitiators) 0,70 eV oder weniger beträgt.

**12.** Lithographischer Druckplattenvorläufer des Auf-Presse-Entwicklungstyps nach einem der Ansprüche 1 bis 11, wobei die Bildaufzeichnungsschicht ferner ein Farbentwicklungsmittel enthält und wobei das Farbentwicklungsmittel ein Säurefarbentwicklungsmittel ist.

**13.** Lithographischer Druckplattenvorläufer des Auf-Presse-Entwicklungstyps nach einem der Ansprüche 1 bis 12,

wobei der Polymerisationsinitiator einen elektronenannehmenden Polymerisationsinitiator umfasst, und der elektronenannehmende Polymerisationsinitiator eine Verbindung enthält, die durch Formel (I) dargestellt wird,

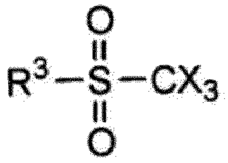

(I)

in Formel (I) X ein Halogenatom darstellt und $R^3$ eine Arylgruppe darstellt.

**14.** Lithographischer Druckplattenvorläufer des Auf-Presse-Entwicklungstyps nach einem der Ansprüche 1 bis 13,

wobei die polymerisierbare Verbindung eine Verbindung mit einer ethylenisch ungesättigten Bindungsvalenz von 5,0 mmol/g oder mehr umfasst, und
die Verbindung mit einer ethylenisch ungesättigten Bindungsvalenz von 5,0 mmol/g oder mehr eine Verbindung ist, die durch Formel (II) dargestellt wird,

Formel (II): $X\text{-}(Y)_n$

in Formel (II) X eine n-valente organische Gruppe mit einer Wasserstoffbindungsgruppe darstellt, Y eine monovalente Gruppe mit 2 oder mehr ethylenisch ungesättigten Gruppen darstellt, n eine ganze Zahl von 2 oder mehr darstellt und Molekulargewicht von X/(Molekulargewicht von Y $\times$ n) 1 oder weniger beträgt.

**15.** Lithographischer Druckplattenvorläufer des Auf-Presse-Entwicklungstyps nach Anspruch 1, wobei die wasserlösliche Deckschicht eine entfärbende Verbindung enthält, wobei eine entfärbende Verbindung eine Verbindung ist, die sich aufgrund der Exposition gegenüber Infrarot Änderung hinsichtlich Absorption in dem Bereich von sichtbarem Licht unterzieht, der in dem Wellenlängenbereich von 400 nm oder mehr und weniger als 750 nm liegt, wobei Infrarot einen Strahl mit einer Wellenlänge von 750 nm bis 1 mm bedeutet.

**16.** Lithographischer Druckplattenvorläufer des Auf-Presse-Entwicklungstyps nach Anspruch 15, wobei die entfärbende Verbindung ein Infrarotabsorber ist.

**17.** Lithographischer Druckplattenvorläufer des Auf-Presse-Entwicklungstyps nach Anspruch 15 oder 16, wobei die entfärbende Verbindung eine zersetzbare Verbindung umfasst, die sich aufgrund Exposition gegenüber Infrarot zersetzt.

**18.** Verfahren zum Herstellen einer lithographischen Druckplatte, umfassend:

einen Schritt des Belichtens des lithographischen Druckplattenvorläufers des Auf-Presse-Entwicklungstyps nach einem der Ansprüche 1 bis 17 in der Form eines Bildes; und
einen Schritt des Zuführens von mindestens einem Material, das aus der Gruppe ausgewählt wird, die aus einem Druckfarbe und Feuchtwasser besteht, auf einen Drucker, so dass eine Bildaufzeichnungsschicht in einem Nichtbildbereich entfernt wird.

**19.** Lithographisches Druckverfahren, umfassend:

einen Schritt des Belichtens des lithographischen Druckplattenvorläufers des Auf-Presse-Entwicklungstyps nach einem der Ansprüche 1 bis 17 in der Form eines Bildes;
einen Schritt des Zuführens von mindestens einem Material, das aus der Gruppe ausgewählt wird, die aus einem Druckfarbe und Feuchtwasser besteht, so dass eine Bildaufzeichnungsschicht in einem Nichtbildbereich entfernt wird und eine lithographische Druckplatte hergestellt wird; und
einen Schritt des Durchführens von Drucken durch Verwenden der erhaltenen lithographischen Druckplatte.

## Revendications

**1.** Précurseur de plaque d’impression lithographique de type développement sur presse comprenant :

un support en aluminium ; et
une couche d’enregistrement d’images sur le support en aluminium,

dans lequel la couche d'enregistrement d'images contient un absorbeur infrarouge, un initiateur de polymérisation, un composé polymérisable, le composé polymérisable inclut un composé polymérisable ayant 7 ou plus groupes fonctionnels ; dans lequel les groupes fonctionnels sont des liaisons éthyléniquement insaturées ; et une résine de type polymérisation par addition ayant une structure hydrophile,
**caractérisé en ce qu'**un angle de contact d'eau sur le côté de couche d'enregistrement d'images du support en aluminium, qui est déterminé par un procédé de gouttelette d'eau en suspension dans l'air, est de 110° ou moins à 25 °C après 0,2 seconde, et
dans lequel le précurseur de plaque d'impression lithographique de type développement sur presse comprend en outre une couche de surcouche hydrosoluble sur la couche d'enregistrement d'images, dans lequel la couche de surcouche hydrosoluble contient un polymère hydrophobe, dans lequel le polymère hydrophobe est un polymère qui se dissout à moins de 5 g ou ne se dissout pas dans 100 g d'eau pure à 125 °C ; et dans lequel le polymère hydrophobe inclut une résine de chlorure de polyvinylidène ou une résine acrylique styrénique.

**2.** Précurseur de plaque d'impression lithographique de type développement sur presse selon la revendication 1, dans lequel l'angle de contact d'eau sur la surface du support en aluminium sur le côté de la couche d'enregistrement d'images, qui est déterminé par le procédé de gouttelette d'eau en suspension dans l'air, est de 50° ou moins.

**3.** Précurseur de plaque d'impression lithographique de type développement sur presse selon la revendication 1 ou la revendication 2, dans lequel le composé polymérisable ayant 7 ou plus groupes fonctionnels inclut un composé polymérisable ayant 11 ou plus groupes fonctionnels ; dans lequel les groupes fonctionnels sont des liaisons éthyléniquement insaturées.

**4.** Précurseur de plaque d'impression lithographique de type développement sur presse selon l'une quelconque des revendications 1 à 3, dans lequel la couche d'enregistrement d'images contient en outre un composé ayant un groupe adsorbant, le groupe adsorbant étant choisi parmi un groupe carboxyle, un groupe sulfo, un groupe acide phosphorique et un groupe amino.

**5.** Précurseur de plaque d'impression lithographique de type développement sur presse selon l'une quelconque des revendications 1 à 4,

dans lequel une couche sur le support en aluminium contient un acide hydroxycarboxylique ou un sel de celui-ci, et
dans lequel l'acide hydroxycarboxylique ou un sel de celui-ci inclut un composé ayant trois ou plus groupes hydroxyles, dans lequel la couche sur le support en aluminium contenant un acide hydroxycarboxylique ou un sel de celui-ci est de préférence une couche de sous-couche.

**6.** Précurseur de plaque d'impression lithographique de type développement sur presse selon l'une quelconque des revendications 1 à 5, dans lequel une teneur de atomes de silicium contenues dans le support en aluminium est 5,0 $g/m^2$ à 20,0 $g/m^2$.

**7.** Précurseur de plaque d'impression lithographique de type développement sur presse selon l'une quelconque des revendications 1 à 6, dans lequel une épaisseur de film de la couche de surcouche hydrosoluble est supérieure à une épaisseur de film de la couche d'enregistrement d'images.

**8.** Précurseur de plaque d'impression lithographique de type développement sur presse selon l'une quelconque des revendications 1 à 7,

dans lequel la structure hydrophile inclut un groupe représenté par Formule Z,

*-Q-W-Y Formule Z

dans Formule Z, Q représente un groupe de liaison divalent, W représente un groupe divalent ayant une structure hydrophile ou un groupe divalent ayant une structure hydrophobe, Y représente un groupe monovalent ayant une structure hydrophile ou un groupe monovalent ayant une structure hydrophobe, soit W ou Y a une structure hydrophile, et * représente un site de liaison avec d'autres structures.

**9.** Précurseur de plaque d'impression lithographique de type développement sur presse selon l'une quelconque des revendications 1 à 8, dans lequel la structure hydrophile inclut une structure de polyalkylène glycol, et dans lequel la

structure de polyalkylène glycol inclut une structure de polyéthylène glycol et une structure de polypropylène glycol.

**10.** Précurseur de plaque d'impression lithographique de type développement sur presse selon l'une quelconque des revendications 1 à 9,

dans lequel l'initiateur de polymérisation inclut un initiateur de polymérisation accepteur d'électrons, et
dans lequel (LUMO de l'initiateur de polymérisation accepteur d'électrons) - (LUMO de l'absorbeur infrarouge) est égal ou inférieur à 0,70 eV ou moins.

**11.** Précurseur de plaque d'impression lithographique de type développement sur presse selon l'une quelconque des revendications 1 à 10,

dans lequel l'initiateur de polymérisation inclut un initiateur de polymérisation donneur d'électrons, et
dans lequel (HOMO de l'absorbeur infrarouge) - (HOMO de l'initiateur de polymérisation donneur d'électrons) est 0,70 eV ou moins.

**12.** Précurseur de plaque d'impression lithographique de type développement sur presse selon l'une quelconque des revendications 1 à 11, dans lequel la couche d'enregistrement d'images contient en outre un agent de développement de couleur, et dans lequel l'agent de développement de couleur est un agent de développement de couleur acide.

**13.** Précurseur de plaque d'impression lithographique de type développement sur presse selon l'une quelconque des revendications 1 à 12,

dans lequel l'initiateur de polymérisation inclut un initiateur de polymérisation accepteur d'électrons, et
l'initiateur de polymérisation accepteur d'électrons inclut un composé représenté par Formule (I),

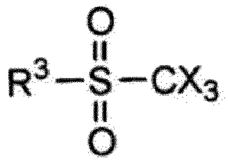
(I)

dans Formule (I), X représente un atome d'halogène et $R^3$ représente un groupe aryle.

**14.** Précurseur de plaque d'impression lithographique de type développement sur presse selon l'une quelconque des revendications 1 à 13,

dans lequel le composé polymérisable inclut un composé ayant une valence de liaison éthyléniquement insaturée de 5,0 mmol/g ou plus, et
le composé ayant une valence de liaison éthyléniquement insaturée de 5,0 mmol/g ou plus est un composé représenté par Formule (II),

Formule (II) : $X\text{-}(Y)_n$

dans Formule (II), X représente un groupe organique n-valent ayant un groupe de liaison hydrogène, Y représente un groupe monovalent ayant 2 ou plus groupes éthyléniquement insaturés, n représente un entier de 2 ou plus, et un poids moléculaire de X/(poids moléculaire de Y × n) est de 1 ou moins.

**15.** Précurseur de plaque d'impression lithographique de type développement sur presse selon la revendication 1, dans lequel la couche de sur-couche hydrosoluble contient un composé décolorant, dans lequel un composé décolorant est un composé qui subit un changement d'absorption dans la région de lumière visible, qui est dans la plage de longueurs d'onde de 400 nm ou plus et inférieure à 750 nm, en raison de l'exposition à l'infrarouge, dans lequel infrarouge signifie un rayon ayant une longueur d'onde de 750 nm à 1 mm.

**16.** Précurseur de plaque d'impression lithographique de type développement sur presse selon la revendication 15, dans lequel le composé décolorant est un absorbeur infrarouge.

**17.** Précurseur de plaque d'impression lithographique de type développement sur presse selon la revendication 15 ou la

revendication 16, dans lequel le composé décolorant inclut un composé décomposable qui se décompose en raison d'exposition à infrarouge.

**18.** Procédé pour fabriquer une plaque d'impression lithographique, comprenant :

une étape d'exposition du précurseur de plaque d'impression lithographique de type développement sur presse selon l'une quelconque des revendications 1 à 17 sous la forme d'une image ; et
une étape de fourniture d'au moins un matériau choisi dans le groupe constitué d'une encre d'impression et d'une eau de mouillage sur une imprimante de manière à éliminer une couche d'enregistrement d'images dans une zone sans image.

**19.** Procédé d'impression lithographique, comprenant :

une étape d'exposition du précurseur de plaque d'impression lithographique de type développement sur presse selon l'une quelconque des revendications 1 à 17 sous la forme d'une image ;
une étape de fourniture d'au moins un matériau choisi dans le groupe constitué d'une encre d'impression et d'une eau de mouillage de manière à éliminer une couche d'enregistrement d'images dans une zone sans image et de préparer une plaque d'impression lithographique ; et
une étape d'exécution d'impression en utilisant la plaque d'impression lithographique obtenue.

FIG. 1

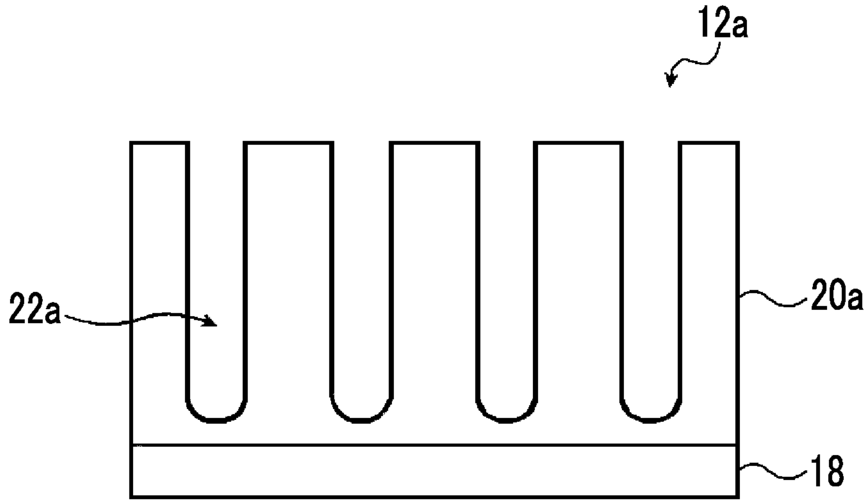


FIG. 2

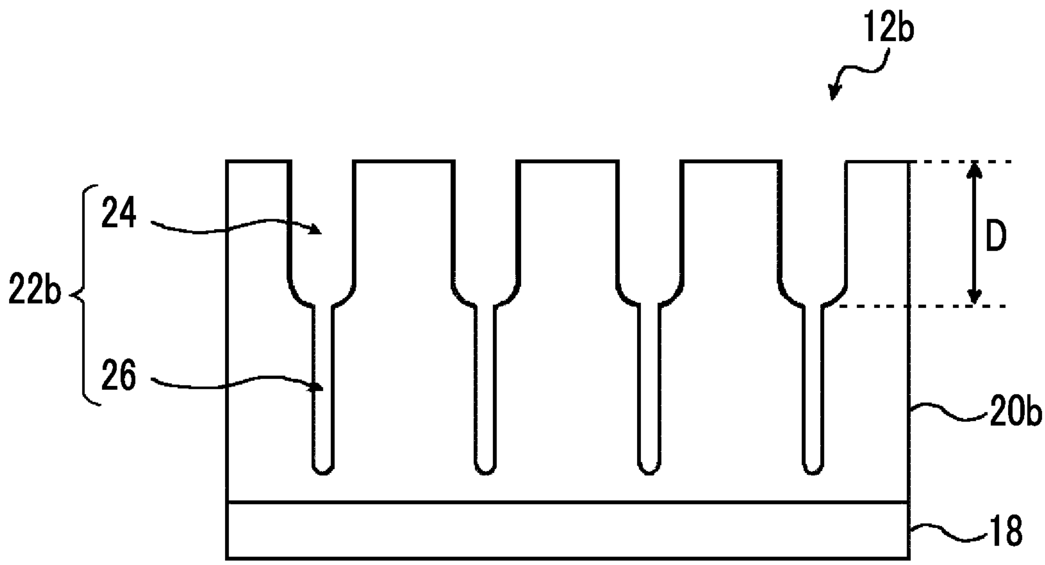

FIG. 3

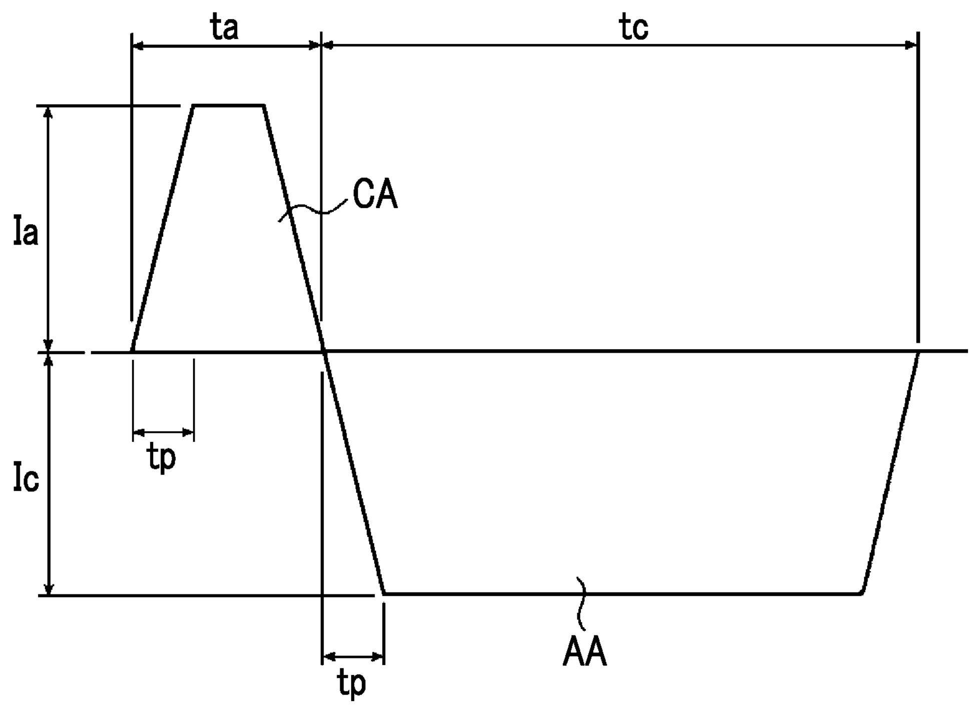


FIG. 4

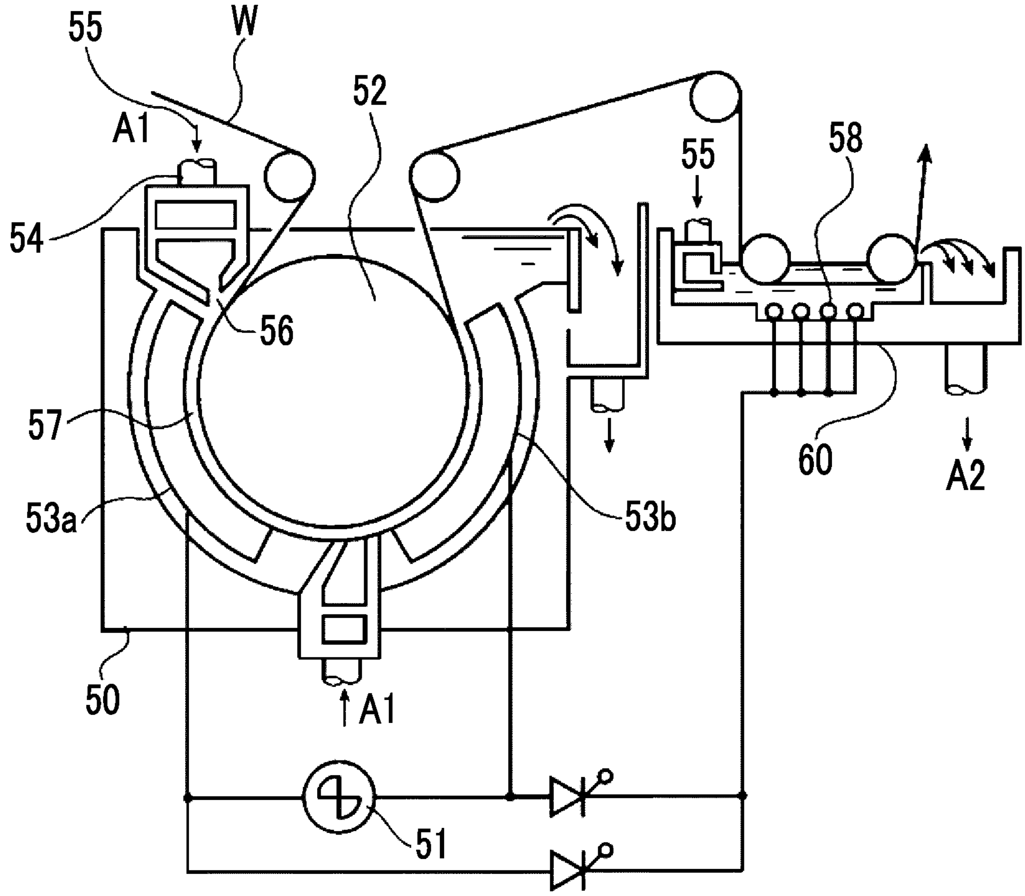

FIG. 5

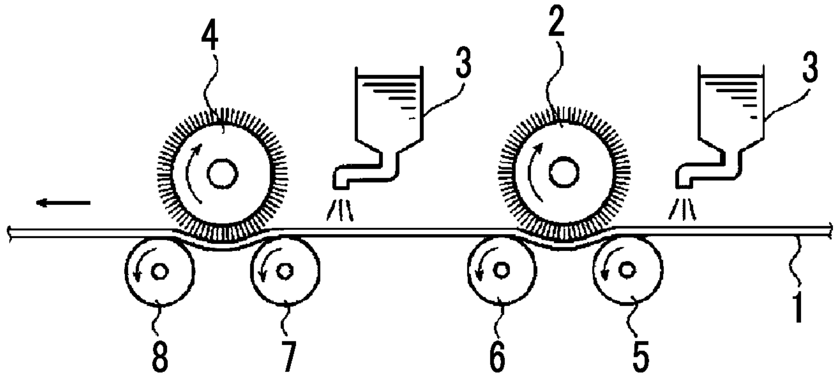


FIG. 6

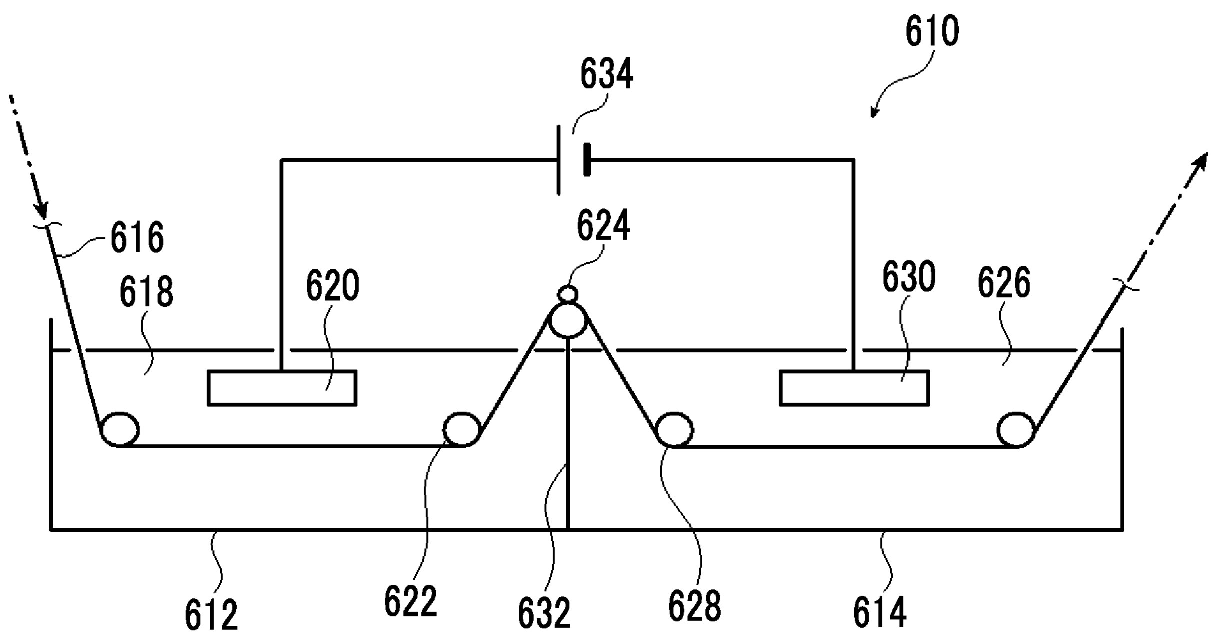

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2019504780 A
- WO 2018181993 A
- JP 2019504780 A
- EP 3456547 A1
- EP 3476616 A1
- WO 2019087516 A1
- WO 2019013268 A1
- EP 2042337 A1
- JP 2001133969 A
- JP 2002023360 A
- JP 2002040638 A
- JP 2002278057 A
- JP 2008195018 A
- JP 2007090850 A
- JP 2012206495 A
- JP 5005005 A
- JP H055005 A
- JP 2001222101 A
- JP 2008544322 A
- WO 2016027886 A
- WO 2017141882 A
- WO 2018043259 A
- JP 8108621 A
- JP H08108621 A
- JP 61166544 A
- JP S61166544 A
- JP 2002328465 A
- JP 2006508380 A
- JP 2002287344 A
- JP 2008256850 A
- JP 2001342222 A
- JP 9179296 A
- JP H09179296 A
- JP 9179297 A
- JP H09179297 A
- JP 9179298 A
- JP H09179298 A
- JP 2004294935 A
- JP 2006243493 A
- JP 2002275129 A
- JP 2003064130 A
- JP 2003280187 A
- JP 10333321 A
- JP H10333321 A
- JP 48041708 B
- JP S48041708 B
- JP 51037193 A
- JP S5137193 A
- JP 2032293 B
- JP H0232293 B
- JP 2016765 B
- JP H0216765 B
- JP 2003344997 A
- JP 2006065210 A
- JP 58049860 B
- JP S5849860 B
- JP 56017654 B
- JP S5617654 B
- JP 62039417 B
- JP S6239417 B
- JP 62039418 B
- JP S6239418 B
- JP 2000250211 A
- JP 2007094138 A
- US 7153632 B
- JP 8505958 A
- JP H08505958 A
- JP 2007293221 A
- JP 2007293223 A
- JP 2007276454 A
- JP 2009154525 A
- JP 2006297907 A
- JP 2007050660 A
- JP 2008284858 A
- JP 2009090645 A
- JP 2009208458 A
- JP 2008284817 A
- JP 50040047 B
- JP S5040047 B
- JP 10282679 A
- JP H10282679 A
- JP 2304441 A
- JP H02304441 A
- JP 2005238816 A
- JP 2005125749 A
- JP 2006239867 A
- JP 2006215263 A
- JP 2006188038 A
- US 3458311 A
- JP 55049729 B
- JP S5549729 B
- JP 2005250216 A
- JP 2006259137 A
- WO 2019219560 A

## Non-patent literature cited in the description


- Dye Handbooks. 1970
- **CHARLES M. HANSEN**. Hansen Solubility Parameters; A Users Handbook. CRC Press, 2007
- Iwanami Dictionary of Physics and Chemistry. Iwanami Shoten, Publishers, 1998